(19) Europäisches Patentamt / European Patent Office / Office européen des brevets

(11) **EP 2 681 970 B1**

(12) **EUROPEAN PATENT SPECIFICATION**

(45) Date of publication and mention of the grant of the patent:
**17.01.2018 Bulletin 2018/03**

(21) Application number: **12709448.0**

(22) Date of filing: **02.03.2012**

(51) Int Cl.:
***H05B 33/14*** (2006.01) ***H05B 33/22*** (2006.01)
***H01L 51/52*** (2006.01)

(86) International application number:
**PCT/US2012/027570**

(87) International publication number:
**WO 2012/119111 (07.09.2012 Gazette 2012/36)**

(54) **POROUS FILMS FOR USE IN LIGHT-EMITTING DEVICES**

PORÖSE FOLIEN ZUR VERWENDUNG FÜR LICHTEMITTIERENDE VORRICHTUNGEN

FILMS POREUX À UTILISER DANS DES DISPOSITIFS ÉLECTROLUMINESCENTS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **03.03.2011 US 201161449032 P**

(43) Date of publication of application:
**08.01.2014 Bulletin 2014/02**


(73) Proprietor: **Nitto Denko Corporation**
**Ibaraki-shi, Osaka 567-8680 (JP)**

(72) Inventors:
- **MOCHIZUKI, Amane**
**Carlsbad, CA 92011 (US)**
- **MA, Liping**
**San Diego, CA 92130 (US)**
- **ZHENG, Shijun**
**San Diego, CA 92129 (US)**
- **KHAN, Sazzadur, Rahman**
**San Diego, CA 92122 (US)**
- **LI, Sheng**
**Vista, CA 92081 (US)**
- **LAI, Qianxi**
**Vista, CA 92081 (US)**
- **SISK, David, T.**
**San Diego, CA 92128 (US)**
- **HARDING, Brett**
**Carlsbad, CA 92009 (US)**

(74) Representative: **Plougmann Vingtoft a/s**
**Rued Langgaards Vej 8**
**2300 Copenhagen S (DK)**



(56) References cited:
**US-A1- 2005 156 520** **US-A1- 2006 220 518**
**US-A1- 2010 326 526**



Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



EP 2 681 970 B1



Printed by Jouve, 75001 PARIS (FR)

## Description

CROSS-REFERENCE TO RELATED APPLICATIONS

The present application claims priority under 35 U.S.C. §119(e) to U.S. Provisional Application No. 61/449,032 filed on March 3, 2011.

BACKGROUND OF THE INVENTION

Field of the Invention

Some embodiments relate to porous films, such as porous films for use in devices, such as light-emitting devices.

Description of the Related Art

Organic light-emitting devices (OLED) may be useful for incorporating into energy-efficient lighting equipment or devices. Unfortunately, the efficiency of OLEDs may be limited by both any inherent inefficiency in producing emitted light, and in the ability of emitted light to escape the device to provide lighting. The inability of emitted light to escape the device may also be referred to as trapping. Because of trapping, the efficiency of a device may be reduced to about 10-30% of the emissive efficiency. Light extraction may reduce trapping and thus substantially improve efficiency.

US2005/156520 discloses light emitting devices wherein a porous film is disposed over an anode or a cathode and the refractive index of the porous film is less than that of the anode or the cathode.

SUMMARY

Some embodiments may include a porous film. A porous film may comprise: a non-polymeric organic compound having a refractive index in the range of about 1.1 to about 1.8; a plurality of irregularly arranged nanoprotrusions, nanoparticles, or aggregates thereof; and/or a plurality of voids having a total volume that is at least about 50% of the volume of the film, and at least about 10% of the plurality of voids have a longest dimension in the range of about 0.5 $\mu$m to about 5 $\mu$m. The porous film may have a thickness in the range of about 500 nm to about 20 microns; and/or the density of the porous film including the voids may be about 0.5 picograms/$\mu m^3$ or less.

Some embodiments may include light-emitting device comprising: a porous film that may comprise: a first interface with a partially internally reflective layer in the light-emitting device, wherein a refractive index of the partially internally reflective layer may be higher than a refractive index of the porous film; a second interface with a substance that may have a refractive index that is lower than the refractive index of the porous film; and wherein the second interface may comprise a plurality of irregularly arranged nanoprotrusions or nanoparticles.

Some embodiments may include a light-emitting device comprising: a porous film that may be disposed over an anode or a cathode; wherein the porous film may have a refractive index that is lower than a refractive index of the anode and a refractive index of the cathode.

Some embodiments include a light-emitting device comprising: a light-emitting diode that may comprise: an anode; a cathode; an emissive layer that may be disposed between the anode and the cathode; and a porous film; wherein the porous film may be disposed on the anode or the cathode; or the light-emitting device may further comprises a transparent layer disposed between the anode and the porous film, or between the cathode and the porous film.

In some embodiments, the porous film may be prepared by a process comprising depositing an organic film; and heating the organic film at a temperature in the range of about 100 °C to about 290 °C.

Some embodiments may include a light-emitting device comprising: a light-emitting diode comprising an porous film; wherein the porous film is disposed on an internally reflective layer selected from the group consisting of: an anode; a cathode; a transparent layer disposed between the anode and the porous film, or a transparent layer disposed between the cathode and the porous film; wherein a refractive index of the internally reflective layer is higher than a refractive index of the porous film; wherein the porous film may comprise a compound described herein.

These and other embodiments are described in detail herein.

BRIEF DESCRIPTION OF THE DRAWINGS

FIG. 1 is a depicted to provide assistance in determining an x dimension, a y dimension, and a z dimension of a particle or protrusion.

FIG. 2A depicts an idealized example of a particle that may be described as: substantially rectangular when viewed in the xz plane. pseudoplanar, or as a nanoflake.

FIG. 2B depicts an example of a particle that may be described as a curved or wavy nanoflake.

FIG. 3 depicts an idealized example of a particle having substantially all substantially right angles in the plane.

FIG. 4 is an idealized example of a pseudo-paralellogramatic particle having angles that may not be substantially right angles.

FIG. 5 depicts an idealized example of a substantially capsule-shaped particle.

FIG. 6 depicts an SEM image of a surface of an embodiment of a porous film.

FIG. 7 depicts an SEM image of a surface of an embodiment of a porous film.

FIG. 8 depicts an SEM image of a surface of an embodiment of a porous film.

FIG. 9 depicts an SEM image of a surface of an embodiment of a porous film.

FIG. 10 depicts an SEM image of a surface of an embodiment of a porous film.

FIG. 11 depicts an SEM image of a surface of an embodiment of a porous film.

FIG. 12 depicts an SEM image of a surface of an embodiment of a porous film.

FIG. 13 depicts an SEM image of a surface of an embodiment of a porous film.

FIG. 14 depicts an SEM image of a surface of an embodiment of a porous film.

FIG. 15 depicts an SEM image of a surface of an embodiment of a porous film.

FIG. 16 depicts an SEM image of a surface of an embodiment of a porous film.

FIG. 17 depicts an SEM image of a surface of an embodiment of a porous film.

FIG. 18 depicts an SEM image of a surface of an embodiment of a porous film.

FIG. 19 depicts an SEM image of a surface of an embodiment of a porous film.

FIG. 20 depicts an SEM image of a surface of an embodiment of a porous film.

FIG. 21 depicts an SEM image of a surface of an embodiment of a porous film.

FIG. 22 depicts an SEM image of a surface of an embodiment of a porous film.

FIG. 23 depicts an SEM image of a surface of an embodiment of a porous film.

FIG. 24 depicts an SEM image of a surface of an embodiment of a porous film.

FIG. 25 depicts an SEM image of a surface of an embodiment of a porous film.

FIG. 26 depicts an SEM image of a surface of an embodiment of a porous film.

FIG. 27 depicts an SEM image of a surface of an embodiment of a porous film.

FIG. 28 depicts an SEM image of a surface of an embodiment of a porous film.

FIG. 29 depicts an SEM image of a surface of an embodiment of a porous film.

FIG. 30 depicts an SEM image of a surface of an embodiment of a porous film.

FIG. 31 depicts an SEM image of a surface of an embodiment of a porous film.

FIG. 32 depicts an SEM image of a surface of an embodiment of a porous film.

FIG. 33 depicts an SEM image of a surface of an embodiment of a porous film.

FIG. 34 depicts an SEM image of a surface of an embodiment of a porous film.

FIG. 35 depicts an SEM image of a surface of an embodiment of a porous film.

FIG. 36 depicts an SEM image of a surface of an embodiment of a porous film.

FIG. 37 depicts an SEM image of a surface of an embodiment of a porous film.

FIG. 38 depicts an SEM image of a surface of an embodiment of a porous film.

FIG. 39 depicts an SEM image of a surface of an embodiment of a porous film.

FIG. 40 depicts an SEM image of a surface of an embodiment of a porous film.

FIG. 41 depicts an SEM image of a surface of an embodiment of a porous film.

FIG. 42 depicts an SEM image of a surface of an embodiment of a porous film.

FIG. 43 depicts an SEM image of a surface of an embodiment of a porous film.

FIG. 44 depicts an SEM image of a surface of an embodiment of a porous film.

FIG. 45 depicts an SEM image of a surface of an embodiment of a porous film.

FIG. 46 depicts an SEM image of a surface of an embodiment of a porous film.

FIG. 47 depicts an SEM image of a surface of an embodiment of a porous film.

FIG. 48 depicts an SEM image of a surface of an embodiment of a porous film.

FIG. 49 depicts an SEM image of a surface of an embodiment of a porous film.

FIG. 50 depicts an SEM image of a surface of an embodiment of a porous film.

FIG. 51 depicts an SEM image of a surface of an embodiment of a porous film.

FIG. 52 depicts an SEM image of a surface of an embodiment of a porous film.

FIG. 53 depicts an SEM image of a surface of an embodiment of a porous film.

FIG. 54 depicts an SEM image of a surface of an embodiment of a porous film.

FIG. 55 is a schematic diagram of some embodiments of a device described herein.

FIG. 56 is a schematic diagram of some embodiments of a device described herein.

FIG. 57A-B are schematic diagrams of some embodiments of a device described herein.

FIG. 58 is a schematic diagram of some embodiments of a device described herein.

FIG. 59 is a schematic diagram of some embodiments a device described herein.

FIG. 60 is a schematic diagram of some embodiments of a device described herein.

FIG. 61 is a flow diagram illustrating certain steps in an embodiment of a method of preparing a light emitting device.

FIG. 62A is a schematic diagram related to an embodiment of a device described herein.

FIG. 62B is a flow diagram illustrating certain steps in an embodiment of a method of preparing a light emitting device.

FIG. 63 is a schematic diagram of some embodiments of a device described herein.

FIG. 64 is a schematic diagram of some embodiments of a device described herein.

FIG. 65 is a plot of power efficiency as a function of luminance for some embodiments of devices described herein.

FIG. 66 is a schematic diagram of some embodiments a device described herein.

FIG. 67 depicts an SEM image of a surface a porous film of the device.

FIG. 68 is a plot of power efficiency as a function of luminance for some embodiments of devices described herein.

FIG. 69 is a schematic diagram of some embodiments of a device described herein.

FIG. 70 is a plot of power efficiency as a function of luminance for some embodiments of devices described herein.

FIG. 71 is a plot of power efficiency as a function of thickness for a porous film comprising a compound described herein.

FIG. 72 is a schematic diagram of a method used to determine trapping in an embodiment of a transparent substrate.

FIG. 73 is a plot of power efficiency as a function of luminance for some embodiments of devices described herein.

FIG. 74A-B is a photograph of some embodiments of the devices described herein.

FIG. 75 is a photograph of some embodiments of the porous films described herein.

FIG. 76 depicts an SEM image of a surface of an embodiment of a porous film.

FIG. 77 depicts an SEM image of a surface of an embodiment of a porous film.

FIG. 78 depicts an SEM image of a surface of an embodiment of a porous film.

FIG. 79 depicts an SEM image of a surface of an embodiment of a porous film.

FIG. 80 is a plot of power efficiency as a function of luminance for some embodiments of devices described herein.

FIG. 81 is a photograph of an embodiment of the porous films described herein.

FIG. 82 is a plot of power efficiency as a function of luminance for some embodiments of devices described herein.

FIG. 83 is a plot of power efficiency as a function of luminance for some embodiments of devices described herein.

## DETAILED DESCRIPTION

The porous films described herein may be useful in a variety of devices involving the transmission of light from

one layer to another, such as light-emitting diodes, photovoltaics, detectors, etc. In some embodiments, a porous film may provide efficient light outcoupling for organic light-emitting diodes for uses such as lighting. With some devices, light extraction from a substrate close to 90%, or possibly greater, may be achieved. The porous films may provide easy processing and potentially low cost improvement in device efficiency.

In some embodiments, the porous films described herein may improve efficiency of a device by reducing the amount of total internal reflection in a layer of the device. Total internal reflection may be a significant cause of trapping. When light passes from a high refractive index material to a low refractive index material, the light may be bent in a direction away from the normal angle to the interface. If light in a higher refractive index material encounters an interface with a lower refractive index material at an angle which deviates substantially from 90°, the bending of the light may be greater than the angle at which the light approaches the interface, so that instead of passing out of the higher refractive index material, the light may be bent back into the higher refractive index material. This may be referred to as total internal reflection. Since air may have a lower refractive index than many materials, many interfaces between a device and air may suffer from loss due to total internal reflection. Furthermore, trapping due to total internal reflection may occur at any interface in a device where the light travels from a higher refractive index layer to a lower refractive index layer. Devices comprising porous films describe herein may have reduced total internal reflection or trapping and thus have improved efficiency.

In some embodiments, a porous film described herein may provide light scattering for a variety of devices that involve light passing from one material to another, including devices that absorb or emit light. Light scattering may be useful in a device to provide viewing angle color consistency, so that the color is substantially similar regardless of the angle from which light is viewed. Devices having no light scattering layer may emit light in such a way that the viewer observes a different color depending upon the angle from which the light is viewed.

In some embodiments, a porous film described herein may also be useful as a filter for a variety of devices that involve light passing from one material to another, including devices that absorb or emit light.

A porous film may include any film comprising a plurality of pores. For example, a porous film may comprise an irregularly oriented intermeshed nanostructure.

In some embodiments a porous film may be deposited on a transparent substrate, which may reduce the total internal reflection of light within the substrate.

In some embodiments, a porous film may comprise a first surface and a second surface, wherein the first surface has a coplanar area that is substantially greater than a coplanar area of the second surface. While "coplanar area" is a broad term, one way to determine the coplanar area of a surface may be to place the surface under consideration on a smooth flat surface, and measure the area of the surface that contacts the smooth flat surface.

A porous film may have a variety of structures. In some embodiments, a porous film may have a surface comprising a plurality of irregularly arranged protrusions, particles, or aggregates thereof. The protrusions or particles may be nanoprotrusions, including nanoprotrusions having one or more dimensions in the nanometer to micron range. For example, nanoprotrusions or nanoparticles may have: an average x dimension of about 400 nm, about 500 nm, about 1000 nm, about 1500 nm, about 2000 nm, about 2500 nm, about 3000 nm, or any value in a range bounded by, or between, any of these lengths; an average y dimension of about 50 nm, about 100 nm, about 300 nm, about 500 nm, about 700 nm, about 1000 nm, about 1200 nm, about 1500 nm, about 1800 nm, about 2000 nm, or any value in a range bounded by, or between, any of these lengths; and/or an average z dimension of about 10 nm, about 30 nm, about 50 nm, about 70 nm, about 90 nm, about 100 nm, or any value in a range bounded by, or between, any of these lengths. In some embodiments, at least one particle in the film, or average of the particles in the film, may have an x dimension, a y dimension, or a z dimension of: about 5 nm, about 0.01 μm, about 0.02 μm, about 0.05 μm, about 0.1 μm, about 0.5 μm, about 1 μm, about 2 μm, about 5 μm, about 10 μm, about 20 μm, about 50 μm, about 100 μm, about 150 μm, about 200 μm, about 500 μm, about 1000 μm, or any length bounded by, or between, any of these values. In some embodiments, the nanoprotrusions or nanoparticles may have: an average x dimension in the range of about 400 nm to about 3000 nm, about 1000 nm to about 3000 nm, or about 2000 nm to about 3000 nm; an average y dimension in the range of about 100 nm to about 2000 nm, about 100 nm to about 1500 nm, or about 100 nm to about 1000 nm; and/or an average z dimension of about 10 nm to about 100 nm, about about 30 nm to about 90 nm, or about 30 nm to about 70 nm. In some embodiments, at least one particle in the film, or average of the particles in the film, may have an x dimension, a y dimension, or a z dimension in the range of: about 5 nm to about 1000 μm, about 0.02 μm to about 1 μm, or about 1 μm to about 200 μm.

In some embodiments, the protrusions, particles, or aggregates thereof may be substantially transparent or substantially translucent.

Although the particles, protrusions, or voids may be irregularly shaped, three dimensions, x, y, and z, may be quantified as depicted in FIG. 1. If a box **120** the shape of a rectangular prism is formed around the particle **110,** or an open box the shape of a rectangular prism is formed around the protrusion, so that the box is as small as possible while still having the particle (or as much of protrusion as possible without altering the dimensions of the open end of the box) contained in it, the x dimension is the longest dimension of the box, the y dimension is the second longest dimension of

the box, and the z dimension is the third longest dimension of the box.

The three dimensional shapes of the particles or protrusions may be characterized by describing the shape of the particles or protrusions when viewed in a certain plane. For example, a particle or protrusion may be substantially rectangular, substantially square, substantially elliptical, substantially circular, substantially triagonal, substantially parallelogramatic, etc., when viewed in the two dimensions of the xy, xz, or yz plane. The particular shape need not be geometrically perfect, but need only be recognizable as reasonably similar to a known shape. The three dimensional shape of the particles or protrusions might also be characterized or described using other terms.

FIG. 2A depicts an idealized example of a particle **210** that is substantially rectangular **220** when viewed in the xz plane. As depicted in this figure, the particle appears perfectly rectangular, but the shape need only be recognizable as similar to a rectangle to be substantially rectangular when viewed in the xz plane or any other plane.

With respect to FIG. 2A, the particle **210** may also be described as substantially linear when viewed in the xy plane because the x dimension is much greater than the z dimension. As depicted in this figure, the particle appears perfectly straight in the x dimension, but the shape need only be recognizable as similar to a line to be substantially linear when viewed in the xz plane or any other plane.

The particle **210** may also be described as a nanoflake. The term "nanoflake" is a broad term that includes particles that are flake-like in shape and have any dimension in the nanometer to micrometer range. This may include particles that are relatively thin in one dimension (e.g. z) and have a relatively large area in another two dimensions (e.g. xy).

The larger area surface need only be identifiable, but does not need to be planar. For example, the larger area surface may be substantially in the xy plane, such as particle **210,** but may also be curved or wavy, such that substantial portions of the surface are not in the plane.

The particle **210** may also be described as pseudoplanar. The term "pseudoplanar" is a broad term that includes particles that are essentially planar. For example, a pseudoplanar particle may have a z dimension that is relatively insignificant as compared to the xy area of the particle that is substantially in the xy plane.

In FIG. 2B, particle **250** is an example of a curved or wavy nanoflake. If substantial portions of the surface are not in the plane, a nanoflake may include particles having a large curved or wavy surface **260** and a small thickness **270** normal to a given point **280** on the surface.

With respect to any nanoflake or pseudoplanar particle or protrusion, including particle **210,** particle **250,** and the like, the ratio of the square root of the larger area or surface to a smallest dimension or a thickness normal to a point on the large surface (such as the ratio of the square root of an xy area to a z dimension), may be: about 3, about 5, about 10, about 20, about 100, about 1000, about 10,000, about 100,000, or any value in a range bounded by, or between, any of these ratios. In some embodiments, the ratio of the square root of the larger area or surface to a smallest dimension or a thickness normal to a point on the large surface may be about 3 to about 100,000, about 5 to about 1000, or about 1000 to about 10,000.

FIG. 3 depicts an idealized example of a particle **310** having substantially all substantially right angles in the xy plane. While not depicted in this figure, some particles may not have substantially all substantially right angles, but may have at least one substantially right angle. The particle **310** of this figure may also be described as pseudo-parallelogramatic. A pseudo-parallelogramatic particle may include two substantially linear portions of outer edges the particle that are substantially parallel viewed in the two dimensions of the xy, xz, or yz plane.

The outer edges of the particle may consist essentially of a plurality of linear edge portions.

Pseudo-parallelogramatic particles may have substantially right angles such as those depicted in FIG. 3, or they may have angles that may not be substantially right angles.

FIG. 4 is an idealized example of a pseudo-paralellogramatic particle **410** having angles that may not be substantially right angles.

A particle or protrusion may be described as needlelike if it has a shape that is reasonably recognizable as similar to a shape of a needle.

A particle or protrusion may be described as fiber-shaped if it has a shape that is reasonably recognizable as similar to a shape of a fiber.

A particle or protrusion may be described as ribbon-shaped if it has a shape that is reasonably recognizable as similar to the shape of a ribbon. This may include particles or protrusions that have a flat rectangular surface that is elongated in one dimension and thin in another dimension. The ribbon shape may also be curved or twisted, so that the particle need not be substantially coplanar to be ribbon-shaped.

FIG. 5 depicts an idealized example of a substantially capsule-shaped particle 1010. When viewed in the xy or the xz plane, the particle **1010** may also be described as substantially oval. When viewed in the yz plane, the particle **1010** may also be described as substantially circular.

A particle or protrusion may be described as rod-shaped if it has a shape that is reasonably recognizable as similar to the shape of a rod. This may include particles or protrusions that are elongated in one dimension. A rod-shaped particle or protrusion may be substantially straight, or have some curvature or bending.

A particle or protrusion may be described as granular if the x, y, and z dimensions are similar, such as within an order of magnitude or one another.

FIGS. 6-53 depict SEM images of actual porous films. All SEM images were recorded using a FEI xTm "Inspect F" SEM; 2007 model, version 3.3.2. In these figures, "mag" indicates the magnification level of the image, "mode" indicates the type of detector used to generate the image, where "SE" stands for secondary electron mode, "HV" indicates the accelerating voltage of the electron beam used to generate the image "WD" indicates the working distance between the detector and the actual surface being imaged, "spot" indicates a unitless indicator of the electron beam diameter, and "pressure" indicates the pressure, in pascals, within the microscope chamber at the time of image capture.

FIG. 6 depicts an SEM image of a surface of an embodiment of a porous film. Although not exhaustive, the following descriptions may apply to at least one of the protrusions or particles in this figure when viewed in the xy plane: pseudo-parallelogramatic, at least one substantially right angle, and substantially all substantially right angles. Although not exhaustive, the following descriptions may apply to at least one of the protrusions or particles in this figure when viewed in the yz plane: substantially rectangular, substantially linear, and substantially all substantially right angles. Although not exhaustive, the following other descriptions may also apply to at least one of the protrusions or particles in this figure: nanoflakes and pseudoplanar.

A scale bar of 5 μm is indicated in the SEM, which may provide an indication of the size of the nanoparticles, nanoprotrusions, or voids of the film. This figure shows that a substantial number of particles or voids may have an x, y, and/or z dimension in the range of about 1 μm to about 20 μm. A substantial number of particles may also have a ratio of the square root of the xy area to the z dimension in the range of about 10 to about 100. For example, the particle circled in the figure appears to have a ratio:

$$\frac{[\text{xy area}]^{1/2}}{\text{z}}$$

of about 40, assuming that the length of the visible edge is about equal to the square root of the area. This method may be used for films such as the one depicted here, where, based upon other nanoflakes visible in the figure, the large area, or the xy area, is about equal to the length of one side viewed in the yz plane. Moreover, at least about 50%, about 70%, or about 90% of the particles on the surface may have a ratio of the square root of the xy area to the z dimension in the range of about 10 to about 1000.

FIG. 7 also depicts an SEM image of a surface of an embodiment of a porous film. Although not exhaustive, the following descriptions may apply to at least one of the protrusions or particles in this figure when viewed in the xy plane: pseudo-parallelogramatic and substantially parallelogramatic. Although not exhaustive, the following descriptions may apply to at least one of the protrusions or particles in this figure when viewed in the yz plane: substantially rectangular, substantially linear, and substantially all substantially right angles. Although not exhaustive, the following other descriptions may also apply to at least one of the protrusions or particles in this figure: nanoflakes and pseudoplanar.

A scale bar of 50 μm is indicated in the SEM of FIG. 7, which may provide an indication of the size of the nanoparticles, nanoprotrusions, or voids of the film. This figure shows that a substantial number of particles or voids may have an x, y, and/or z dimension in the range of about 1 μm to about 500 μm. A substantial number of particles may also have a ratio of the square root of the xy area to the z dimension in the range of about 5 to about 100.

FIG. 8 also depicts an SEM image of a surface of an embodiment of a porous film. Although not exhaustive, the following descriptions may apply to at least one of the protrusions or particles in this figure when viewed in the xy plane: pseudo-parallelogramatic and substantially parallelogramatic. Although not exhaustive, the following descriptions may apply to at least one of the protrusions or particles in this figure when viewed in the yz plane: substantially rectangular, substantially linear, at least one substantially right angle, and substantially all substantially right angles. Although not exhaustive, the following other descriptions may also apply to at least one of the protrusions or particles in this figure: nanoflakes and pseudoplanar.

A scale bar of 100 μm is indicated in the SEM of FIG. 8, which may provide an indication of the size of the nanoparticles, nanoprotrusions, or voids of the film. This figure shows that a substantial number of particles or voids may have an x, y, and/or z dimension in the range of about 1 μm to about 500 μm. A substantial number of particles may also have a ratio of the square root of the xy area to the z dimension in the range of about 5 to about 100.

FIG. 9 also depicts an SEM image of a surface of an embodiment of a porous film. Although not exhaustive, the following descriptions may apply to at least one of the protrusions or particles in this figure when viewed in the xy plane: pseudo-parallelogramatic and substantially parallelogramatic. Although not exhaustive, the following descriptions may apply to at least one of the protrusions or particles in this figure when viewed in the yz plane: substantially linear. Although not exhaustive, the following other descriptions may also apply to at least one of the protrusions or particles in this figure: nanoflakes and pseudoplanar.

A scale bar of 50 μm is indicated in the SEM of FIG. 9, which may provide an indication of the size of the

nanoparticles, nanoprotrusions, or voids of the film. This figure shows that a substantial number of particles or voids may have an x, y, and/or z dimension in the range of about 1 μm to about 500 μm.

FIG. 10 also depicts an SEM image of a surface of an embodiment of a porous film. Although not exhaustive, the following descriptions also apply to at least one of the protrusions or particles in this figure: nanoflakes and pseudoplanar.

A scale bar of 4 μm is indicated in the SEM of FIG. 10, which may provide an indication of the size of the nanoparticles, nanoprotrusions, or voids of the film. This figure shows that a substantial number of particles or voids may have an x, y, and/or z dimension in the range of about 1 μm to about 20 μm.

FIG. 11 also depicts an SEM image of a surface of an embodiment of a porous film. Although not exhaustive, the following descriptions may apply to at least one of the protrusions or particles in this figure when viewed in the xy plane, the xz plane, and/or the yz plane: substantially linear. Although not exhaustive, the following other descriptions may also apply to at least one of the protrusions or particles in this figure: fiber-shaped and needlelike.

A scale bar of 100 μm is indicated in the SEM of FIG. 11, which may provide an indication of the size of the nanoparticles, nanoprotrusions, or voids of the film. This figure shows that a substantial number of particles or voids may have an x, y, and/or z dimension in the range of about 20 μm to about 1000 μm.

FIG. 12 also depicts an SEM image of a surface of an embodiment of a porous film. Although not exhaustive, the following descriptions may apply to at least one of the protrusions or particles in this figure when viewed in the xy plane: substantially linear, pseudo-parallelogramatic, and substantially parallelogramatic. Although not exhaustive, the following descriptions may apply to at least one of the protrusions or particles in this figure when viewed in the yz plane: substantially rectangular, substantially linear, pseudo-parallelogramatic, and substantially parallelogramatic. Although not exhaustive, the following other descriptions may also apply to at least one of the protrusions or particles in this figure: fiber-shaped and needlelike.

A scale bar of 10 μm is indicated in the SEM of FIG. 12, which may provide an indication of the size of the nanoparticles, nanoprotrusions, or voids of the film. This figure shows that a substantial number of particles or voids may have an x, y, and/or z dimension in the range of about 1 μm to about 100 μm.

FIG. 13 also depicts an SEM image of a surface of an embodiment of a porous film. Although not exhaustive, the following descriptions may apply to at least one of the protrusions or particles in this figure when viewed in the xy plane: substantially linear. Although not exhaustive, the following descriptions may apply to at least one of the protrusions or particles in this figure when viewed in the yz plane: substantially linear. Although not exhaustive, the following other descriptions may also apply to at least one of the protrusions or particles in this figure: fiber-shaped, needlelike, and pseudoplanar.

A scale bar of 20 μm is indicated in the SEM of FIG. 13, which may provide an indication of the size of the nanoparticles, nanoprotrusions, or voids of the film. This figure shows that a substantial number of particles or voids may have an x, y, and/or z dimension in the range of about 2 μm to about 100 μm.

FIG. 13 also shows that the particles or protrusions form aggregates having a pseudofloral arrangement. For example, the manner in which some of the particles protrude from a common central area provides an appearance that is recognizable as similar to a flower. A substantial number of these pseudofloral aggregates may have a diameter in the range of about 10 μm to about 50 μm.

FIG. 14 also depicts an SEM image of a surface of an embodiment of a porous film. Although not exhaustive, the following descriptions may apply to at least one of the protrusions or particles in this figure when viewed in the xy plane: substantially linear, substantially parallelogramatic, and pseudo-parallelogramatic. Although not exhaustive, the following descriptions may apply to at least one of the protrusions or particles in this figure when viewed in the yz plane: substantially linear, substantially parallelogramatic, and pseudo-parallelogramatic. Although not exhaustive, the following other descriptions may also apply to at least one of the protrusions or particles in this figure: fiber-shaped, needlelike, and pseudoplanar.

A scale bar of 5 μm is indicated in the SEM of FIG. 15, which may provide an indication of the size of the nanoparticles, nanoprotrusions, or voids of the film. This figure shows that a substantial number of particles or voids may have an x, y, and/or z dimension in the range of about 0.5 μm to about 50 μm.

FIG. 15 also depicts an SEM image of a surface of an embodiment of a porous film. Although not exhaustive, the following descriptions may apply to at least one of the protrusions or particles in this figure: pseudoplanar.

A scale bar of 1 μm is indicated in the SEM of FIG. 15, which may provide an indication of the size of the nanoparticles, nanoprotrusions, or voids of the film. This figure shows that a substantial number of particles or voids may have an x, y, and/or z dimension in the range of about 0.1 μm to about 5 μm.

FIG. 16 also depicts an SEM image of a surface of an embodiment of a porous film. Although not exhaustive, the following descriptions may apply to at least one of the protrusions or particles in this figure when viewed in the xy plane: substantially linear. Although not exhaustive, the following descriptions may apply to at least one of the protrusions or particles in this figure when viewed in the yz plane: substantially linear. Although not exhaustive, the following other descriptions may also apply to at least one of the protrusions or particles in this figure: needlelike and pseudoplanar.

A scale bar of 5 μm is indicated in the SEM of FIG. 16, which may provide an indication of the size of the nanoparticles, nanoprotrusions, or voids of the film. This figure shows that a substantial number of particles or voids may have an x, y, and/or z dimension in the range of about 0.1 μm to about 10 μm.

FIG. 17 also depicts an SEM image of a surface of an embodiment of a porous film. Although not exhaustive, the following descriptions may apply to at least one of the protrusions or particles in this figure when viewed in the xy plane: substantially rectangular, substantially linear, pseudo-parallelogramatic, substantially parallelogramatic, at least one substantially right angle, and substantially all substantially right angles. Although not exhaustive, the following descriptions may apply to at least one of the protrusions or particles in this figure when viewed in the yz plane: substantially rectangular, substantially linear, pseudo-parallelogramatic, substantially parallelogramatic, at least one substantially right angle, and substantially all substantially right angles. Although not exhaustive, the following other descriptions may also apply to at least one of the protrusions or particles in this figure: nanoflake, fiber-shaped, and pseudoplanar.

A scale bar of 1 μm is indicated in the SEM of FIG. 17, which may provide an indication of the size of the nanoparticles, nanoprotrusions, or voids of the film. This figure shows that a substantial number of particles or voids may have an x, y, and/or z dimension in the range of about 0.1 μm to about 5 μm.

FIG. 18 also depicts an SEM image of a surface of an embodiment of a porous film. Although not exhaustive, the following descriptions may apply to at least one of the protrusions or particles in this figure when viewed in the xy plane: substantially rectangular, pseudo-parallelogramatic, substantially parallelogramatic, and substantially all substantially right angles. Although not exhaustive, the following descriptions may apply to at least one of the protrusions or particles in this figure when viewed in the yz plane: substantially linear, substantatially rectangular, substantially parallelogramatic, and pseudo-parallelogramatic. Although not exhaustive, the following other descriptions may also apply to at least one of the protrusions or particles in this figure: pseudoplanar.

A scale bar of 1 μm is indicated in the SEM of FIG. 19, which may provide an indication of the size of the nanoparticles, nanoprotrusions, or voids of the film. This figure shows that a substantial number of particles or voids may have an x, y, and/or z dimension in the range of about 0.1 μm to about 20 μm.

FIG. 19 also depicts an SEM image of a surface of an embodiment of a porous film. Although not exhaustive, the following descriptions may apply to at least one of the protrusions or particles in this figure: nanoflake and pseudoplanar.

A scale bar of 5 μm is indicated in the SEM of FIG. 19, which may provide an indication of the size of the nanoparticles, nanoprotrusions, or voids of the film. This figure shows that a substantial number of particles or voids may have an x, y, and/or z dimension in the range of about 1 μm to about 20 μm.

FIG. 20 also depicts an SEM image of a surface of an embodiment of a porous film. Although not exhaustive, the following descriptions may apply to at least one of the protrusions or particles in this figure when viewed in the yz plane: substantially linear. Although not exhaustive, the following other descriptions may also apply to at least one of the protrusions or particles in this figure: nanoflake and pseudoplanar.

A scale bar of 30 μm is indicated in the SEM of FIG. 20, which may provide an indication of the size of the nanoparticles, nanoprotrusions, or voids of the film. This figure shows that a substantial number of particles or voids may have an x, y, and/or z dimension in the range of about 1 μm to about 50 μm.

FIG. 21 also depicts an SEM image of a surface of an embodiment of a porous film. Although not exhaustive, the following description may also apply to at least one of the protrusions or particles in this figure: pseudoplanar.

A scale bar of 50 μm is indicated in the SEM of FIG. 21, which may provide an indication of the size of the nanoparticles, nanoprotrusions, or voids of the film. This figure shows that a substantial number of particles or voids may have an x, y, and/or z dimension in the range of about 1 μm to about 200 μm.

FIG. 22 also depicts an SEM image of a surface of an embodiment of a porous film. Although not exhaustive, the following description may apply to at least one of the protrusions or particles in this figure: pseudoplanar.

A scale bar of 1 μm is indicated in the SEM of FIG. 22, which may provide an indication of the size of the nanoparticles, nanoprotrusions, or voids of the film. This figure shows that a substantial number of particles or voids may have an x, y, and/or z dimension in the range of about 0.1 μm to about 5 μm.

FIG. 23 also depicts an SEM image of a surface of an embodiment of a porous film. Although not exhaustive, the following description may apply to at least one of the protrusions or particles in this figure: pseudoplanar.

A scale bar of 500 nm is indicated in the SEM of FIG. 23, which may provide an indication of the size of the nanoparticles, nanoprotrusions, or voids of the film. This figure shows that a substantial number of particles or voids may have an x, y, and/or z dimension in the range of about 50 nm to about 5 μm.

FIG. 24 also depicts an SEM image of a surface of an embodiment of a porous film. Although not exhaustive, the following descriptions may apply to at least one of the protrusions or particles in this figure when viewed in the xy, xy, and/the yz plane: substantially oval, substantially elliptical, and substantially circular. Although not exhaustive, the following other descriptions may also apply to at least one of the protrusions or particles in this figure: rod-shaped, substantially capsule-shaped.

A scale bar of 3 μm is indicated in the SEM of FIG. 24, which may provide an indication of the size of the

nanoparticles, nanoprotrusions, or voids of the film. This figure shows that a substantial number of particles or voids may have an x, y, and/or z dimension in the range of about 0.01 μm to about 1 μm.

FIG. 25 also depicts an SEM image of a surface of an embodiment of a porous film. Although not exhaustive, the following descriptions may apply to at least one of the protrusions, particles, and/or aggregates thereof: fiber-shaped.

A scale bar of 5 μm is indicated in the SEM of FIG. 25, which may provide an indication of the size of the nanoparticles, nanoprotrusions, or voids of the film. This figure shows that a substantial number of particles or voids may have an x, y, and/or z dimension in the range of about 0.01 μm to about 20 μm.

FIG. 25 also comprises aggregates of nanoparticles or nanoprotrusion having a fiber bundle configuration. In some embodiments, the aggregates may be described as having a center-bound fiber bundle configuration in that they may resemble a bundle of fibers having a strap or binding in the center of the bundle holding it together, such that the ends diverge more than the center of the bundle.

FIG. 26 also depicts an SEM image of a surface of an embodiment of a porous film. Although not exhaustive, the following descriptions may apply to at least one of the protrusions, particles, and/or aggregates thereof: fiber-shaped.

A scale bar of 2 μm is indicated in the SEM of FIG. 26, which may provide an indication of the size of the nanoparticles, nanoprotrusions, or voids of the film. This figure shows that a substantial number of particles or voids may have an x, y, and/or z dimension in the range of about 0.01 μm to about 10 μm.

FIG. 26 also comprises aggregates of nanoparticles or nanoprotrusion having a fiber bundle configuration and/or a center-bound fiber bundle configuration.

FIG. 27 also depicts an SEM image of a surface of an embodiment of a porous film. Although not exhaustive, the following descriptions may apply to at least one of the protrusions or particles in this figure: fiber-shaped and pseudoplanar.

A scale bar of 500 nm is indicated in the SEM of FIG. 27, which may provide an indication of the size of the nanoparticles, nanoprotrusions, or voids of the film. This figure shows that a substantial number of particles or voids may have an x, y, and/or z dimension in the range of about 5 nm to about 5 μm.

FIG. 28 also depicts an SEM image of a surface of an embodiment of a porous film. Although not exhaustive, the following descriptions may apply to at least one of the protrusions or particles in this figure when viewed in the xy plane: substantially linear. Although not exhaustive, the following other descriptions may also apply to at least one of the protrusions or particles in this figure: needlelike and fiber-shaped.

A scale bar of 5 μm is indicated in the SEM of FIG. 28, which may provide an indication of the size of the nanoparticles, nanoprotrusions, or voids of the film. This figure shows that a substantial number of particles or voids may have an x, y, and/or z dimension in the range of about 0.1 μm to about 100 μm.

FIG. 29 also depicts an SEM image of a surface of an embodiment of a porous film. Although not exhaustive, the following descriptions may apply to at least one of the protrusions or particles in this figure when viewed in the xy plane: substantially rectangular, substantially parallelogramatic, at least one substantially right angle, and substantially linear. Although not exhaustive, the following descriptions may apply to at least one of the protrusions or particles in this figure when viewed in the yz plane: substantially parallelogramatic. Although not exhaustive, the following other descriptions may also apply to at least one of the protrusions or particles in this figure: needlelike and fiber-shaped.

A scale bar of 50 μm is indicated in the SEM of FIG. 29, which may provide an indication of the size of the nanoparticles, nanoprotrusions, or voids of the film. This figure shows that a substantial number of particles or voids may have an x, y, and/or z dimension in the range of about 1 μm to about 500 μm.

FIG. 30 also depicts an SEM image of a surface of an embodiment of a porous film. Although not exhaustive, the following descriptions may apply to at least one of the protrusions or particles in this figure when viewed in the xy plane: pseudo-parallelogramatic, substantially parallelogramatic, and substantially linear. Although not exhaustive, the following descriptions may apply to at least one of the protrusions or particles in this figure when viewed in the yz plane: substantially parallelogramatic. Although not exhaustive, the following other descriptions may also apply to at least one of the protrusions or particles in this figure: needlelike, and fiber-shaped.

A scale bar of 20 μm is indicated in the SEM of FIG. 30, which may provide an indication of the size of the nanoparticles, nanoprotrusions, or voids of the film. This figure shows that a substantial number of particles or voids may have an x, y, and/or z dimension in the range of about 0.1 μm to about 150 μm.

FIG. 31 also depicts an SEM image of a surface of an embodiment of a porous film. Although not exhaustive, the following descriptions may apply to at least one of the protrusions or particles in this figure: fiber-shaped.

A scale bar of 500 nm is indicated in the SEM of FIG. 31, which may provide an indication of the size of the nanoparticles, nanoprotrusions, or voids of the film. This figure shows that a substantial number of particles or voids may have an x, y, and/or z dimension in the range of about 10 nm to about 5 μm.

FIG. 32 also depicts an SEM image of a surface of an embodiment of a porous film. Although not exhaustive, the following descriptions may apply to at least one of the protrusions or particles in this figure when viewed in the xy, xz, or the yz plane: substantially rectangular, at least one substantially right angle, substantially all substantially right angles, and substantially linear. Although not exhaustive, the following descriptions may apply to at least one of the

protrusions or particles in this figure when viewed in the yz plane: substantially linear, substantially parallelogramatic, and pseudo-parallelogramatic. Although not exhaustive, the following other descriptions may also apply to at least one of the protrusions or particles in this figure: granular.

A scale bar of 1 μm is indicated in the SEM of FIG. 32, which may provide an indication of the size of the nanoparticles, nanoprotrusions, or voids of the film. This figure shows that a substantial number of particles or voids may have an x, y, and/or z dimension in the range of about 0.01 μm to about 5 μm.

FIG. 33 also depicts an SEM image of a surface of an embodiment of a porous film. Although not exhaustive, the following descriptions may apply to at least one of the protrusions or particles in this figure: nanoflake and pseudoplanar.

A scale bar of 1 μm is indicated in the SEM of FIG. 33, which may provide an indication of the size of the nanoparticles, nanoprotrusions, or voids of the film. This figure shows that a substantial number of particles or voids may have an x, y, and/or z dimension in the range of about 0.1 μm to about 20 μm.

FIG. 34 also depicts an SEM image of a surface of an embodiment of a porous film. Although not exhaustive, the following descriptions may apply to at least one of the protrusions or particles in this figure when viewed in the xy plane: substantially rectangular, at least one substantially right angle, and substantially all substantially right angles. Although not exhaustive, the following descriptions may apply to at least one of the protrusions or particles in this figure when viewed in the yz plane: substantially linear, and substantially rectangular. Although not exhaustive, the following other descriptions may also apply to at least one of the protrusions or particles in this figure: fiber-shaped and ribbon-shaped.

A scale bar of 2 μm is indicated in the SEM of FIG. 34, which may provide an indication of the size of the nanoparticles, nanoprotrusions, or voids of the film. This figure shows that a substantial number of particles or voids may have an x, y, and/or z dimension in the range of about 0.1 μm to about 10 μm.

FIG. 35 also depicts an SEM image of a surface of an embodiment of a porous film. Although not exhaustive, the following descriptions may apply to at least one of the protrusions or particles in this figure when viewed in the xy plane: substantially rectangular, at least one substantially right angle, and substantially all substantially right angles. Although not exhaustive, the following descriptions may apply to at least one of the protrusions or particles in this figure when viewed in the yz plane: substantially linear, substantially rectangular, at least one substantially right angle, and substantially all substantially right angle. Although not exhaustive, the following other descriptions may also apply to at least one of the protrusions or particles in this figure: fiber-shaped and granular.

A scale bar of 1 μm is indicated in the SEM of FIG. 35, which may provide an indication of the size of the nanoparticles, nanoprotrusions, or voids of the film. This figure shows that a substantial number of particles or voids may have an x, y, and/or z dimension in the range of about 0.01 μm to about 10 μm.

FIG. 36 also depicts an SEM image of a surface of an embodiment of a porous film. Although not exhaustive, the following descriptions may apply to at least one of the protrusions or particles in this figure when viewed in the xy plane: substantially rectangular, at least one substantially right angle, and substantially all substantially right angles. Although not exhaustive, the following descriptions may apply to at least one of the protrusions or particles in this figure when viewed in the yz plane: substantially rectangular. Although not exhaustive, the following other descriptions may also apply to at least one of the protrusions or particles in this figure: fiber-shaped and pseudoplanar.

A scale bar of 1 μm is indicated in the SEM of FIG. 36, which may provide an indication of the size of the nanoparticles, nanoprotrusions, or voids of the film. This figure shows that a substantial number of particles or voids may have an x, y, and/or z dimension in the range of about 0.01 μm to about 10 μm.

FIG. 37 also depicts an SEM image of a surface of an embodiment of a porous film. Although not exhaustive, the following descriptions may apply to at least one of the protrusions or particles in this figure when viewed in the xy plane: substantially linear. Although not exhaustive, the following other descriptions may also apply to at least one of the protrusions or particles in this figure: rod-shaped and fiber-shaped.

A scale bar of 4 μm is indicated in the SEM of FIG. 37, which may provide an indication of the size of the nanoparticles, nanoprotrusions, or voids of the film. This figure shows that a substantial number of particles or voids may have an x, y, and/or z dimension in the range of about 0.05 μm to about 10 μm.

FIG. 38 also depicts an SEM image of a surface of an embodiment of a porous film. Although not exhaustive, the following descriptions may apply to at least one of the protrusions or particles in this figure when viewed in the xy plane: substantially linear. Although not exhaustive, the following other descriptions may also apply to at least one of the protrusions or particles in this figure: rod-shaped and fiber-shaped.

A scale bar of 4 μm is indicated in the SEM of FIG. 38, which may provide an indication of the size of the nanoparticles, nanoprotrusions, or voids of the film. This figure shows that a substantial number of particles or voids may have an x, y, and/or z dimension in the range of about 0.05 μm to about 10 μm.

FIG. 39 also depicts an SEM image of a surface of an embodiment of a porous film. Although not exhaustive, the following descriptions may apply to at least one of the protrusions or particles in this figure when viewed in the xy plane: substantially rectangular, at least one substantially right angle, and substantially all substantially right angles.

Although not exhaustive, the following descriptions may apply to at least one of the protrusions or particles in this figure when viewed in the yz plane: substantially linear, substantially rectangular, at least one substantially right angle, and substantially all substantially right angles Although not exhaustive, the following other descriptions may also apply to at least one of the protrusions or particles in this figure: ribbon-shaped, nanoflake and pseudoplanar.

A scale bar of 1 μm is indicated in the SEM of FIG. 39, which may provide an indication of the size of the nanoparticles, nanoprotrusions, or voids of the film. This figure shows that a substantial number of particles or voids may have an x, y, and/or z dimension in the range of about 0.1 μm to about 20 μm.

FIG. 40 also depicts an SEM image of a surface of an embodiment of a porous film. Although not exhaustive, the following descriptions may apply to at least one of the protrusions or particles in this figure when viewed in the xy plane: substantially rectangular, pseudo-parallelogramatic, substantially parallelogramatic, at least one substantially right angle, and substantially all substantially right angles. Although not exhaustive, the following descriptions may apply to at least one of the protrusions or particles in this figure when viewed in the yz plane: substantially linear, substantially parallelogramatic, and pseudo-parallelogramatic. Although not exhaustive, the following other descriptions may also apply to at least one of the protrusions or particles in this figure: ribbon-shaped, fiber-shaped, and pseudoplanar.

A scale bar of 1 μm is indicated in the SEM of FIG. 40, which may provide an indication of the size of the nanoparticles, nanoprotrusions, or voids of the film. This figure shows that a substantial number of particles or voids may have an x, y, and/or z dimension in the range of about 0.01 μm to about 10 μm.

FIG. 41 also depicts an SEM image of a surface of an embodiment of a porous film. Although not exhaustive, the following descriptions may apply to at least one of the protrusions or particles in this figure: rod-shaped and fiber-shaped.

A scale bar of 10 μm is indicated in the SEM of FIG. 41, which may provide an indication of the size of the nanoparticles, nanoprotrusions, or voids of the film. This figure shows that a substantial number of particles or voids may have an x, y, and/or z dimension in the range of about 0.1 μm to about 10 μm.

FIG. 42 also depicts an SEM image of a surface of an embodiment of a porous film. Although not exhaustive, the following descriptions may apply to at least one of the protrusions or particles in this figure when viewed in the xy plane: substantially rectangular, substantially linear, at least one substantially right angle, and substantially all substantially right angles. Although not exhaustive, the following other descriptions may also apply to at least one of the protrusions or particles in this figure: fiber-shaped and ribbon shaped.

A scale bar of 1 μm is indicated in the SEM of FIG. 42, which may provide an indication of the size of the nanoparticles, nanoprotrusions, or voids of the film. This figure shows that a substantial number of particles or voids may have an x, y, and/or z dimension in the range of about 0.1 μm to about 5 μm.

FIG. 43 also depicts an SEM image of a surface of an embodiment of a porous film. Although not exhaustive, the following descriptions may apply to at least one of the protrusions or particles in this figure when viewed in the xy plane: substantially rectangular, at least one substantially right angle, and substantially all substantially right angles. Although not exhaustive, the following descriptions may apply to at least one of the protrusions or particles in this figure when viewed in the yz plane: substantially linear, substantially rectangular, at least one substantially right angle, and substantially all substantially right angles. Although not exhaustive, the following other descriptions may also apply to at least one of the protrusions or particles in this figure: nanoflake, ribbon-shaped, and pseudoplanar.

A scale bar of 500 nm is indicated in the SEM of FIG. 43, which may provide an indication of the size of the nanoparticles, nanoprotrusions, or voids of the film. This figure shows that a substantial number of particles or voids may have an x, y, and/or z dimension in the range of about 50 nm to about 2 μm.

FIG. 44 also depicts an SEM image of a surface of an embodiment of a porous film. Although not exhaustive, the following descriptions may apply to at least one of the protrusions or particles in this figure when viewed in the xy plane: substantially rectangular, substantially linear, at least one substantially right angle, and substantially all substantially right angles. Although not exhaustive, the following descriptions may apply to at least one of the protrusions or particles in this figure when viewed in the yz plane: substantially rectangular, substantially linear, at least one substantially right angle, and substantially all substantially right angles. Although not exhaustive, the following other descriptions may also apply to at least one of the protrusions or particles in this figure: ribbon-shaped, nanoflake, and pseudoplanar.

A scale bar of 1 μm is indicated in the SEM of FIG. 44, which may provide an indication of the size of the nanoparticles, nanoprotrusions, or voids of the film. This figure shows that a substantial number of particles or voids may have an x, y, and/or z dimension in the range of about 0.01 μm to about 1 μm.

FIG. 45 also depicts an SEM image of a surface of an embodiment of a porous film. Although not exhaustive, the following descriptions may apply to at least one of the protrusions or particles in this figure when viewed in the xy plane: substantially rectangular, substantially linear, at least one substantially right angle, and substantially all substantially right angles. Although not exhaustive, the following descriptions may apply to at least one of the protrusions or particles in this figure when viewed in the yz plane: substantially rectangular, substantially linear, at least one substantially right angle, and substantially all substantially right angles. Although not exhaustive, the following other descriptions may also apply to at least one of the protrusions or particles in this figure: ribbon-shaped, nanoflake, and pseudoplanar.

A scale bar of 1 μm is indicated in the SEM of FIG. 45, which may provide an indication of the size of the nanoparticles, nanoprotrusions, or voids of the film. This figure shows that a substantial number of particles or voids may have an x, y, and/or z dimension in the range of about 0.1 μm to about 20 μm.

FIG. 46 also depicts an SEM image of a surface of an embodiment of a porous film. Although not exhaustive, the following descriptions may apply to at least one of the protrusions or particles in this figure when viewed in the xy plane: substantially rectangular, substantially linear, and substantially all substantially right angles. Although not exhaustive, the following other descriptions may also apply to at least one of the protrusions or particles in this figure: ribbon-shaped, fiber-shaped, and pseudoplanar.

A scale bar of 4 μm is indicated in the SEM of FIG. 46, which may provide an indication of the size of the nanoparticles, nanoprotrusions, or voids of the film. This figure shows that a substantial number of particles or voids may have an x, y, and/or z dimension in the range of about 0.05 μm to about 10 μm.

FIG. 47 also depicts an SEM image of a surface of an embodiment of a porous film. Although not exhaustive, the following descriptions may apply to at least one of the protrusions or particles in this figure: fiber-shaped.

A scale bar of 5 μm is indicated in the SEM of FIG. 47, which may provide an indication of the size of the nanoparticles, nanoprotrusions, or voids of the film. This figure shows that a substantial number of particles or voids may have an x, y, and/or z dimension in the range of about 0.05 μm to about 10 μm.

FIG. 48 also depicts an SEM image of a surface of an embodiment of a porous film. Although not exhaustive, the following descriptions may apply to at least one of the protrusions or particles in this figure when viewed in the xy plane: substantially rectangular, and at least one substantially right angle. Although not exhaustive, the following descriptions may apply to at least one of the protrusions or particles in this figure when viewed in the yz plane: substantially linear, and substantially rectangular. Although not exhaustive, the following other descriptions may also apply to at least one of the protrusions or particles in this figure: nanoflake, ribbon-shaped, and pseudoplanar.

A scale bar of 1 μm is indicated in the SEM of FIG. 48, which may provide an indication of the size of the nanoparticles, nanoprotrusions, or voids of the film. This figure shows that a substantial number of particles or voids may have an x, y, and/or z dimension in the range of about 0.01 μm to about 5 μm.

FIG. 49 also depicts an SEM image of a surface of an embodiment of a porous film. Although not exhaustive, the following descriptions may apply to at least one of the protrusions or particles in this figure when viewed in the xy plane: substantially rectangular, and at least one substantially right angle. Although not exhaustive, the following descriptions may apply to at least one of the protrusions or particles in this figure when viewed in the yz plane: substantially linear, and substantially rectangular. Although not exhaustive, the following other descriptions may also apply to at least one of the protrusions or particles in this figure: nanoflake, ribbon-shaped, and pseudoplanar.

A scale bar of 1 μm is indicated in the SEM of FIG. 49, which may provide an indication of the size of the nanoparticles, nanoprotrusions, or voids of the film. This figure shows that a substantial number of particles or voids may have an x, y, and/or z dimension in the range of about 0.02 μm to about 10 μm.

FIG. 50 also depicts an SEM image of a surface of an embodiment of a porous film. Although not exhaustive, the following descriptions may apply to at least one of the protrusions or particles in this figure: fiber-shaped and ribbon shaped.

A scale bar of 5 μm is indicated in the SEM of FIG. 50, which may provide an indication of the size of the nanoparticles, nanoprotrusions, or voids of the film. This figure shows that a substantial number of particles or voids may have an x, y, and/or z dimension in the range of about 0.01 μm to about 20 μm.

FIG. 51 also depicts an SEM image of a surface of an embodiment of a porous film. Although not exhaustive, the following descriptions may apply to at least one of the protrusions or particles in this figure: granular, capsule-shaped, fiber-shaped, ribbon-shape, and rod-shaped.

A scale bar of 3 μm is indicated in the SEM of FIG. 51, which may provide an indication of the size of the nanoparticles, nanoprotrusions, or voids of the film. This figure shows that a substantial number of particles or voids may have an x, y, and/or z dimension in the range of about 0.01 μm to about 5 μm.

FIG. 52 also depicts an SEM image of a surface of an embodiment of a porous film. Although not exhaustive, the following descriptions may apply to at least one of the protrusions or particles in this figure: nanoflake, pseudoplanar, ribbon-shaped, and granular.

A scale bar of 4 μm is indicated in the SEM of FIG. 52, which may provide an indication of the size of the nanoparticles, nanoprotrusions, or voids of the film. This figure shows that a substantial number of particles or voids may have an x, y, and/or z dimension in the range of about 0.05 μm to about 10 μm.

FIG. 53 also depicts an SEM image of a surface of an embodiment of a porous film. Although not exhaustive, the following descriptions may apply to at least one of the protrusions or particles in this figure: nanoflake, pseudoplanar, ribbon-shaped, and granular.

A scale bar of 3 μm is indicated in the SEM of FIG. 53, which may provide an indication of the size of the nanoparticles, nanoprotrusions, or voids of the film. This figure shows that a substantial number of particles or voids may have an x, y, and/or z dimension in the range of about 0.05 μm to about 10 μm.

FIG. 54 also depicts an SEM image of a surface of an embodiment of a porous film. Although not exhaustive, the following descriptions may apply to at least one of the protrusions or particles in this figure when viewed in the xy plane: substantially rectangular, at least one substantially right angle, and substantially all substantially right angles. Although not exhaustive, the following descriptions may apply to at least one of the protrusions or particles in this figure when viewed in the yz plane: substantially linear, substantially rectangular, at least one substantially right angle, and substantially all substantially right angles. Although not exhaustive, the following other descriptions may also apply to at least one of the protrusions or particles in this figure: nanoflake, ribbon-shaped, pseudoplanar.

A scale bar of 400 nm is indicated in the SEM of FIG. 54, which may provide an indication of the size of the nanoparticles, nanoprotrusions, or voids of the film. This figure shows that a substantial number of particles or voids may have an x, y, and/or z dimension in the range of about 50 nm to about 2000 nm.

Various shapes and dimensions are recited herein with respect to several examples of images and figures of associated with various examples of porous films. These shapes and dimensions are provided merely to help provide an understanding of the terminology used, and are not intended to be exhaustive descriptions for any particular example or figure. Thus, the omission of any particular term with respect to any particular example or figure does not suggest that the particular term does not apply to the particular example or figure.

In some embodiments, an angle between the plane of the individual nanostructures and the film may be any value between 0 and 90 degrees with equal probability and/or it may be that no particular angle is preferred. In other words, it may be that no particular general alignment or substantial orientation is exhibited by the nanostructures of this film.

The thickness of a porous film may vary. In some embodiments, a porous film may have a thickness in the nanometer to micro range. For example, the thickness of the film may be about 500 nm, about 0.1 μm, about 1 μm, about 1.3 μm, about 3 μm, or about 4 μm, about 5 μm, about 7 μm, about 10 μm, about 20 μm, about 100 μm, or any thickness in a range bounded by, or between, any of these values. In some embodiments, the thickness of the film may be about 500 nm to about 100 μm, about 0.1 μm to about 10 μm, or about 1 μm to about 5 μm.

A porous film may comprise a number of pores or voids. For example, a porous film may comprises a plurality of voids having a total volume that may be about 50%, about 70%, about 80%; about 85%, about 90%, about 95%, or about 99% of the volume of the film including the voids, or any percentage of total volume in a range bounded by, or between, any of these values. Thus, if the total volume of the voids is 50% of the volume of the film, 50% of the volume of the film is the material of the film and 50% of the volume of the film is the plurality of voids. In some embodiments, the porous film may comprise a plurality of voids having a total volume that may be about 50% to about 99%, about 70% to about 99%, about 80% to about 99%, or about 90% to about 99% of the volume of the film.

In some embodiments, a film may comprises a plurality of voids of a number and size such that the film may have a thickness that is about 2 times, about 10 times; up to about 50 times, or about 100 times, that of the thickness of a film of the same material which has no voids, or any thickness ratio in a range bounded by, or between, any of these values. For example, a film may have a thickness of about 5 μm when a film of the same material would have a thickness of 800 nm if the film had no voids. In some embodiments, the film may have a thickness that is in the range of about 2 times to about 100 times or about 2 to about 10 times that of the thickness of a film of the same material which has no voids.

The size of the voids may vary. The dimensions of a void may be quantified as described above for a particle or protrusion. In some embodiments, at least about 10% of the voids have a largest dimension, or an x dimension, of about 0.5 μm, about 1 μm, about 2 μm, about 3 μm, about 4μm, about 5 μm, or any length in a range bounded by, or between, any of these values. In some embodiments, at least one void in the film, or an average of the voids in the film, may have an x dimension, a y dimension, or a z dimension of: about 5 nm, about 0.01 μm, about 0.02 μm, about 0.05 μm, about 0.1 μm, about 0.5 μm, about 1 μm, about 2 μm, about 5 μm, about 10 μm, about 20 μm, about 50 μm, about 100 μm, about 150 μm, about 200 μm, about 500 μm, about 1000 μm, or any length bounded by, or between, any of these values. In some embodiments, at least one void in the film, or an average of the voids in the film, may have an x dimension, a y dimension, or a z dimension in the range of: about 0.01 μm to about 5 μm, about 0.01 μm to about 1 μm, about 0.01 μm to about 10 μm, about 0.01 μm to about 20 μm, about 0.01 μm to about 5 μm, about 0.02 μm to about 10 μm, about 0.05 μm to about 10 μm, about 0.1 μm to about 10 μm, about 0.1 μm to about 100 μm, about 0.1 μm to about 150 μm, about 0.1 μm to about 20 μm, about 0.1 μm to about 5 μm, about 0.5 μm to about 50 μm, about 1 μm to about 100 μm, about 1 μm to about 20 μm, about 1 μm to about 200 μm, about 1 μm to about 50 μm, about 1 μm to about 500 μm, about 10 μm to about 50 μm, about 10 nm to about 5 μm, about 2 μm to about 100 μm, about 20 μm to about 1000 μm, about 5 nm to about 5 μm, about 50 nm to about 2 μm, or about 50 nm to about 5 μm. The density of a porous film may vary, and may be affected by the voids, the material, and other factors. In some embodiments, the density of the film including the voids may be about 0.005 picograms/$\mu m^3$, about 0.05 picograms/$\mu m^3$, about 0.1 picograms/$\mu m^3$, about 0.3 picograms/$\mu m^3$, about 0.5 picograms/$\mu m^3$, about 0.7 picograms/$\mu m^3$, about 0.9 picograms/$\mu m^3$, or any density in a range bounded by, or between, any of these values. In some embodiments, the including the voids may be in the range of about: about 0.005 picograms/$\mu m^3$ to about 0.9 picograms/$\mu m^3$, about 0.05 picograms/$\mu m^3$ to about 0.7 picograms/$\mu m^3$, or about 0.1 picograms/$\mu m^3$ to about 0.5 picograms/$\mu m^3$.

The refractive index of the material of the porous film may vary. In some embodiments, the refractive index of

the material of the porous film may be greater than or equal to that of the substrate. In some embodiments, a refractive index of an anode, a refractive index of a cathode, a refractive index of a transparent layer between an anode and a porous layer, and/or a refractive index of a transparent layer between a cathode and a porous layer, may be higher than a refractive index of a porous layer. For example, the refractive index may be about 1.1, about 1.5, about 1.7, about 1.8, or any refractive index in a range bounded by, or between, any of these values. In some embodiments, the refractive index may be in the range of about 1.1 to about 1.8, about 1.1 to about 1.7, or about 1.1 to about 1.5.

In some embodiments, at least 1, at least 50% or at least 90% of the particles, the protrusions, or the voids of a porous film may have an x, y, and/or z dimension in the range of: about 0.01 μm to about 5 μm, about 0.01 μm to about 1 μm, about 0.01 μm to about 10 μm, about 0.01 μm to about 20 μm, about 0.01 μm to about 5 μm, about 0.02 μm to about 10 μm, about 0.05 μm to about 10 μm, about 0.1 μm to about 10 μm, about 0.1 μm to about 100 μm, about 0.1 μm to about 150 μm, about 0.1 μm to about 20 μm, about 0.1 μm to about 5 μm, about 0.5 μm to about 50 μm, about 1 μm to about 100 μm, about 1 μm to about 20 μm, about 1 μm to about 200 μm, about 1 μm to about 50 μm, about 1 μm to about 500 μm, about 10 μm to about 50 μm, about 10 nm to about 5 μm, about 2 μm to about 100 μm, about 20 μm to about 1000 μm, about 5 nm to about 5 μm, about 50 nm to about 2 μm, or about 50 nm to about 5 μm.

A porous film may be prepared by depositing an organic film on a surface, such as a substrate. For example, the deposition may be vapor deposition, which may be carried out under high temperature and/or high vacuum conditions; or the porous film may be deposited by drop casting or spin casting. In some embodiments, the material may be deposited on a substantially transparent substrate. Deposition and/or annealing conditions may affect the characteristics of the film.

The rate of deposition of the material on a surface may vary. For example, the organic film may be deposited at a rate of: about 0.1 Å/sec, about 0.2 Å/sec, about 1 Å/sec, about 10 Å/sec, about 20 Å/sec, about 60 Å/sec, about 100 Å/sec, about 500 Å/sec, about 1000 Å/sec, or any value in a range bounded by, or between, any of these deposition rates. In some embodiments, the organic film may be deposited at a rate in the range of about about 0.1 Å/sec to about 1000 Å/sec, about 1 Å/sec to about 100 Å/sec, or about 2 Å/sec to about 60 Å/sec.

The material may be deposited onto a variety of surfaces to form a porous film or an organic film. For some devices, the material may be deposited onto an anode, a cathode, or a transparent layer.

An organic film that has been deposited on a surface may be further treated by heating or annealing. The temperature of heating may vary. For example, an organic film may be heated at a temperature of about 80 °C, about 100 ° C, about 110° C, about 120 °C, about 130 °C, about 150 °C, about 180° C, about 200 °C, about 240 °C, about about 260° C, about 290 °C, or any temperature in a range bounded by, or between, any of these values. In some embodiments, an organic film may be heated at a temperature in the range of about 100 °C to about 290 °C, about 100°C to about 260°C, about 80 °C to about 240 °C, about 80 °C to about 200 °C, about 200°C to about 260 °C, or about 200 °C to about 240 °C.

The time of heating may also vary. For example, an organic film may be heated for about 5 minutes, about 15 minutes, about 30 minutes, about 60 minutes, about 2 hours, about 5 hours, about 10 hours, about 20 hours, or any amount of time in a range bounded by, or between, any of these values. In some embodiments, an organic film may be heated fro about 5 minutes to about 20 hours, about 4 minutes to about 2 hours, or about 5 minutes to about 30 minutes. In some embodiments, a material may be heated at about 100°C to about 260°C for about 5 minutes to about 30 minutes.

A porous film or an organic film may comprise a material that includes a non-polymeric organic compound, and may comprise an optionally substituted aromatic ring. In some embodiments, a porous film or an organic film may comprise at least one of the compounds below:

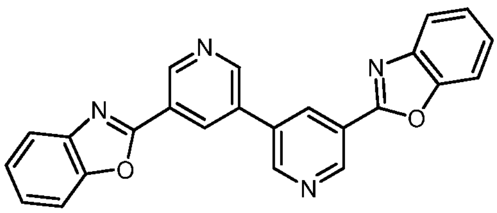

Compound-1

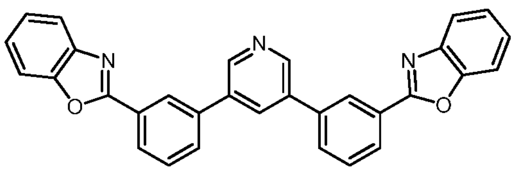

Compound-2

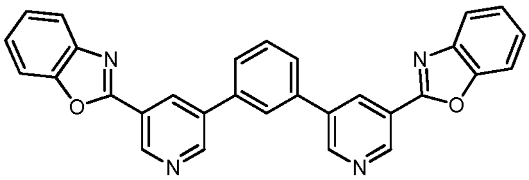

Compound-3

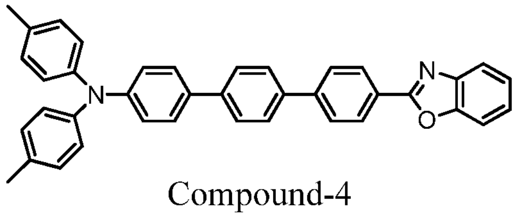

Compound-4

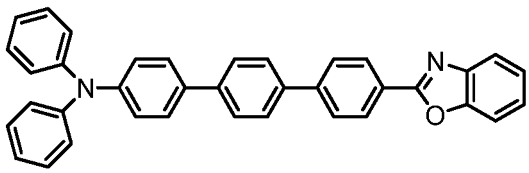

Compound-5

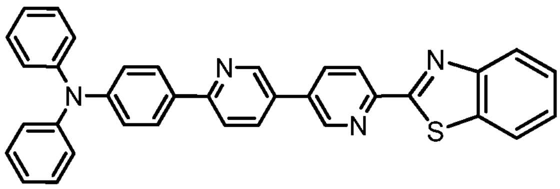

Compound-6

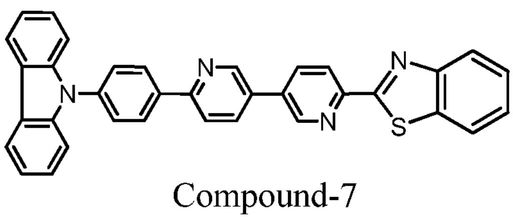

Compound-7

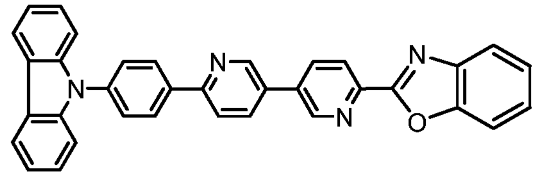

Compound-8

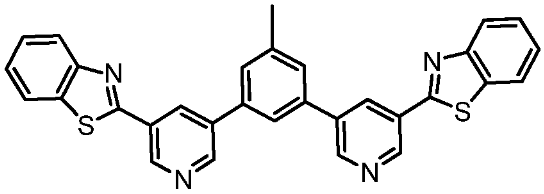

Compound-9

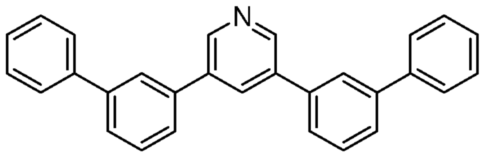

**Compound-10**

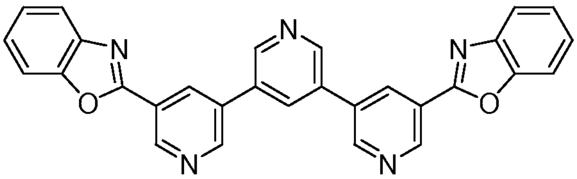

**Compound-11**

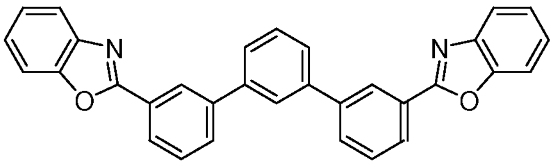

**Compound-12**

Other compounds that may be useful in porous films or organic films include any compound described in one of the following documents: United States Provisional Application No. 61/221,427, filed June 29, 2009, which is incorporated by reference herein in its entirety; United States Patent Application No. 12/825,953, filed June 29, 2010, which is incorporated by reference herein its entirety; United States Provisional Patent Application No. 61/383,602, filed September 16, 2010, which is incorporated by reference herein in its entirety; United States Provisional Application No. 61/426,259, filed December 22, 2010; the United States Patent Provisional Application No. 61/449,001, filed on March 3, 2011 under the title SUBSTITUTED BIPYRIDINES FOR USE IN LIGHT-EMITTING DEVICES" by inventor Shijun Zheng, which is incorporated by reference herein in its entirety; and the United States Patent Provisional Application No. 61/449,034, filed on March 3, 2011 under the title COMPOUNDS FOR POROUS FILMS IN LIGHT-EMITTING DEVICES" by inventors Shijun Zheng and Jensen Cayas, which is incorporated by reference herein in its entirety.

In some embodiments a porous film may comprise COMPOUND-2 and may have a density of about 80% and/or a thickness greater than about 4 μm. In some embodiments, COMPOUND-2 may be heated at about 110 °C and/or heating may be carried out for about 60 min.

In some embodiments a porous film may comprise COMPOUND-3 and may have a thickness of about 1.3 μm. In some embodiments, COMPOUND-3 may be heated at about 180° C and/or heating may be carried out for about 15 minutes.

Table 1 below describes the materials and process used to prepare the films depicted in FIGS 6-54.

| FIG. | Compound | Deposition Rate (Å/sec) | Heating Temperature (°C) | Heating Time (min) |
|---|---|---|---|---|
| 6 | Compound-3 | 2 | 240 | 5 |
| 7 | Compound-5 (drop cast from DiChlroBenzene) | n/a | n/a | n/a |
| 8 | Compound-5 (drop cast from DiChlroBenzene) | n/a | 200 | 60 |
| 9 | Compound-5 (drop cast from DiChlroBenzene) | n/a | n/a | n/a |
| 10 | Compound-5 (drop cast from DiChlroBenzene) | n/a | n/a | n/a |
| 11 | Compound-4 (spin cast from DCB) | n/a | n/a | n/a |
| 12 | Compound-4 (drop cast from DCB) | n/a | n/a | n/a |
| 13 | Compound-4 (drop cast from DCB) | n/a | n/a | n/a |
| 14 | Compound-4 (spin cast from DCB) | n/a | n/a | n/a |
| 15 | Compound-4 (spin cast from DCB) | n/a | n/a | n/a |
| 16 | Compound-8 | 20 | n/a | n/a |
| 17 | Compound-8 | 20 | 150 | 60 |
| 18 | Compound-8 | 20 | 150 | 60 |
| 19 | Compound-6 | 2 | 150 | 30 |
| 20 | Compound-6 | 2 | 150 | 30 |
| 21 | Compound-6 drop cast from $CHCl_3$ | n/a | n/a | n/a |
| 22 | Compound-7 drop cast from $CHCl_3$ | n/a | n/a | n/a |
| 23 | Compound-7 drop cast from $CHCl_3$ | n/a | n/a | n/a |
| 24 | Compound-8 | 2 | n/a | n/a |
| 25 | Compound-8 drop cast from $CHCl_3$ | n/a | n/a | n/a |
| 26 | Compound-8 drop cast from $CHCl_3$ | n/a | n/a | n/a |
| 27 | Compound-8 drop cast from $CHCl_3$ | n/a | n/a | n/a |
| 28 | Compound-8 drop cast from $CHCl_3$ | n/a | n/a | n/a |
| 29 | Compound-4 drop cast from $CHCl_3$ | n/a | 150 | 60 |
| 30 | Compound-4 drop cast from $CHCl_3$ | n/a | 200 | 60 |
| 31 | Compound-9 | 2 | n/a | n/a |
| 32 | Compound-8 | 2 | n/a | n/a |
| 33 | Compound-1 cross section | 2 | 150 | 60 |
| 34 | Compound-1 top view | 60 | 150 | 60 |
| 35 | Compound-1 top view | 60 | 150 | 60 |
| 36 | Compound-1 cross section | 60 | 150 | 60 |
| 37 | Compound-2 | 2 | n/a | n/a |

(continued)

| FIG. | Compound | Deposition Rate (Å/sec) | Heating Temperature (°C) | Heating Time (min) |
|---|---|---|---|---|
| 38 | Compound-2 | 2 | n/a | n/a |
| 39 | Compound-2 | 2 | 100 | 60 |
| 40 | Compound-2 | 2 | 150 | 60 |
| 41 | Compound-2 | 2 | 80 | 1200 (20h) |
| 42 | Compound-2 | 2 | 80 | 1200 (20h) |
| 43 | Compound-2 | 2 | 80 | 1200 (20h) |
| 44 | Compound-2 | 60 | n/a | n/a |
| 45 | Compound-2 | 60 | 150 | 60 |
| 46 | Compound-3 | 20 | 150 | 60 |
| 47 | Compound-3 cross section | 20 | 150 | 60 |
| 48 | Compound-2 | 10 | 150 | 60 |
| 49 | Compound-2 cross section | 60 | 150 | 60 |
| 50 | Compound-2 cross section | 2 | 80 | 1200 (20h) |
| 51 | Compound-3 | 2 | n/a | n/a |
| 52 | Compound-3 | 2 | 200 | 5 |
| 53 | Compound-3 | 2 | 200 | 30 |
| 54 | Compound-2 | 2 | n/a | n/a |
| # n/a: not applicable | | | | |

Generally, a porous film may be deposited on at least part of a surface of a layer in a device to provide an outcoupling or a scattering effect. For outcoupling, a porous film may deposited on at least part of a surface of any partially internally reflective layer, including any layer that may both internally reflect light and allow light to pass through the partially internally reflective layer to an adjacent layer, such as an emissive layer, an anode, a cathode, any transparent layer, etc. In some embodiments, a transparent layer may be disposed between the anode and the film, the cathode and the film, etc.

A light-emitting device comprising a porous film may have a variety of configurations. For example, a light emitting device may include an anode, a cathode and an emissive layer disposed between the anode and cathode.

With respect to the devices described herein, if a first layer is "disposed over" a second layer, the first layer covers at least a portion of the second layer, but optionally allows one or more additional layers to be positioned between the two layers. If a first layer is "disposed on" a second layer, the first layer makes direct contact with at least a portion of the second layer. For simplicity, in any situation where the "disposed over" is used herein, it should be understood to mean "disposed over or disposed on."

With reference to FIGS 55 and 56, a porous film **5430** may be disposed over the emitting surface **5415** of an OLED **5410.** In some embodiments, the porous film **5430** is disposed directly on the emitting surface **5415** of an OLED **5410** (FIG. 55) and functions as an outcoupling film. Emitted light **5440** from the OLED **5410** may pass through the porous film **5430.** In some embodiments, a glass substrate **5420** may be disposed between the OLED **5410** and the porous film **5430,** wherein the glass substrate **5420** is in contact with or adjacent to the light emitting surface **5415** of the OLED **5410.** Emitted light **5440** may pass from the OLED **5410** through the glass substrate **5420** and out of the porous film **5430.** The porous film **5430** functions as an outcoupling film.

The OLED **5410** that is suitable for the devices described above generally comprises an emissive layer **5425** disposed between an anode **5560** and a cathode **5510.** Other layers, such as an electron-transport layer, a hole-transport layer, an electron-injection layer, a hole-injection layer, an electron-blocking layer, a hole-blocking layer, additional emissive layers, etc., may be present between the emissive layer **5425,** and the anode **5560** and/or the cathode **5510.** With reference to FIG. 57A, an emissive layer **5425** is disposed over an anode **5560,** and a cathode **5510** is disposed over an emissive layer **5425.** Light may be emitted from the top and/or the bottom of the device. FIG. 57B depicts an

example wherein an emissive layer **5425** may be disposed over a cathode **5510,** and an anode **5560** may be disposed over the emissive layer **5425.** Light may be emitted from the top and/or the bottom of the device.

In some embodiments, an outcoupling film or porous layer **5430** described herein may be disposed over the anode **5560** or the cathode **5510,** so that light passes through the anode or the cathode, any intervening layers (if present), and through the outcoupling film or porous layer **5430.** In some embodiments, a transparent substrate or a glass substrate may be disposed between the anode **5560** and the porous layer **5430,** or between the cathode **5510** and the porous layer **5430.** In some embodiments, the porous layer **5430** is disposed on the transparent substrate. The transparent substrate is disposed on the anode **5560** if the light is emitted from the OLED through the anode **5560.** In other embodiments, the transparent substrate is disposed on the cathode **5510** when the light is emitted from the OLED through the cathode **5510.**

In some embodiments, additional layers may be present between the emissive layer **5425** and the anode **5560** or between the emissive layer **5425** and the cathode **5510.** With reference to FIG. 58, an electron-transport layer **5530** may be disposed between the emissive layer **5425** and the cathode **5510,** a hole-injection layer **5550** may be disposed between the emissive layer **5425** and the anode **5560,** and a hole-transport layer **5540** may be disposed between the emissive layer **5425** and the hole-injection layer **5550.** When the light is emitted from the anode **5560** side, a porous layer **5430** may be disposed over the anode **5560.** In some embodiments, a transparent substrate **5570** may be disposed between the anode **5560** and the porous layer **5430.** Light emitted by the emissive layer **5425** may pass through the hole-transport layer **5540,** the hole-injection layer **5550,** the anode **5560,** the transparent substrate **5570,** and the porous film **5430** to provide light **5440** emitted by the device through the bottom of the device.

In some embodiments, the anode may be reflective and the light may be emitted from the cathode **5510** side. With reference to FIG. 59, an electron-transport layer **5530** may be disposed between the emissive layer **5425** and the cathode **5510,** a hole-injection layer **5550** may be disposed between the emissive layer **5425** and the reflective anode **5610,** and a hole-transport layer **5540** may be disposed between the emissive layer **5425** and the hole-injection layer **5550.** A capping layer **5710** may be disposed on the cathode **5510.** A porous layer **5430** can be disposed over the cathode **5510.** In some embodiments, a capping layer **5710** may be disposed on the cathode **5510,** between the cathode **5510** and the porous layer **5430.** Light that is emitted by the emissive layer **5425,** may pass through the electron-transport layer **5530,** the cathode **5510,** the capping layer **5710,** and the porous film **5430** to provide light **5440** emitted by the device through the top of the device. In some embodiments, the OLED device may be disposed on a substrate **5620,** such as an indium tin oxide (ITO)/glass substrate. In the embodiments where a reflective anode **5610** is present, the substrate **5620** may be in contact with or adjacent to the reflective anode **5610.** Light that may be emitted by the emissive layer **5425,** may pass through the electron-transport layer **5530,** the cathode **5510,** the capping layer **5710,** and the porous film **5430** to provide light **5440** emitted by the device through the top of the device.

In some embodiments, the light may be emitted through a transparent anode **5560.** With reference to FIG. 60, an emissive layer **5425** is disposed between the cathode **5510** and the transparent anode **5560.** A porous film or layer **5430** is disposed on the transparent anode **5560.** In some embodiments, an electron-transport layer **5530** may be disposed between the emissive layer **5425** and the cathode **5510,** a hole-injection layer **5550** may be disposed between the emissive layer **5425** and the transparent anode **5560,** and a hole-transport layer **5540** may be disposed between the emissive layer **5425** and the hole-injection layer **5550.** In some embodiments, the OLED may be disposed on a substrate **5620,** such as an indium tin oxide (ITO)/glass substrate. The substrate **5620** may be in contact with or adjacent to the cathode **5510.** Light may be emitted by the emissive layer **5425** and pass through the hole-transport layer **5540,** the hole-injection layer **5550,** the anode **5560,** and the porous film **5430** to provide light **5440** emitted through the top of the device.

An anode may be a layer comprising a conventional material such as a metal, a mixed metal, an alloy, a metal oxide or a mixed-metal oxide, a conductive polymer, and/or an inorganic material such as carbon nanotube (CNT). Examples of suitable metals include the Group 1 metals, the metals in Groups 4, 5, 6, and the Group 8-10 transition metals. If the anode layer is to be light-transmitting, metals in Group 10 and 11, such as Au, Pt, and Ag, or alloys thereof; or mixed-metal oxides of Group 12, 13, and 14 metals, such as indium-tin-oxide (ITO), indium-zinc-oxide (IZO), and the like, may be used. In some embodiments, the anode layer may be an organic material such as polyaniline. The use of polyaniline is described in "Flexible light-emitting diodes made from soluble conducting polymer," Nature, vol. 357, pp. 477-479 (11 June 1992). Examples of suitable high work function metals and metal oxides include but are not limited to Au, Pt, or alloys thereof; ITO; IZO; and the like. In some embodiments, the anode layer can have a thickness in the range of about 1 nm to about 1000 nm.

A cathode may be a layer including a material having a lower work function than the anode layer. Examples of suitable materials for the cathode layer include those selected from alkali metals of Group 1, Group 2 metals, Group 12 metals including rare earth elements, lanthanides and actinides, materials such as aluminum, indium, calcium, barium, samarium and magnesium, and combinations thereof. Li-containing organometallic compounds, LiF, and $Li_2O$ may also be deposited between the organic layer and the cathode layer to lower the operating voltage. In some embodiments a cathode may comprise Al, Ag, Mg, Ca, Cu, Mg/Ag, LiF/Al, CsF, CsF/Al or alloys thereof. In some embodiments, the

cathode layer can have a thickness in the range of about 1 nm to about 1000 nm.

A transparent electrode may include an anode or a cathode through which some light may pass. In some embodiments, a transparent electrode may have a relative transmittance of about 50%, about 80%, about 90%, about 100%, or any transmittance in a range bounded by, or between, any of these values. In some embodiments, a transparent electrode may have a relative transmittance of about 50% to about 100%, about 80% to about 100%, or about 90% to about 100%.

An emissive layer may be any layer that can emit light. In some embodiments, an emissive layer may comprise an emissive component, and optionally, a host. The device may be configured so that holes can be transferred from the anode to the emissive layer and/or so that electrons can be transferred from the cathode to the emissive layer. If present, the amount of the host in an emissive layer may vary. For example, the host may be about 50%, about 60%, about 90%, about 97%, or about 99% by weight of the emissive layer, or may be any percentage in a range bounded by, or between, any of these values. In some embodiments, the host may be about 50% to about 99%, about 90% to about 99%, or about 97% to about 99% by weight of the emissive layer.

In some embodiments, Compound 10 may be the host in an emissive layer.

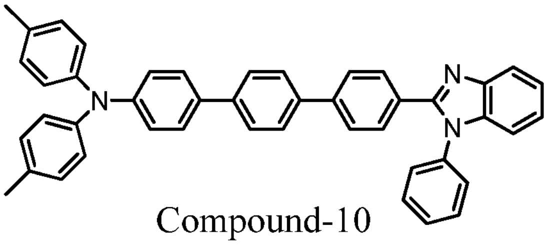

Compound-10

The amount of an emissive component in an emissive layer may vary. For example, the emissive component may be about 0.1%, about 1%, about 3%, about 5%, about 10%, or about 100% of the weight of the emissive layer, or may be any percentage in a range bounded by, or between, any of these values. In some embodiments, the emissive layer may be a neat emissive layer, meaning that the emissive component is about 100% by weight of the emissive layer, or alternatively, the emissive layer consists essentially of emissive component. In some embodiments, the emissive component may be about 0.1% to about 10%, about 0.1% to about 3%, or about 1% to about 3% by weight of the emissive layer.

The emissive component may be a fluorescent and/or a phosphorescent compound. In some embodiments, the emissive component comprises a phosphorescent material. Some non-limiting examples of emissive compounds may include: PO-01, bis-{2-[3,5-bis(trifluoromethyl)phenyl]pyridinato-N,C2'}iridium(III)-picolinate, bis(2-[4,6-difluorophenyl]pyridinato-N,C2')iridium (III) picolinate, bis(2-[4,6-difluorophenyl]pyridinato-N,C2')iridium(acetylacetonate), Iridium (III) bis(4,6-difluorophenylpyridinato)-3-(trifluoromethyl)-5-(pyridine-2-yl)-1,2,4-triazolate, Iridium (III) bis(4,6-difluorophenylpyridinato)-5-(pyridine-2-yl)-1H-tetrazolate, bis[2-(4,6-difluorophenyl)pyridinato-N,$C^2$']iridium(III)tetra(1-pyrazolyl)borate, Bis[2-(2'-benzothienyl)-pyridinato-N,C3'] iridium (III)(acetylacetonate); Bis[(2-phenylquinolyl)-N,C2']iridium (III) (acetylacetonate); Bis[(1-phenylisoquinolinato-N,C2')]iridium (III) (acetylacetonate); Bis[(dibenzo[f, h]quinoxalino-N,C2')iridium (III)(acetylacetonate); Tris(2,5-bis-2'-(9',9'-dihexylfluorene)pyridine)iridium (III); Tris[1-phenylisoquinolinato-N,C2']iridium (III); Tris-[2-(2'-benzothienyl)-pyridinato-N,C3'] iridium (III); Tris[1-thiophen-2-ylisoquinolinato-N,C3']iridium (III); and Tris[1-(9,9-dimethyl-9H-fluoren-2-yl)isoquinolinato-(N,C3')iridium (III)), Bis(2-phenylpyridinato-N,C2')iridium(III)(acetylacetonate) [Ir(ppy)$_2$(acac)], Bis(2-(4-tolyl)pyridinato-N,C2')iridium(III)(acetylacetonate) [Ir(mppy)$_2$(acac)], Bis(2-(4-*tert*-butyl)pyridinato-N,C2')iridium (III)(acetylacetonate) [Ir(*t*-Buppy)$_2$(acac)], Tris(2-phenylpyridinato-N,C2')iridium (III) [Ir(ppy)$_3$], Bis(2-phenyloxazolinato-N,C2')iridium (III) (acetylacetonate) [Ir(op)$_2$(acac)], Tris(2-(4-tolyl)pyridinato-N,C2')iridium(III) [Ir(mppy)$_3$], Bis[2-phenylbenzothiazolato-N,C2'] iridium (III)(acetylacetonate), Bis[2-(4-tert-butylphenyl)benzothiazolato-N,C2']iridium(III)(acetylacetonate), Bis[(2-(2'-thienyl)pyridinato-N,C3')]iridium (III) (acetylacetonate), Tris[2-(9.9-dimethylfluoren-2-yl)pyridinato-(N,C3')]iridium (III), Tris[2-(9.9-dimethylfluoren-2-yl)pyridinato-(N,C3')]iridium (III), Bis[5-trifluoromethyl-2-[3-(N-phenylcarbzolyl)pyridinato-N,C2']iridium(III)(acetylacetonate), (2-PhPyCz)$_2$Ir(III)(acac), etc.

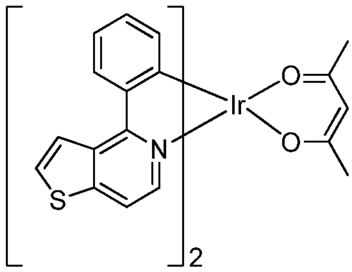

PO-01

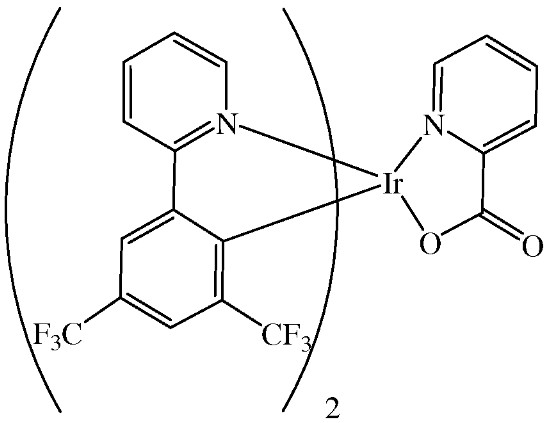

bis-{2-[3,5-bis(trifluoromethyl)phenyl]pyridinato-N,C2'}iridium(III)-picolinate ($Ir(CF_3ppy)_2(Pic)$)

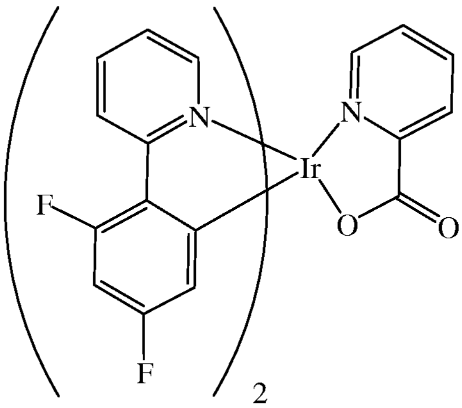

bis(2-[4,6-difluorophenyl]pyridinato-N,C2')iridium (III) picolinate [FIrPic]

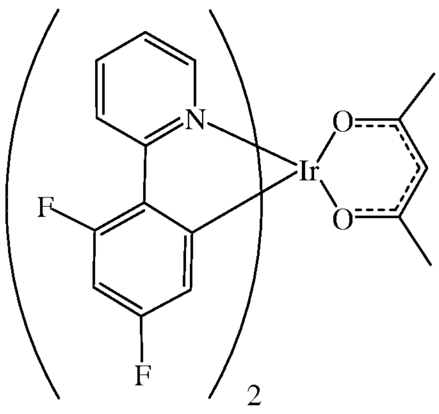

bis(2-[4,6-difluorophenyl]pyridinato-N,C2')iridium(acetylacetonate) [FIr(acac)]

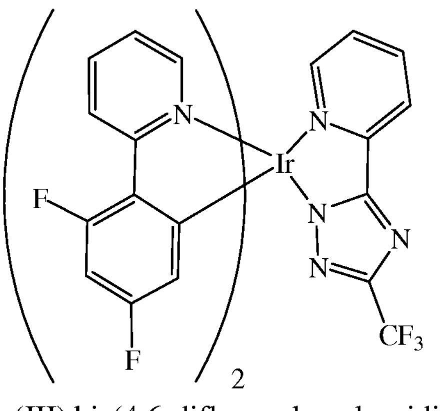

Iridium (III) bis(4,6-difluorophenylpyridinato)-3-(trifluoromethyl)-5-(pyridine-2-yl)-1,2,4-triazolate (FIrtaz)

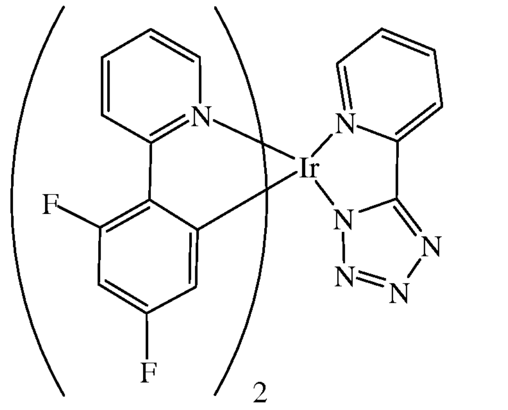

Iridium (III) bis(4,6-difluorophenylpyridinato)-5-(pyridine-2-yl)-1H-tetrazolate (FIrN4)

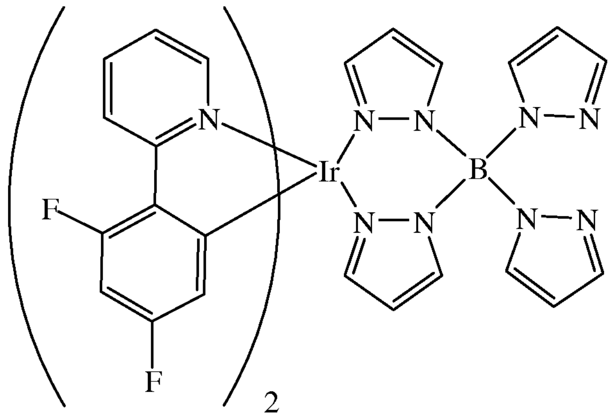

bis[2-(4,6-difluorophenyl)pyridinato-N,C$^{2'}$]iridium(III)tetra(1-pyrazolyl)borate (Fir6)

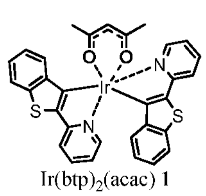

Ir(btp)$_2$(acac) **1**

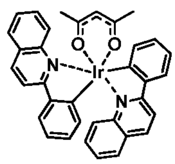

Ir(pq)$_2$(acac) **2**

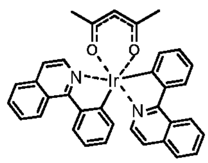

Ir(piq)$_2$(acac) **3**

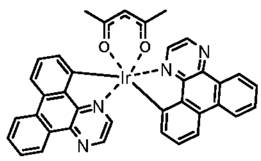

Ir(DBQ)$_2$(acac) **4**

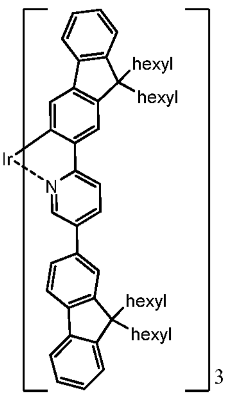

Ir(HFP)$_3$ **5**

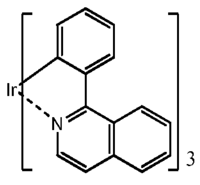

Ir(piq)$_3$ **6**

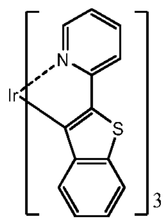

Ir(btp)$_3$ 7

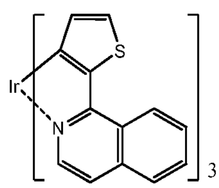

Ir(tiq)$_3$ **8**

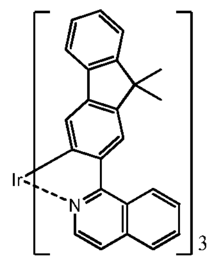

Ir(fli1)$_3$ **9**

1. (Btp)$_2$Ir(III)(acac); Bis[2-(2'-benzothienyl)-pyridinato-N,C3'] iridium (III)(acetylacetonate)
2. (Pq)$_2$Ir(III)(acac); Bis[(2-phenylquinolyl)-N,C2']iridium (III) (acetylacetonate)
3. (Piq)$_2$Ir(III)(acac); Bis[(1-phenylisoquinolinato-N,C2')]iridium (III) (acetylacetonate)
4. (DBQ)$_2$Ir(acac); Bis[(dibenzo[f, h]quinoxalino-N,C2')iridium (III)(acetylacetonate)
5. [Ir(HFP)$_3$], Tris(2,5-bis-2'-(9',9'-dihexylfluorene)pyridine)iridium (III)
6. Ir(piq)$_3$, Tris[1-phenylisoquinolinato-N,C2']iridium (III)
7. Ir(btp)$_3$, Tris-[2-(2'-benzothienyl)-pyridinato-N,C3'] iridium (III)
8. Ir(tiq)$_3$, Tris[1-thiophen-2-ylisoquinolinato-N,C3']iridium (III)
9. Ir(fliq)$_3$; Tris[1-(9,9-dimethyl-9H-fluoren-2-yl)isoquinolinato-(N,C3')iridium (III))

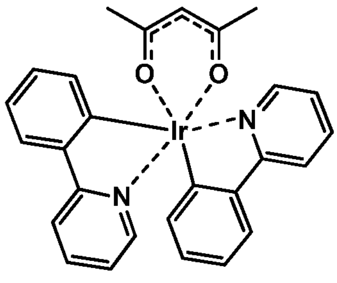

Ir(ppy)$_2$(acac)

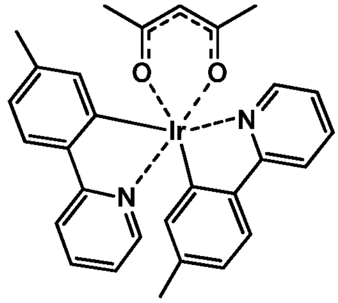

Ir(mppy)$_2$(acac)

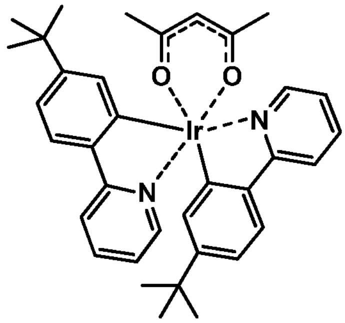

Ir(t-Buppy)$_2$(acac)

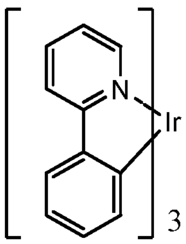

Ir(ppy)$_3$

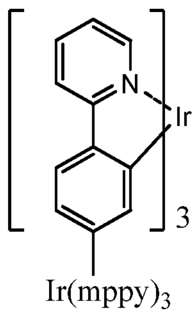

Ir(mppy)$_3$

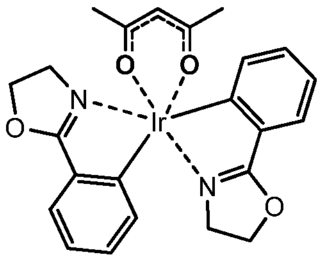

Ir(op)$_2$(acac)

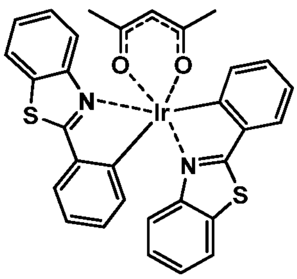

**(bt)$_2$Ir(III)(acac)**
Bis[2-phenylbenzothiazolato -N,C2'] iridium (III)(acetylacetonate)

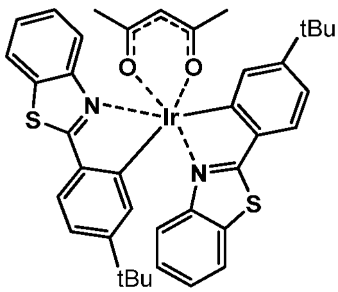

**(*t*-bt)$_2$Ir(III)(acac)**
Bis[2-(4-tert-butylphenyl)benzothiazolato-N,C2']iridium(III)(acetylacetonate)

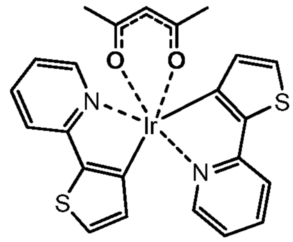

**(thp)$_2$Ir(III)(acac)**
Bis[(2-(2'-thienyl)pyridinato-N,C3')]iridium (III) (acetylacetonate)

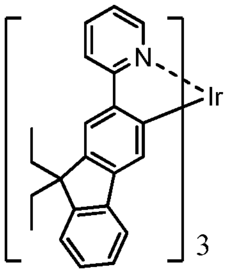

**[Ir(Flpy)$_3$]**
Tris[2-(9.9-dimethylfluoren-2-yl)pyridinato-(N,C3')]iridium (III)

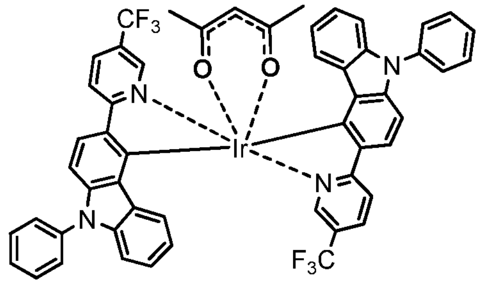

**(Cz-CF$_3$)Ir(III)(acac)**
Bis[5-trifluoromethyl-2-[3-(N-phenylcarbzolyl)pyridinato-N,C2']iridium(III)(acetylacetonate)

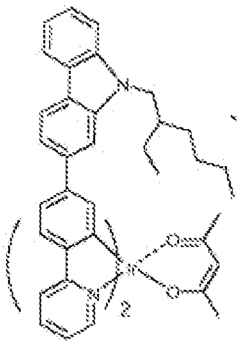

**(2-PhPyCz)$_2$Ir(III)(acac)**

The thickness of an emissive layer may vary. In some embodiments, an emissive layer may have a thickness in the range of about 1 nm to about 150 nm or about 200 nm.

A hole-transport layer may comprise at least one hole-transport material. Examples of hole-transport materials may include: an aromatic-substituted amine, a carbazole, a polyvinylcarbazole (PVK), e.g. poly(9-vinylcarbazole); polyfluorene; a polyfluorene copolymer; poly(9,9-di-n-octylfluorene-alt-benzothiadiazole); poly(paraphenylene); poly[2-(5-cyano-5-methylhexyloxy)-1,4-phenylene]; a benzidine; a phenylenediamine; a phthalocyanine metal complex; a polyacetylene; a polythiophene; a triphenylamine; copper phthalocyanine; 1,1-Bis(4-bis(4-methylphenyl) aminophenyl) cyclohexane; 2,9-Dimethyl-4,7-diphenyl-1,10-phenanthroline; 3,5-Bis(4-tert-butyl-phenyl)-4-phenyl[1,2,4]triazole; 3,4,5-Triphenyl-1,2,3-triazole; 4,4',4'-tris(3-methylphenylphenylamino)triphenylamine (MTDATA); N,N'-bis(3-methylphenyl)N,N'-diphenyl-[1,1'-biphenyl]-4,4'-diamine (TPD); 4,4'-bis[N-(naphthyl)-N-phenyl-amino]biphenyl ($\alpha$-NPD); 4,4',4"-tris(carbazol-9-yl)-triphenylamine (TCTA); 4,4'-bis[N,N'-(3-tolyl)amino]-3,3'-dimethylbiphenyl (HMTPD); 4,4'-N,N'-dicarbazole-biphenyl (CBP); 1,3-N,N-dicarbazole-benzene (mCP); Bis[4-(p,p'-ditolyl-amino)phenyl]diphenylsilane (DTASi); 2,2'-bis(4-carbazolylphenyl)-1,1'-biphenyl (4CzPBP); N,N'N"-1,3,5-tricarbazoloylbenzene (tCP); N,N'-bis(4-butylphenyl)-N,N'-bis(phenyl)benzidine; a combination thereof; or any other material known in the art to be useful as a hole-transport material.

An electron-transport layer may comprise at least one electron-transport material. Examples of electron-transport materials may include: 2-(4-biphenylyl)-5-(4-*tert*-butylphenyl)-1,3,4-oxadiazole (PBD); 1,3-bis(N,N-t-butyl-phenyl)-1,3,4-oxadiazole (OXD-7), 1,3-bis[2-(2,2'-bipyridine-6-yl)-1,3,4-oxadiazo-5-yl]benzene; 3-phenyl-4-(1'-naphthyl)-5-phenyl-1,2,4-triazole (TAZ); 2,9-dimethyl-4,7-diphenyl-phenanthroline (bathocuproine or BCP); aluminum tris(8-hydroxyquinolate) (Alq3); and 1,3,5-tris(2-N-phenylbenzimidazolyl)benzene; 1,3-bis[2-(2,2'-bipyridine-6-yl)-1,3,4-oxadiazo-5-yl]benzene (BPY-OXD); 3-phenyl-4-(1'-naphthyl)-5-phenyl-1,2,4-triazole (TAZ), 2,9-dimethyl-4,7-diphenyl-phenanthroline (bathocuproine or BCP); and 1,3,5-tris[2-N-phenylbenzimidazol-z-yl]benzene (TPBI). In some embodiments, the electron transport layer may be aluminum quinolate ($Alq_3$), 2-(4-biphenylyl)-5-(4-*tert*-butylphenyl)-1,3,4-oxadiazole (PBD), phenanthroline, quinoxaline, 1,3,5-tris[N-phenylbenzimidazol-z-yl] benzene (TPBI), a derivative or a combination thereof, or any other material known in the art to be useful as an electron-transport material.

A hole-injection layer may include any material that can inject electrons. Some examples of hole-injection materials may include an optionally substituted compound selected from the following: a polythiophene derivative such as poly(3,4-ethylenedioxythiophene (PEDOT)/polystyrene sulphonic acid (PSS), a benzidine derivative such as N, N, N', N'-tetraphenylbenzidine, poly(N,N'-bis(4-butylphenyl)-N,N'-bis(phenyl)benzidine), a triphenylamine or phenylenediamine derivative such as N,N'-bis(4-methylphenyl)-N,N'-bis(phenyl)-1,4-phenylenediamine, 4,4',4"-tris(N-(naphthylen-2-yl)-N-phenylamino)triphenylamine, an oxadiazole derivative such as 1,3-bis(5-(4-diphenylamino)phenyl-1,3,4-oxadiazol-2-yl)benzene, a polyacetylene derivative such as poly(1,2-bis-benzylthio-acetylene), a phthalocyanine metal complex derivative such as phthalocyanine copper (CuPc), a combination thereof, or any other material known in the art to be useful as a hole-injection material. In some embodiments, hole-injection materials, while still being able to transport holes, may have a hole mobility substantially less than the hole mobility of conventional hole-transport materials.

A variety of methods may be used to provide a porous film layer to a light-emitting device. FIG. 61 depicts an example of a method that may be used. The first step **5910** involves depositing a material of porous film on a transparent substrate. An optional heating step **5930** may then be carried out upon the material deposited on the transparent substrate

to provide a porous film. Then an OLED is coupled to the substrate using a coupling medium in step **5950.**

A coupling medium may be any material that has a similar refractive index to the glass substrate and may be capable of causing the glass substrate to be affixed to the OLED, such as by adhesion. Examples may include a refractive index matching oil or double sticky tape. In some embodiments, a glass substrate may have refractive index of about 1.5, and a coupling medium may have refractive index of about 1.4. This may allow light to come through the glass substrate and the coupling medium without light loss.

In some embodiments, the material of the porous film may be deposited directly on the OLED. An optional heating step may also be carried out on the deposited material to provide a porous film.

In some embodiments, the heating temperature may be sufficiently low that the performance of the OLED is not adversely affected to a degree that is unacceptable. In some embodiments wherein the material of the porous film comprises COMPOUND-1, annealing (i.e., heating step) may not be necessary.

A light-emitting device may further comprise an encapsulation or protection layer to protect the porous film element from environmental damage, such as damage due to moisture, mechanical deformation, etc. For example, a protective layer may be placed in such a way as to provide a protective barrier between the porous film and the environment.

While there may be many ways to encapsulate or protect a porous film, FIG. 62A is a schematic of a structure of an encapsulated device and FIG. 62B shows one method that may be used to prepare the device. In this method, step **6200** involves disposing a porous film **5430** on a transparent substrate **5570,** and step **6201** involves affixing a transparent sheet **6210** over a porous film **5430.** When the transparent sheet **6210** is positioned over the porous film **5430,** the edges of the transparent sheet **6210** and the transparent substrate **5570** may be sealed to one another by a sealing material **6220** as shown in step **6202.** The sealing material **6220** may be an epoxy resin, a UV-curable epoxy, or another cross-linkable material. Optionally, a gap **6280** may be present between the transparent sheet **6210** and the porous material **5430.** A protection layer (i.e., transparent sheet) may also be coated onto the porous film **5430** without sealing the edges of the protection layer **6250** and the transparent substrate **5570.** In step **6205,** the encapsulated porous film may then be coupled to an OLED **5410** by a coupling medium **5960.** If desired, additional layers may be included in the light-emitting device. These additional layers may include an electron injection layer (EIL), a hole-blocking layer (HBL), and/or an exciton-blocking layer (EBL).

If present, an electron injection layer may be in a variety of positions in a light-emitting device, such as any position between the cathode layer and the light emitting layer. In some embodiments, the lowest unoccupied molecular orbital (LUMO) energy level of the electron injection material(s) is high enough to prevent it from receiving an electron from the light emitting layer. In other embodiments, the energy difference between the LUMO of the electron injection material(s) and the work function of the cathode layer is small enough to allow the electron injection layer to efficiently inject electrons into the emissive layer from the cathode. A number of suitable electron injection materials are known to those skilled in the art. Examples of suitable electron injection materials may include but are not limited to, an optionally substituted compound selected from the following: LiF, CsF, Cs doped into electron transport material as described above or a derivative or a combination thereof.

If present, a hole-blocking layer may be in a variety of positions in a light-emitting device, such as any position between the cathode and the emissive layer. Various suitable hole-blocking materials that can be included in the hole-blocking layer are known to those skilled in the art. Suitable hole-blocking material(s) include but are not limited to, an optionally substituted compound selected from the following: bathocuproine (BCP), 3,4,5-triphenyl-1,2,4-triazole, 3,5-bis(4-*tert*-butyl-phenyl)-4-phenyl-[1,2,4] triazole, 2,9-dimethyl-4,7-diphenyl-1,10-phenanthroline, 1,1-bis(4-bis(4-methylphenyl)aminophenyl)-cyclohexane, etc, and combinations thereof.

If present, an exciton-blocking layer may be in a variety of positions in a light-emitting device, such as in any position between the emissive layer and the anode. In some embodiments, the band gap energy of the material(s) that comprise exciton-blocking layer may be large enough to substantially prevent the diffusion of excitons. A number of suitable exciton-blocking materials that can be included in the exciton-blocking layer are known to those skilled in the art. Examples of material(s) that can compose an exciton-blocking layer include an optionally substituted compound selected from the following: aluminum quinolate ($Alq_3$), 4,4'-bis[N-(naphthyl)-N-phenyl-amino]biphenyl ($\alpha$-NPD), 4,4'-N,N'-dicarbazole-biphenyl (CBP), and bathocuproine (BCP), and any other material(s) that have a large enough band gap to substantially prevent the diffusion of excitons.

## Examples

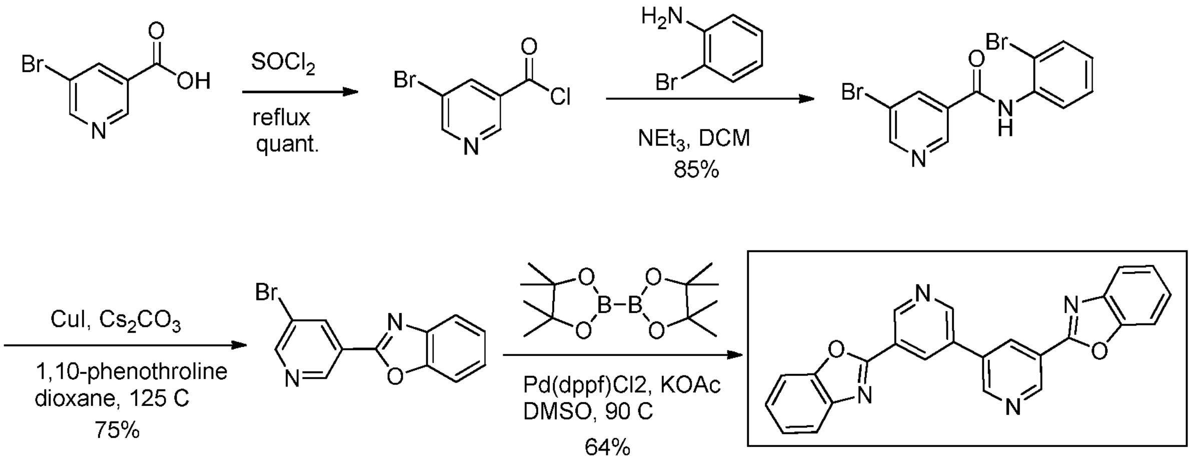


**Compound-1**

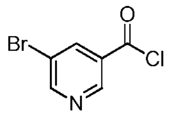

**5-Bromonicotinoyl chloride:** To a mixture of 5-bromonicotinic acid (10 g) in thionyl chloride (25 ml) was added anhydrous DMF (0.5 ml). The whole was refluxed overnight. After cooling to room temperature (RT), the excess thionyl chloride was removed under reduced pressure. A white solid (11 g) was obtained, which was used for the next step without further purification.

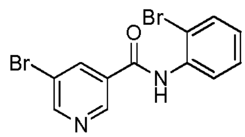

**5-bromo-N-(2-bromophenyl)nicotinamide:** A mixture of 5-bromonicotinoyl chloride (7.5 g, 33 mmol), 2-bromoaniline (5.86g, 33 mmol) and triethylamine (14 ml, 100 mmol) in anhydrous dichloromethane (100 ml) was stirred under argon overnight. The resulting mixture was worked up with water and extracted with dichloromethane (200 ml x 2). The organic phase was collected and dried over $Na_2SO_4$. After the organic phase was concentrated to 150 ml, white crystalline solid was crashed out. Filtration and washing with hexanes gave a white solid (10.0 g, 85% yield).

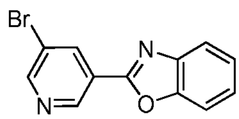

**2-(5-bromopyridin-3-yl)benzo[d]oxazole:** A mixture of 5-bromo-N-(2-bromophenyl)nicotinamide (3.44 g, 9.7 mmol), CuI (0.106 g, 0.56 mmol), $Cs_2CO_3$ (3.91 g, 12 mmol) and 1,10-phenanthroline (0.20 g, 1.12 mmol) in anhydrous 1,4-dioxane (50 mL) was heated at 100 °C overnight. After cooling to RT, the mixture was poured into ethyl acetate (200 ml), then washed with water. The aqueous phase was extracted with ethyl acetate (200 ml x 2), and the organic phase was collected and dried over $Na_2SO_4$, purified by flash chromatography (silica gel, hexanes/ethyl acetate 3:1) to give a light yellow solid (2.0 g, 75% yield).

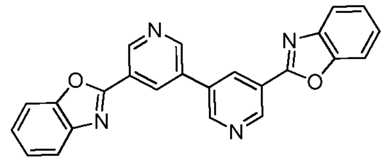

**Compound-1:** A mixture of 2-(5-bromopyridin-3-yl)benzo[d]oxazole (550 mg, 2 mmol), potassium acetate (600 mg, 6.1 mmol), bis(pinacolato)diboron (254 mg, 1 mmol) and [1,1'-bis(diphenylphosphino)ferrocene]dichloropalladium (73 mg, 0.1 mmol) in DMSO was degassed and heated at 90 °C under argon atmosphere overnight. After cooling, the whole was poured into water, filtration gave a solid which was washed with isopropanol, methylene chloride. A white solid was obtained (250 mg, 64% yield) as product Compound-1.

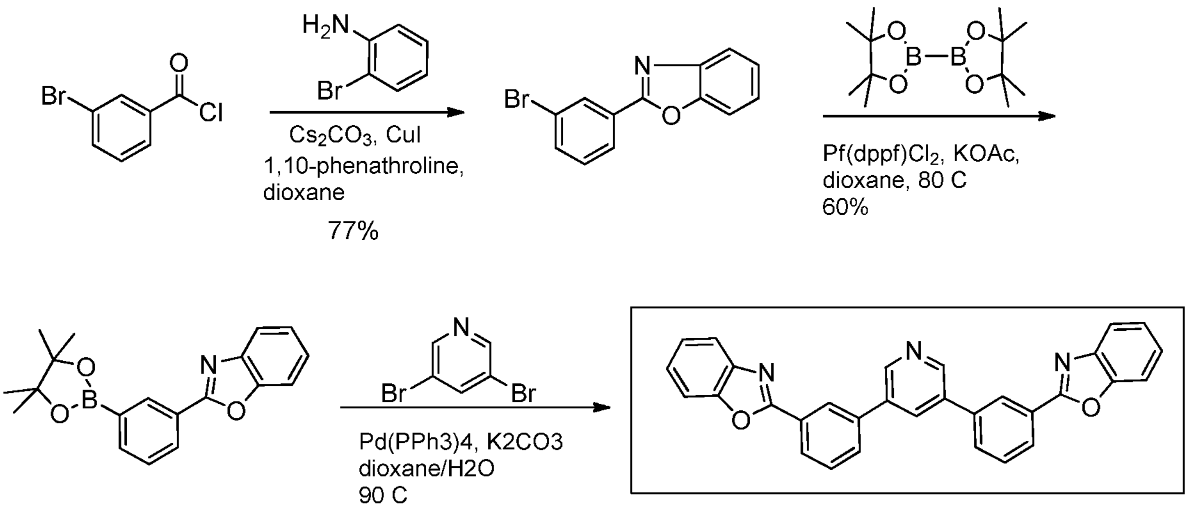


**Compound-2**

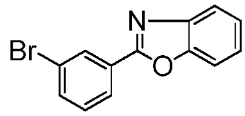

**2-(3-bromophenyl)benzo[d]oxazole:** A mixture of 3-bromobenzoyl chloride (10.0 g, 45.6 mmol), 2-bromoaniline (7.91 g, 46 mmol), $Cs_2CO_3$ (30 g, 92 mmol), CuI (0.437 g, 2.3 mmol) and 1,10-phenanthroline (0.829 g, 4.6 mmol) in anhydrous 1,4-dioxane (110 ml) was heated at 120 °C for 8 h. After cooling to RT, the mixture was poured into ethyl acetate (300 ml), worked up with water (250 ml). The aqueous solution was extracted with dichloromethane (300 ml). The organic phase was collected, combined, and dried over $Na_2SO_4$. Purification by a short silica gel column (hexanes/ ethyl acetate 3:1) gave a solid which was washed with hexanes to give a light yellow solid (9.54 g, 76% yield).

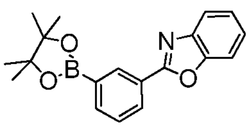

**2-(3-(4,4,5,5-tetramethyl-1,3,2-dioxaborolan-2-yl)phenyl)benzo[d]oxazole:** A mixture of 2-(3-bromophenyl)benzo[d]oxazole (2.4g, 8.8mmol), bis(pinacolato)diboron (2.29g, 9.0mmol), [1,1'-Bis(diphenylphosphino)ferrocene]dichloropalladium (0.27g, 0.37mmol), and potassium acetate (2.0g, 9.0mmol) in anhydrous 1,4-dioxane (50mL) was degassed, then heated at 80 °C overnight. After cooling to RT, the mixture was poured into ethyl acetate (100 ml). After filtration, the solution was absorbed on silica gel and purified by flash chromatography (hexanes/ethyl acetate 4:1) to give a white solid (2.1g in 75% yield).

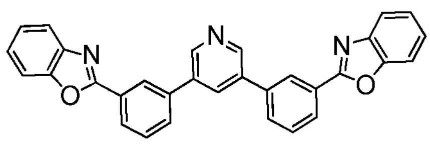

**Compound-2:** A mixture of 3,5-dibromopyridine (0.38 g, 1.6 mmol), 2-(3-(4,4,5,5-tetramethyl-1,3,2-dioxaborolan-2-yl)phenyl)benzo[d]oxazole (1.04g, 3.1 mol), $Pd(PPh_3)_4$ (0.20 g, 0.17 mmol) and potassium carbonate (0.96g, 7.0mmol) in dioxane/water (40ml/8ml) was degassed and heated at 90 °C overnight under argon. After cooling to RT,

the precipitate was filtered and washed with methanol to give a white solid (0.73 g, in 95% yield).

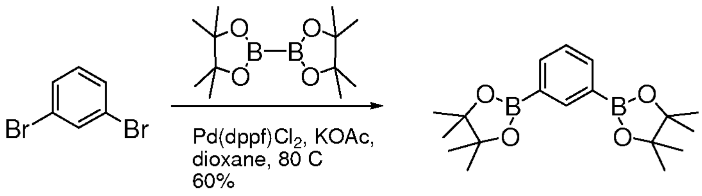


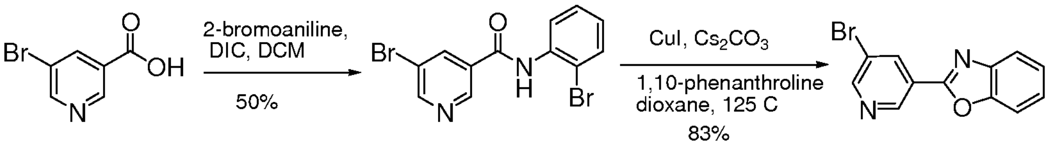


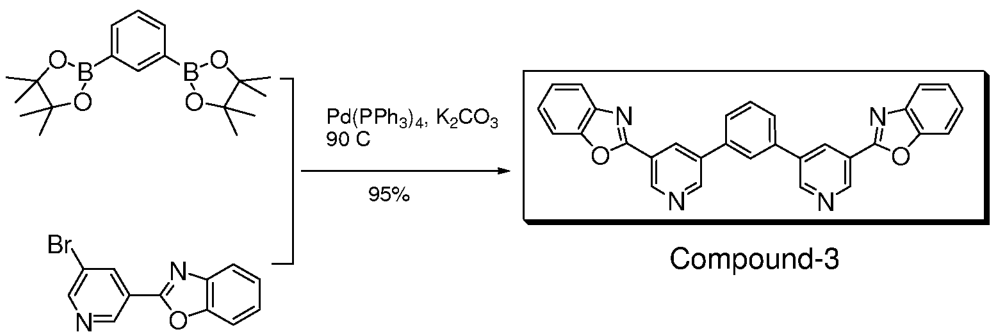


Compound-3

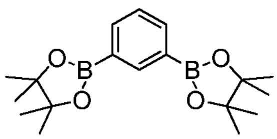

**1,3-bis(4,4,5,5-tetramethyl-1,3,2-dioxaborolan-2-yl)benzene:** 1,3-dibromobenzene (2.5g, 10.6mmol), bis(pinacolato)diboron (6.0g, 23.5mmol), Pd(dppf)$_2$Cl$_2$ (.9 g, 1.2mmol), and potassium acetate (7.1g, 72.1mmol) were dissolved in 50 mL of 1,4-dioxane. The reaction mixture was degassed with argon and then heated to 85 °C under argon for 18 hours. The reaction mixture was filtered and an extraction was performed in ethyl acetate. The organic phase was washed with water and brine. The extract was dried over sodium sulfate, filtered, and concentrated. The resulting residue was purified by a silica gel column with 1:9 ethyl acetate:hexanes as the eluent. The solvents were removed and the product was recrystallized from dichloromethane/methanol to yield the product as an off-white solid (3.008 g, 86% yield).

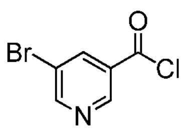

**5-Bromonicotinoyl chloride:** To a mixture of 5-bromonicotinic acid (10 g) in thionyl chloride (25 ml) was added anhydrous DMF (0.5 ml). The whole was heated to reflux for overnight. After cooled to RT, the excess thionyl chloride was removed under reduced pressure. A white solid (11 g) was obtained, which was used for the next step without further purification.

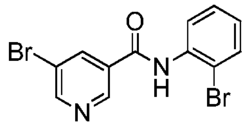

**5-bromo-N-(2-bromophenyl)nicotinamide:** A mixture of 5-bromonicotinoyl chloride (7.5 g, 33 mmol), 2-bromoaniline (5.86g, 33 mmol) and triethylamine (14 mL, 100 mmol) in anhydrous dichloromethane (100 ml) was stirred under argon overnight. The resulting mixture was worked up with water and extracted with dichloromethane (200 mL x 2). The organic phase was collected and dried over $Na_2SO_4$. After concentrated to 150 mL, white crystalline solid was crashed out. Filtration and washing with hexanes gave a white solid (10.0 g, 85% yield).

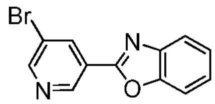

**2-(5-bromopyridin-3-yl)benzo[d]oxazole:** A mixture of 5-bromo-N-(2-bromophenyl)nicotinamide (3.44 g, 9.7 mmol), CuI (0.106 g, 0.56 mmol), $Cs_2CO_3$ (3.91 g, 12 mmol) and 1,10-phenanthroline (0.20 g, 1.12 mmol) in anhydrous 1,4-dioxane (50 ml) was heated at 100 °C overnight. After cooling to RT, the mixture was poured into ethyl acetate (200 ml), then washed with water. The aqueous phase was extracted with ethyl acetate (200 ml x 2), and the organic phase was collected and dried over $Na_2SO_4$, purified by flash chromatography (silica gel, hexanes/ethyl acetate 3:1) to give a light yellow solid (2.0 g, 75% yield).

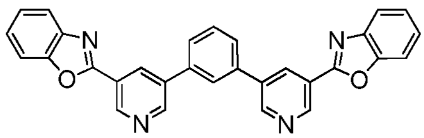

**Compound-3:** A mixture of 1,3-bis(4,4,5,5-tetramethyl-1,3,2-dioxaborolan-2-yl)benzene (0.63g, 1.92 mmol), 2-(5-bromopyridin-3-yl)benzo[d]oxazole (1.05 g, 3.83 mmol), $Pd(PPh_3)_4$ (0.219g, 0.19 mmol) and potassium carbonate (1.1 g, 8 mmol) in dioxane/water (30 ml/6 ml) was degassed and heated at 85 °C overnight under argon. After cooling to RT, the precipitate was filtered and washed with methanol (300 ml x 3) and dried under vacuum to give a white solid (0.88 g, 98% yield).

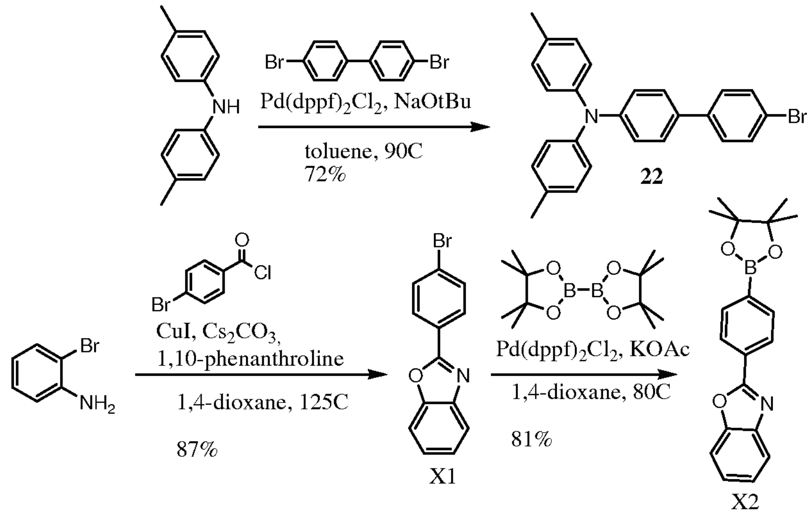


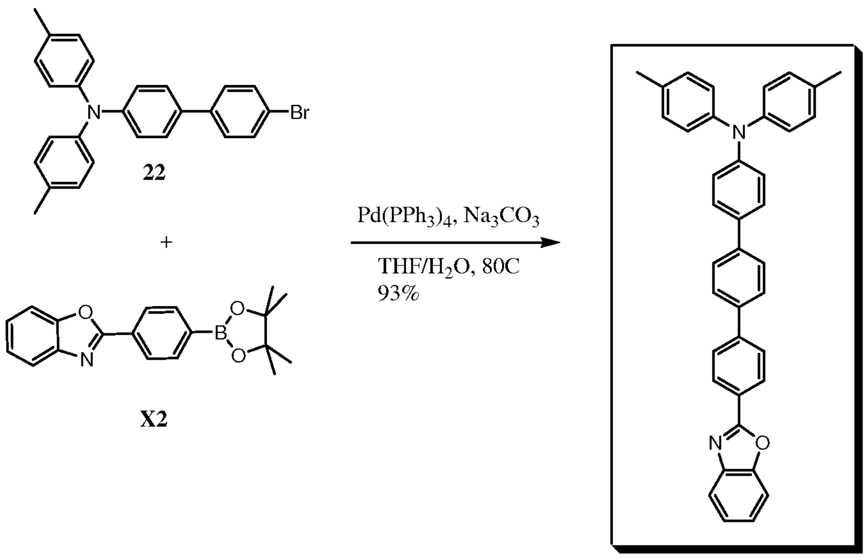


**Compound-4**

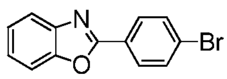

**2-(4-bromophenyl)benzo[d]oxazole (X1):** A mixture of 4-bromobenzoylchloride (4.84 g, 22 mmol), 2-bromoaniline (3.8 g, 22 mmol), CuI (0.21 g, 1.1 mmol), $Cs_2CO_3$ (14.3 g, 44 mmol) and 1,10-phenanthroline (0.398 g, 2.2 mmol) in anhydrous 1,4-dioxane (80 ml) was degassed and heated at about 125 °C under argon overnight. The mixture was cooled and poured into ethyl acetate (~200 ml) and filtered. The filtrate was absorbed on silica gel, purified by column chromatography (hexanes/ethyl acetate 4:1), and precipitated by hexanes to give a white solid (5.2 g, in 87% yield).

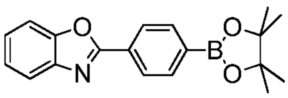

**2-(4-(4,4,5,5-tetramethyl-1,3,2-dioxaborolan-2-yl)phenyl)benzo[d]oxazole (X2):** A mixture of **X1** (4.45 g, 16 mmol), bis(pinacolate)diborane (4.09 g, 16.1 mmol), anhydrous potassium acetate (3.14 g, 32 mmol) and Pd(dppf)$Cl_2$ (0.48 g, 0.66 mmol) in anhydrous 1,4-dioxane (80 ml) was degassed and heated at about 85 °C for about 48 hours under argon. After cooling to RT, the mixture was poured into ethyl acetate (~200 ml) and filtered. The filtrate was absorbed on silica gel and purified by column chromatography (hexanes/ethyl acetate, 4:1) to give a white solid (4.15 g, in 81% yield).

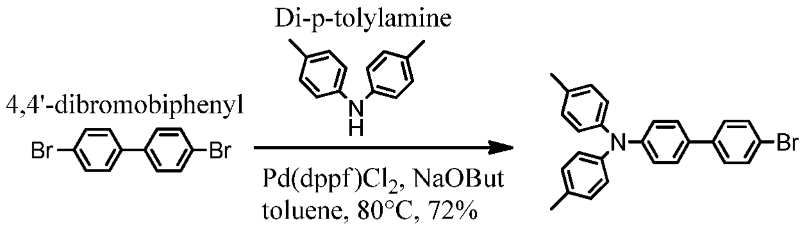


**4'-bromo-N,N-dip-tolylbiphenyl-4-amine (22):** Di-p-tolylamine (6.0g, 30.4mmol), 4,4'-dibromobiphenyl (23.7g, 76.0mmol), sodium tert-butoxide (7.26g, 91.2 mmol), and [1,1-bis(diphenylphosphino)ferrocene]palladium(II)dichloride ($Pd(dppf)Cl_2$) (666mg, 0.912mmol, 3mol%) were added to anhydrous toluene (about 250ml) and degassed in argon for about 30 minutes. The resulting mixture was heated at about 80 °C for about 6 hours, after which a TLC analysis indicated that most of the di-p-tolylamine was consumed. After being cooled to RT, the mixture was poured into saturated aqueous sodium bicarbonate and extracted with 2 portions of ethyl acetate. The organic layers were pooled and washed with water and brine, then dried over $MgSO_4$. After filtration, the extract was concentrated to dryness on a rotary evaporator, and then loaded onto silica gel. A flash column (gradient of 100% hexane to 1% methylene chloride in hexane) resulted in 9.4g (72%) of a white solid confirmed by $^1H$ NMR in $CDCl_3$.

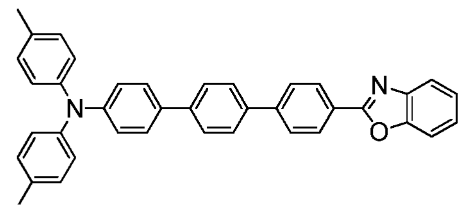

**Compound-4:** A mixture of **X2** (0.66 g, 2.05 mmol), compound 22 (0.80 g, 1.87 mmol), $Na_2CO_3$ (0.708 g, 6.68 mmol) and $Pd(PPh_3)_4$ (0.065 g, 56.1 mmol) in $THF/H_2O$ (10 mL/6 mL) was degassed and heated at 80 °C overnight under argon atmosphere. After cooling, the mixture was poured into dichloromethane (100 ml) and washed with water (2x 200 ml) and brine (100 ml). Organic phase was collected, dried over $Na_2SO_4$, then purified by flash chromatography (silica gel, hexanes/ethyl acetate 40:1 to 9:1) to give a solid (0.936 g, in 93% yield).

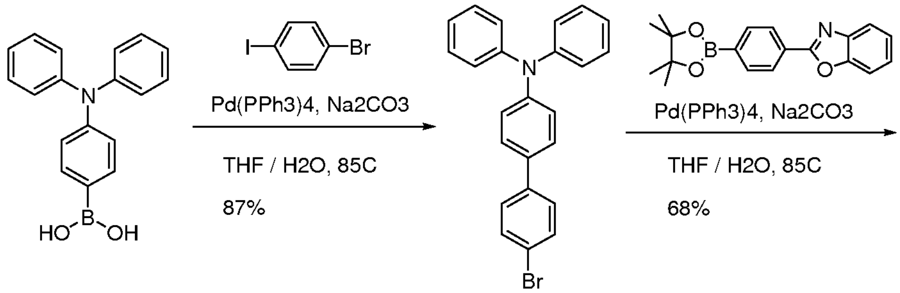


$X_3$

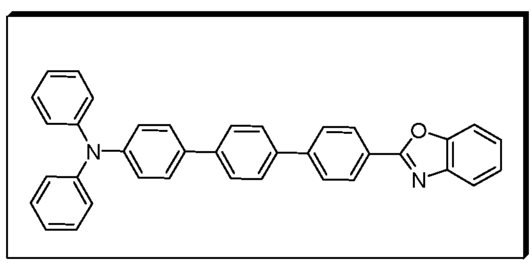

**Compound-5**

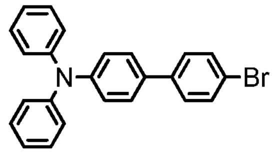

**4'-bromo-N,N-diphenyl-[1,1'-biphenyl]-4-amine (X3):** A mixture of (4-(diphenylamino)phenyl)boronic acid (1.5 g, 5.19 mmol), 4-iodo-1-bromobenzene (1.33 g, 4.71 mmol), $Na_2CO_3$ (1.78 g, 16.8 mmol) and $Pd(PPh_3)_4$ (0.163 g, 0.141 mmol) in THF/$H_2O$ (28 mL/17 mL) was degassed and heated at reflux overnight under argon atmosphere. After cooling, the mixture was poured into dichloromethane (150 mL), then washed with water (2 x 150 mL) and brine (100 mL). The organic phase was dried over $Na_2SO_4$, purified with flash column chromatography (silica gel, hexanes/ethyl acetate 50:1) then recrystallized in dichloromethane/methanol to afford a white solid (1.64 g, in 87% yield).

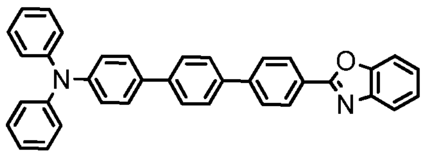

**Compound-5:** A mixture of **X3** (1.40 g, 3.5 mmol), compound 10 (1.52 g, 3.85 mmol), $Na_2CO_3$ (1.32g, 12.5 mmol) and $Pd(PPh_3)_4$ (121 mg, 0.105 mmol) in THF/$H_2O$ (21 ml/12.5 ml) was degassed and heated to reflux overnight under an argon atmosphere. After cooling to RT, the mixture was poured into dichloromethane (150 ml), then washed with water (150 ml) and brine (150 ml). The organic phase was dried over $Na_2SO_4$, absorbed on silica gel, and purified with flash column chromatography (hexane/ethyl acetate 5:1 to 2:1, then dichoromethane as eluent). Product was collected and recrystallized from acetone/hexanes to give a solid (1.69g). It was recrystallized again in dichoromethane/ethyl acetate to give a solid (1.4 g, 68% yield).

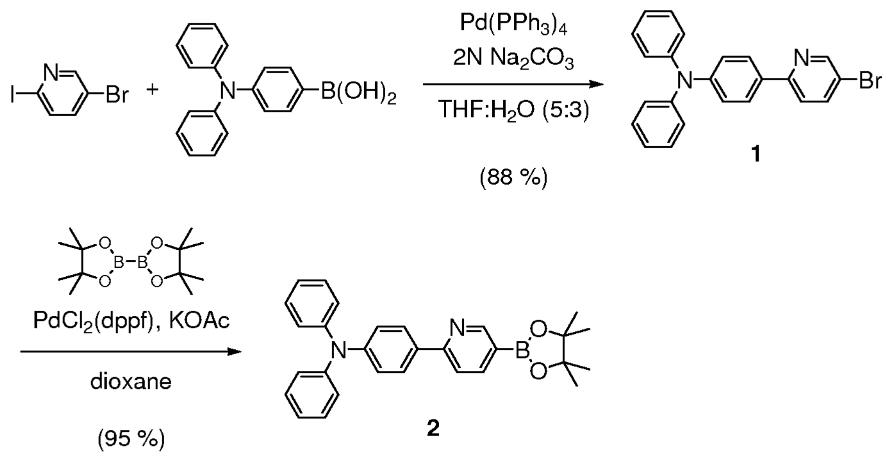


1

2

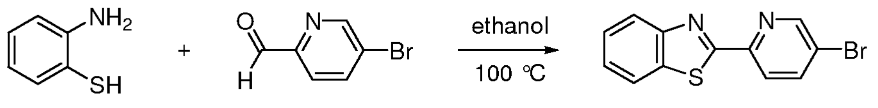


9

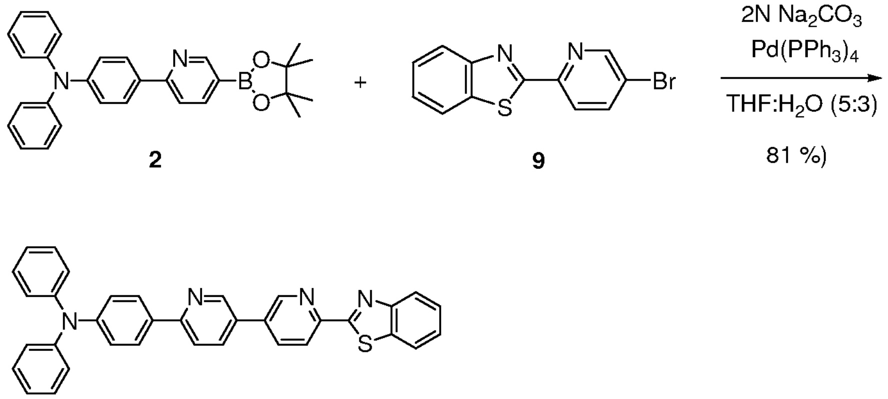


2

9

**Compound-6**

**4-(5-bromopyridin-2-yl)-N,N-diphenylaniline (1).** A mixture of 4-(diphenylamino)phenylboronic acid (7.00 g, 24.2 mmol), 5-bromo-2-iodopyridine (7.56 g, 26.6 mmol), tetrakis(triphenylphosphine)palladium(0) (1.40 g, 1.21 mmol), $Na_2CO_3$ (9.18 g, 86.6 mmol), $H_2O$ (84 mL) and THF (140 mL) was degassed with argon for 1.5 h while stirring. The stirring reaction mixture was then maintained under argon at 80 °C for 19 h. Upon confirming consumption of the starting material by TLC ($SiO_2$, 19:1 hexanes-EtOAc), the reaction was cooled to RT and poured over EtOAc (500 mL). The organics were then washed with sat. $NaHCO_3$, $H_2O$ and brine, dried over $MgSO_4$, filter and concentrated *in vacuo.* The crude product was purified via flash chromatography ($SiO_2$, 2:1 hexanes-dichloromethane) to afford compound 1 (9.54 g, 98 %) as a light yellow, crystalline solid.

**N,N-diphenyl-4-(5-(4,4,5,5-tetramethyl-1,3,2-dioxaborolan-2-yl)pyridin-2-yl)aniline (2).** A mixture of **1** (6.00 g, 15.0 mmol), bis(pinacolato)diboron (4.18 g, 16.4 mmol), [1,1'-bis(diphenylphosphino)-ferrocene]dichloropalladium(II) (0.656 g, 0.897 mmol), potassium acetate (4.40, 44.9 mmol) and anhydrous 1,4-dioxane (90 mL) was degassed with argon for 50 min while stirring. The stirring reaction mixture was then maintained under argon at 80 °C for 67 h. Upon confirming consumption of the starting material by TLC ($SiO_2$, 4:1 hexanes-acetone), the reaction was cooled to RT, filtered, and the filtrant washed copiously with EtOAc (ca. 200 mL). The organics were then washed with sat. $NaHCO_3$,

$H_2O$, sat. $NH_4Cl$ and brine, dried over $MgSO_4$, filtered and concentrated *in vacuo.* The crude was then taken up in hexanes (ca. 300 mL), the insolubles filtered off and the filtrate concentrated to yield **2** (6.34 g, 95 %) as a yellow foam, which was carried forward without further purification.

**2-(5-bromopyridin-2-yl)benzo[*d*]thiazole (9).** A mixture of 2-aminothiophenol (5.01 g, 40.0 mmol), 5-bromo-2-formylpyridine (7.44 g, 40.0 mmol) and ethanol (40 mL) was heated to reflux (100 °C) while open to the atmosphere for 3 days. Upon confirming consumption of the starting materials by TLC ($SiO_2$, 29:1 hexanes-acetone), the reaction was cooled to RT, the resulting mixture filtered, and the filtrant washed copiously with ethanol to afford **9** (5.62 g, 48 %) as an off-white solid.

**4-(6'-(benzo[*d*]thiazol-2-yl)-3,3'-bipyridin-6-yl)-*N,N*-diphenylaniline (Compound-6).** A mixture of **9** (3.05 g, 7.59 mmol), **2** (3.40 g, 7.59 mmol), tetrakis(triphenylphosphine)palladium(0) (0.438 g, 0.379 mmol), $Na_2CO_3$ (7.42 g, 70.0 mmol), $H_2O$ (70 mL) and THF (115 mL) was degassed with argon for 1.25 h while stirring. The stirring reaction mixture was then maintained under argon at 80 °C for 65 h. Upon confirming consumption of the starting materials by TLC ($SiO_2$, $CH_2Cl_2$), the reaction was cooled to RT and poured over $CH_2Cl_2$ (400 mL). The organics were then washed with sat. $NaHCO_3$, $H_2O$ and brine, dried over $MgSO_4$, filter and concentrated *in vacuo.* Purification of the crude product via flash chromatography ($SiO_2$, 100 % $CH_2Cl_2$ to 49:1 $CH_2Cl_2$-acetone) provided **Compound-6** (3.98 g, 82 %) as a yellow solid.

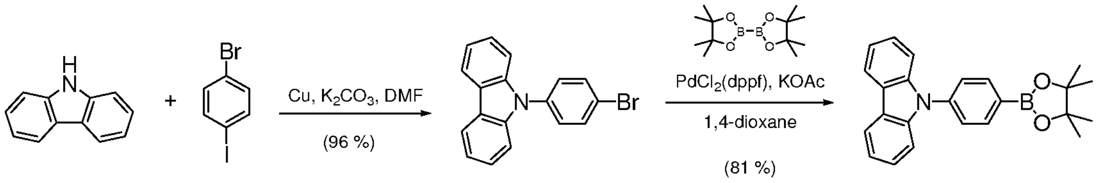


**4** **5**

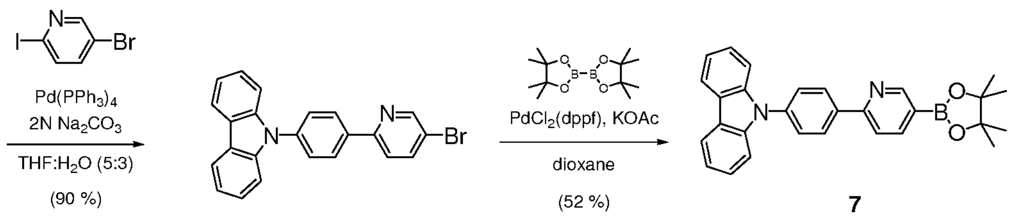


**6** **7**

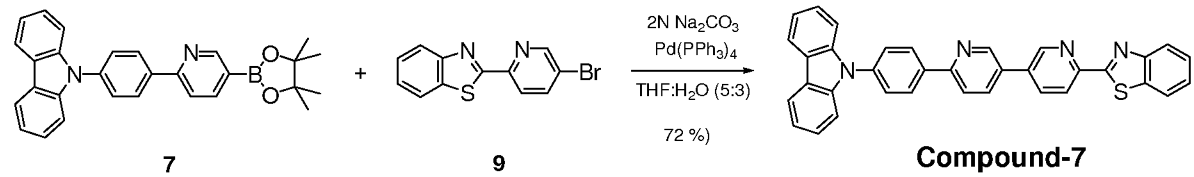


**7** **9** **Compound-7**

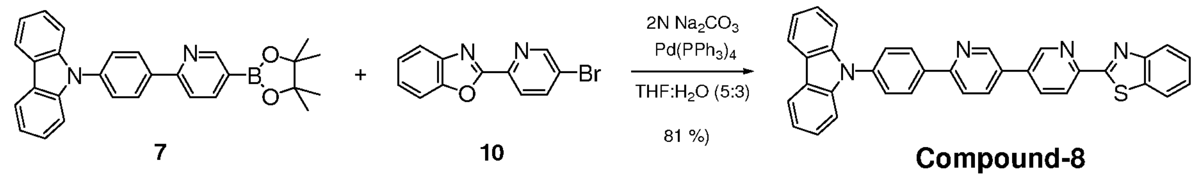


**7** **10** **Compound-8**

**9-(4-bromophenyl)-9*H*-carbazole (4)**. a mixture of carbazole (6.30 g, 37.7 mmol), 1-bromo-4-iodobenzene (15.99 g, 56.52 mmol), copper powder (4.79 g, 75.4 mmol), $K_2CO_3$ (20.83 g, 150.7 mmol) and anhydrous DMF (100 mL) was degassed with argon for 1 h while stirring. The stirring reaction mixture was then maintained under argon at 130 °C for 42 h. Upon confirming consumption of the starting material by TLC ($SiO_2$, 4:1 hexanes-dichloromethane), the mixture was cooled to RT, filtered, the filtrant washed copiously with EtOAc (ca. 200 mL) and the resulting filtrate concentrated *in vacuo.* Purification of the crude product by flash chromatography ($SiO_2$, hexanes) afforded **4** (11.7 g, 96 %) as a pale yellow solid.

**9-(4-(4,4,5,5-tetramethyl-1,3,2-dioxaborolan-2-yl)phenyl)-9H-carbazole (5).** a mixture of **4** (11.64 g, 36.12 mmol), bis(pinacolato)diboron (19.26 g, 75.85 mmol), [1,1'-bis(diphenylphosphino)-ferrocene]dichloropalladium(II) (1.59

g, 2.17 mmol), potassium acetate (10.64, 108.4 mmol) and anhydrous 1,4-dioxane (200 mL) was degassed with argon for 2 h while stirring. The stirring reaction mixture was then maintained under argon at 80 °C for 67 h. Upon confirming consumption of the starting material by TLC ($SiO_2$, hexanes), the mixture was cooled to RT, filtered through a short silica gel plug and the filtrant washed copiously with EtOAc (ca. 400 mL). The organics were then washed with sat. $NaHCO_3$, $H_2O$ and brine, dried over $MgSO_4$, filtered and concentrated *in vacuo.* Purification of the crude product via flash chromatography ($SiO_2$, 7:3 to 1:1 hexanes-dichloromethane) provided **5** (10.8 g, 81 %) as a colorless solid.

**9-(4-(5-bromopyridin-2-yl)phenyl)-9*H*-carbazole (6).** Following the procedure for **1, 5** (4.84 g, 13.1 mmol), 5-bromo-2-iodopyridine (3.72 g, 13.1 mmol), tetrakis(triphenylphosphine)palladium(0) (0.757 g, 0.655 mmol), $Na_2CO_3$ (4.97 g, 46.9 mmol), $H_2O$ (45 mL) and THF (75 mL) yielded **6** (4.73 g, 90 %) as a colorless solid after flash chromatography ($SiO_2$, 1:1 hexanes-dichloromethane) and subsequent trituration with EtOAc.

**9-(4-(5-(4,4,5,5-tetramethyl-1,3,2-dioxaborolan-2-yl)pyridin-2-yl)phenyl)-9H-carbazole (7).** Following the procedure for **2, 6** (6.22 g, 15.6 mmol), bis(pinacolato)diboron (4.35 g, 17.1 mmol), [1,1'-bis(diphenylphosphino)-ferrocene]dichloropalladium(II) (0.684 g, 0.935 mmol), potassium acetate (4.59, 46.7 mmol) and anhydrous 1,4-dioxane (93 mL) yielded **7** (6.55 g, 94 %) as a brownish gray solid.

**2-(6'-(4-(9*H*-carbazol-9-yl)phenyl)-3,3'-bipyridin-6-yl)benzo[*d*]thiazole (Compound-7).** A mixture of **7** (0.841 g, 1.89 mmol), **9** (0.549 g, 1.89 mmol), tetrakis(triphenylphosphine)palladium(0) (109 mg, 94.2 μmol), $Na_2CO_3$ (1.59 g, 15.0 mmol), $H_2O$ (15 mL) and THF (25 mL) was degassed with argon for 20 min while stirring. The stirring reaction mixture was then maintained under argon at 80 °C for 18 h. Upon confirming consumption of the starting materials by TLC ($SiO_2$, $CH_2Cl_2$), the mixture was cooled to RT and poured over $CHCl_3$ (300 mL). The organics were then washed with sat. $NaHCO_3$, $H_2O$ and brine, dried over $MgSO_4$, filtered and concentrated *in vacuo.* Purification of the crude product via flash chromatography ($SiO_2$, 100 % $CH_2Cl_2$ to 49:1 $CH_2Cl_2$-acetone) provided **Compound-7** (0.72 g, 72 %) as a light yellow solid.

**2-(6'-(4-(9*H*-carbazol-9-yl)phenyl)-3,3'-bipyridin-6-yl)benzo[*d*]oxazole (Compound-8).** Following the procedure for **Compound-7,** a mixture of **7** (0.868 g, 1.95 mmol), **10** (0.535 g, 1.95 mmol) (which is made following the same procedure as of for **9**), tetrakis(triphenylphosphine)palladium(0) (112 mg, 97.2 μmol), $Na_2CO_3$ (1.59 g, 15.0 mmol), $H_2O$ (15 mL) and THF (25 mL) yielded **Compound-8** (0.81 g, 81 %) as a white solid after flash chromatography ($SiO_2$, 100 % $CH_2Cl_2$ to 19:1 $CH_2Cl_2$-acetone).

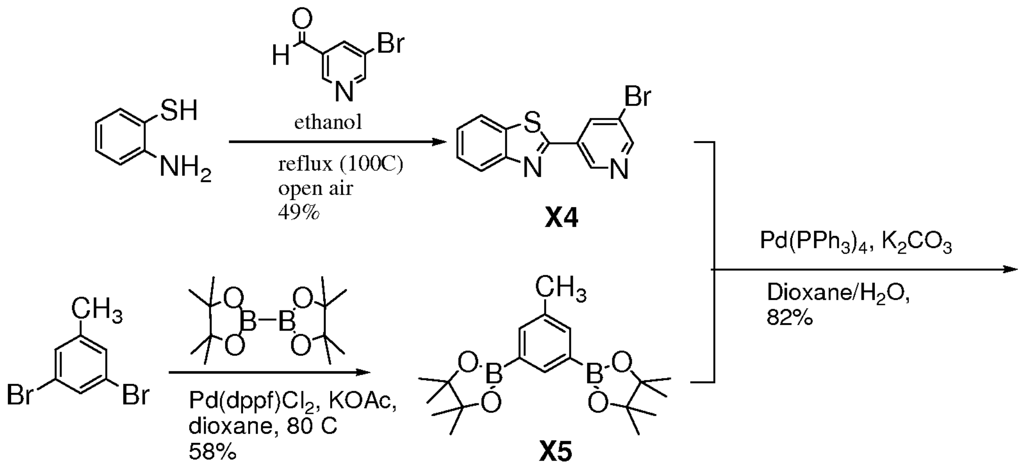


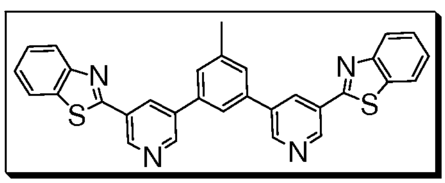

**Compound-9**

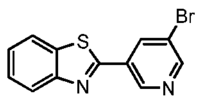

**2-(5-bromopyridin-3-yl)benzo[d]thiazole (X4):** To a mixture of 2-aminothiophenol (500mg, 3.99mmol) and 5-bromo-3-pyridinecarboxaldehyde (743mg, 3.99mmol) was added ethanol (10mL). The mixture was then heated to reflux (100 °C) overnight under ambient air. After cooling, the mixture was dried under vacuum then redissolved in methylene chloride (100ml). Solution was washed with water (100ml) and brine (50ml), and dried over sodium sulfate. The crude material was run through a plug of silica (16% ethyl acetate in hexanes), and precipitated from methanol to give 564 mg of the material in 49% yield.

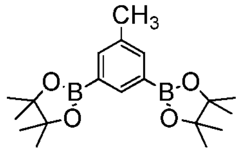

**2,2'-(5-methyl-1,3-phenylene)bis(4,4,5,5-tetramethyl-1,3,2-dioxaborolane) (X5):** 1,3-dibromo-5-methylbenzene (5.0g, 20.0mmol), bis(pinacolato)diboron (11.3g, 44.4mmol), Pd(dppf)$Cl_2$ (1.6g, 2.2mmol), and potassium acetate (13.3g, 136.0mmol) were dissolved in 75 ml of 1,4-dioxane. The reaction mixture was degassed with argon and then heated to 85 °C under argon for 18 hours. The reaction mixture was filtered and an extraction was performed in ethyl acetate. The organic phase was washed with water and brine, then dried over magnesium sulfate, filtered, and concentrated. The resulting residue was purified by a silica gel column with 1:4 ethyl acetate:hexanes as the eluent to yield the product as an off-white solid (0.399g, 58% yield).

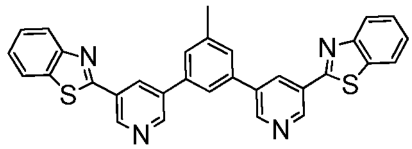

**Compound-9:** A mixture of 2,2'-(5-methyl-1,3-phenylene)bis(4,4,5,5-tetramethyl-1,3,2-dioxaborolane) (0.747 g, 2.17 mmol), 2-(5-bromopyridin-3-yl)benzo[d]thiazole (1.39g, 4.77 mmol), $Pd(PPh_3)_4$ (0.165 g, 0.143 mmol) and potassium carbonate (1.81 g, 17.0 mmol) in THF/water (30 ml/17 ml) was degassed and heated at reflux (85 °C) overnight under argon. After cooling to RT, the mixture was filtered and the solid was washed with water, methanol and THF. The solid was collected and the filtrate was added to water (150 ml) and extracted with dichloromethane (150 ml × 2). The organic solution was dried over $Na_2SO_4$ and loaded on silica gel, purified by flash column using hexanes/acetone (4:1 to 3:1). The desired fraction was collected and combined with the solid from the first filtration. The solid was washed with hot dichloromethane, filtered and washed with methanol to afford 0.91 g product in 82% yield.

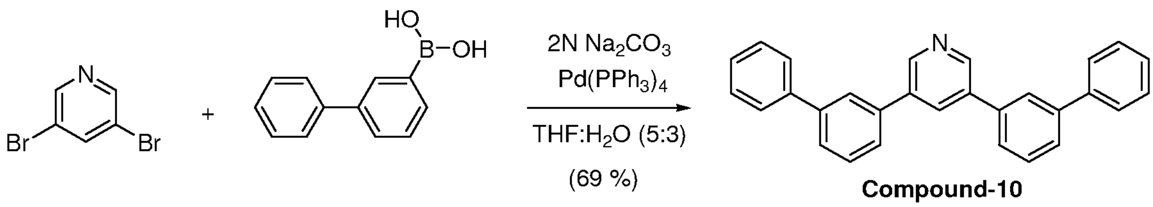


**Compound-10**

**Compound-10 3,5-di([1,1'-biphenyl]-3-yl)pyridine:** A mixture of 3,5-dibromopyridine (1.235 g, 5.215 mmol), [1,1'-biphenyl]-3-ylboronic acid (2.169 g, 10.95 mmol), tetrakis(triphenylphosphine)palladium(0) (0.362 g, 0.313 mmol), $Na_2CO_3$ (2.544 g, 24.00 mmol), $H_2O$ (24 mL) and THF (40 mL) was degassed with argon for 43 min while stirring. The reaction mixture was then maintained under argon at 80 °C while stirring until TLC ($SiO_2$, 7:3 hexanes-ethyl acetate) confirmed consumption of the starting material (4 days). Upon completion, the reaction was cooled to RT and poured over dichloromethane (ca. 250 mL). The organics were then washed with $H_2O$ and brine, dried over $MgSO_4$, filter and concentrated *in vacuo.* Purification of the crude product via flash chromatography ($SiO_2$, 100 % dichloromethane) yielded **compound-10** (1.38 g, 69 %) as an off-white solid.

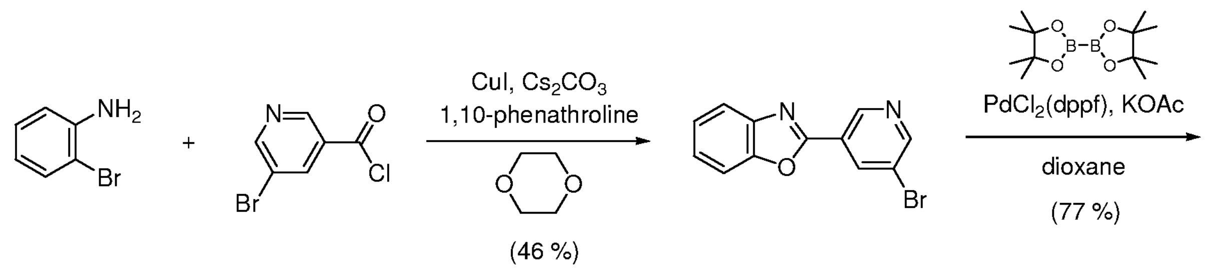


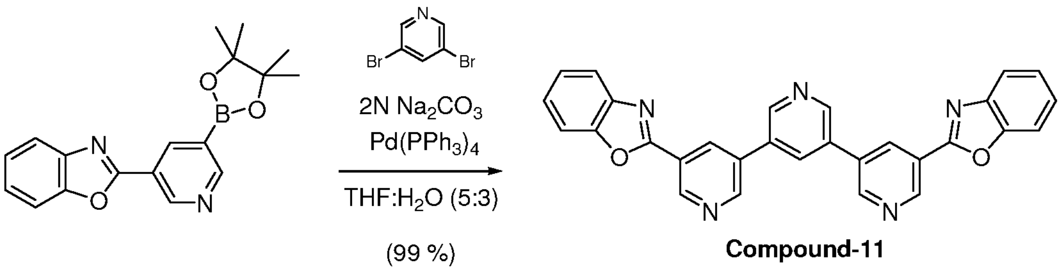


**Compound-11**

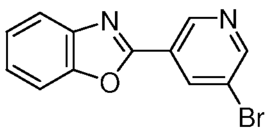

**2-(5-bromopyridin-3-yl)benzo[*d*]oxazole:** A mixture of 5-bromonicotinoyl chloride (13.46 g, 61.04 mmol), 2-bromoaniline (10.00 g, 58.13 mmol), $Cs_2CO_3$ (37.88 g, 116.3 mmol), CuI (0.554 g, 2.907 mmol), 1,10-phenanthroline (1.048 g, 5.813 mmol) and anhydrous 1,4-dioxane (110 mL) was degassed with argon for 1 h while stirring. The reaction mixture was then maintained under argon at 120 °C while stirring until TLC ($SiO_2$, 1:1 hexanes-dichloromethane) confirmed consumption of the starting material (48 h). Upon cooling to RT, dichloromethane (ca. 200 mL) was added to the reaction, the mixture filtered, the filtrant washed copiously with dichloromethane (ca. 200 mL) and ethyl acetate (ca. 200 mL) and the filtrate concentrated *in vacuo*. Purification of the crude product via flash chromatography ($SiO_2$, 100 % dichloromethane to 29:1-dichloromethane:acetone) afforded 2-(5-bromopyridin-3-yl)benzo[*d*]oxazole (7.32 g, 46 %) as a light brown crystalline solid.

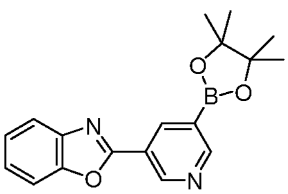

**2-(5-bromopyridin-3-yl)benzo[*d*]oxazole:** A mixture of 2-(5-bromopyridin-3-yl)benzo[*d*]oxazole (7.119 g, 25.88 mmol), bis(pinacolato)diboron (7.229 g, 28.47 mmol), [1,1'-Bis(diphenylphosphino)ferrocene]dichloropalladium (0.947 g, 1.294 mmol), potassium acetate (7.619 g, 77.63 mmol) and anhydrous 1,4-dioxane (150 mL) was maintained under argon at 100 °C while stirring until TLC ($SiO_2$, 9:1 dichloromethane:acetone) confirmed consumption of the starting material (3 days). Upon cooling to RT, dichloromethane (ca. 300 mL) was added to the reaction, the mixture filtered and the filtrant washed with dichloromethane (ca. 100 mL). The fitrate was then washed with sat. $NaHCO_3$, $H_2O$ and brine, dried over $MgSO_4$, filter and concentrated *in vacuo*. The crude product was purified by filtration from hot hexanes and the resulting filtrate concentrated to yield 2-(5-bromopyridin-3-yl)benzo[*d*]oxazole (6.423 g, 77 %) as an orangish-brown solid via recrystallization.

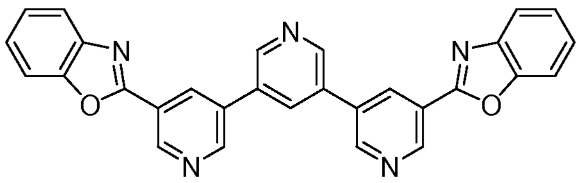

**Compound-11**

**5,5"-bis(benzo[*d*]oxazol-2-yl)-3,3':5',3"-terpyridine (Compound-11):** A mixture of 2-(5-bromopyridin-3-yl)benzo[*d*]oxazole (2.000 g, 6.208 mmol), 3,5-dibromopyridine (0.7003 g, 2.956 mmol), tetrakis(triphenylphosphine)palladium(0) (0.205 g, 0.177 mmol), $Na_2CO_3$ (3.18 g, 30.0 mmol), $H_2O$ (15 mL) and THF (25 mL) was degassed with argon for 27 min while stirring. The reaction mixture was then maintained under argon at 85 °C for 16 h. Upon cooling to RT, the reaction mixture was filtered and the filtrant washed copiously with $H_2O$ and methanol to provide **Compound-11** (1.36 g, 99 %) as an off-white solid.

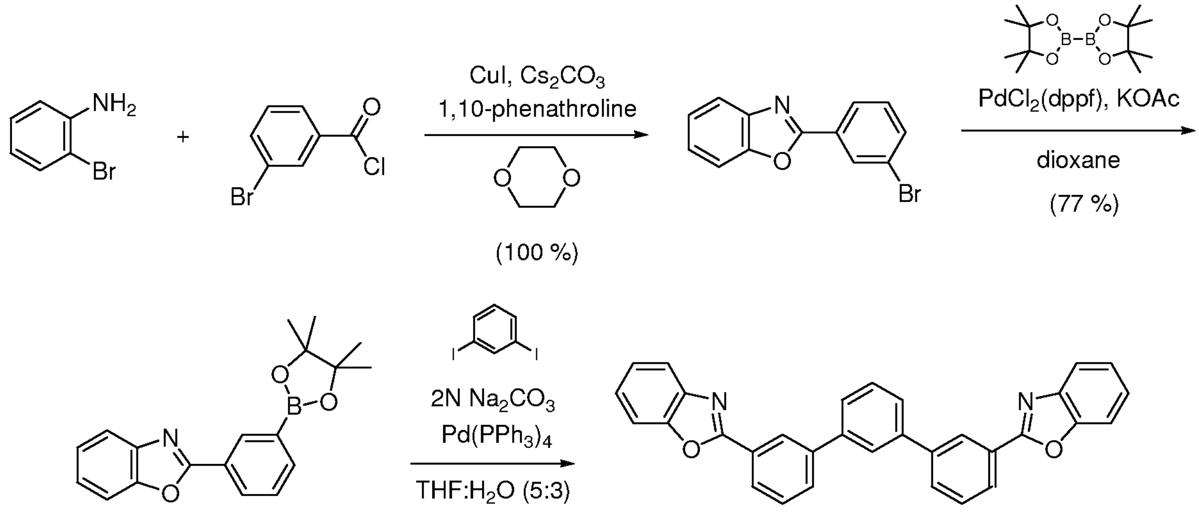


(63 %)

**Compound-12**

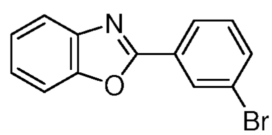

**2-(3-bromophenyl)benzo[d]oxazole:** A mixture of 3-bromobenzoyl chloride (6.005 g, 27.36 mmol), 2-bromoaniline (4.707 g, 27.36 mmol), $Cs_2CO_3$ (17.83 g, 54.73 mmol), CuI (0.261 g, 1.37 mmol), 1,10-phenanthroline (0.493 g, 2.74 mmol) and anhydrous 1,4-dioxane (50 mL) was degassed with argon at 40 °C for 30 min while stirring. The reaction mixture was then maintained under argon at 120 °C while stirring until TLC ($SiO_2$, 4:1 hexanes-ethyl acetate) confirmed consumption of the starting material (24 h). Upon cooling to RT, the mixture was filtered and the filtrant washed copiously with ethyl acetate (ca. 350 mL). The filtrate was then washed with sat. $NaHCO_3$, $H_2O$ and brine, dried over $MgSO_4$, filter and concentrated *in vacuo.* Purification of the crude product via flash chromatography ($SiO_2$, 4:1-hexanes:ethyl acetate) afforded 2-(3-bromophenyl)benzo[d]oxazole (7.50 g, 100 %) as an off-white solid.

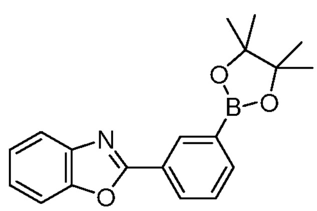

**2-(3-(4,4,5,5-tetramethyl-1,3,2-dioxaborolan-2-yl)phenyl)benzo[d]oxazole:** A mixture of 2-(3-bromophenyl)benzo[d]oxazole (7.500 g, 27.36 mmol), bis(pinacolato)diboron (7.296 g, 28.73 mmol), [1,1'-Bis(diphenylphosphino)ferrocene]dichloropalladium (1.001 g, 1.368 mmol), potassium acetate (6.176 g, 62.93 mmol) and anhydrous 1,4-dioxane (71 mL) was degassed with argon at 40 °C for 37 min while stirring. The reaction mixture was then maintained under argon at 100 °C while stirring until TLC ($SiO_2$, 2:1 hexanes-dichloromethane) confirmed consumption of the starting material (21 h). Upon cooling to RT, the mixture was filtered and the filtrate washed copiously with ethyl acetate (ca. 700 mL). The filtrate was then washed with sat. $NaHCO_3$, $H_2O$ and brine, dried over $MgSO_4$, filter and concentrated *in vacuo.* Purification of the crude product via flash chromatography ($SiO_2$, 9:1-dichloromethane:hexanes to 19:1-dichloromethane:acetone) afforded 2-(3-(4,4,5,5-tetramethyl-1,3,2-dioxaborolan-2-yl)phenyl)benzo[d]oxazole (6.76 g, 77 %) as an off-white solid.

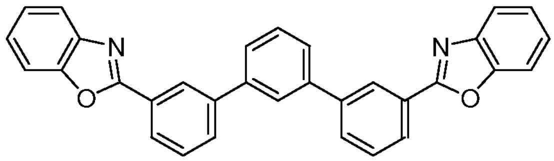

**3,3"-bis(benzo[*d*]oxazol-2-yl)-1,1':3',1"-terphenyl (Compound-12).** A mixture of 2-(3-(4,4,5,5-tetramethyl-1,3,2-dioxaborolan-2-yl)phenyl)benzo[d]oxazole (2.25 g, 7.01 mmol), 1,3-diiodobenzene (1.101 g, 3.337 mmol), tetrakis(triphenylphosphine)palladium(0) (0.193 g, 0.167 mmol), $Na_2CO_3$ (2.555 g, 24.11 mmol), $H_2O$ (24 mL) and THF (40 mL) was degassed with argon for 33 min while stirring. The reaction mixture was then maintained under argon at 80 °C while stirring until TLC ($SiO_2$, 9:1 hexanes-acetone) confirmed consumption of the starting material (22 h). Upon completion, the reaction was cooled to RT and poured over dichloromethane (ca. 350 mL). The resulting mixture was then filtered, the filtrate washed with sat. $NaHCO_3$, $H_2O$ and brine, dried over $MgSO_4$, filter and concentrated *in vacuo.* Purification of the crude product via flash chromatography ($SiO_2$, 19:1-dichloromethane:hexanes to 100 % dichloromethane) yielded **compound-12** (0.98 g, 63 %) as a light yellow solid.

Device examples

I-V-L characteristics were taken with a Keithley 2400 SourceMeter and Newport 2832-C power meter and 818 UV detector.

Control Example 1

OLED A (Device A) Preparation

OLED A **6401** was prepared according to the schematic shown in FIG. 63. OLED A **6401** included a cathode **6460** that was disposed on an electron-transport layer **6450,** that was disposed on emissive layer **6440,** that was disposed on a hole-transport layer **6430,** that was disposed on a hole-injection layer **6420,** that was disposed on an anode **6410,** that was disposed on a transparent substrate **6400.**

Although the layers of a device such as OLED A may comprise a variety of materials, in OLED A the cathode **6460** was LiF/Al, the electron-transport layer **6450** was TPBI, the emissive layer **6440** comprised about 5% PO-01 as emitter and Compound-10 as a host, the hole-transport layer **6430** was α-NPD, the hole-injection layer **6420** was PEDOT, the anode **6410** was ITO, and the transparent substrate **6400** was glass.

OLED A was prepared by the following procedure. The PEDOT hole injection layer was spin-coated on top of a pre-cleaned ITO/glass, followed by vacuum deposition of the 30 nm-thick α-NPD hole-transport layer at a deposition rate of about 1Å/s. The emissive layer was added by co-deposition of yellow emitter PO-01 and host Compound-10 at a deposition rate of about 0.05 and about 1 Å/s, respectively, to form an emissive layer having a thickness of about 30nm. Then TPBI was deposited at about 1 Å/s to a thickness of about 30nm. LiF was deposited on top of ETL at 0.1 Å/s deposition rate to a thickness of about 1nm, followed by the deposition of Al at 2 Å/s rate to a thickness of about 100nm. The base vacuum of the chamber was about $3x10^{-7}$ torr.

Comparative example 2

Device B **6501** was prepared according to the schematic shown in FIG. 64. A layer of α-NPD **6500** having a thickness of 50nm was coated onto the bottom surface of the transparent substrate **6400** of OLED A **6401.** The α-NPD layer **6500** was characterized by a smooth morphology.

Device B was prepared by the same procedure as Device A except that a 50-nm thickness α-NPD layer was deposited on the outer surface of the glass substrate at a deposition rate of about 2 Å/s under a vacuum of about 4 x $10^{-7}$ torr.

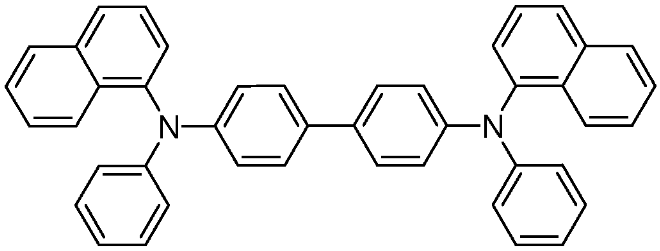

α-NPD

FIG. 65 is a plot of the power efficiency as a function of luminance (B) for OLED A as compared to Device B. The plot shows that Device B has about a 2% decrease in power efficiency as compared to OLED A over the luminance range obtained. Thus, a smooth layer of α-NPD did not appear to improve device efficiency.

Comparative Example 3

Device C **6701** was prepared according to the schematic shown in FIG. 66. A layer of COMPOUND-9 **6700** having a thickness of about 50 nm was coated onto the bottom surface of transparent substrate **6400** of OLED A **6401.** The layer **6700** of COMPOUND-9, depicted, in FIG. 67, was characterized by a regular nanostructure that was not highly porous.

Device C was prepared by the same procedure as Device A, except that a 600 nm-thick layer of COMPOUND-9 was deposited on top of the outer-face of the glass substrate at a deposition rate of about 2 Å/s under a vacuum of about 4 x $10^{-7}$ torr.

FIG. 68 is a plot of the power efficiency as a function of luminance (B) for OLED A as compared to Device C. The plot shows that Device C has a similar power efficiency to OLED A over the luminance range obtained. Thus, a regular nanostructure of COMPOUND-9 did not appear to improve device efficiency.

Device Example 1

Device D **7000** was prepared according to the schematic shown in FIG. 69. A layer **7010** of COMPOUND-2 having a thickness of 3 μm was coated onto the bottom surface of transparent substrate **6400** of OLED A **6401.** An SEM of the layer **7010** of COMPOUND-2 is depicted in FIG. 54 and described above.

Device D was prepared by the same procedure as Device A, except that a 600nm-thick layer of COMPOUND-2 was deposited on the outer surface of the glass substrate. The thickness was determined by a thickness sensor installed near the deposition source that records deposition rate. The thickness obtained by the thickness sensor relies upon the assumption that the film is dense. The material was deposited at a rate that corresponded to about of 2 Å/s of dense material under a vacuum of about 4 x $10^{-7}$ torr. SEM and thickness measurements showed that the deposited COMPOUND-2 layer is highly porous, and has a thickness of about 3 μm, which is about 5 times the thickness of a nonporous film.

FIG. 70 is a plot of the power efficiency as a function of luminance (B) for OLED A as compared to Device D. Over the entire range, the efficiency of Device D was nearly twice as high as OLED A. Thus, in this example, a porous film comprising a plurality of irregularly arranged nanoprotrusions or nanoparticles provided a substantial improvement in device efficiency.

Device Example 2

The power efficiency of a device similar to Device D was obtained with varying thickness of the COMPOUND-2 layer. FIG. 71 is a plot of the power efficiency at 1000 cd/m2 over a range of thickness of the COMPOUND-2 layer. FIG. 71 shows that PE efficiency is increased by a factor of about 1.94 at a thickness of about 3 μm or higher.

The light extraction efficiency from the transparent substrate by the porous film was determined by the following method. The experimental setup is depicted in FIG. 72.

The power efficiency of OLED A **6401** was obtained with only air **6405** between the glass substrate **6410** of the OLED device A and the surface of the light-detection sensor **6407** (Si photo diode), as shown in the left side of FIG.

72. Some light emitted from the emissive layer of the OLED will remained trapped inside the glass substrate (Glass-mode) due to the mismatch of refractive index of glass (n=1.5) and air (n=1).

OLED A was then immersed in an oil **6403** with an index of refraction of about 1.5, which is the same as the index of refraction of the transparent substrate. The oil **6403** filled the entire gap between the device **6401** and the light detection sensor **6407** (Si-photo diode), so all the light trapped within the glass passes through the glass-oil interface. Thus, the Si-photo diode detector receives the amount of light it would in the ideal case of 100% light extraction.

FIG. 73 is a plot of the efficiency of OLED A immersed in oil and obtained directly without immersion (Reference). The power efficiency of the immersed device is about twice the power efficiency of the device without the immersion (e.g. 2.18 times at 1000 cd/$m^2$). Assuming that all of the power efficiency of the immersed device represents the 100% light extraction from the transparent substrate, Device D has a light extraction efficiency of about 89% (e.g. 1.94/2.18 = 0.89).

FIG. 74 is a photograph of OLED A, illuminated (A), and Device D illuminated (B).

Device Example 3

COMPOUND-3 was deposited on a glass substrate. A photograph of the film on the substrate is indicated as slide 1 in FIG. 75. An SEM of this film is depicted in FIG. 76. The appearance of this SEM is similar to that of FIG. 51, and all of the shapes and dimensions recited with respect to FIG. 51 may apply to FIG. 76. At least some of the particles or protrusions in this film may have an x dimension of about 300 nm, a y dimension of about 50 nm, and/or a z dimension of about 50 nm.

COMPOUND-3 was also deposited on a glass substrate and then heated at about 200 °C for about 5 minutes. A photograph of this heated film is indicated as slide 2 in FIG. 75. An SEM of this film is depicted in FIG. 77. The appearance of this SEM is similar to that of FIG. 52, and all of the shapes and dimensions recited with respect to FIG. 51 may apply to FIG. 77. At least some of the particles or protrusions in this film may have an x dimension of about 800 nm, a y dimension of about 300 nm, and/or a z dimension of about 50 nm.

COMPOUND-3 was also deposited on a glass substrate and then heated at about 200 °C for about 30 minutes. A photograph of this heated film is indicated as slide 5 in FIG. 75. An SEM of this film is depicted in FIG. 78. The appearance of this SEM is similar to that of FIG. 53, and all of the shapes and dimensions recited with respect to FIG. 53 may apply to FIG. 78. At least some of the particles or protrusions in this film may have an x dimension of about 900 nm, a y dimension of about 300 nm, and/or a z dimension of about 50 nm.

COMPOUND-3 was also deposited on a glass substrate and then heated at about 240 °C for about 5 minutes. A photograph of this heated film is indicated as slide 6 in FIG. 75. An SEM of this film is depicted in FIG. 79. The appearance of this SEM is similar to that of FIG. 6, and all of the shapes and dimensions recited with respect to FIG. 6 may apply to FIG. 79. At least some of the particles or protrusions in this film may have an x dimension of about 2200 nm, a y dimension of about 1200 nm, and/or a z dimension of about 50 nm.

COMPOUND-3 was also deposited on a glass substrate and then heated at about 300 °C for about 5 minutes. This appears to have caused a substantial amount of the film to evaporate. A photograph of this heated film is indicated as slide 7 in FIG. 75.

Films prepared as described above were coated onto the exterior surface of the transparent substrate of OLED A and the power efficiency was measured as a function of luminance, as shown in FIG. 80. The plot shows that deposition of COMPOUND-3 and heating at about 200 to about 240 °C for about 5 to about 30 minutes, or more, provides a film with a significant porous film effect such that the efficiency of the device is substantially improved. For example, heating the film at about 200 °C for about 30 minutes improved the power efficiency by about 1.82 times at about 2000 cd/$m^2$ luminance.

Device Example 4

COMPOUND-2 was coated on a polyethylene terephthalate (PET) flexible substrate through vacuum deposition by the same method as the COMPOUND-2 layer on the Device D to form a layer having a thickness of about 6um. The substrate with the coating was heated at 110 °C for 1 hour. FIG. 81 is a photograph of this coated flexible substrate.

The coated flexible substrate was coupled to OLED A using the refractive index matching oil to obtain Device E. FIG. 82 is a plot of the power efficiency as a function of luminance of Device E as compared to OLED A. Device E, with the porous film, has significantly higher efficiency than OLED A without the porous film. For example, the power efficiency of Device E is 1.8 times greater than OLED A at 2000 cd/$m^2$.

Device Example 5

Device F

As described with respect to FIG 62. The light-scattering layer (COMPOUND LAYER, 3 um thickness, 110 °C for 1 hour) was deposited on top of transparent substrate (glass). This light-scattering film was then coupled to the bottom of Device A using refractive index matching oil as a coupling medium to form Device F.

Device G

An encapsulation or protection layer was added to Device F as follows to provide Device G: an epoxy resin was applied around the edge of the light scattering layer, which upon curing built a gap between the transparent substrate and the encapsulation/protection layer that is another transparent cover glass.

Fig. 83 is a plot of the power efficiency as a function of luminance for OLED A, Device F, and Device G. This plot shows that encapsulated device (Device G) shows similar light-outcoupling efficiency as the device (Device F) that is not encapsulated.

## Claims

**1.** A light-emitting device comprising:

a porous film disposed over an anode or a cathode; and
wherein the porous film has a refractive index that is lower than a refractive index of the anode and a refractive index of the cathode; and the porous film comprises at least one compound selected from the group consisting of:

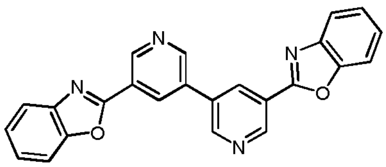 , 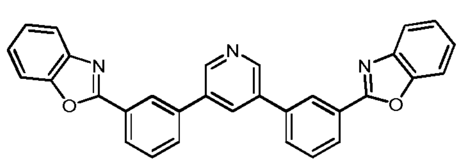 ,

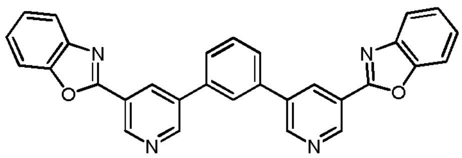 , 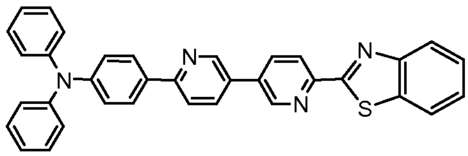 ,

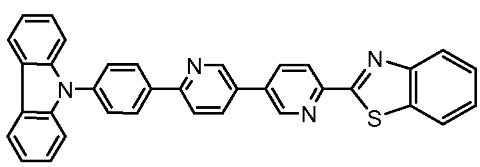 , 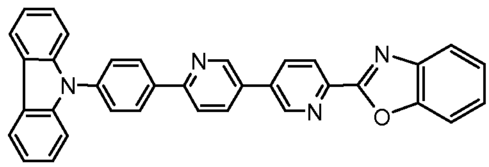 ,

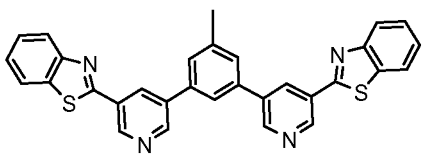 , 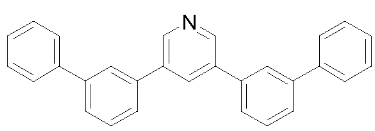 ,

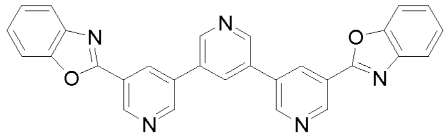 , and 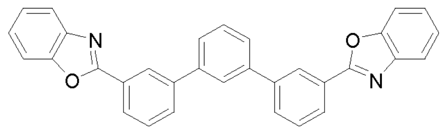 .

2. The light-emitting device of claim 1, further comprising an emissive layer disposed between the anode and the cathode.

3. The light-emitting device of claim 1 or 0, wherein the porous film is disposed on the anode or the cathode.

4. The light-emitting device of claim 1 or 0, further comprising a transparent layer between the porous film and the anode or between the porous film and the cathode.

5. The light-emitting device of claim 0, wherein a refractive index of the transparent layer is higher than the refractive index of the porous film.

6. The light-emitting device of any one of claims 1-5, wherein the porous film comprises:

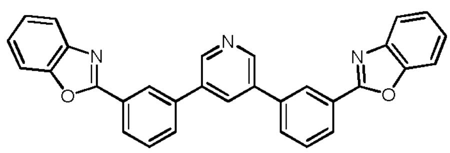

.

7. The light-emitting device of any one of claims 1-5, wherein the porous film comprises:

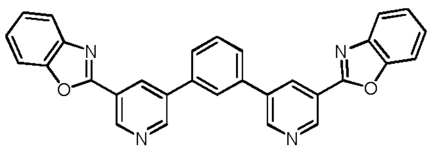

.

8. A light-emitting device comprising:

a porous film comprising:

a first interface with a partially internally reflective layer in the light-emitting device, wherein a refractive index of the partially internally reflective layer is higher than a refractive index of the porous film;
a second interface with a substance that has a refractive index that is lower than the refractive index of the porous film; and

wherein the second interface comprises a plurality of irregularly arranged nanoprotrusions or nanoparticles.

9. The light-emitting device of claim 8, wherein the nanoprotrusions or nanoparticles have an average x dimension in the range of about 400 nm to about 3000 nm.

10. The light-emitting device of claim 8 or 9, wherein the nanoprotrusions or nanoparticles have an average z dimension in the range of about 10 nm to about 100 nm.

11. The light-emitting device of claim 10, wherein the nanoprotrusions or nanoparticles have an average y dimension in the range of about 100 nm to about 2000 nm.

12. The light-emitting device of claim 8, wherein the nanoprotrusions or nanoparticles comprise nanoflakes.

13. The light-emitting device of claim 8, wherein the porous film has a thickness in the range of about 0.1 μm to about 10 μm.

**14.** The light-emitting device of claim 8, wherein the porous film has a thickness in the range of about 1 μm to about 5 μm.

**15.** The light-emitting device of any one of claims 8-14, wherein the porous solid comprises a plurality of pores having a total volume which is from about 50% to about 99% of the volume of the porous solid.

**16.** A method of preparing a porous film for a light-emitting device comprising:

depositing an organic film on an anode or a cathode; and
heating the organic film at a temperature in the range of about 100 °C to about 290 °C.

**17.** The method of claim 16, wherein heating the organic film comprises heated at a temperature in the range of about 200 °C to about 260 °C.

**18.** The method of claim 16 or 17, wherein depositing the organic film is carried out at a rate of about 0.1 Å/sec to about 1000 Å/sec.

**19.** A porous film comprising:

a non-polymeric organic compound having a refractive index in the range of about 1.1 to about 1.8;
a plurality of irregularly arranged nanoprotrusions, nanoparticles, or aggregates thereof;
a plurality of voids having a total volume that is at least about 50% of the volume of the film, and at least about 10% of the plurality of voids have a longest dimension in the range of about 0.5 μm to about 5 μm;
wherein the porous film has a thickness in the range of about 500 nm to about 20 microns; and
wherein the density of the porous film including the voids is about 0.5 picograms/$\mu m^3$ or less.

**20.** The porous film of claim 19 wherein the non-polymeric organic compound comprises an aromatic ring.

**21.** The porous film of claim 19 wherein at least a portion of the nanoprotrusions, nanoparticles or aggregates thereof are substantially rectangular, substantially square, substantially parallelogramatic, pseudo-parallelogramatic, or have at least one substantially right angle when viewed in the xy plane.

**22.** The porous film of claim 19 wherein at least a portion of the nanoprotrusions, nanoparticles or aggregates thereof are substantially elliptical, substantially circular, or substantially oval when viewed in the xy plane, the xy plane, or the yz plane.

**23.** The porous film of claim 19 wherein at least a portion of the nanoprotrusions, nanoparticles or aggregates thereof are substantially linear when viewed in the yz plane.

**24.** The porous film of claim 19 wherein at least a portion of the nanoprotrusions, nanoparticles or aggregates thereof are nanoflakes, pseudoplanar, or ribbon-shaped.

**25.** The porous film of claim 19 wherein at least a portion of the nanoprotrusions, nanoparticles or aggregates thereof are needlelike or fiber-shaped.

**26.** The porous film of claim 19 wherein at least a portion of the nanoprotrusions, nanoparticles or aggregates thereof are rod-shaped or capsule-shaped

**27.** The porous film of claim 19 wherein at least a portion of the nanoprotrusions, nanoparticles or aggregates thereof are granular.

## Patentansprüche

**1.** Lichtemittierende Vorrichtung, umfassend:

einen porösen Film, der über einer Anode oder einer Kathode angeordnet ist; und
wobei der poröse Film einen Brechungsindex hat, der niedriger als ein Brechungsindex der Anode und ein Brechungsindex der Kathode ist; und wobei der poröse Film zumindest eine Verbindung umfasst, ausgewählt

aus der Gruppe bestehend aus:

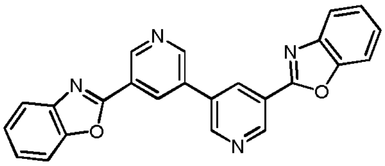,
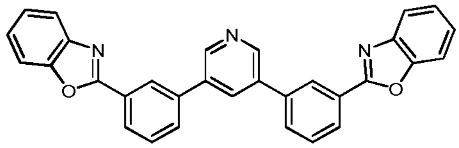,
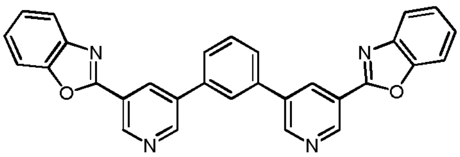,
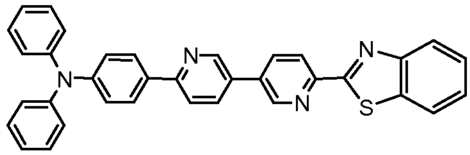,
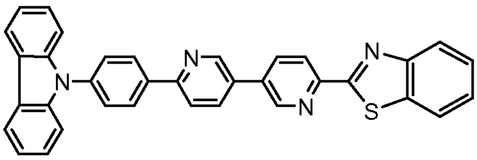,
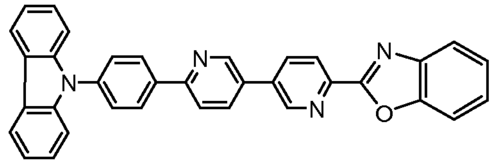,
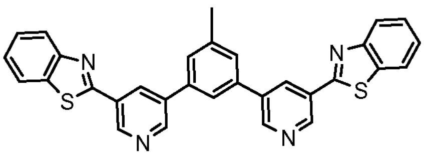,
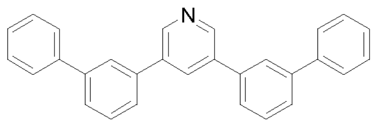,
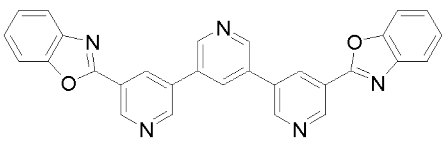 und 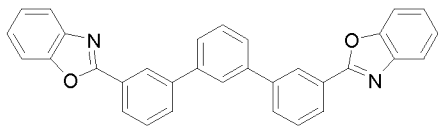.

2. Lichtemittierende Vorrichtung nach Anspruch 1, ferner umfassend eine emittierende Schicht, die zwischen der Anode und der Kathode angeordnet ist.

3. Lichtemittierende Vorrichtung nach Anspruch 1 oder 2, wobei der poröse Film an der Anode oder der Kathode angeordnet ist.

4. Lichtemittierende Vorrichtung nach Anspruch 1 oder 2, ferner umfassend eine transparente Schicht zwischen dem porösen Film und der Anode oder zwischen dem porösen Film und der Kathode.

5. Lichtemittierende Vorrichtung nach Anspruch 4, wobei ein Brechungsindex der transparenten Schicht höher als der Brechungsindex des porösen Films ist.

6. Lichtemittierende Vorrichtung nach einem der Ansprüche 1-5, wobei der poröse Film Folgendes umfasst:

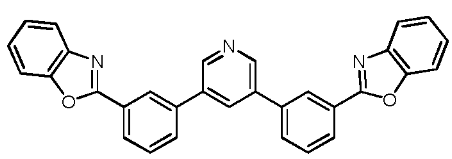.

7. Lichtemittierende Vorrichtung nach einem der Ansprüche 1-5, wobei der poröse Film Folgendes umfasst:

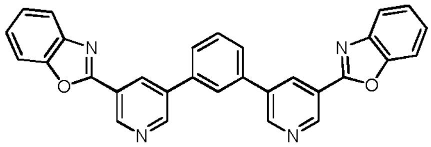

.

8. Lichtemittierende Vorrichtung, umfassend:

einen porösen Film, umfassend:

eine erste Grenzfläche mit einer teilweise intern reflektierenden Schicht in der lichtemittierenden Vorrichtung, wobei ein Brechungsindex der teilweise intern reflektierenden Schicht höher als ein Brechungsindex des porösen Films ist;
eine zweite Grenzfläche mit einer Substanz, die einen Brechungsindex hat, der niedriger als der Brechungsindex des porösen Films ist; und

wobei die zweite Grenzfläche eine Vielzahl von unregelmäßig angeordneten Nanovorsprüngen oder Nanopartikeln umfasst.

9. Lichtemittierende Vorrichtung nach Anspruch 8, wobei die Nanovorsprünge oder Nanopartikel eine mittlere x-Abmessung in dem Bereich von etwa 400 nm bis etwa 3000 nm haben.

10. Lichtemittierende Vorrichtung nach Anspruch 8 oder 9, wobei die Nanovorsprünge oder Nanopartikel eine mittlere z-Abmessung in dem Bereich von etwa 10 nm bis etwa 100 nm haben.

11. Lichtemittierende Vorrichtung nach Anspruch 10, wobei die Nanovorsprünge oder Nanopartikel eine mittlere y-Abmessung in dem Bereich von etwa 100 nm bis etwa 2000 nm haben.

12. Lichtemittierende Vorrichtung nach Anspruch 8, wobei die Nanovorsprünge oder Nanopartikel Nanoblätter umfassen.

13. Lichtemittierende Vorrichtung nach Anspruch 8, wobei der poröse Film eine Dicke in dem Bereich von etwa 0,1 μm bis etwa 10 μm hat.

14. Lichtemittierende Vorrichtung nach Anspruch 8, wobei der poröse Film eine Dicke in dem Bereich von etwa 1 μm bis etwa 5 μm hat.

15. Lichtemittierende Vorrichtung nach einem der Ansprüche 8-14, wobei der poröse Feststoff eine Vielzahl von Poren umfasst, die ein Gesamtvolumen haben, das etwa 50 % bis etwa 99 % des Volumens des porösen Feststoffs beträgt.

16. Verfahren zum Herstellen eines porösen Films für eine lichtemittierende Vorrichtung, umfassend:

Aufbringen eines organischen Films auf eine Anode oder eine Kathode; und
Erhitzen des organischen Films bei einer Temperatur in dem Bereich von etwa 100 °C bis etwa 290 °C.

17. Verfahren nach Anspruch 16, wobei das Erhitzen des organischen Films ein Erhitzen bei einer Temperatur in dem Bereich von etwa 200 °C bis etwa 260 °C umfasst.

18. Verfahren nach Anspruch 16 oder 17, wobei das Aufbringen des organischen Films bei einer Rate von etwa 0,1 Å/s bis etwa 1000 Å/s durchgeführt wird.

19. Poröser Film, umfassend:

eine nicht-polymere organische Verbindung mit einem Brechungsindex in dem Bereich von etwa 1,1 bis etwa 1,8;
eine Vielzahl von unregelmäßig angeordneten Nanovorsprüngen, Nanopartikeln oder Aggregaten davon;
eine Vielzahl von Hohlräumen mit einem Gesamtvolumen, das zumindest etwa 50 % des Volumens des Films beträgt, und wobei zumindest etwa 10 % der Vielzahl von Hohlräumen eine längste Abmessung in dem Bereich

von etwa 0,5 μm bis etwa 5 μm haben;
wobei der poröse Film eine Dicke in dem Bereich von etwa 500 nm bis etwa 20 Mikron hat; und
wobei die Dichte des porösen Films einschließlich der Hohlräume etwa 0,5 Pikogramm/$\mu m^3$ oder weniger beträgt.

**20.** Poröser Film nach Anspruch 19, wobei die nicht-polymere organische Verbindung einen aromatischen Ring umfasst.

**21.** Poröser Film nach Anspruch 19, wobei zumindest ein Teil der Nanovorsprünge, Nanopartikel oder Aggregate davon im Wesentlichen rechteckig, im Wesentlichen quadratisch, im Wesentlichen parallelogrammartig, pseudo-parallelogrammartig ist oder zumindest einen im Wesentlichen rechten Winkel hat, wenn die Betrachtung in der xy-Ebene erfolgt.

**22.** Poröser Film nach Anspruch 19, wobei zumindest ein Teil der Nanovorsprünge, Nanopartikel oder Aggregate davon im Wesentlichen elliptisch, im Wesentlichen kreisförmig oder im Wesentlichen oval ist, wenn die Betrachtung in der xy-Ebene, der xy-Ebene oder der yz-Ebene erfolgt.

**23.** Poröser Film nach Anspruch 19, wobei zumindest ein Teil der Nanovorsprünge, Nanopartikel oder Aggregate davon im Wesentlichen linear ist, wenn die Betrachtung in der yz-Ebene erfolgt.

**24.** Poröser Film nach Anspruch 19, wobei zumindest ein Teil der Nanovorsprünge, Nanopartikel oder Aggregate davon Nanoblätter sind, pseudoplanar oder bandförmig ist.

**25.** Poröser Film nach Anspruch 19, wobei zumindest ein Teil der Nanovorsprünge, Nanopartikel oder Aggregate davon nadelartig oder faserförmig ist.

**26.** Poröser Film nach Anspruch 19, wobei zumindest ein Teil der Nanovorsprünge, Nanopartikel oder Aggregate davon stangenförmig oder kapselförmig ist.

**27.** Poröser Film nach Anspruch 19, wobei zumindest ein Teil der Nanovorsprünge, Nanopartikel oder Aggregate davon granular ist.

## Revendications

**1.** Dispositif émettant une lumière comprenant :

un film poreux disposé par-dessus une anode ou une cathode ; et
le film poreux ayant un indice de réfraction qui est inférieur à un indice de réfraction de l'anode et à un indice de réfraction de la cathode ; et le film poreux comprenant au moins un composant sélectionné dans le groupe constitué de :

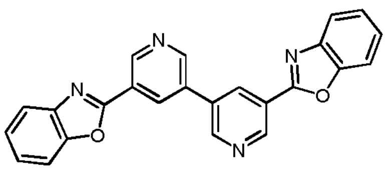
,
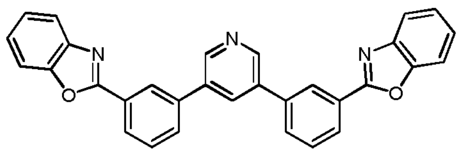
,
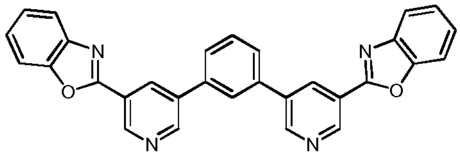
,
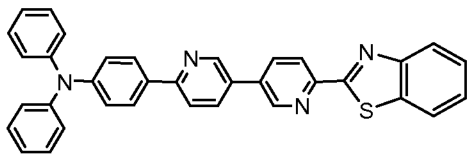
,

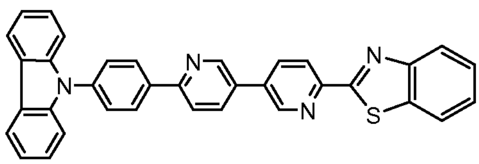,
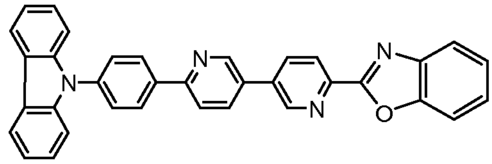,

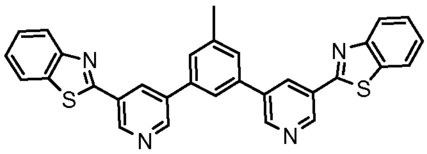,
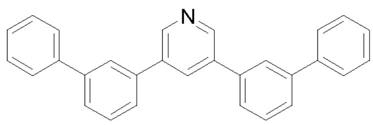,

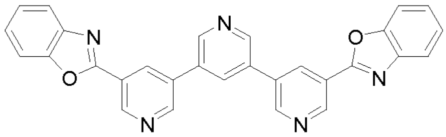, et
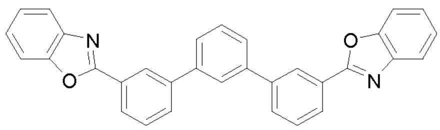.

**2.** Dispositif émettant une lumière selon la revendication 1, comprenant en outre une couche émissive disposée entre l'anode et la cathode.

**3.** Dispositif émettant une lumière selon la revendication 1 ou 2, dans lequel le film poreux est disposé sur l'anode ou la cathode.

**4.** Dispositif émettant une lumière selon la revendication 1 ou 2, comprenant en outre une couche transparente entre le film poreux et l'anode ou entre le film poreux et la cathode.

**5.** Dispositif émettant une lumière selon la revendication 4, dans lequel un indice de réfraction de la couche transparente est supérieur à l'indice de réfraction du film poreux.

**6.** Dispositif émettant une lumière selon l'une quelconque des revendications 1-5, dans lequel le film poreux comprend :

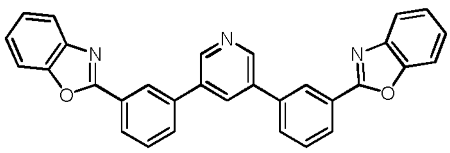.

**7.** Dispositif émettant une lumière selon l'une quelconque des revendications 1-5, dans lequel le film poreux comprend :

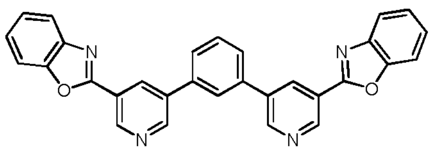.

**8.** Dispositif émettant une lumière, comprenant :

un film poreux comprenant :

une première interface ayant une couche partiellement réfléchissante intérieurement dans le dispositif émettant une lumière, où un indice de réfraction de la couche partiellement réfléchissante intérieurement est supérieur à un indice de réfraction du film poreux ;
une deuxième interface ayant une substance qui a un indice de réfraction qui est inférieur à l'indice de réfraction du film poreux ; et

dans lequel la deuxième interface comprend une pluralité de nano-saillies ou de nano-particules disposées irrégulièrement.

**9.** Dispositif émettant une lumière selon la revendication 8, dans lequel les nano-saillies ou nano-particules ont une dimension x moyenne dans la gamme d'environ 400 nm à environ 3000 nm.

**10.** Dispositif émettant une lumière selon la revendication 8 ou 9, dans lequel les nano-saillies ou nano-particules ont une dimension z moyenne dans la gamme d'environ 10 nm à environ 100 nm.

**11.** Dispositif émettant une lumière selon la revendication 10, dans lequel les nano-saillies ou nano-particules ont une dimension y dans la gamme d'environ 100 nm à environ 2000 nm.

**12.** Dispositif émettant une lumière selon la revendication 8, dans lequel les nano-saillies ou nano-particules comprennent des nano-paillettes.

**13.** Dispositif émettant une lumière selon la revendication 8, dans lequel le film poreux a une épaisseur dans la gamme d'environ 0,1 $\mu$m à environ 10 $\mu$m.

**14.** Dispositif émettant une lumière selon la revendication 8, dans lequel le film poreux a une épaisseur dans la gamme d'environ 1 $\mu$m à environ 5 $\mu$m.

**15.** Dispositif émettant une lumière selon l'une quelconque des revendications 8-14, dans lequel le solide poreux comprend une pluralité de pores ayant un volume total qui est d'environ 50% à environ 99% du volume du solide poreux.

**16.** Procédé de préparation d'un film poreux pour un dispositif émettant une lumière, comprenant :

le dépôt d'un film organique sur une anode ou une cathode ; et
le chauffage du film organique à une température dans la gamme d'environ 100 °C à environ 290 °C.

**17.** Procédé selon la revendication 16, dans lequel le chauffage du film organique comprend le chauffage à une température dans la gamme de 200 °C à environ 260 °C.

**18.** Procédé selon la revendication 16 ou 17, dans lequel le dépôt du film organique est effectué à un taux d'environ 0,1 Å/sec à environ 1000 Å/sec.

**19.** Film poreux comprenant :

un composant organique non polymérique ayant un indice de réfraction dans la gamme d'environ 1,1 à environ 1,8 ;
une pluralité de nano-saillies, de nano-particules ou de leurs agrégats disposés irrégulièrement ;
une pluralité de vides ayant un volume total qui est d'au moins environ 50 % du volume du film, et au moins environ 10 % de la pluralité de vides ont une dimension la plus longue dans la gamme d'environ 0,5 $\mu$m à environ 5 $\mu$m ;
le film poreux ayant une épaisseur dans la gamme d'environ 500 nm à environ 20 microns ; et
la masse volumique du film poreux, y compris les vides, étant d'environ 0,5 picogrammes/$\mu m^3$ ou moins.

**20.** Film poreux selon la revendication 19, dans lequel le composé organique non polymérique comprend un noyau aromatique.

**21.** Film poreux selon la revendication 19, dans lequel au moins une partie des nano-saillies, des nano-particules ou de leurs agrégats ont essentiellement une forme de carré, de rectangle, de parallélogramme, de pseudo-parallélogramme, ou ont au moins un angle essentiellement droit, vus dans le plan xy.

**22.** Film poreux selon la revendication 19, dans lequel au moins une partie des nano-saillies, des nano-particules ou de leurs agrégats ont une forme essentiellement elliptique, essentiellement circulaire ou essentiellement ovale, vus dans le plan xy, le plan xy ou le plan yz.

**23.** Film poreux selon la revendication 19, dans lequel au moins une partie des nano-saillies, des nano-particules ou

de leurs agrégats sont essentiellement linéaires, vus dans le plan yz.

**24.** Film poreux selon la revendication 19, dans lequel au moins une partie des nano-saillies, des nano-particules ou de leurs agrégats sont des nano-paillettes, pseudo-plans, ou en forme de ruban.

**25.** Film poreux selon la revendication 19, dans lequel au moins une partie des nano-saillies, des nano-particules ou de leurs agrégats sont en forme d'aiguille ou de fibre.

**26.** Film poreux selon la revendication 19, dans lequel au moins une partie des nano-saillies, des nano-particules ou de leurs agrégats sont en forme de tige ou de capsule.

**27.** Film poreux selon la revendication 19, dans lequel au moins une partie des nano-saillies, des nano-particules ou de leurs agrégats sont granulaires.

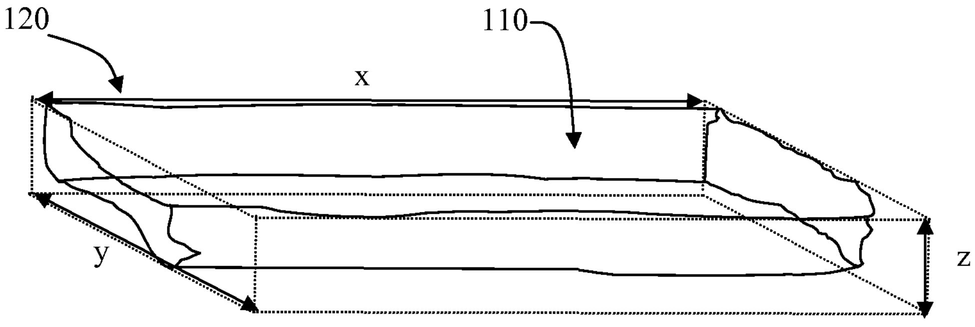


FIG. 1

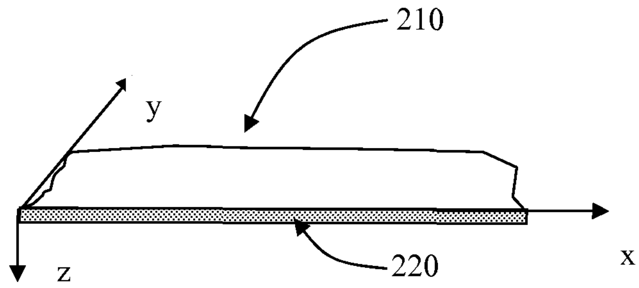


FIG. 2A

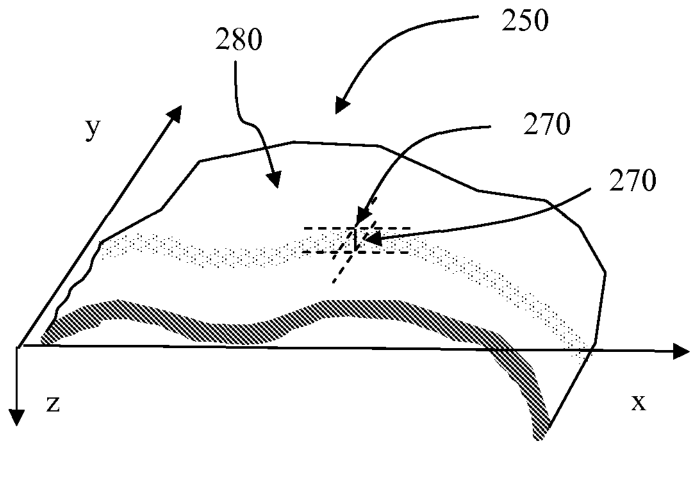


FIG. 2B

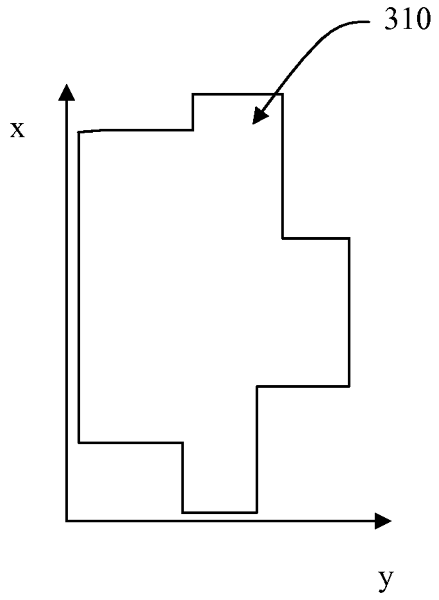


FIG. 3

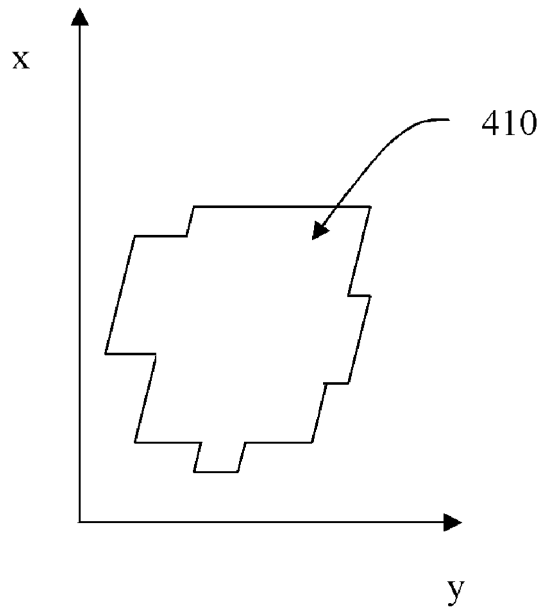


FIG. 4

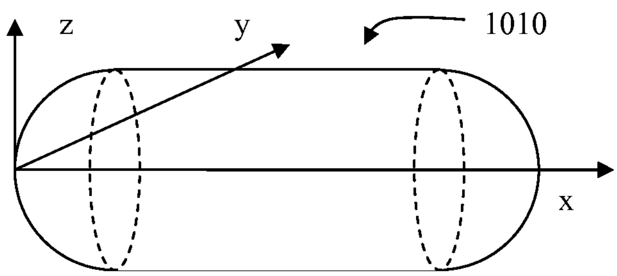


FIG. 5

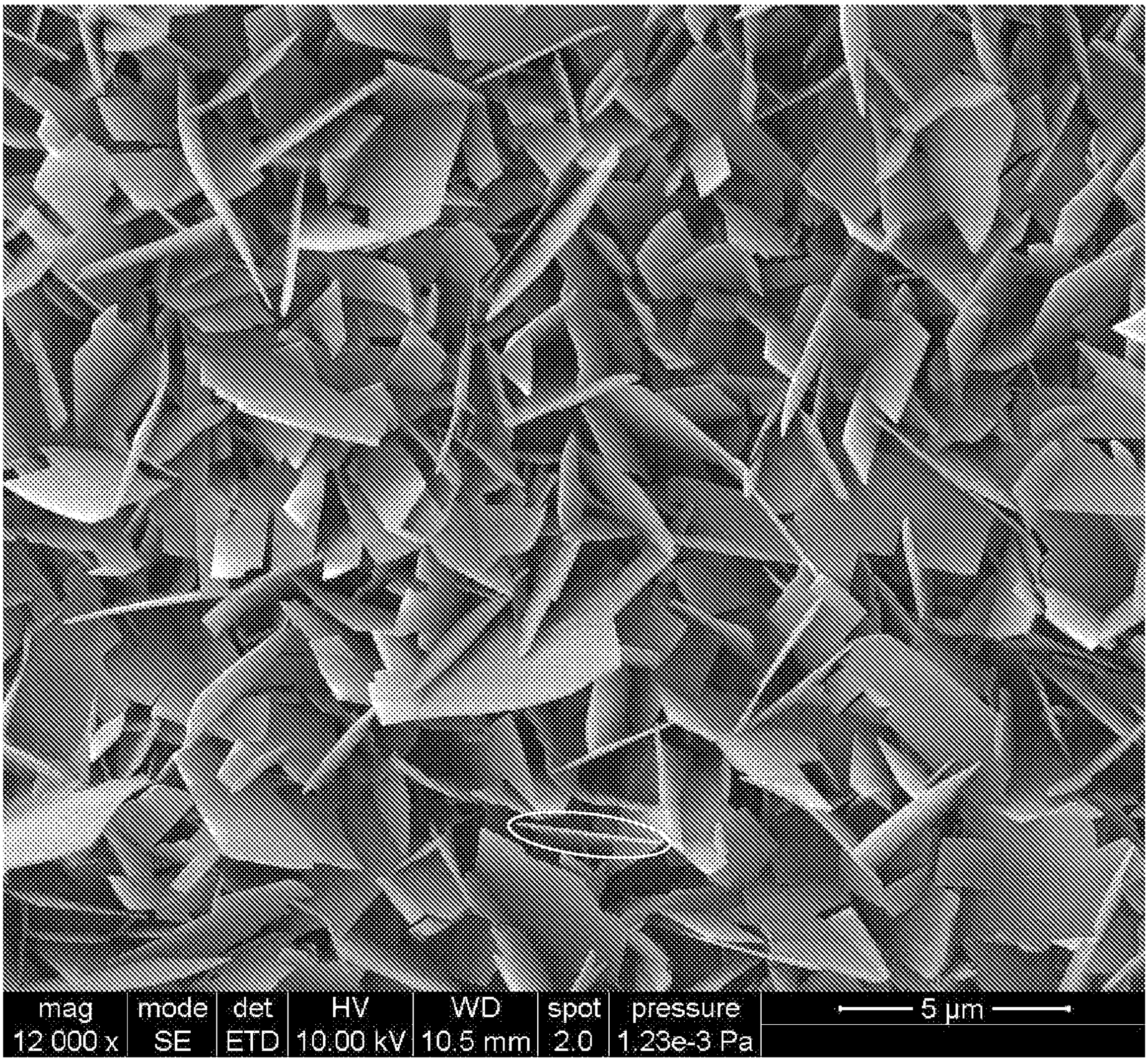
mag
12 000 x
mode
SE
det
ETD
HV
10.00 kV
WD
10.5 mm
spot
2.0
pressure
1.23e-3 Pa
5 µm

FIG. 6

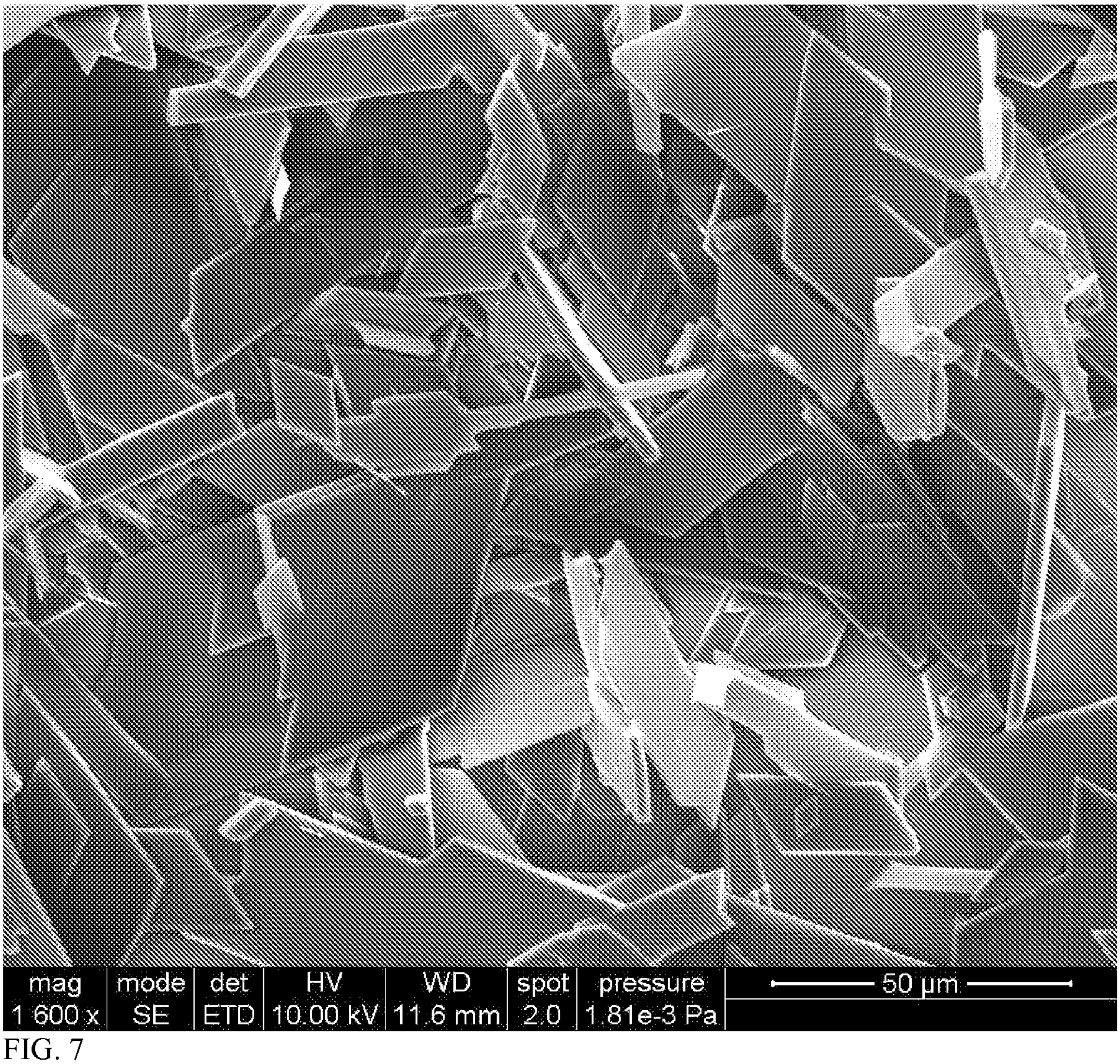
mag
1 600 x
mode
SE
det
ETD
HV
10.00 kV
WD
11.6 mm
spot
2.0
pressure
1.81e-3 Pa
50 µm
FIG. 7

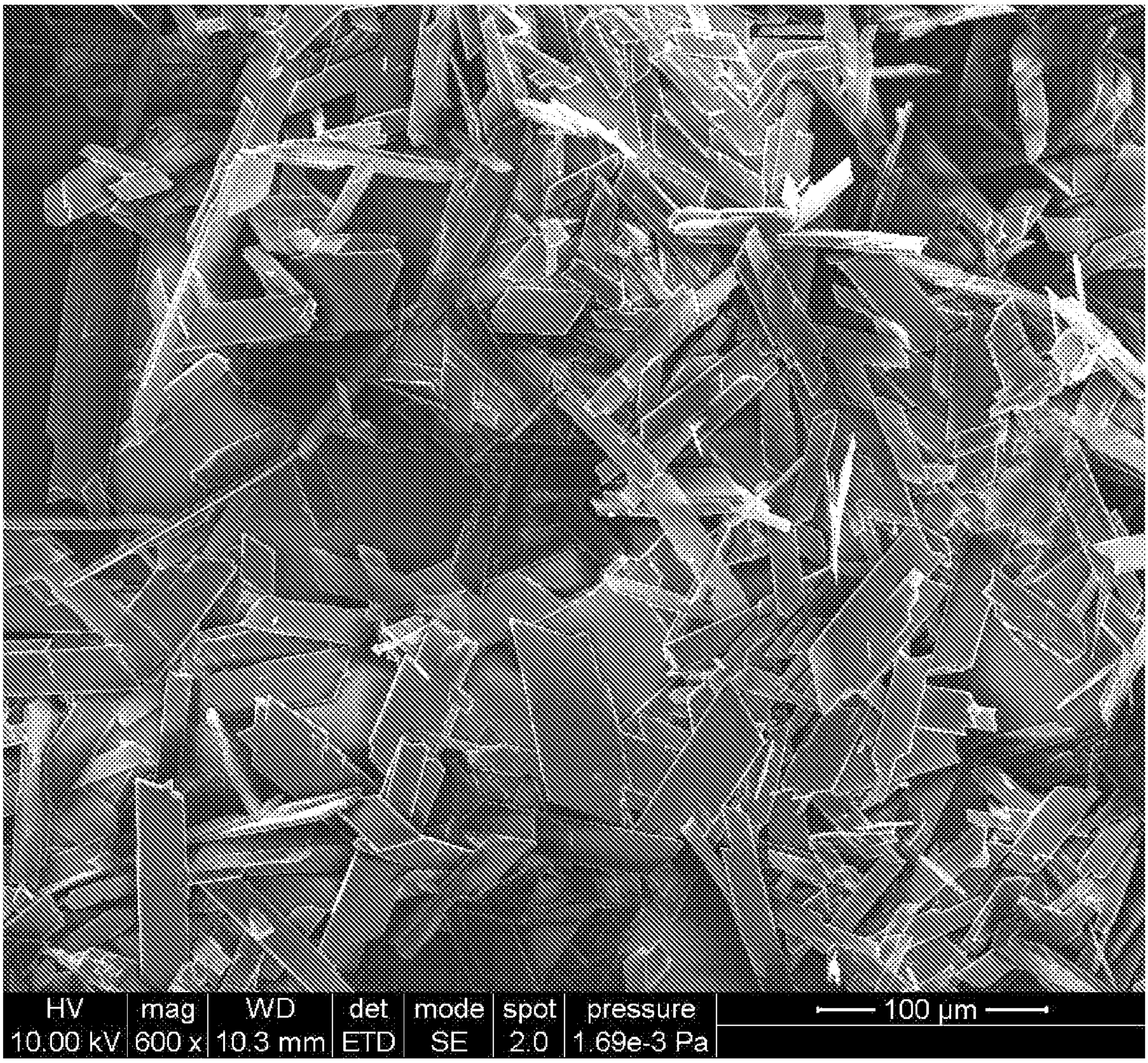
HV
mag
WD
det
mode
spot
pressure
100 μm
10.00 kV
600 x
10.3 mm
ETD
SE
2.0
1.69e-3 Pa
FIG. 8

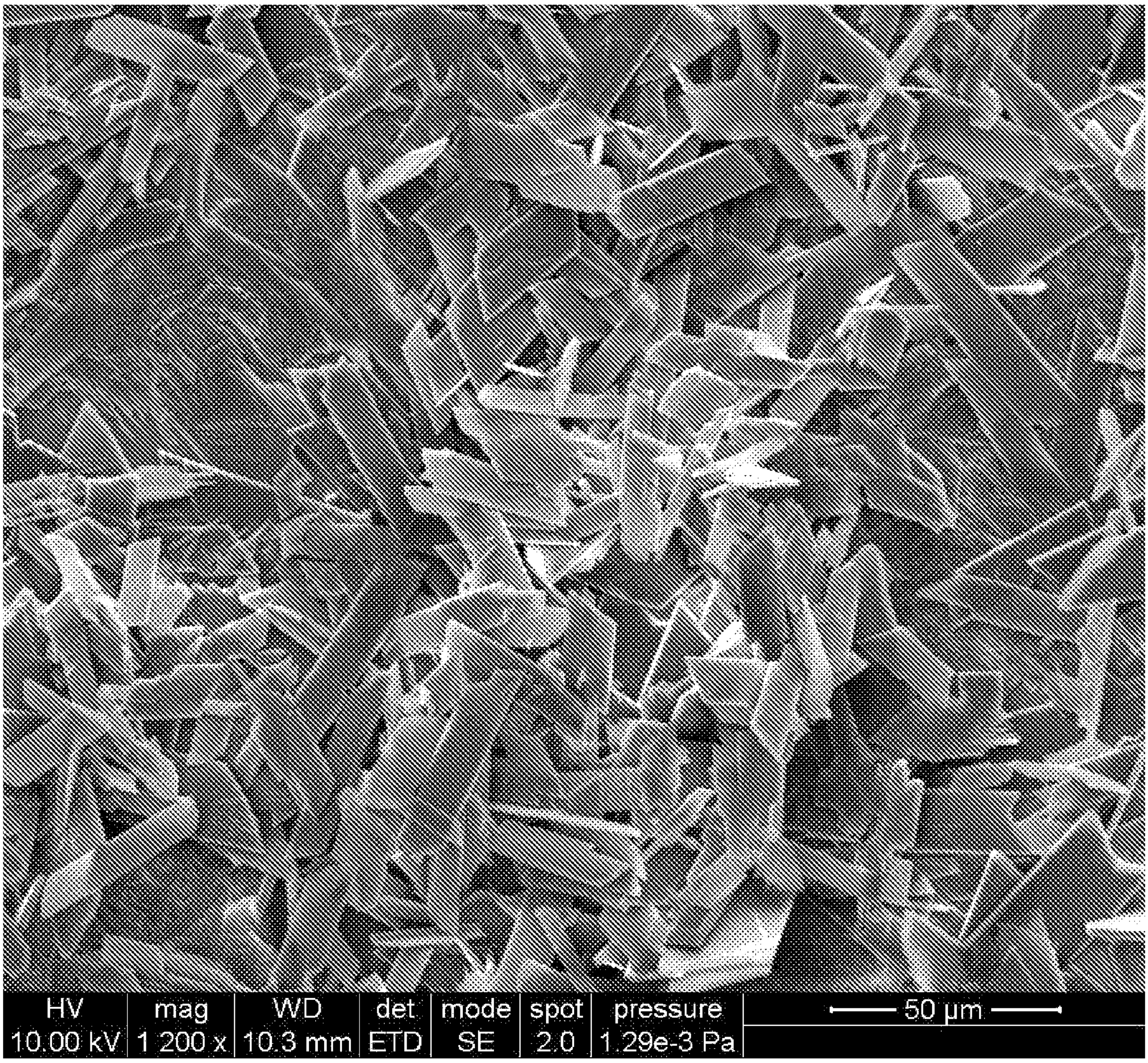
HV
10.00 kV
mag
1 200 x
WD
10.3 mm
det
ETD
mode
SE
spot
2.0
pressure
1.29e-3 Pa
50 µm
FIG. 9

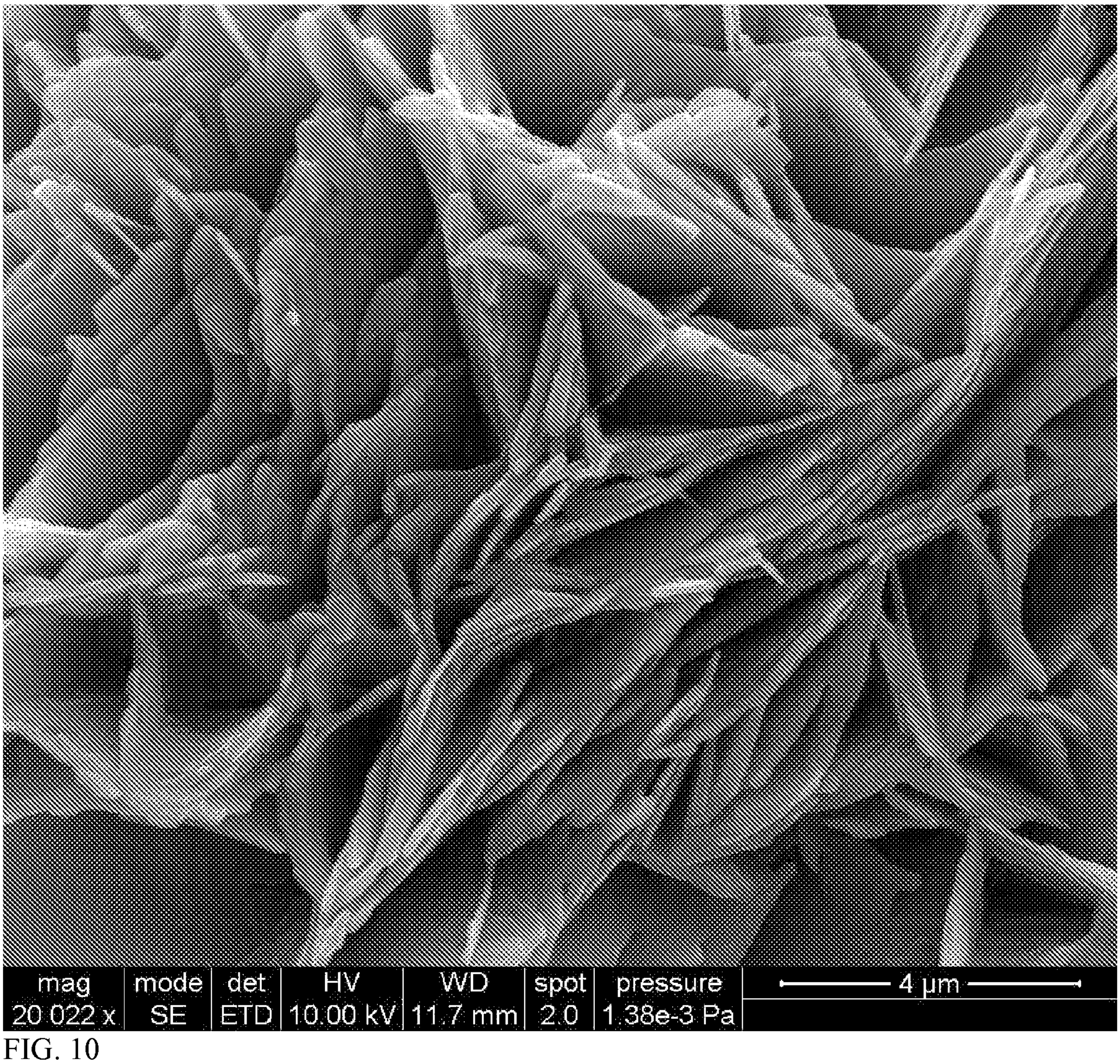
mag
20 022 x
mode
SE
det
ETD
HV
10.00 kV
WD
11.7 mm
spot
2.0
pressure
1.38e-3 Pa
4 μm
FIG. 10

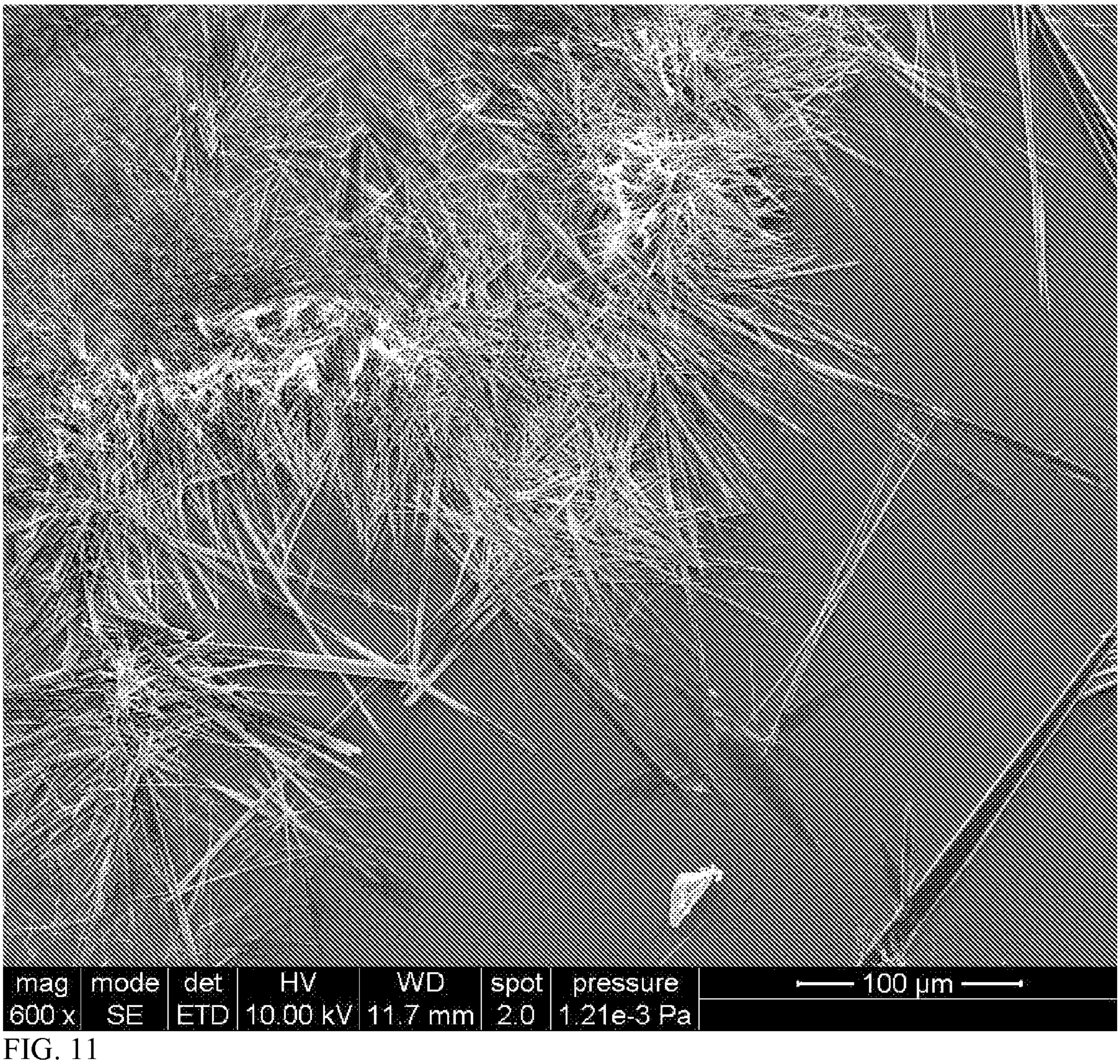
mag 600 x
mode SE
det ETD
HV 10.00 kV
WD 11.7 mm
spot 2.0
pressure 1.21e-3 Pa
100 μm

FIG. 11

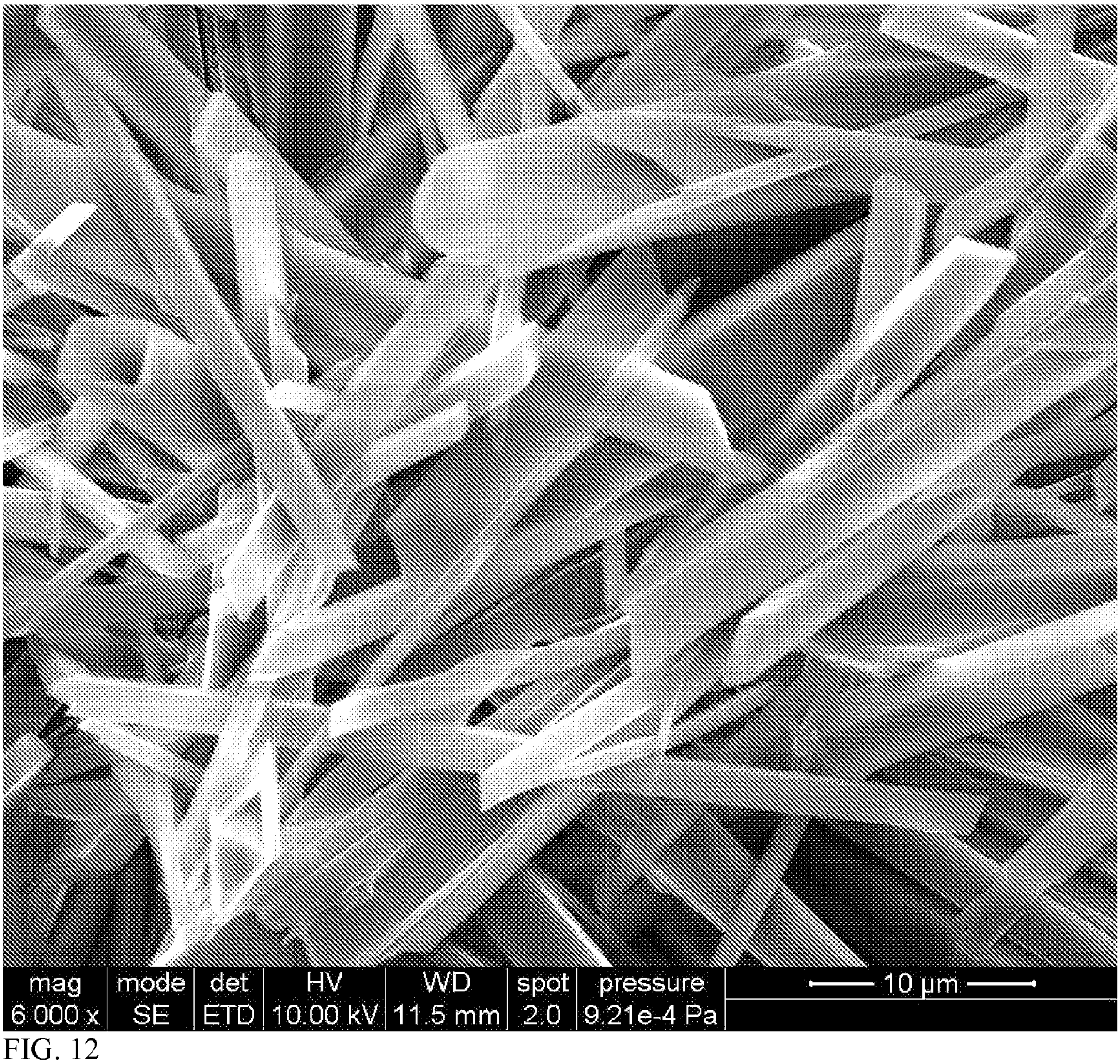
mag
6 000 x
mode
SE
det
ETD
HV
10.00 kV
WD
11.5 mm
spot
2.0
pressure
9.21e-4 Pa
10 μm
FIG. 12

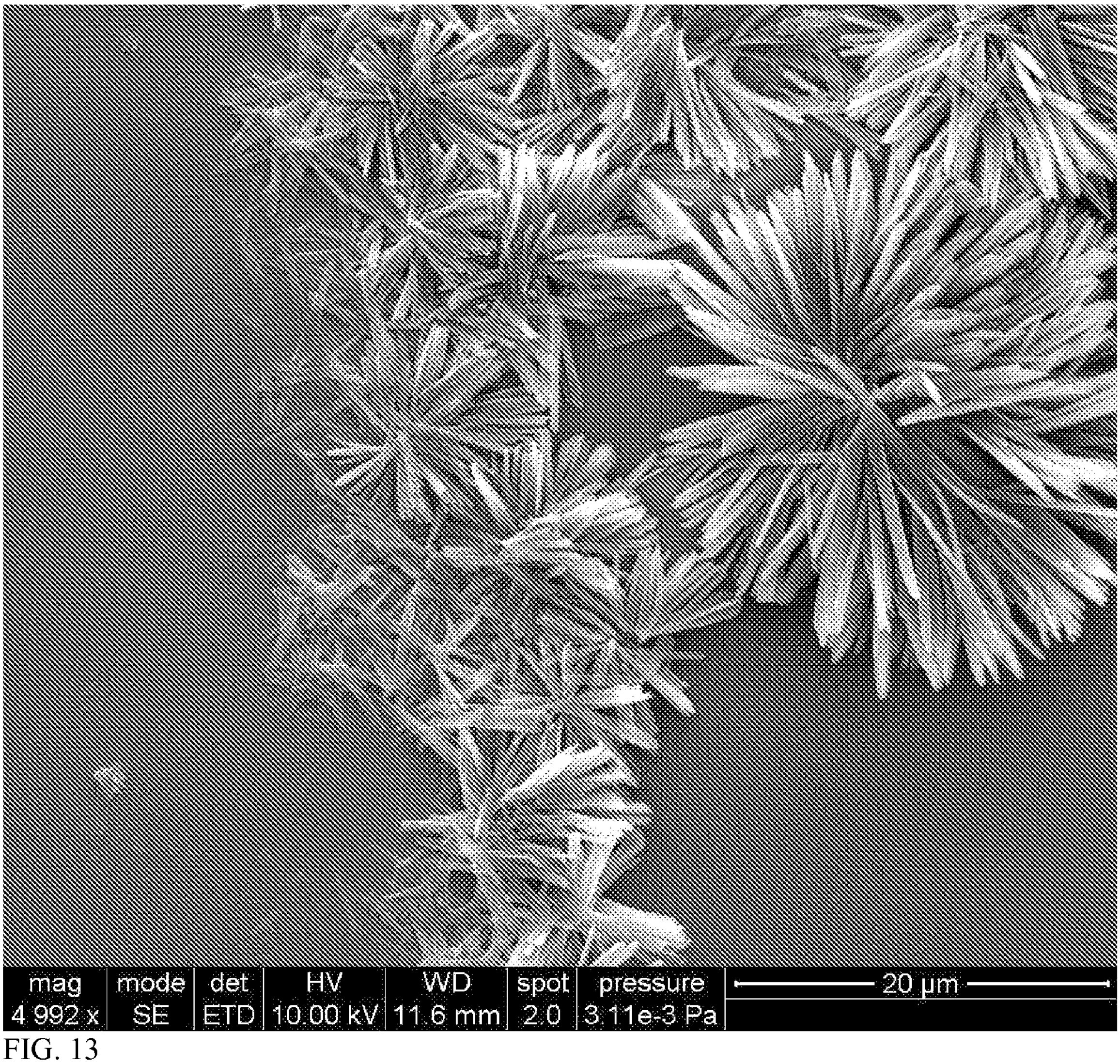
mag
4 992 x
mode
SE
det
ETD
HV
10.00 kV
WD
11.6 mm
spot
2.0
pressure
3.11e-3 Pa
20 μm
FIG. 13

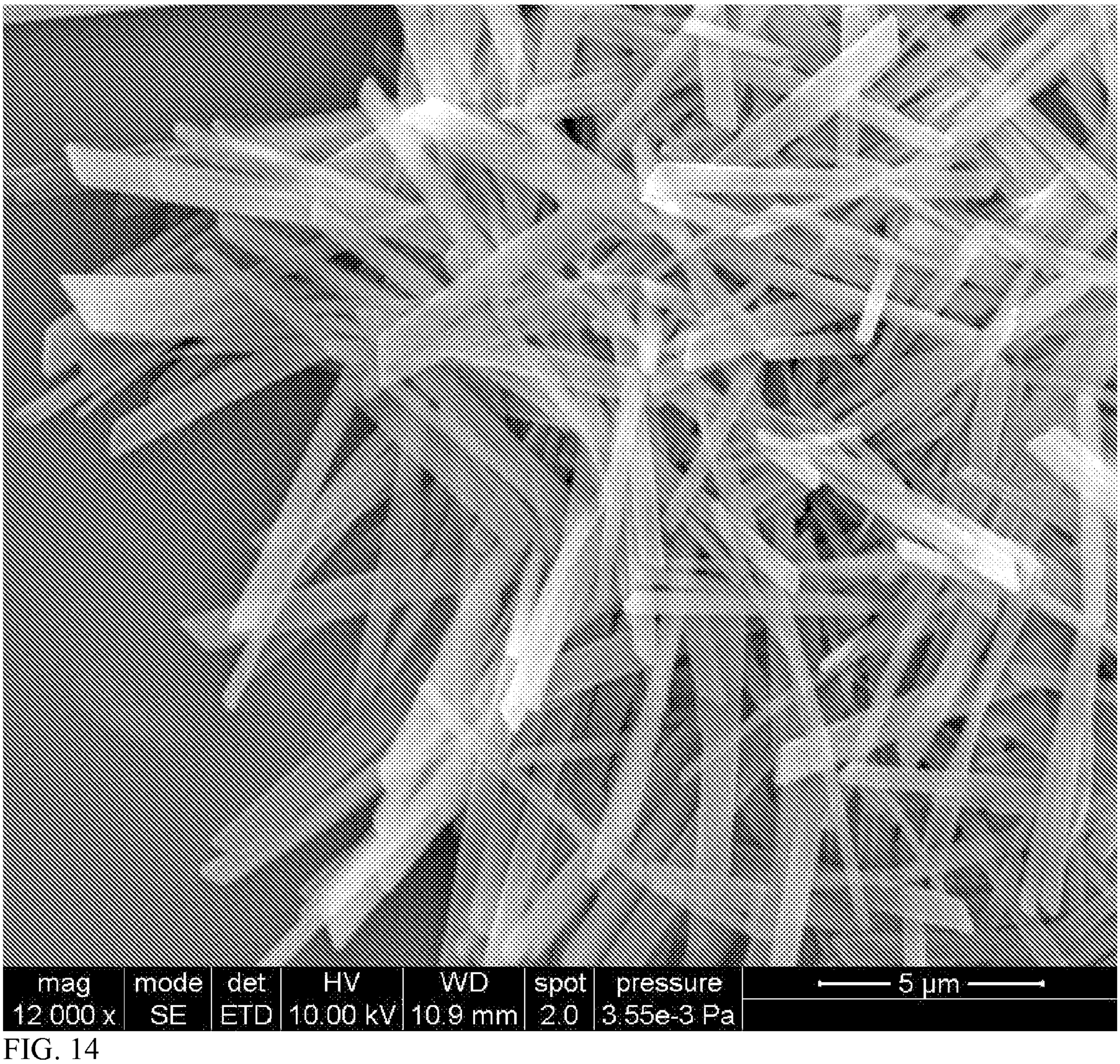
mag
12 000 x
mode
SE
det
ETD
HV
10.00 kV
WD
10.9 mm
spot
2.0
pressure
3.55e-3 Pa
5 µm
FIG. 14

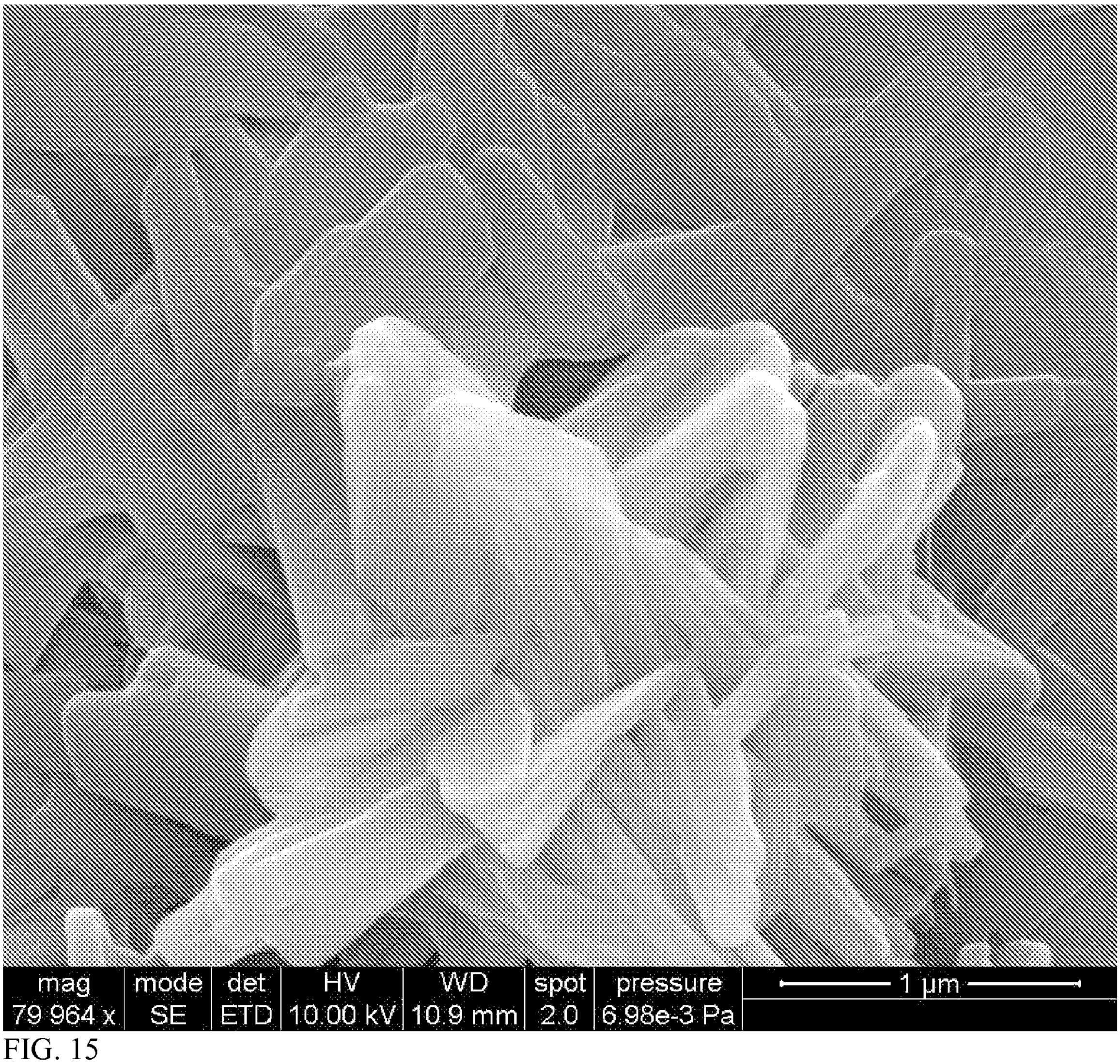
mag
79 964 x
mode
SE
det
ETD
HV
10.00 kV
WD
10.9 mm
spot
2.0
pressure
6.98e-3 Pa
1 μm
FIG. 15

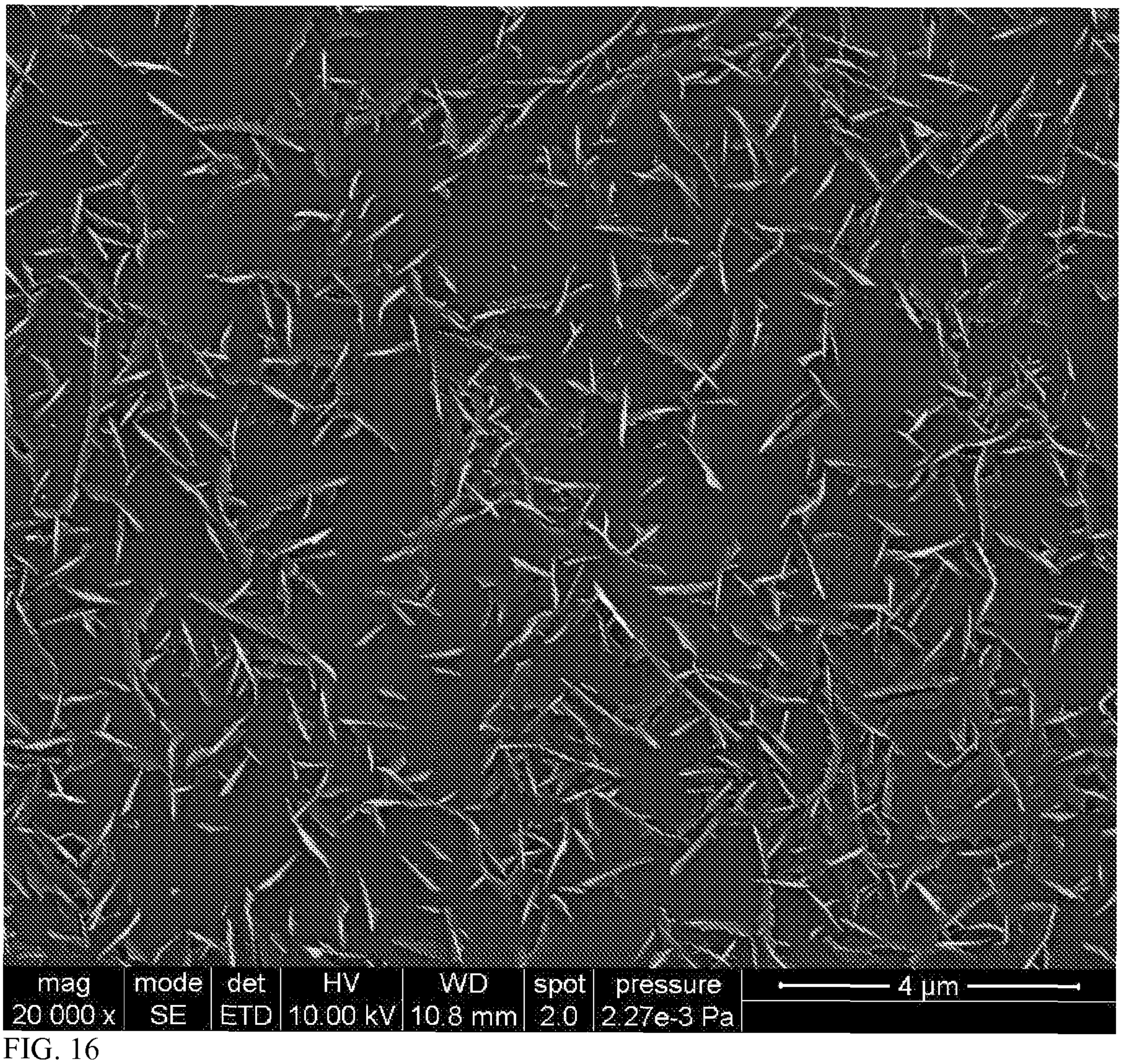
mag
20 000 x
mode
SE
det
ETD
HV
10.00 kV
WD
10.8 mm
spot
2.0
pressure
2.27e-3 Pa
4 μm
FIG. 16

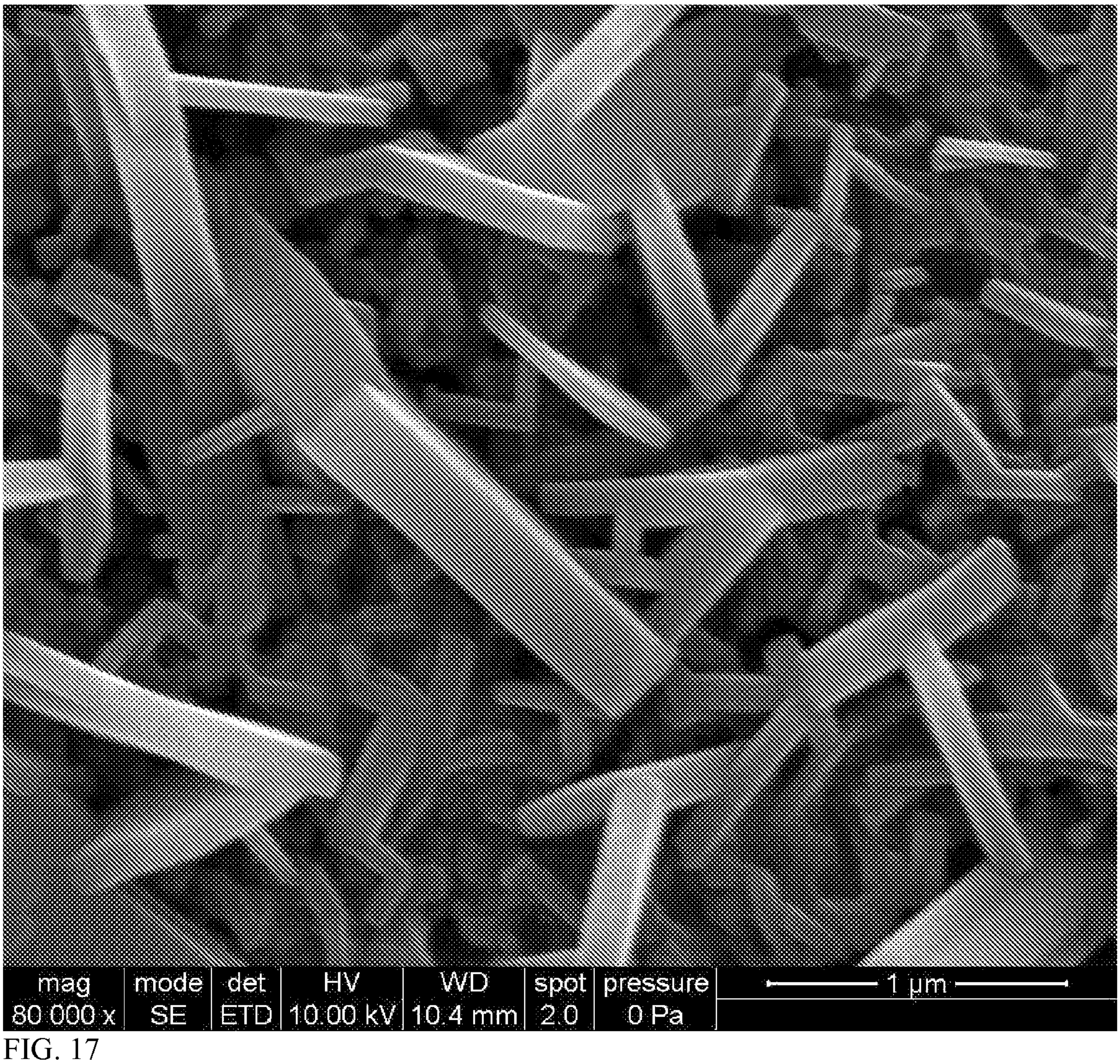
mag
80 000 x
mode
SE
det
ETD
HV
10.00 kV
WD
10.4 mm
spot
2.0
pressure
0 Pa
1 μm
FIG. 17

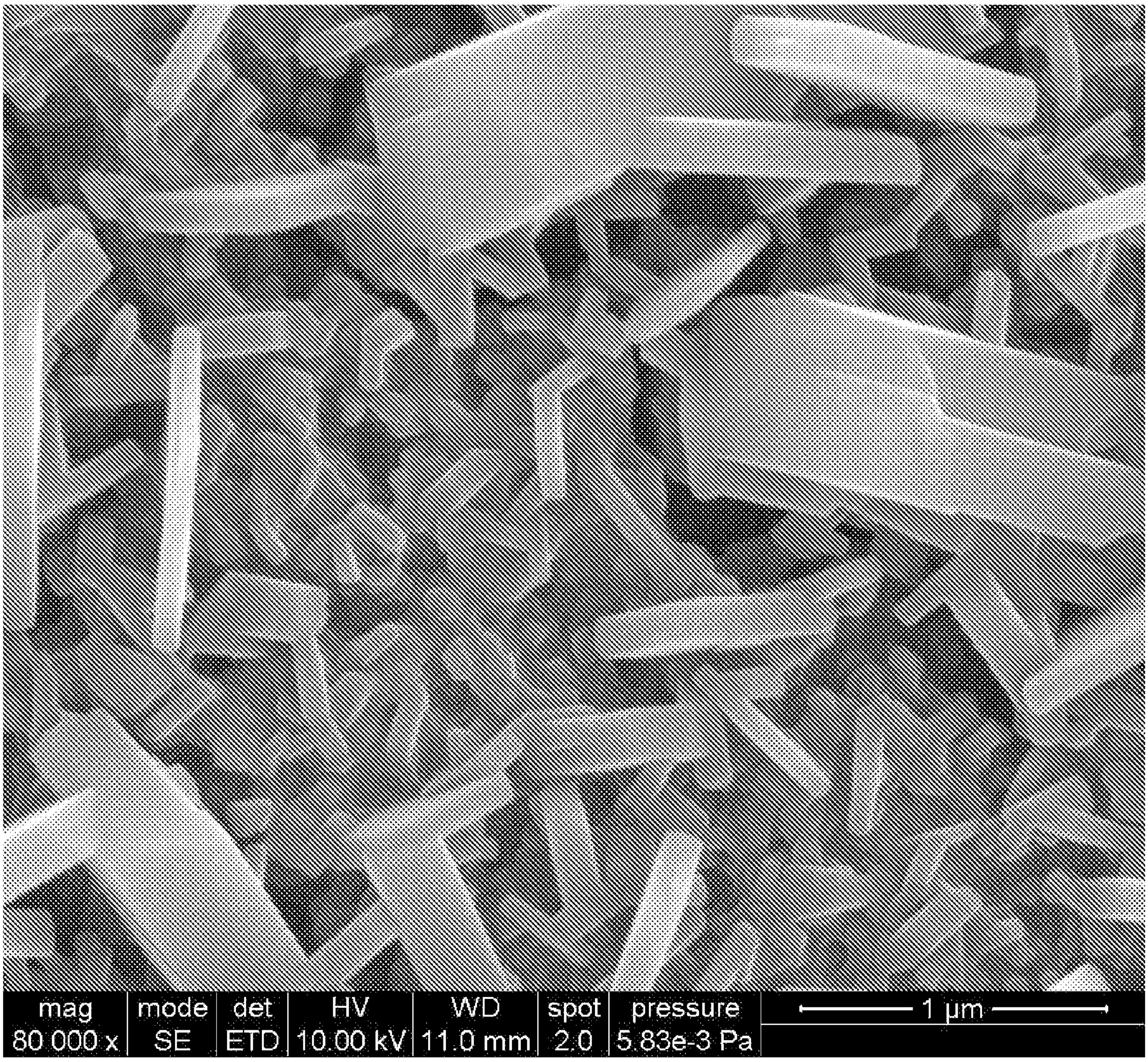
mag
80 000 x
mode
SE
det
ETD
HV
10.00 kV
WD
11.0 mm
spot
2.0
pressure
5.83e-3 Pa
1 μm
FIG. 18

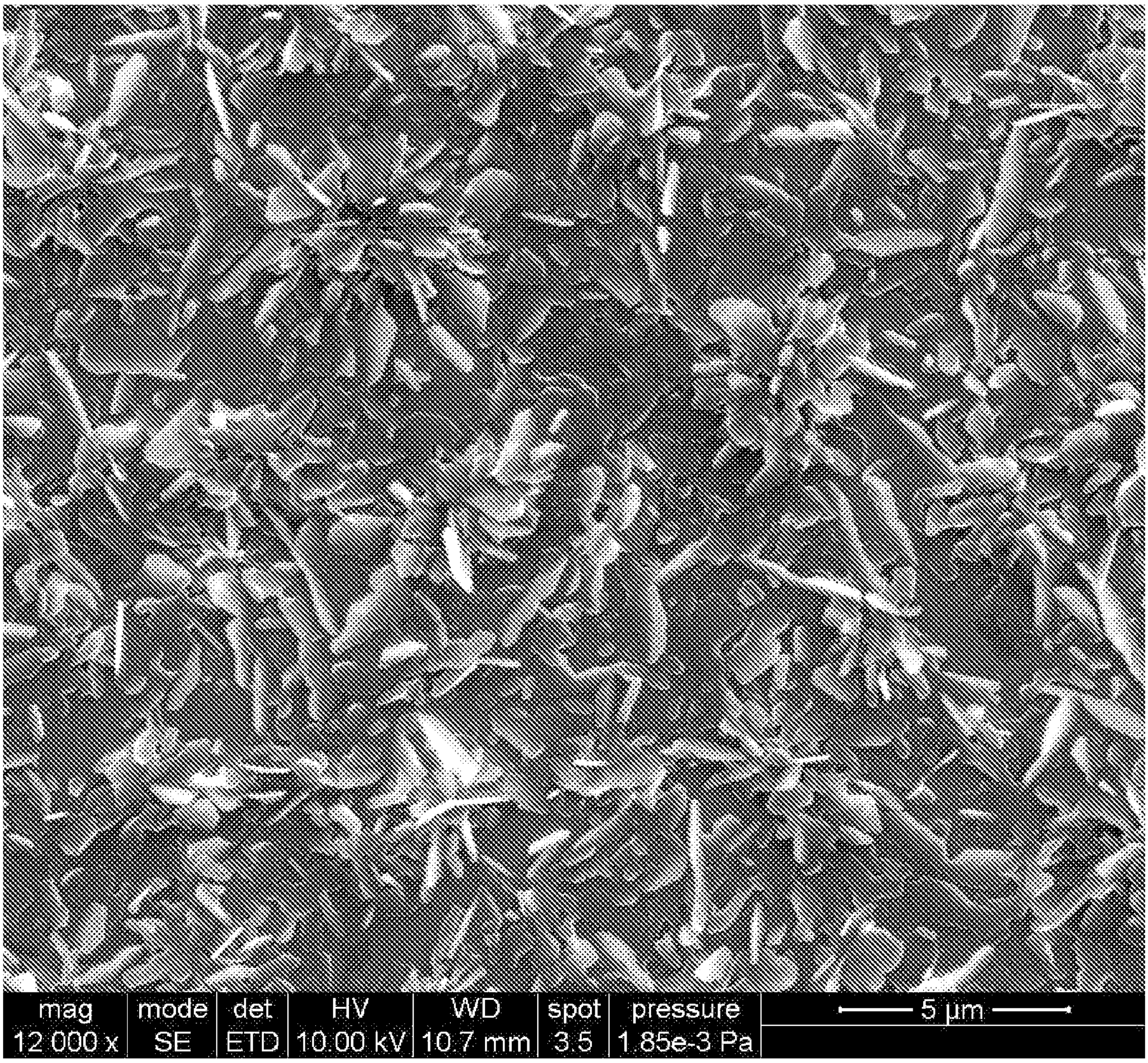
mag
12 000 x
mode
SE
det
ETD
HV
10.00 kV
WD
10.7 mm
spot
3.5
pressure
1.85e-3 Pa
5 µm
FIG. 19

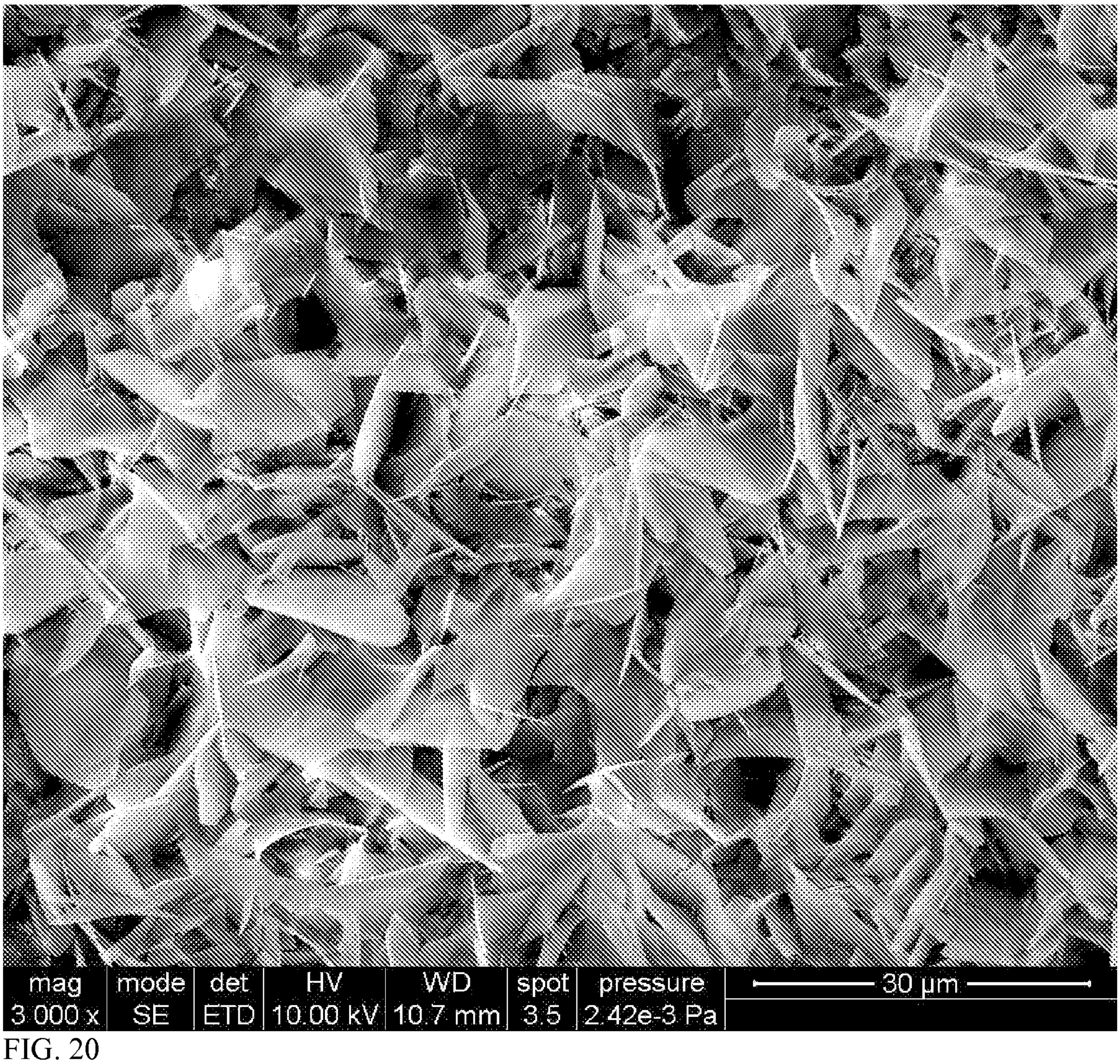
mag
3 000 x
mode
SE
det
ETD
HV
10.00 kV
WD
10.7 mm
spot
3.5
pressure
2.42e-3 Pa
30 µm
FIG. 20

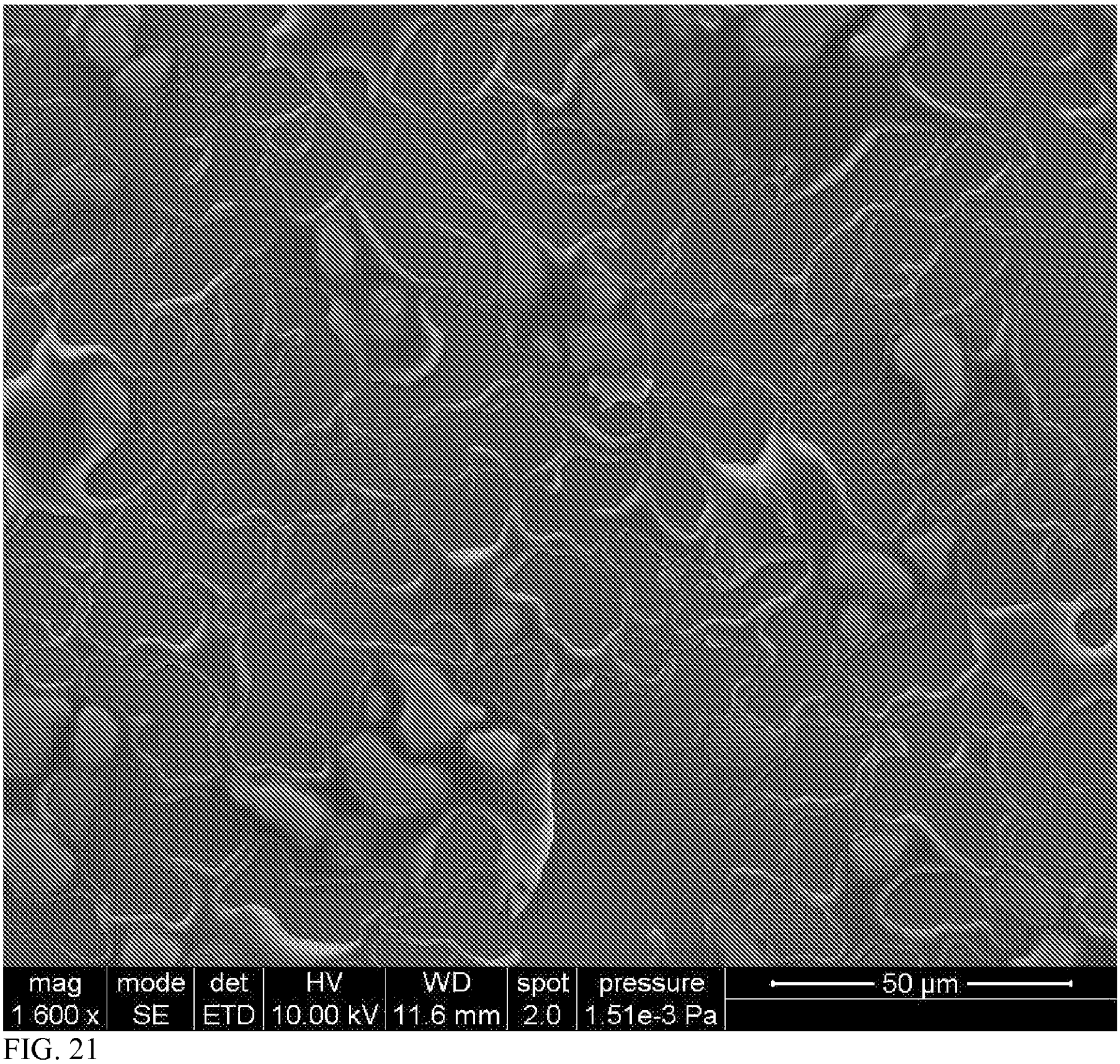
mag
1 600 x
mode
SE
det
ETD
HV
10.00 kV
WD
11.6 mm
spot
2.0
pressure
1.51e-3 Pa
50 µm
FIG. 21

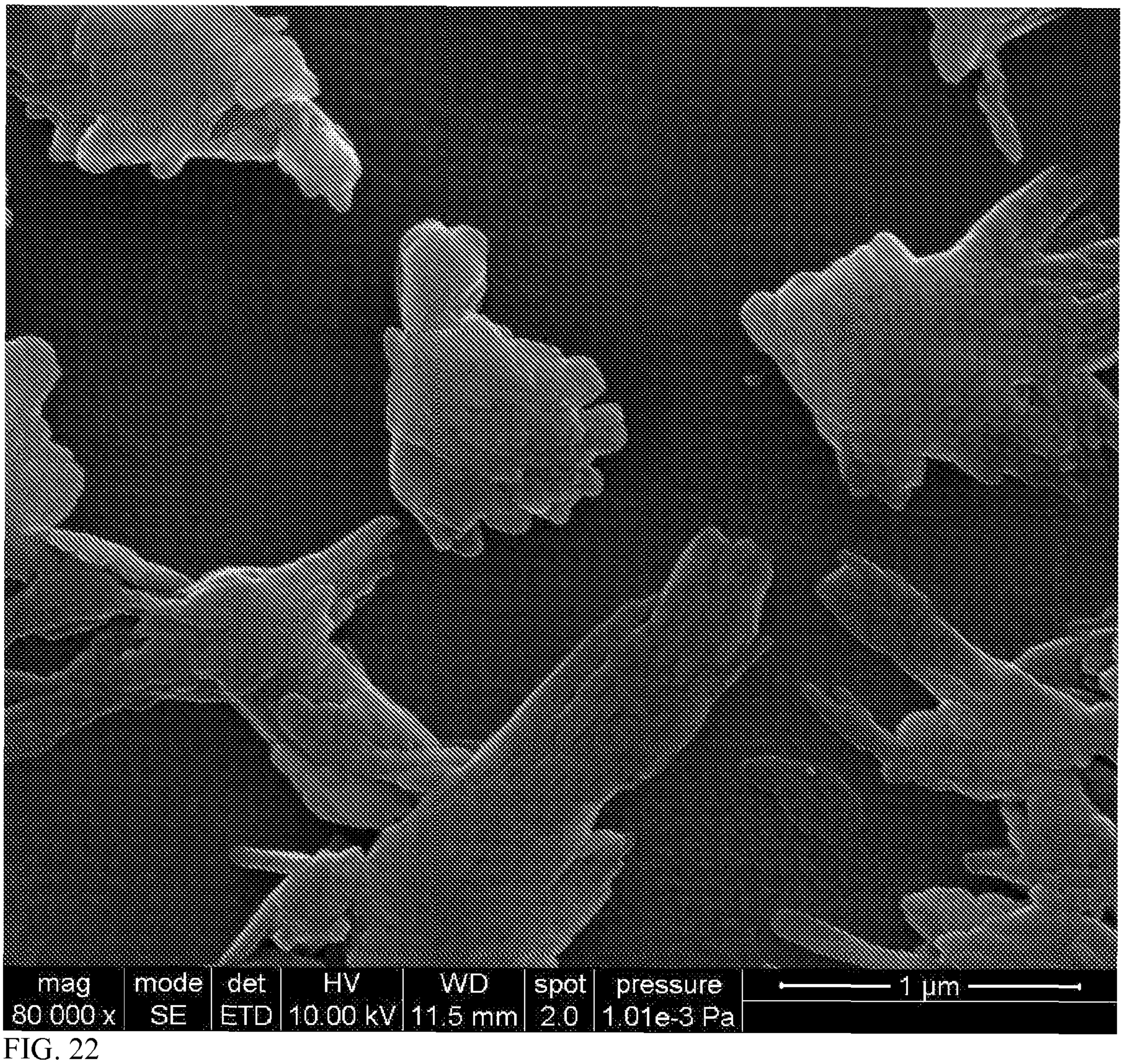
mag
80 000 x
mode
SE
det
ETD
HV
10.00 kV
WD
11.5 mm
spot
2.0
pressure
1.01e-3 Pa
1 µm
FIG. 22

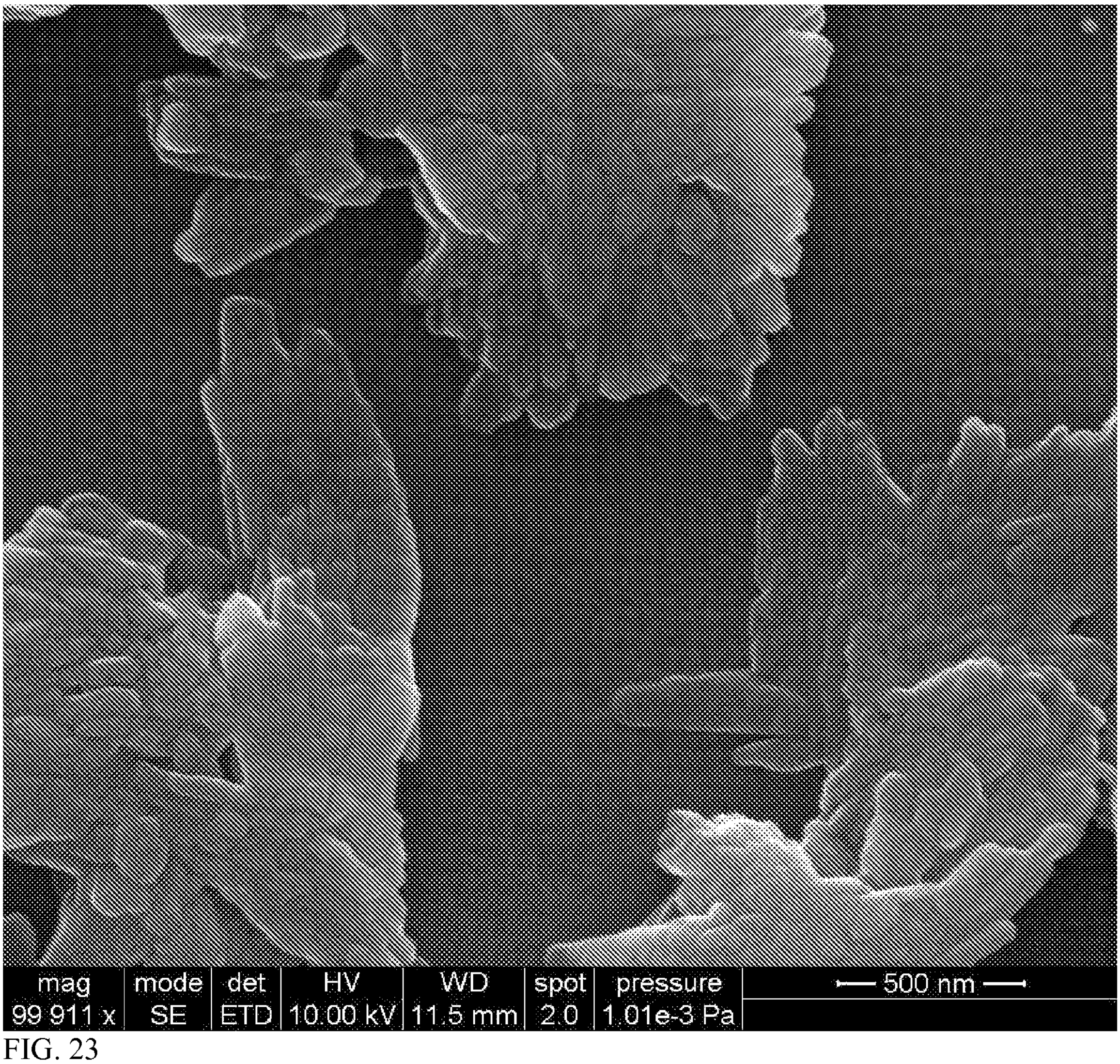
mag
99 911 x
mode
SE
det
ETD
HV
10.00 kV
WD
11.5 mm
spot
2.0
pressure
1.01e-3 Pa
500 nm
FIG. 23

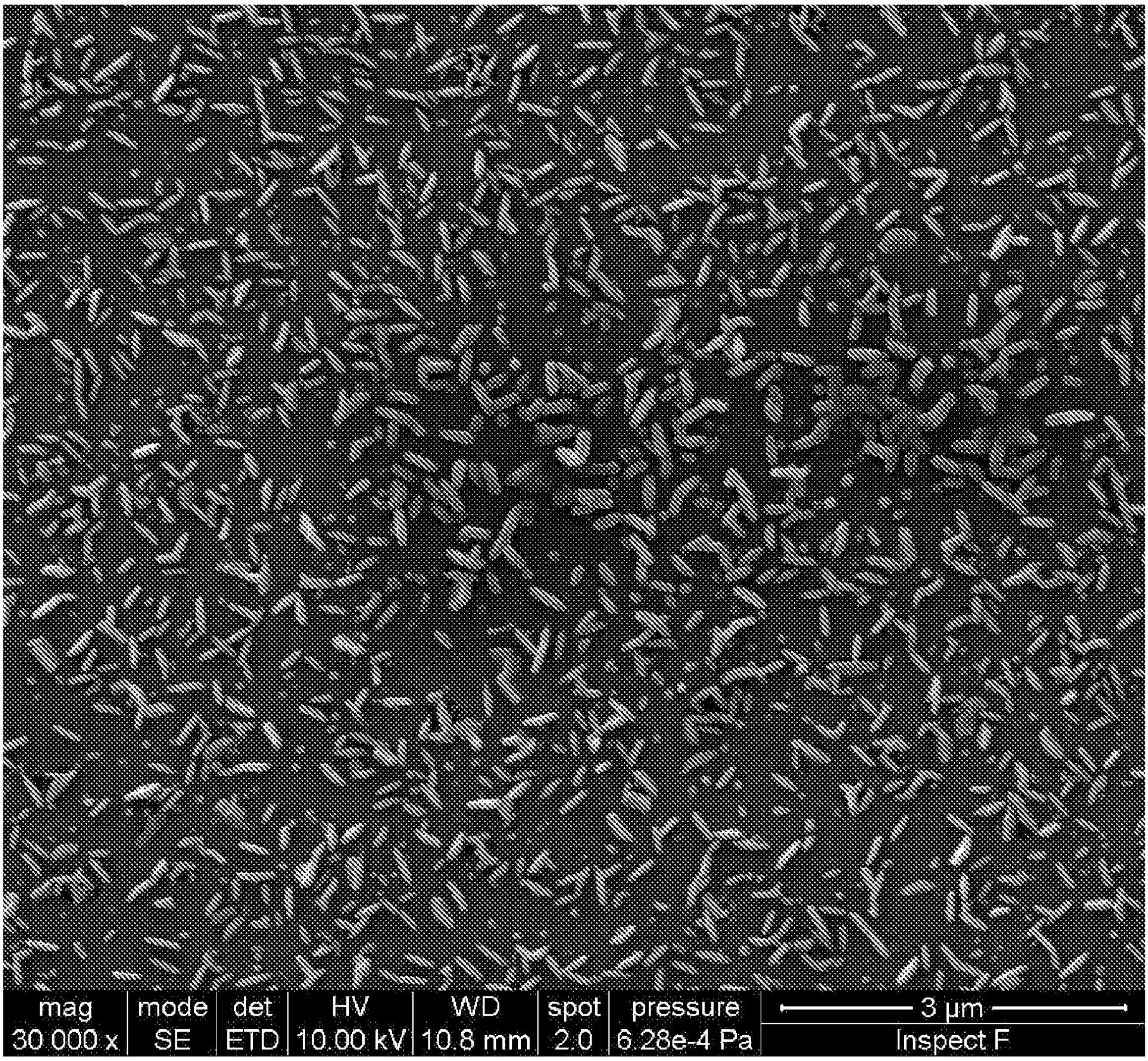
mag
30 000 x
mode
SE
det
ETD
HV
10.00 kV
WD
10.8 mm
spot
2.0
pressure
6.28e-4 Pa
3 μm
Inspect F

FIG. 24

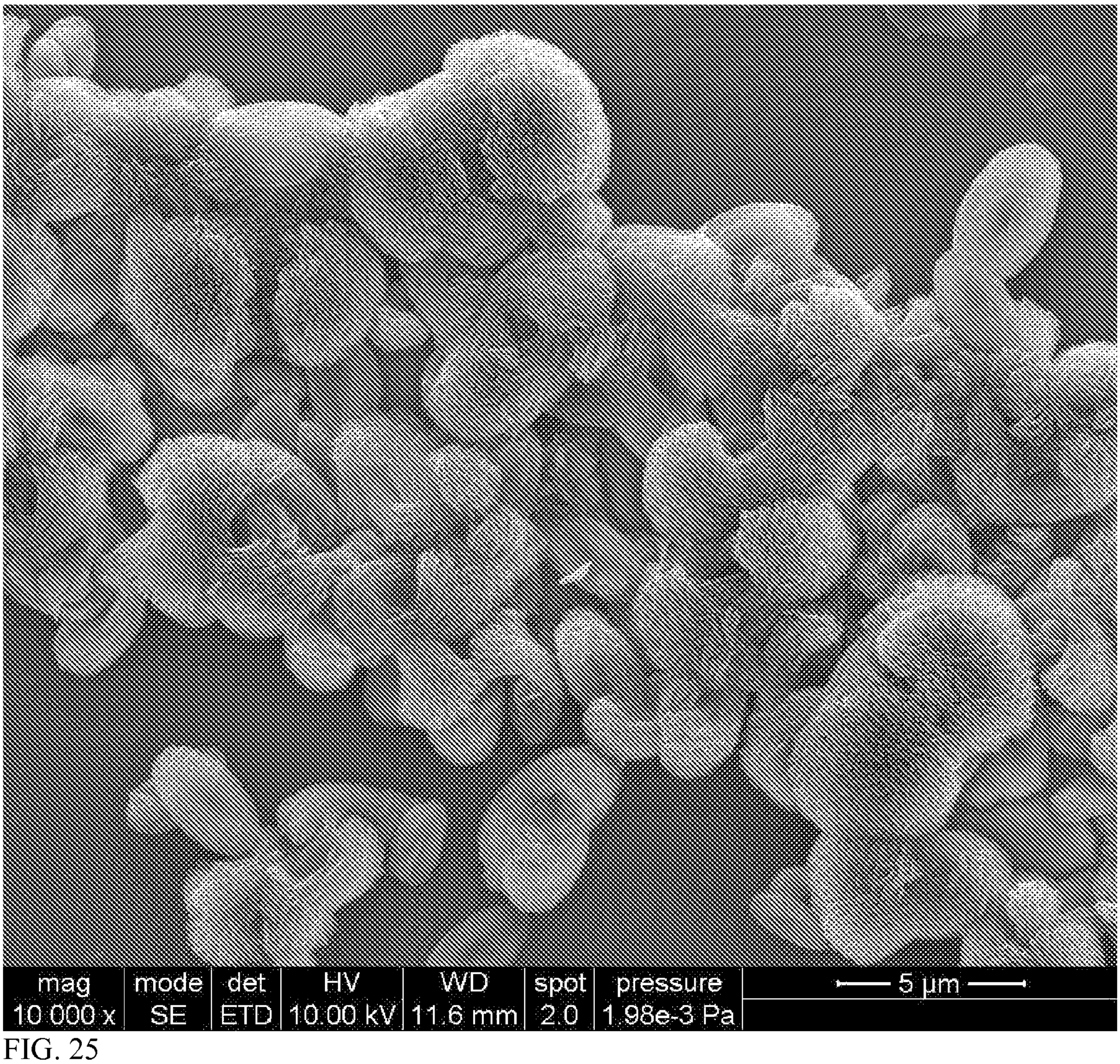
mag
10 000 x
mode
SE
det
ETD
HV
10.00 kV
WD
11.6 mm
spot
2.0
pressure
1.98e-3 Pa
5 μm
FIG. 25

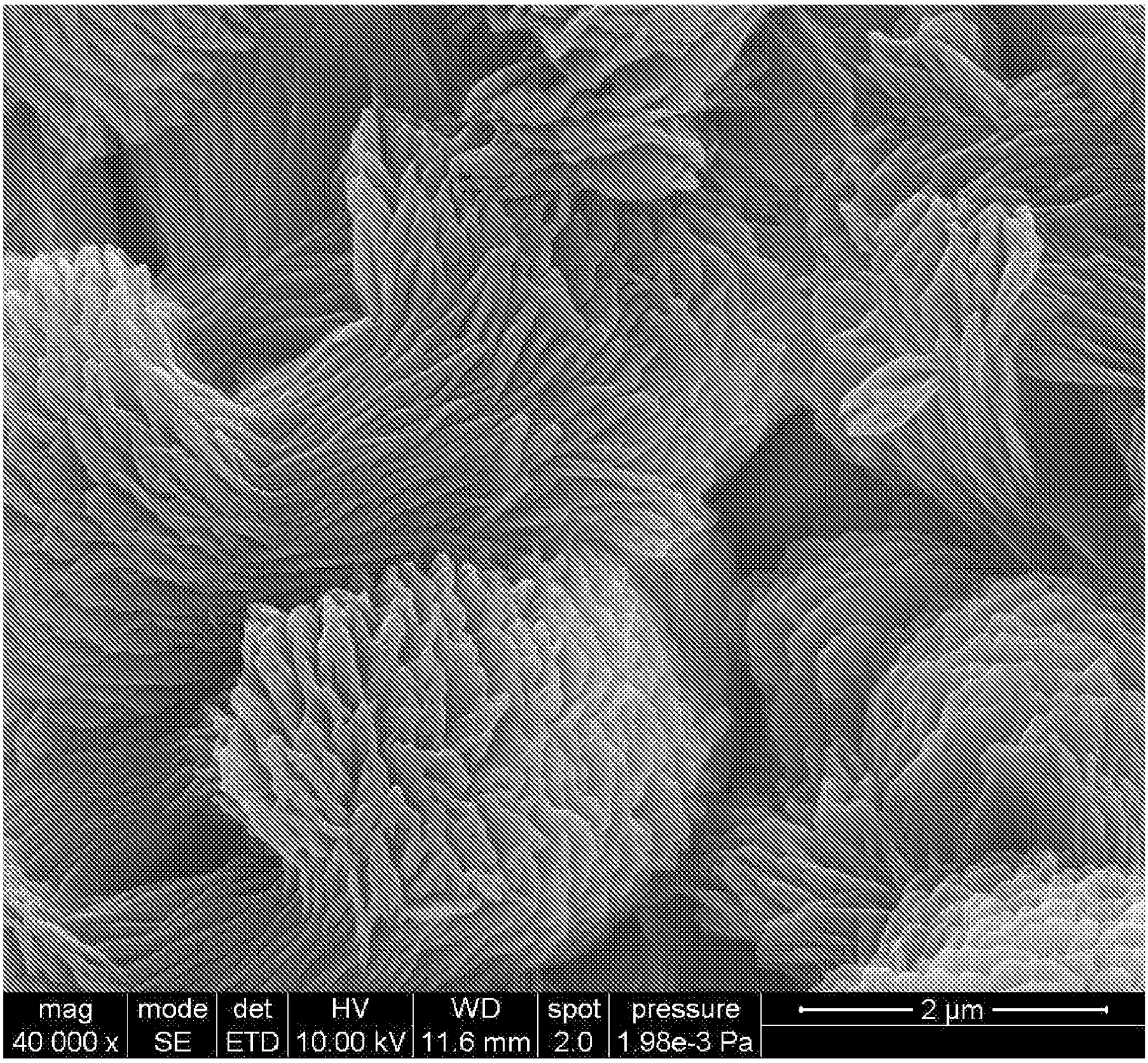
mag
40 000 x
mode
SE
det
ETD
HV
10.00 kV
WD
11.6 mm
spot
2.0
pressure
1.98e-3 Pa
2 µm
FIG. 26

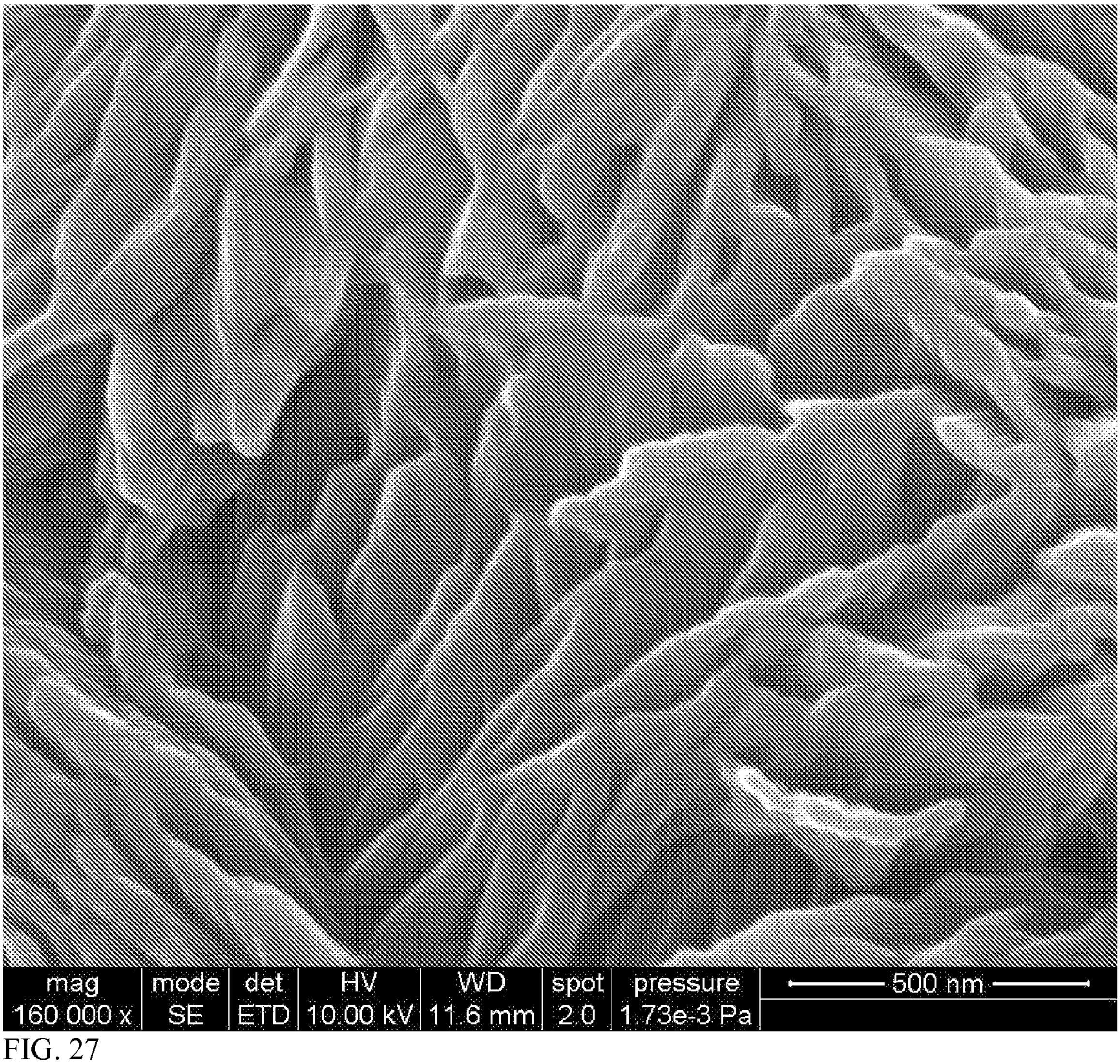
mag
160 000 x
mode
SE
det
ETD
HV
10.00 kV
WD
11.6 mm
spot
2.0
pressure
1.73e-3 Pa
500 nm
FIG. 27

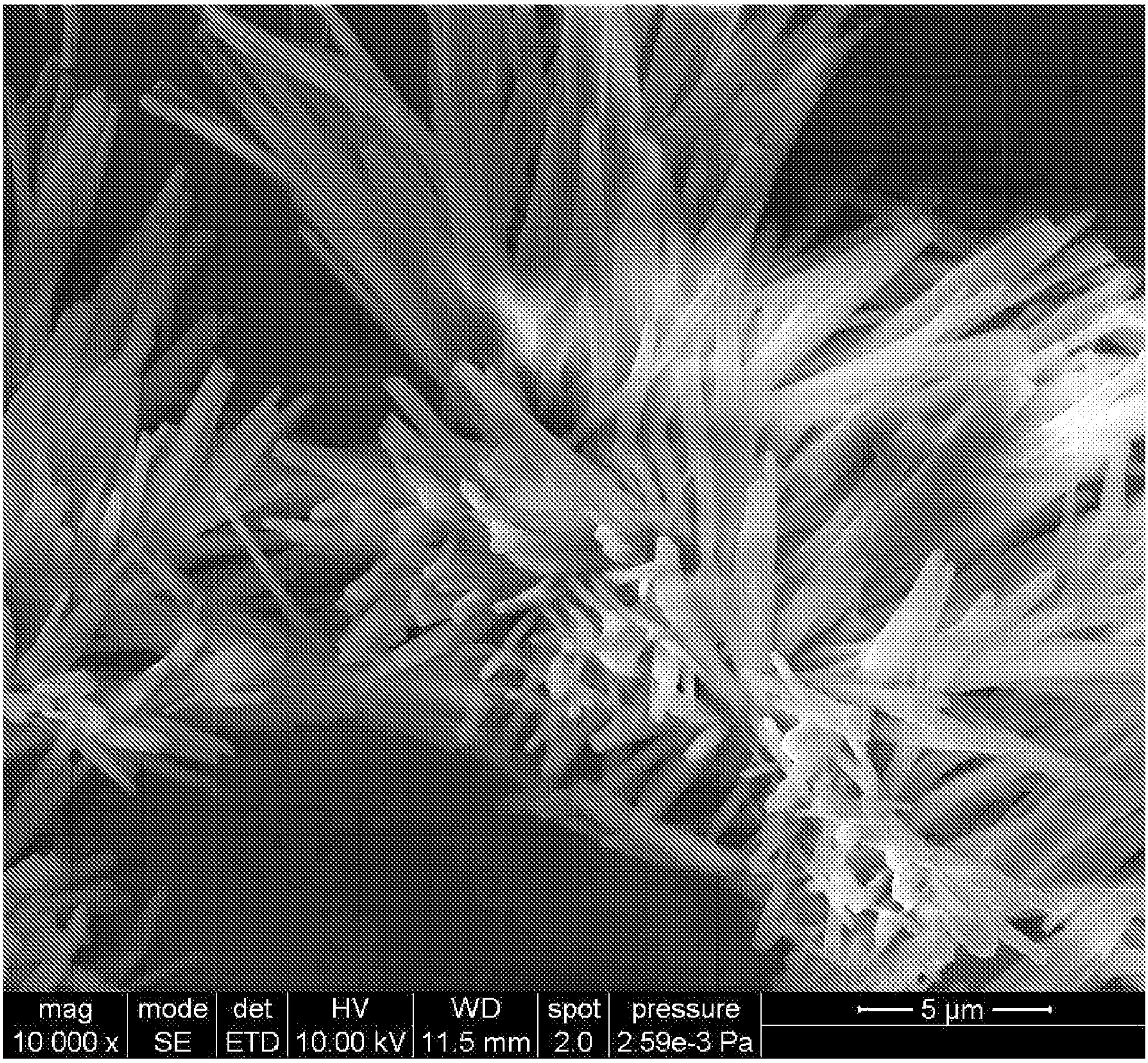
mag
10 000 x
mode
SE
det
ETD
HV
10.00 kV
WD
11.5 mm
spot
2.0
pressure
2.59e-3 Pa
5 µm

FIG. 28

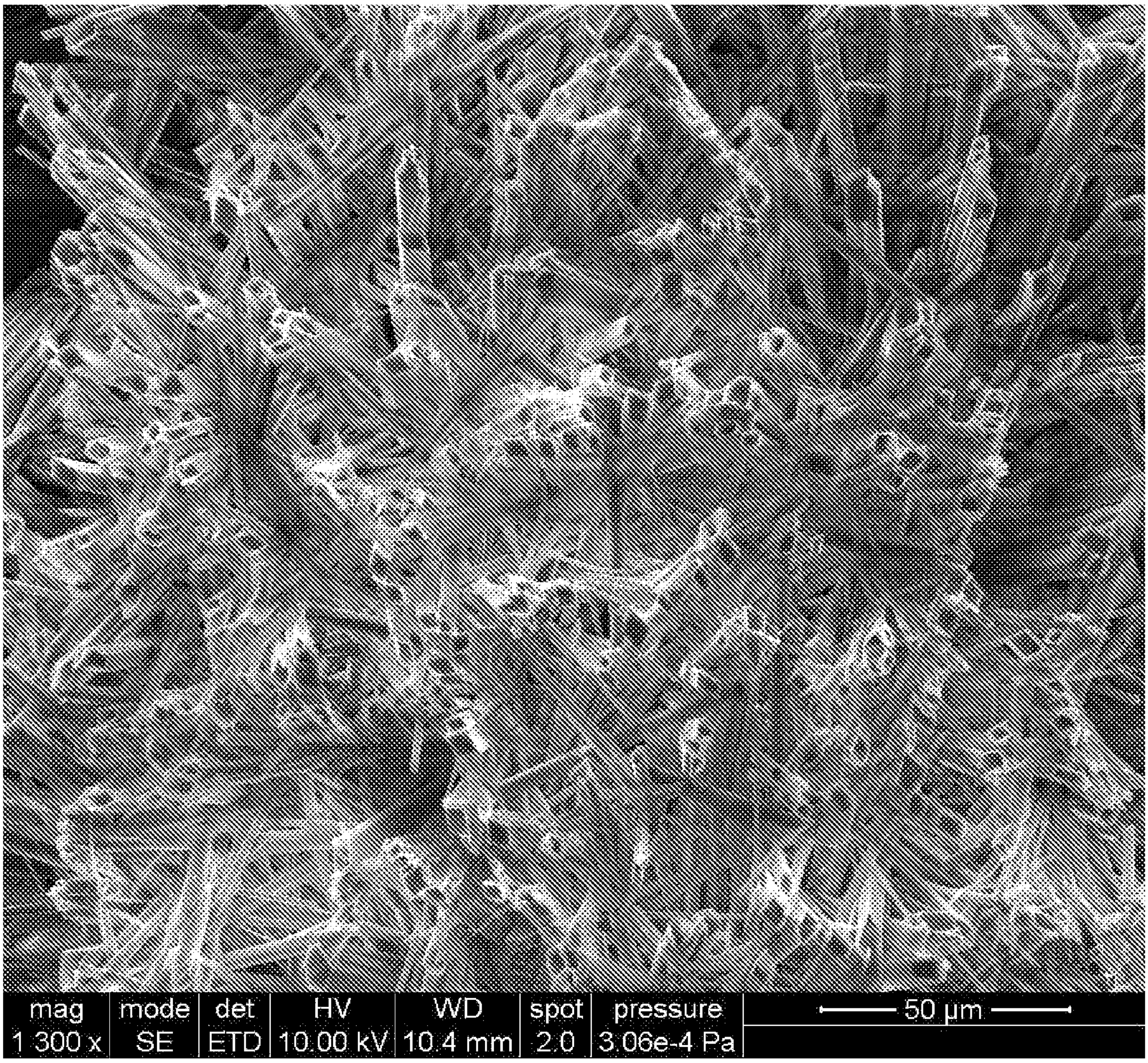
mag
1 300 x
mode
SE
det
ETD
HV
10.00 kV
WD
10.4 mm
spot
2.0
pressure
3.06e-4 Pa
50 µm
FIG. 29

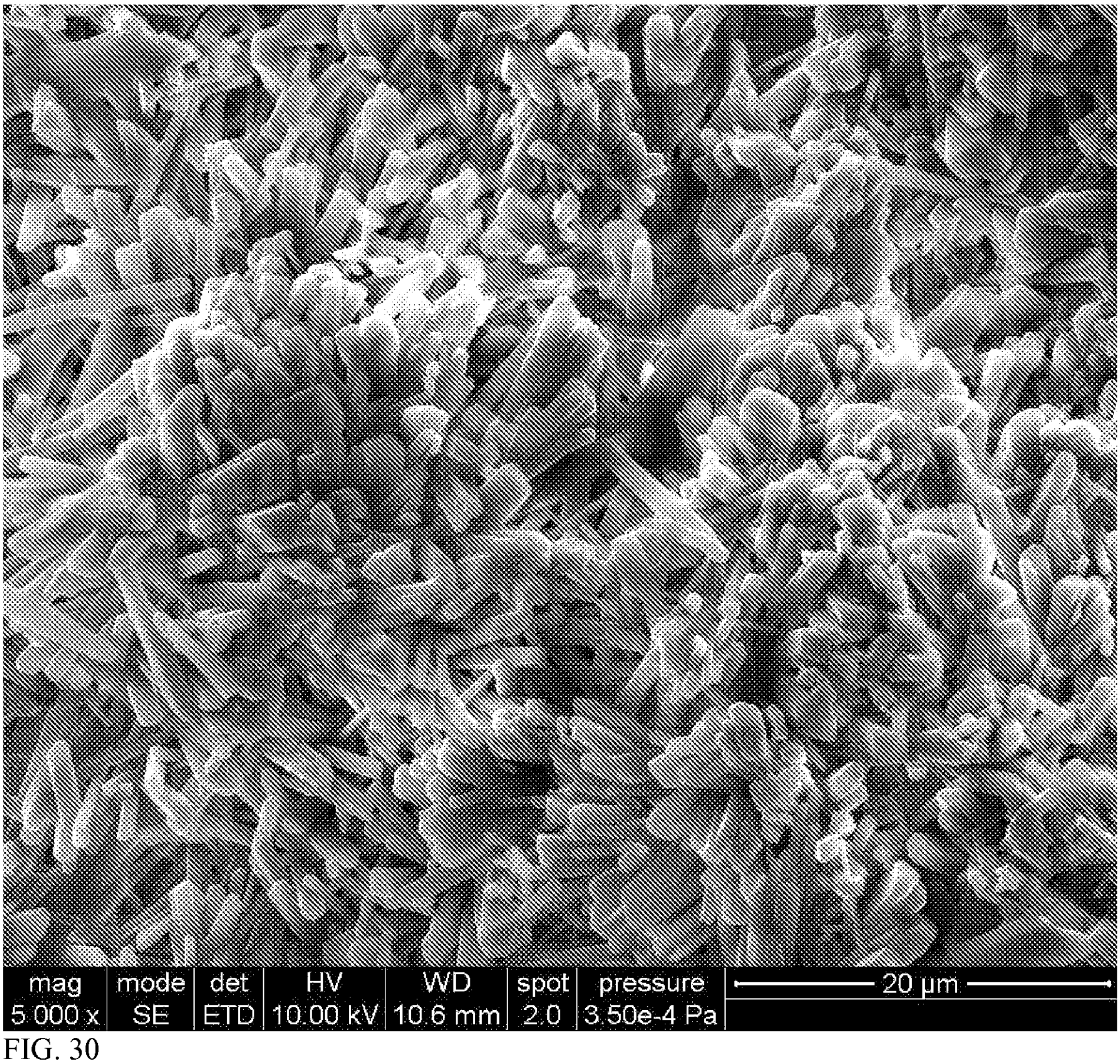
mag
5 000 x
mode
SE
det
ETD
HV
10.00 kV
WD
10.6 mm
spot
2.0
pressure
3.50e-4 Pa
20 µm
FIG. 30

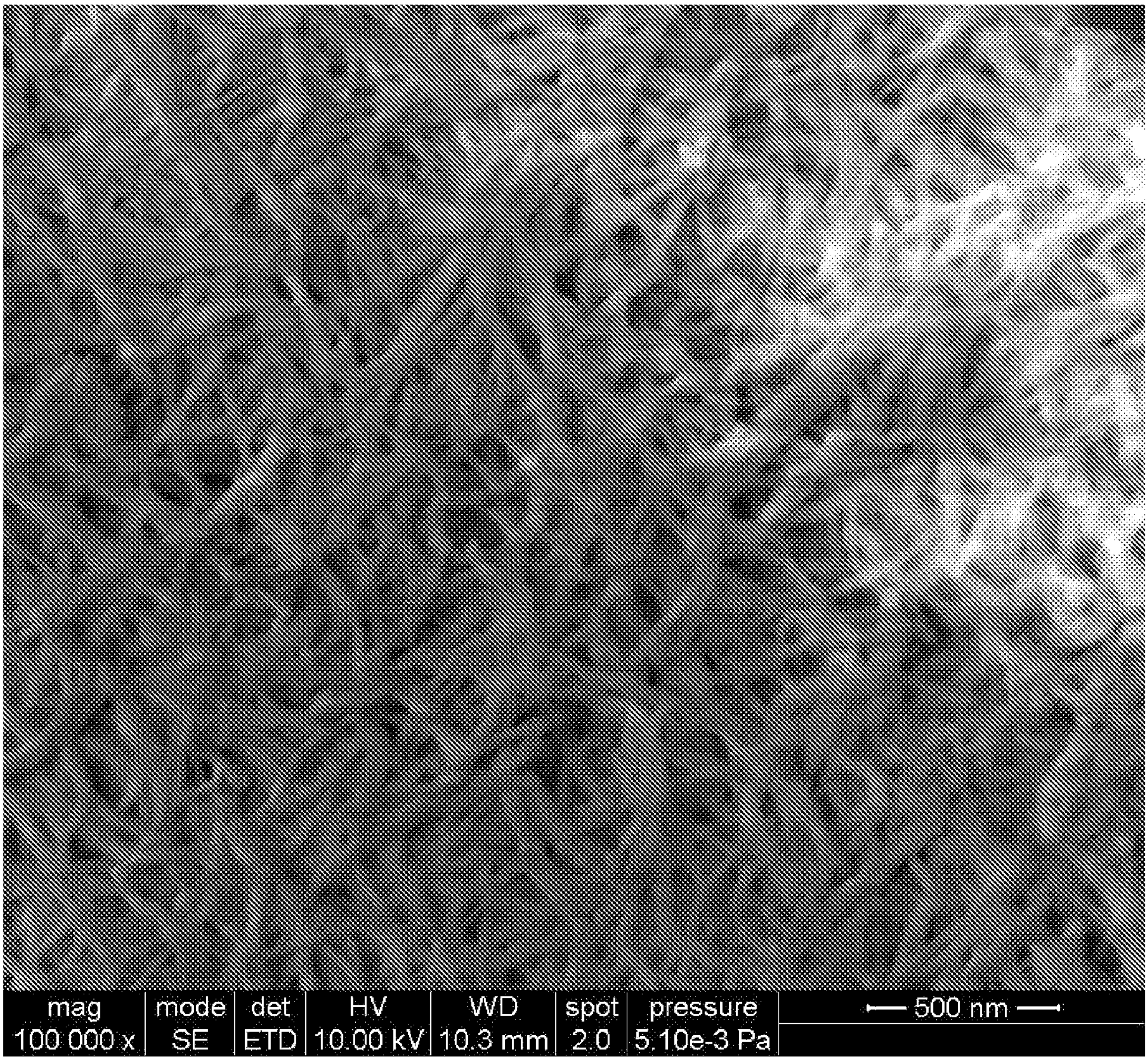
mag
100 000 x
mode
SE
det
ETD
HV
10.00 kV
WD
10.3 mm
spot
2.0
pressure
5.10e-3 Pa
500 nm
FIG. 31

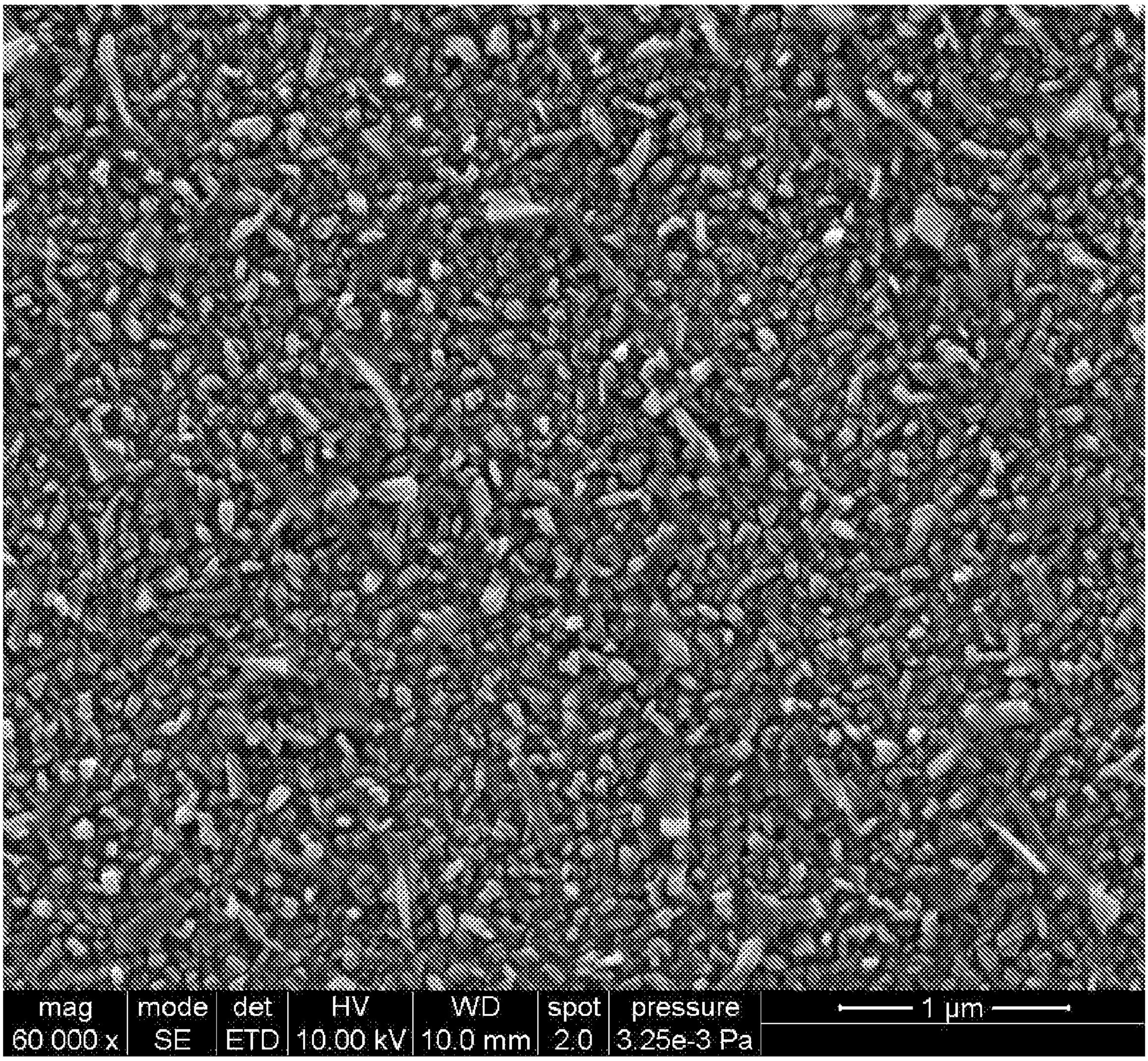
mag
60 000 x
mode
SE
det
ETD
HV
10.00 kV
WD
10.0 mm
spot
2.0
pressure
3.25e-3 Pa
1 μm
FIG. 32

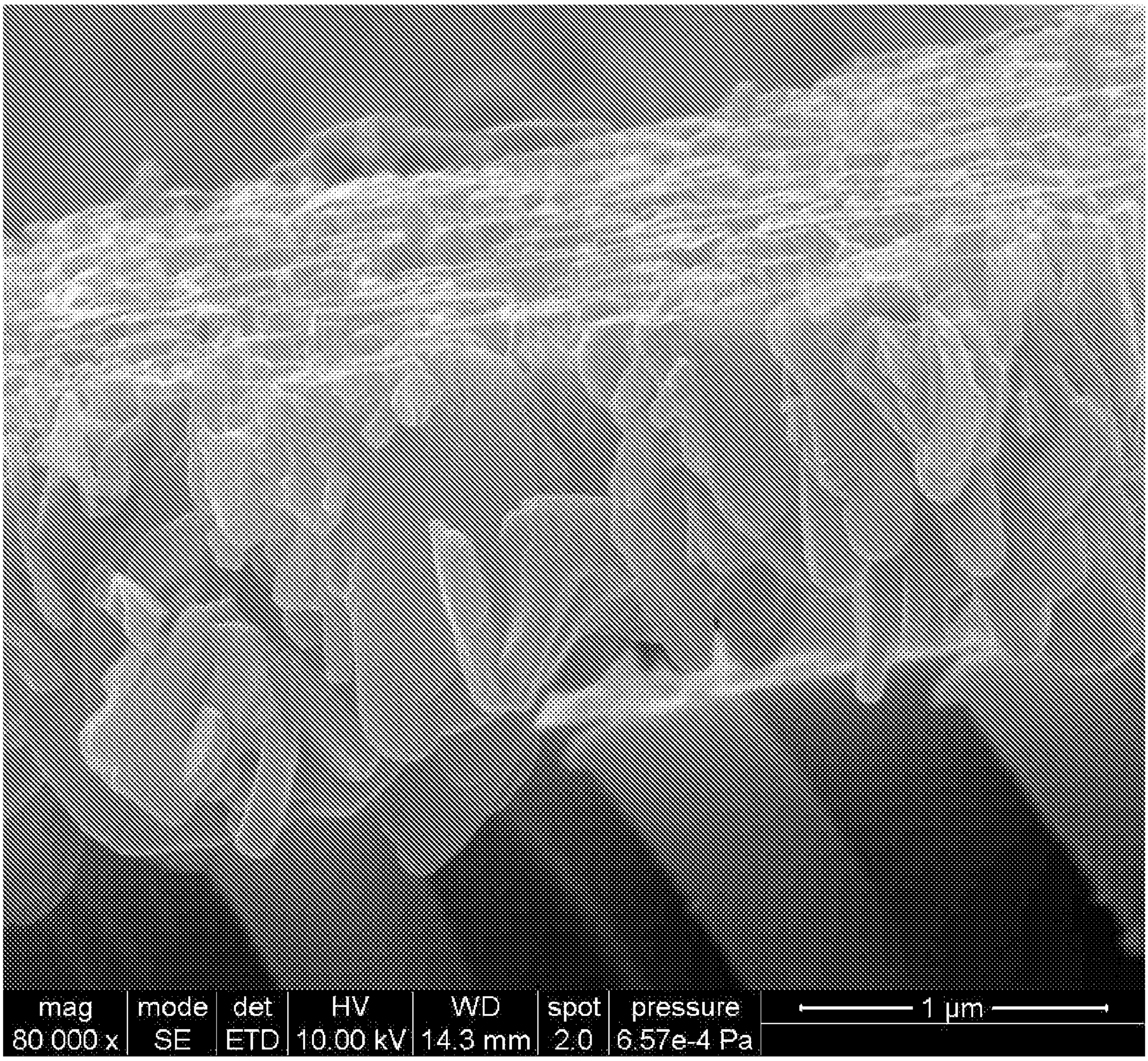
mag
80 000 x
mode
SE
det
ETD
HV
10.00 kV
WD
14.3 mm
spot
2.0
pressure
6.57e-4 Pa
1 µm
FIG. 33

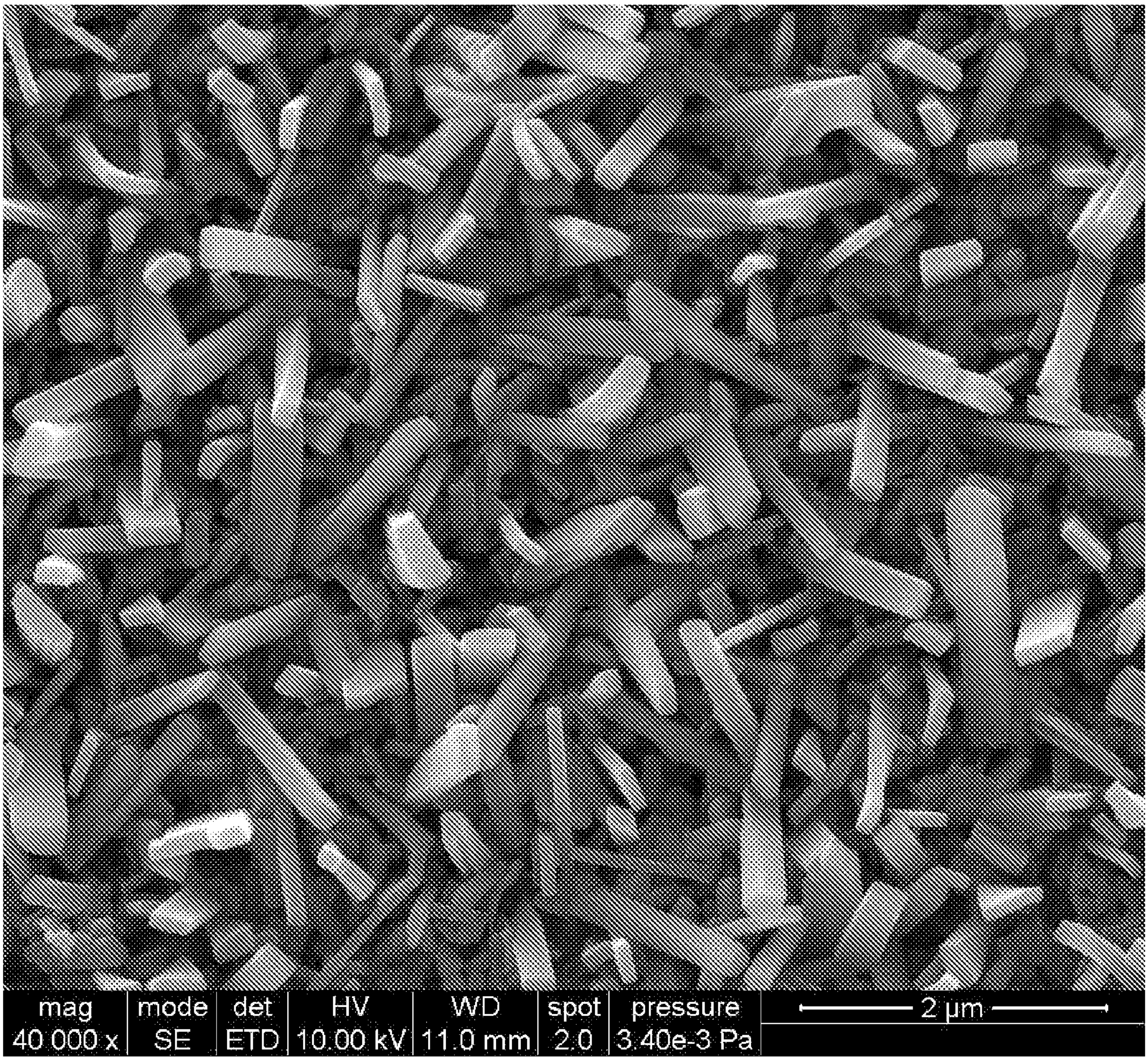
mag
40 000 x
mode
SE
det
ETD
HV
10.00 kV
WD
11.0 mm
spot
2.0
pressure
3.40e-3 Pa
2 µm
FIG. 34

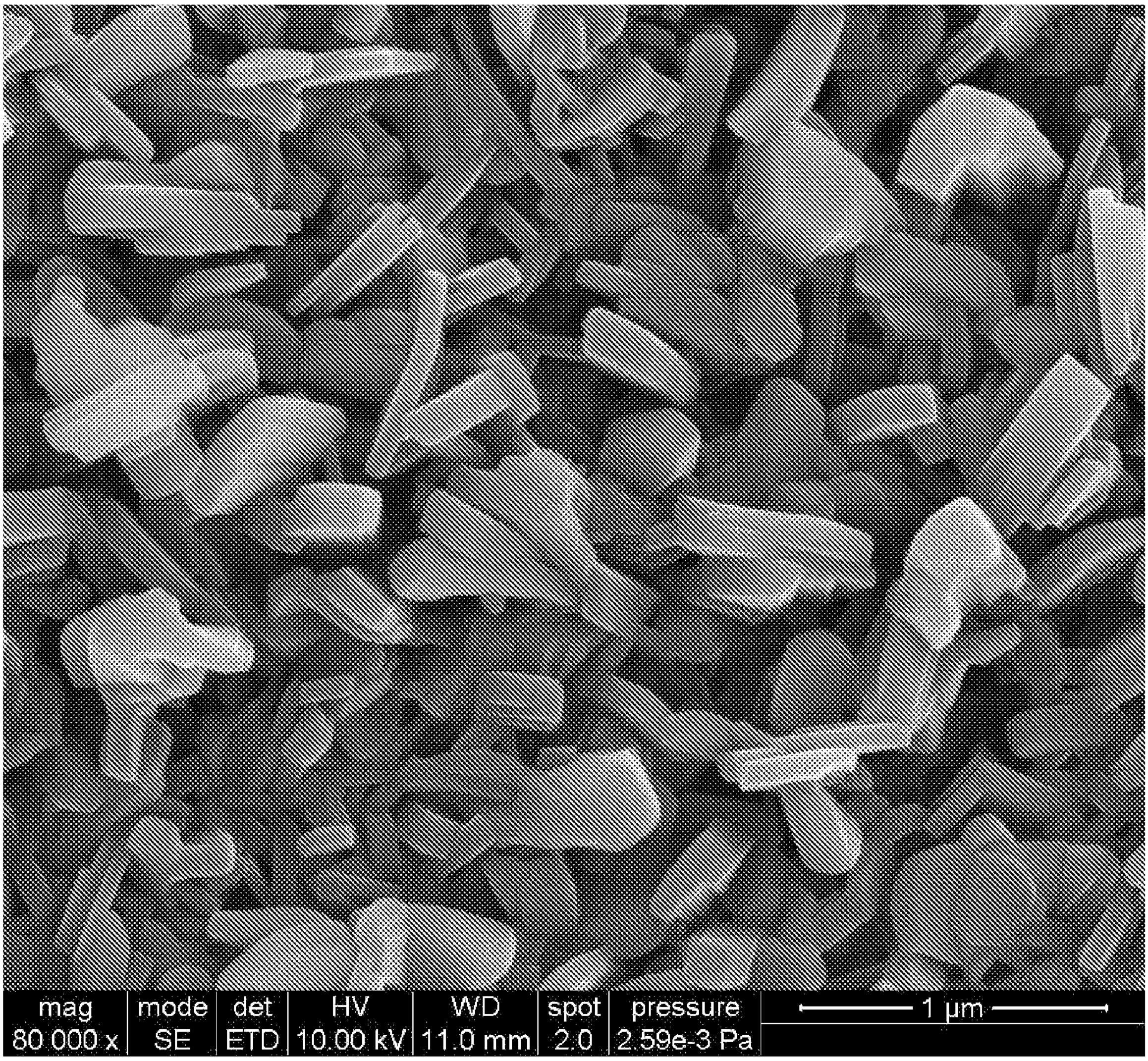
mag
80 000 x
mode
SE
det
ETD
HV
10.00 kV
WD
11.0 mm
spot
2.0
pressure
2.59e-3 Pa
1 µm
FIG. 35

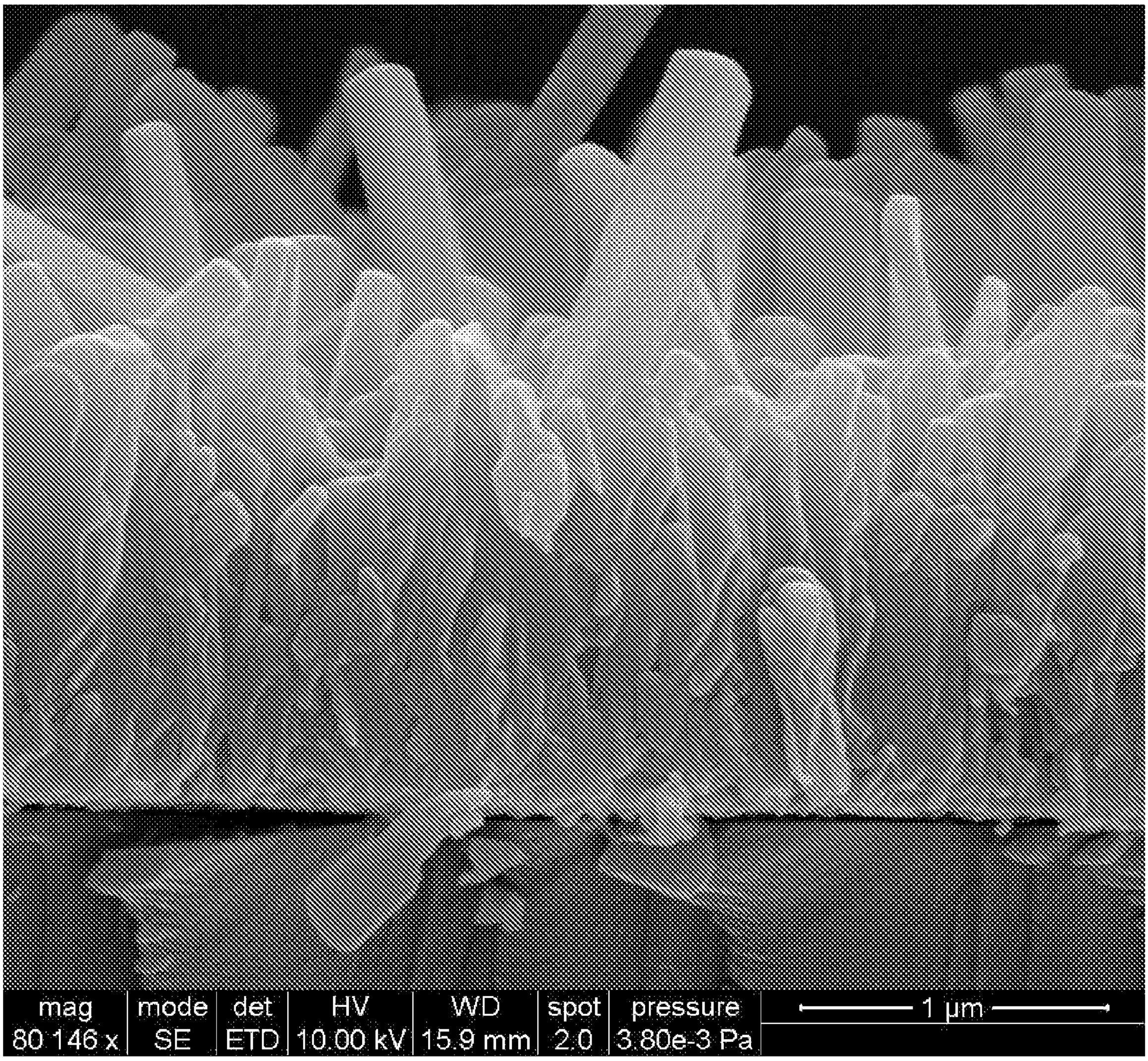
mag
80 146 x
mode
SE
det
ETD
HV
10.00 kV
WD
15.9 mm
spot
2.0
pressure
3.80e-3 Pa
1 µm
FIG. 36

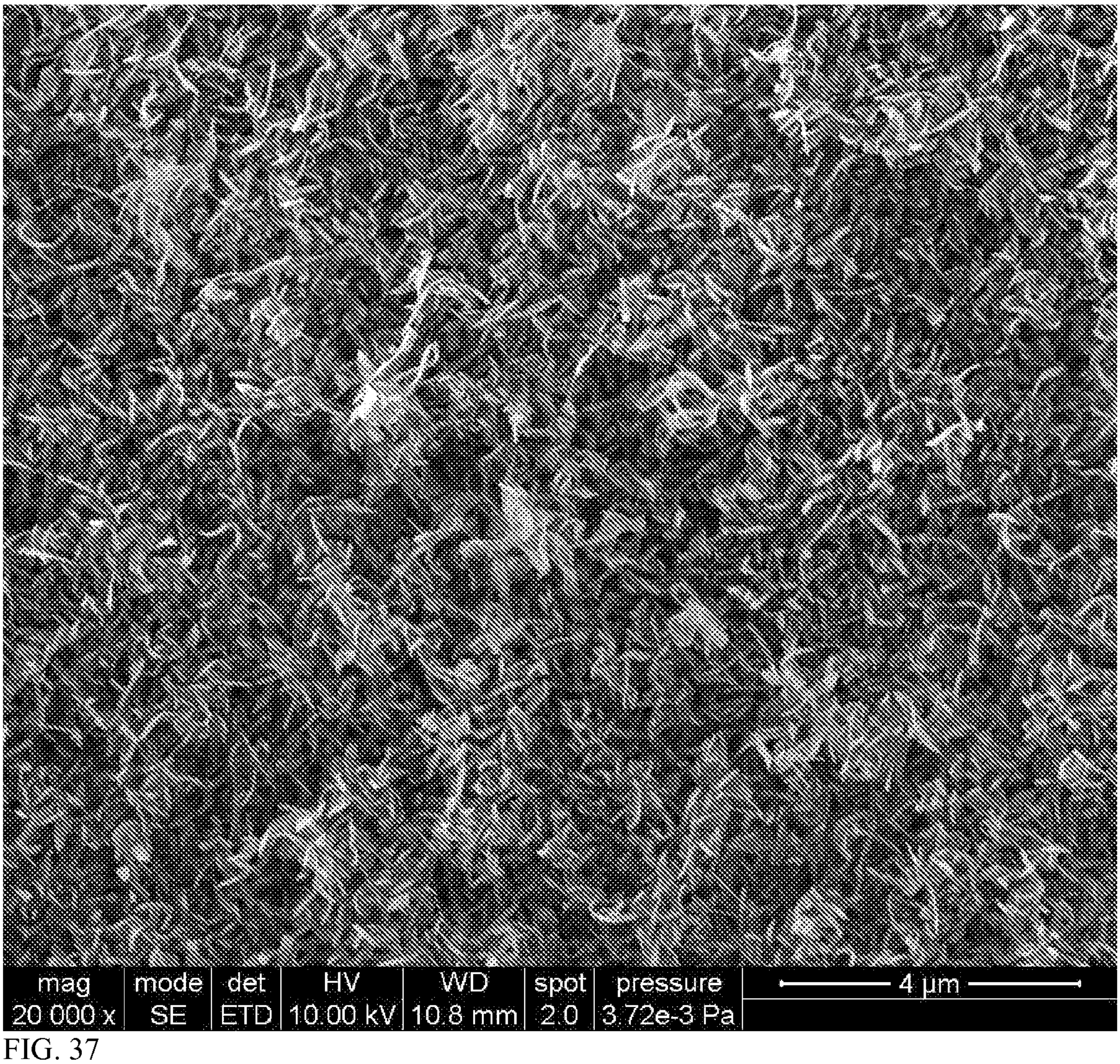
mag
20 000 x
mode
SE
det
ETD
HV
10.00 kV
WD
10.8 mm
spot
2.0
pressure
3.72e-3 Pa
4 μm

FIG. 37

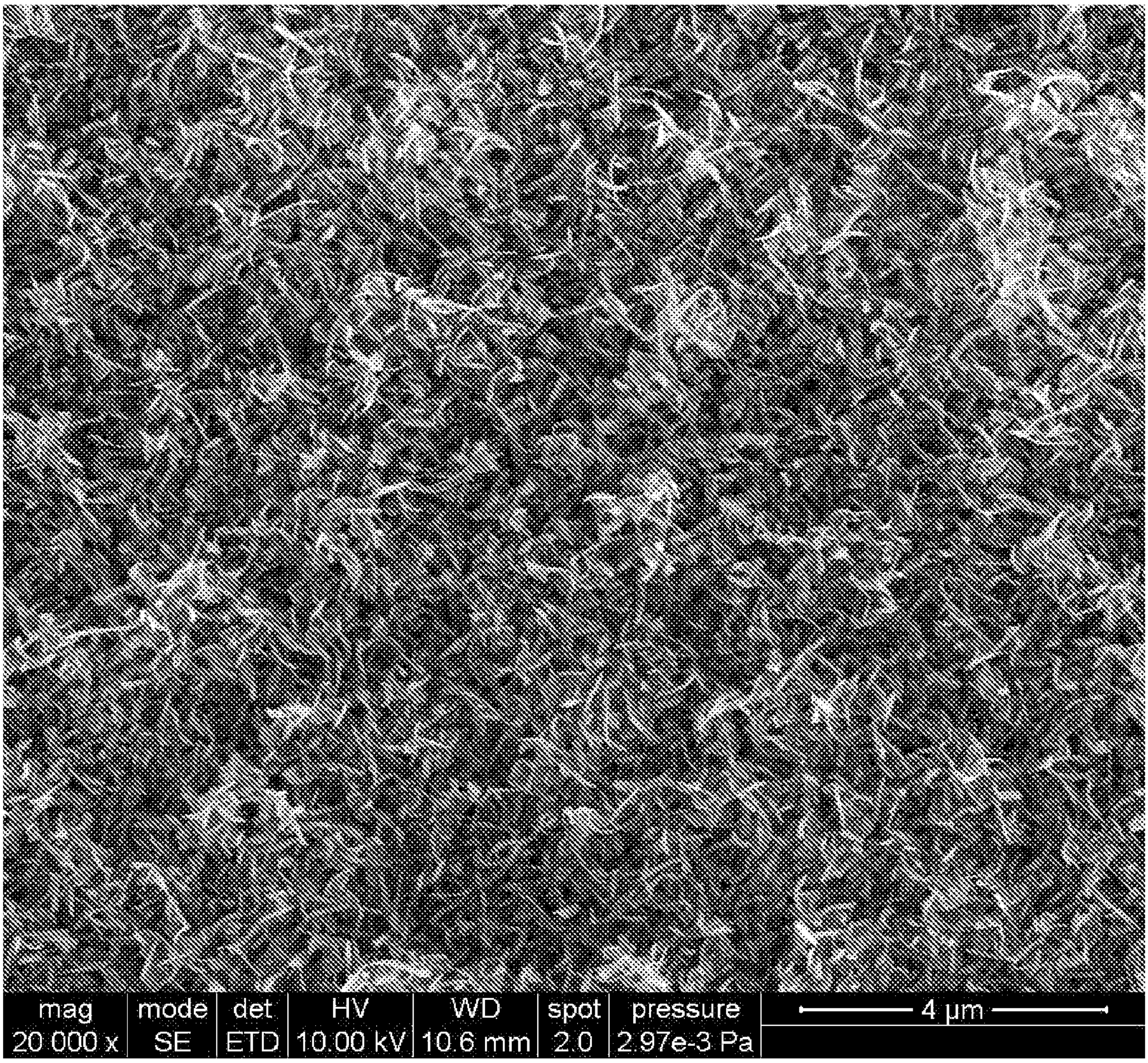
mag
20 000 x
mode
SE
det
ETD
HV
10.00 kV
WD
10.6 mm
spot
2.0
pressure
2.97e-3 Pa
4 µm
FIG. 38

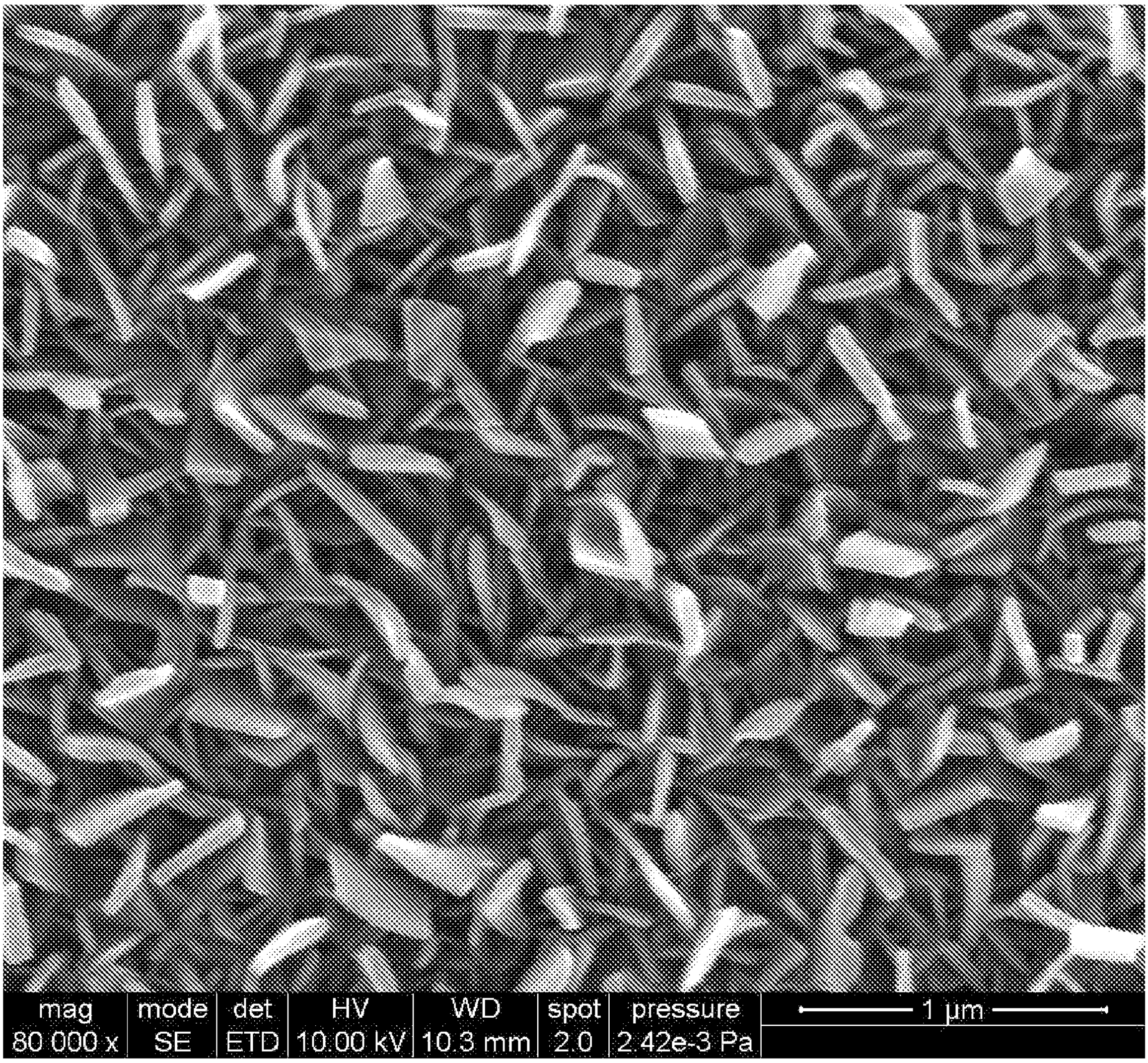
mag
80 000 x
mode
SE
det
ETD
HV
10.00 kV
WD
10.3 mm
spot
2.0
pressure
2.42e-3 Pa
1 µm

FIG. 39

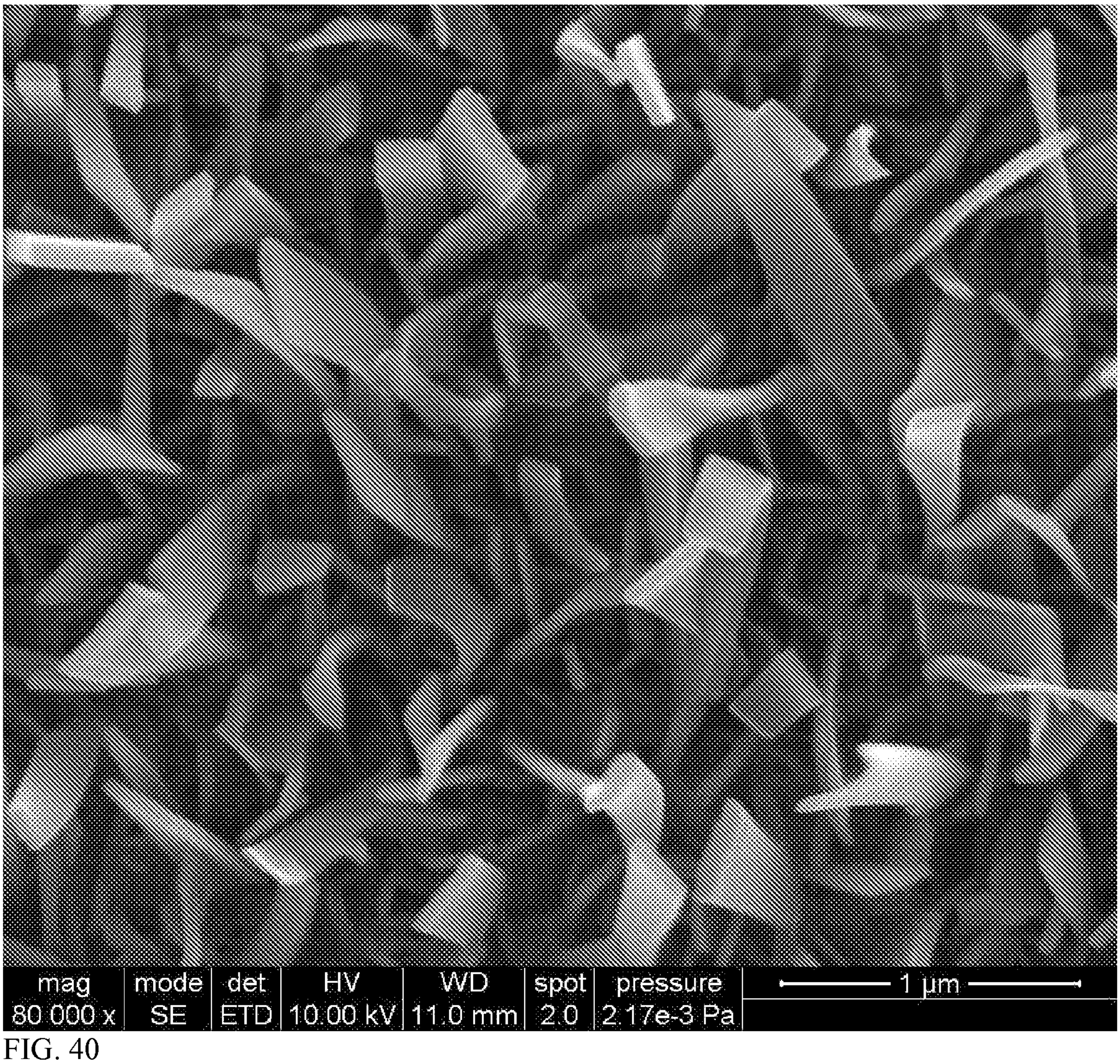
mag
80 000 x
mode
SE
det
ETD
HV
10.00 kV
WD
11.0 mm
spot
2.0
pressure
2.17e-3 Pa
1 μm
FIG. 40

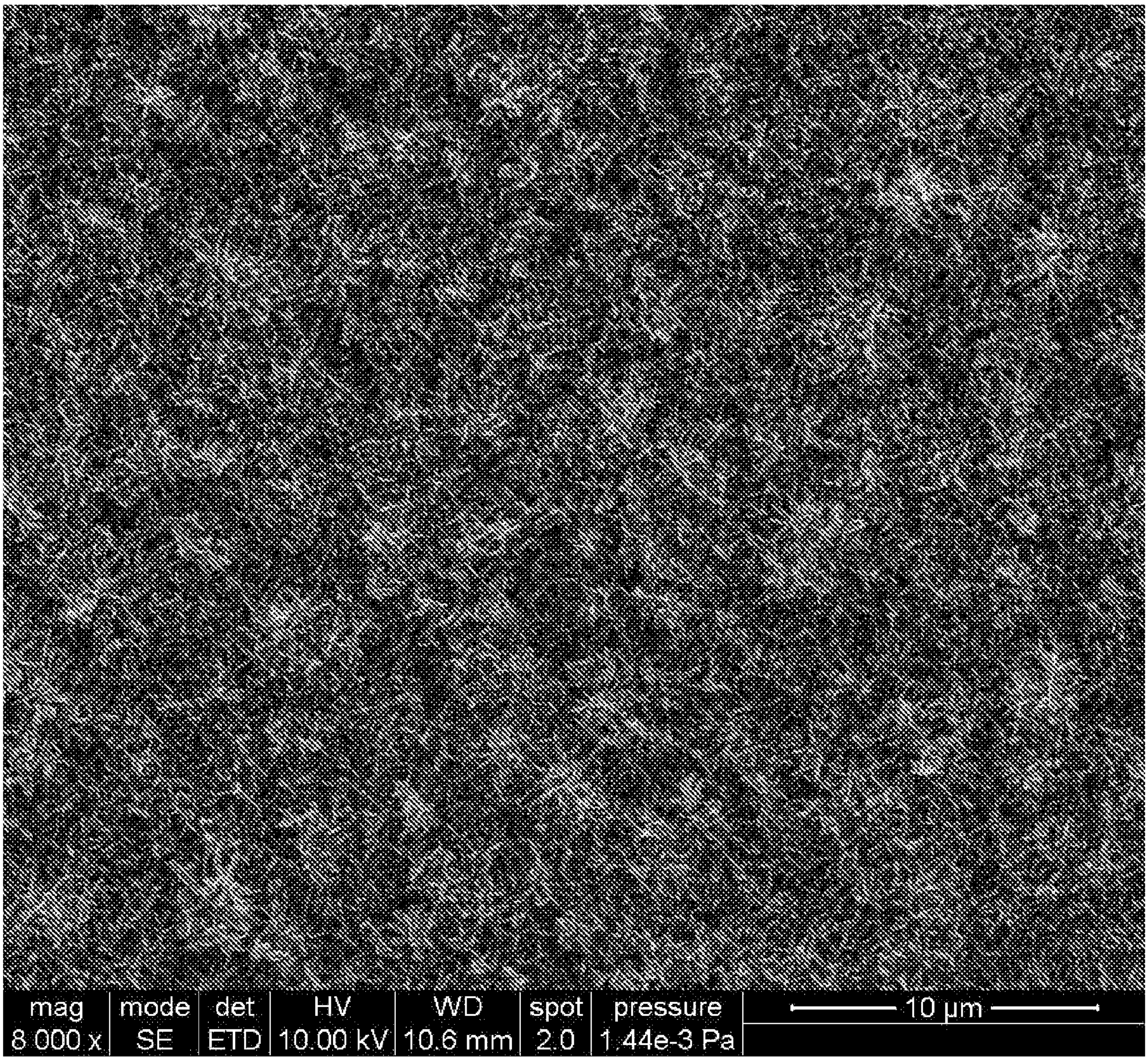
mag
8 000 x
mode
SE
det
ETD
HV
10.00 kV
WD
10.6 mm
spot
2.0
pressure
1.44e-3 Pa
10 µm
FIG. 41

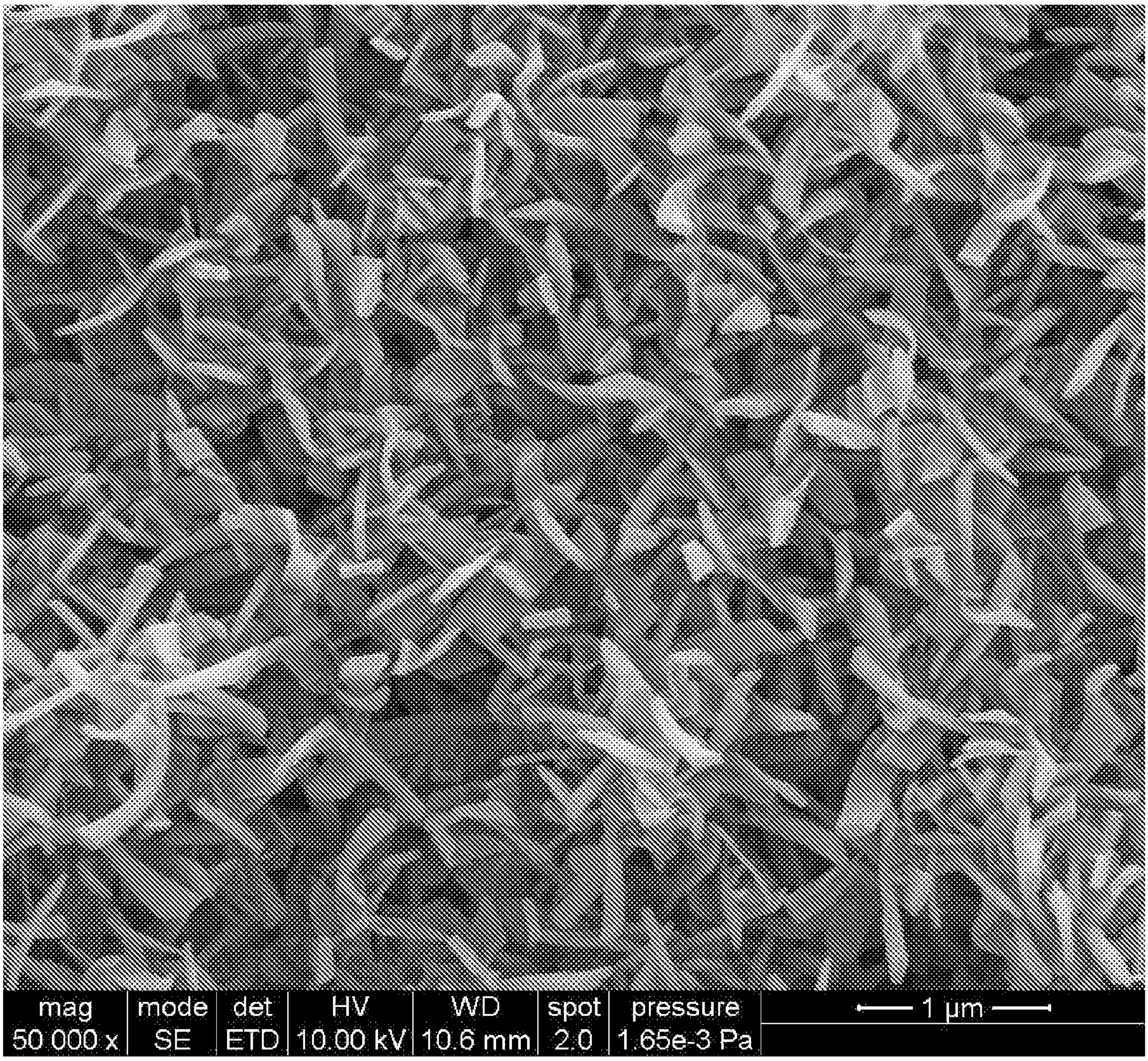
mag
50 000 x
mode
SE
det
ETD
HV
10.00 kV
WD
10.6 mm
spot
2.0
pressure
1.65e-3 Pa
1 µm
FIG. 42

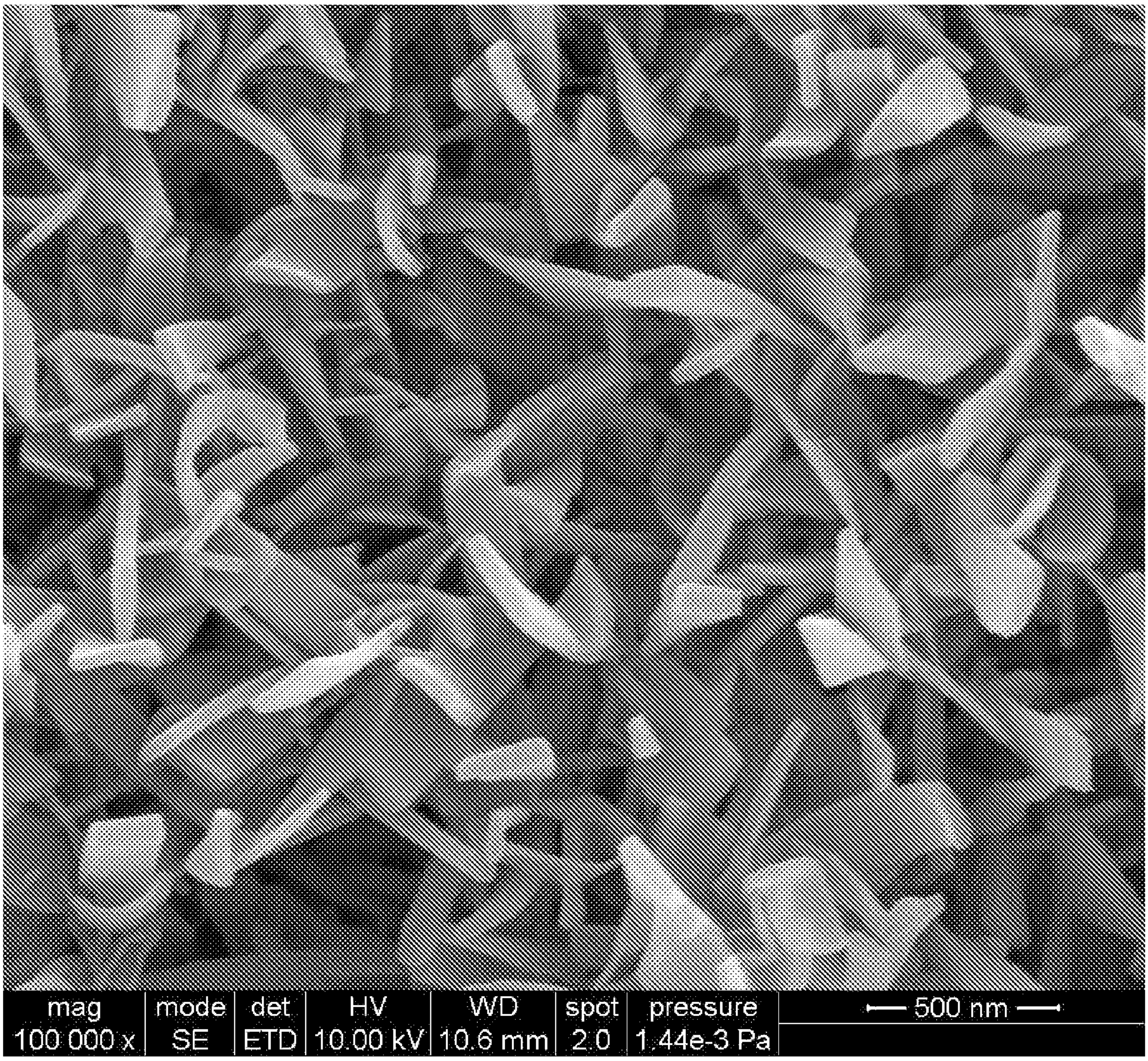
mag
100 000 x
mode
SE
det
ETD
HV
10.00 kV
WD
10.6 mm
spot
2.0
pressure
1.44e-3 Pa
500 nm

FIG. 43

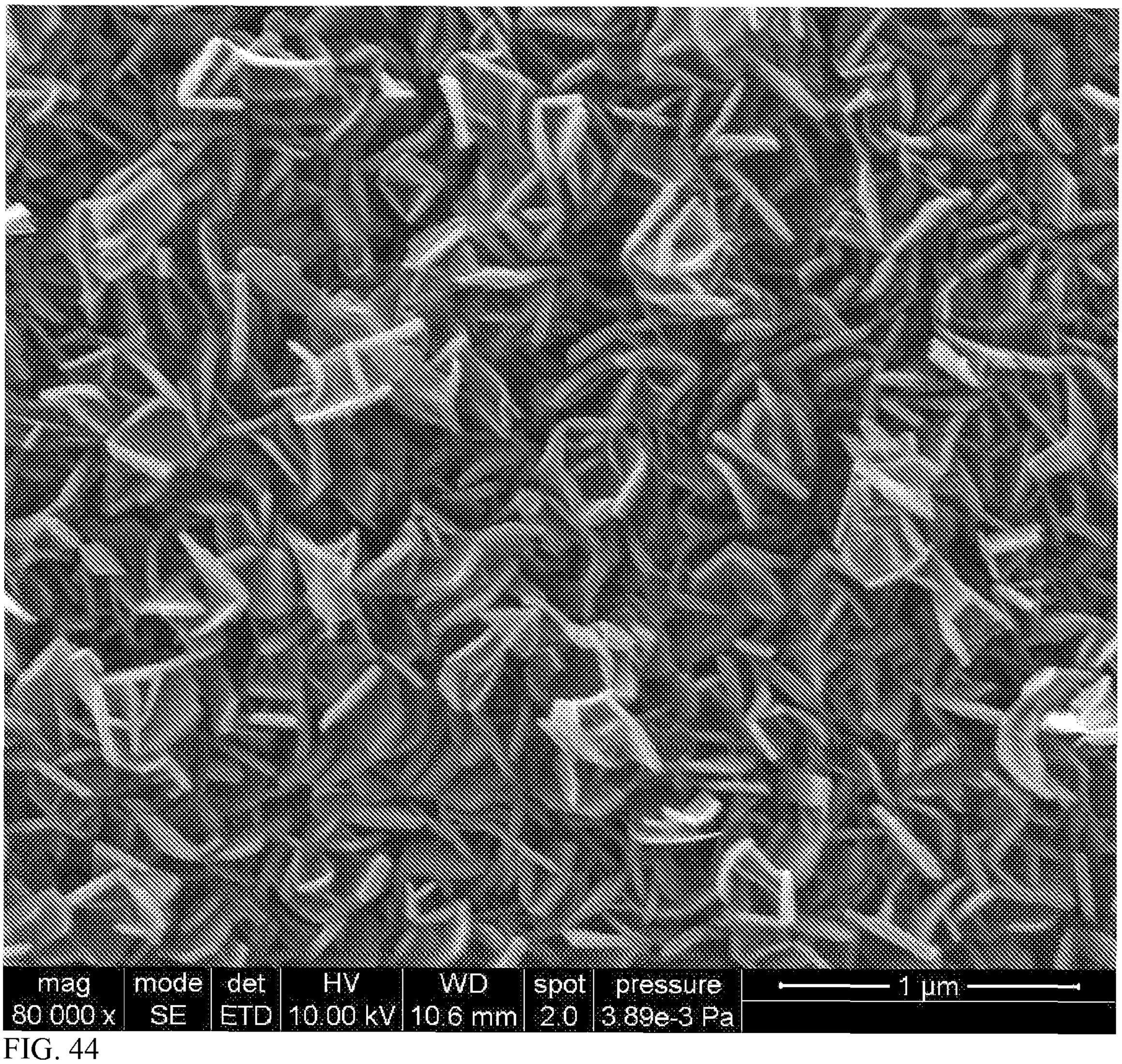
mag
80 000 x
mode
SE
det
ETD
HV
10.00 kV
WD
10.6 mm
spot
2.0
pressure
3.89e-3 Pa
1 µm

FIG. 44

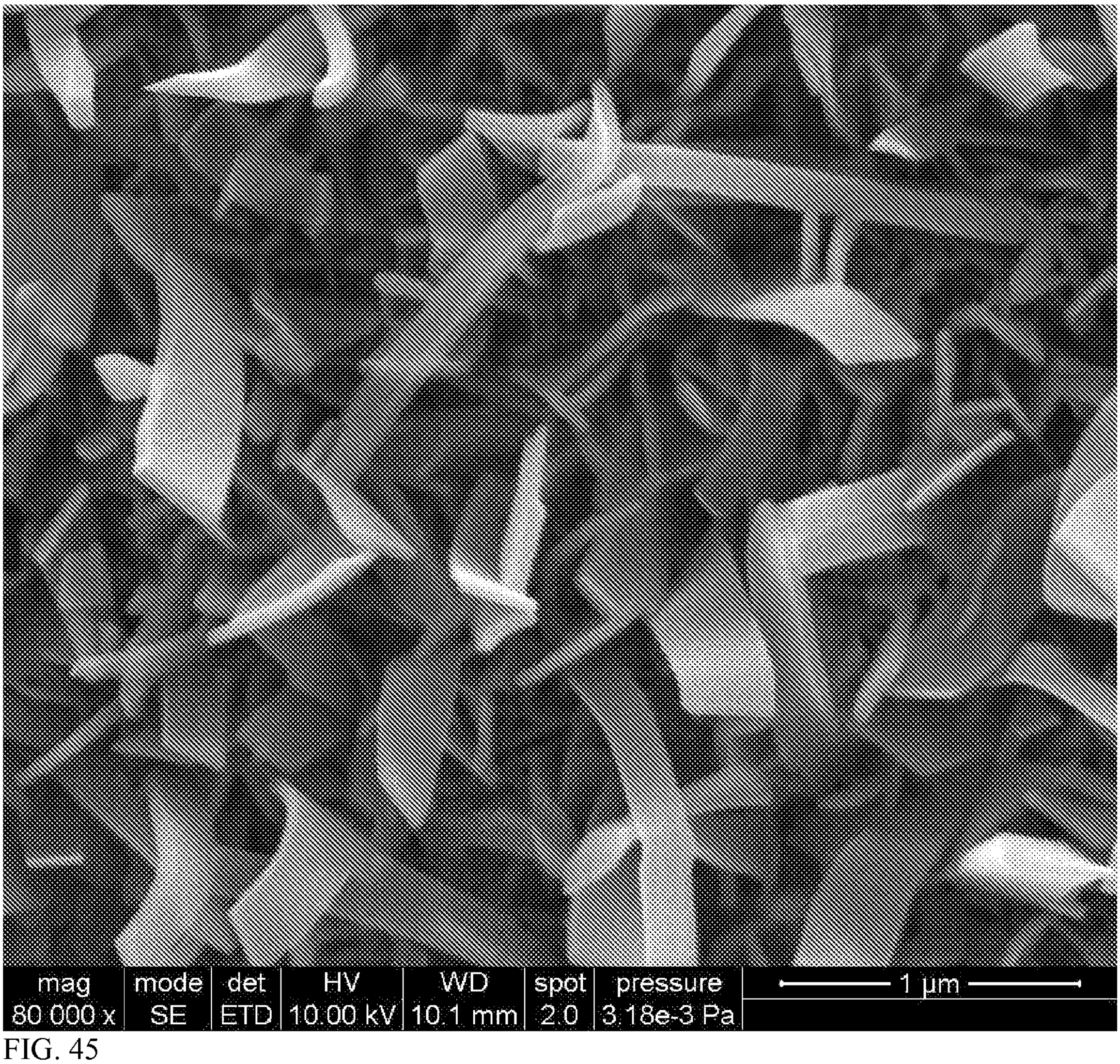
mag
80 000 x
mode
SE
det
ETD
HV
10.00 kV
WD
10.1 mm
spot
2.0
pressure
3.18e-3 Pa
1 μm
FIG. 45

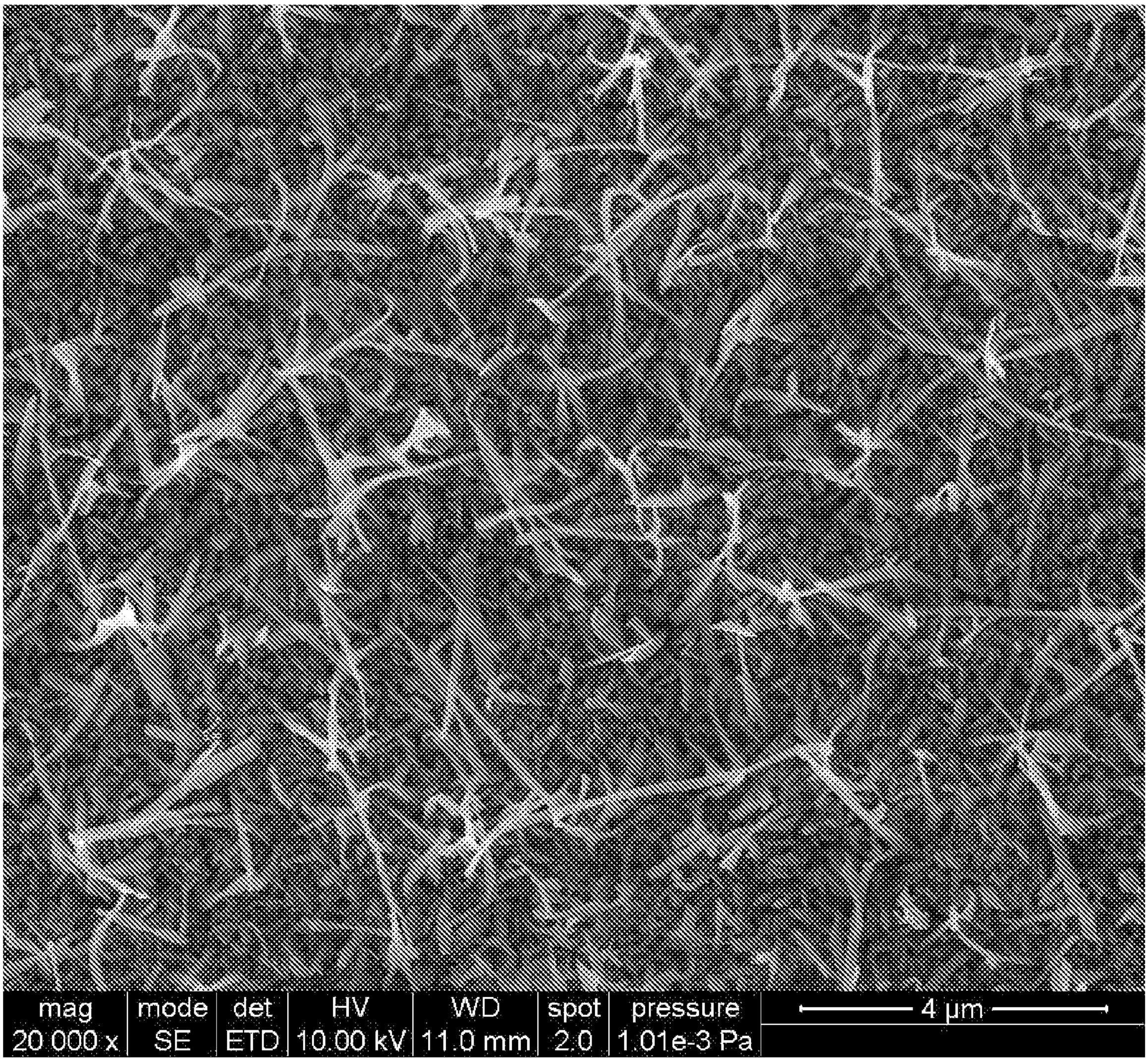
mag
20 000 x
mode
SE
det
ETD
HV
10.00 kV
WD
11.0 mm
spot
2.0
pressure
1.01e-3 Pa
4 μm
FIG. 46

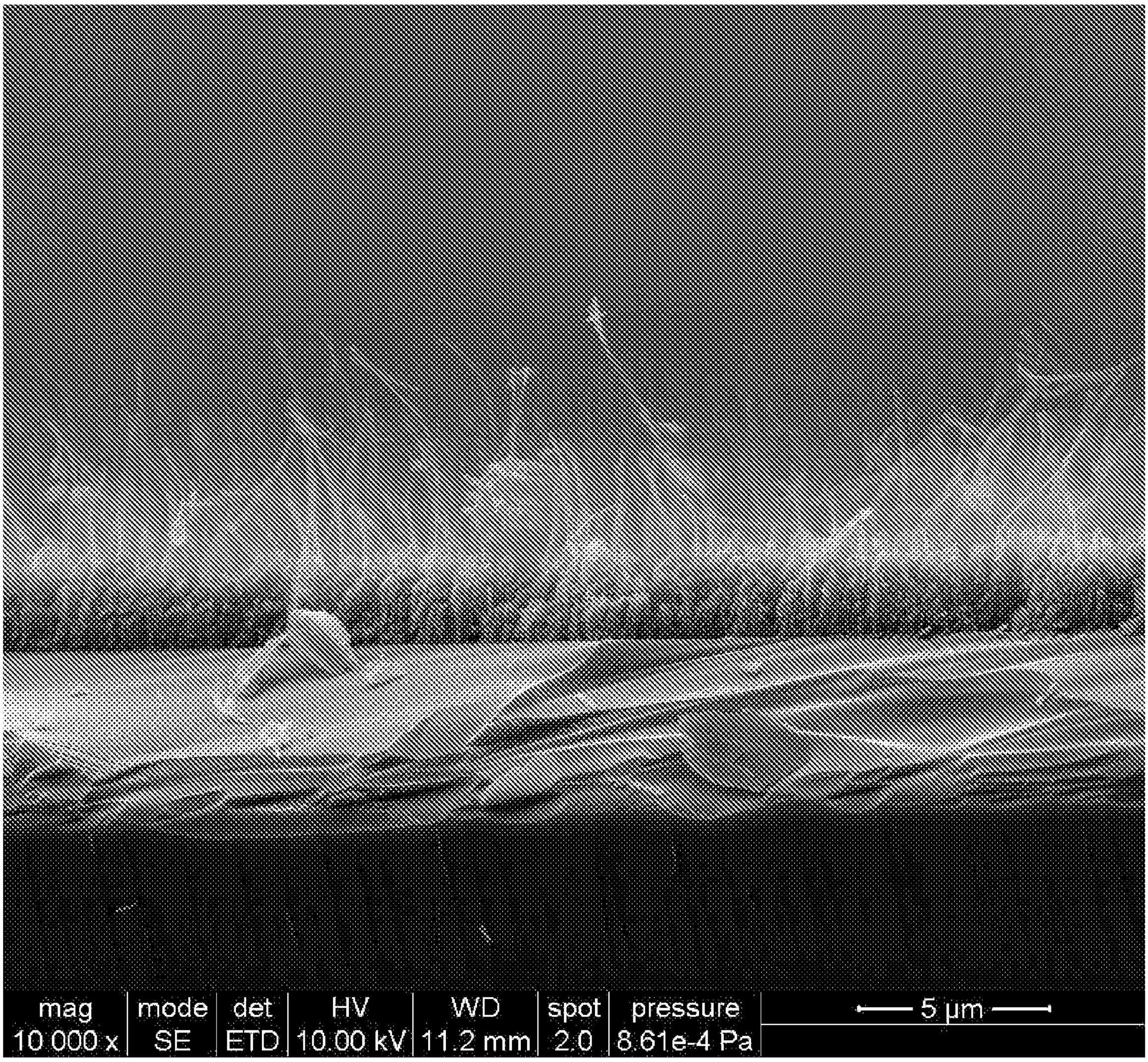
mag
10 000 x
mode
SE
det
ETD
HV
10.00 kV
WD
11.2 mm
spot
2.0
pressure
8.61e-4 Pa
5 µm
FIG. 47

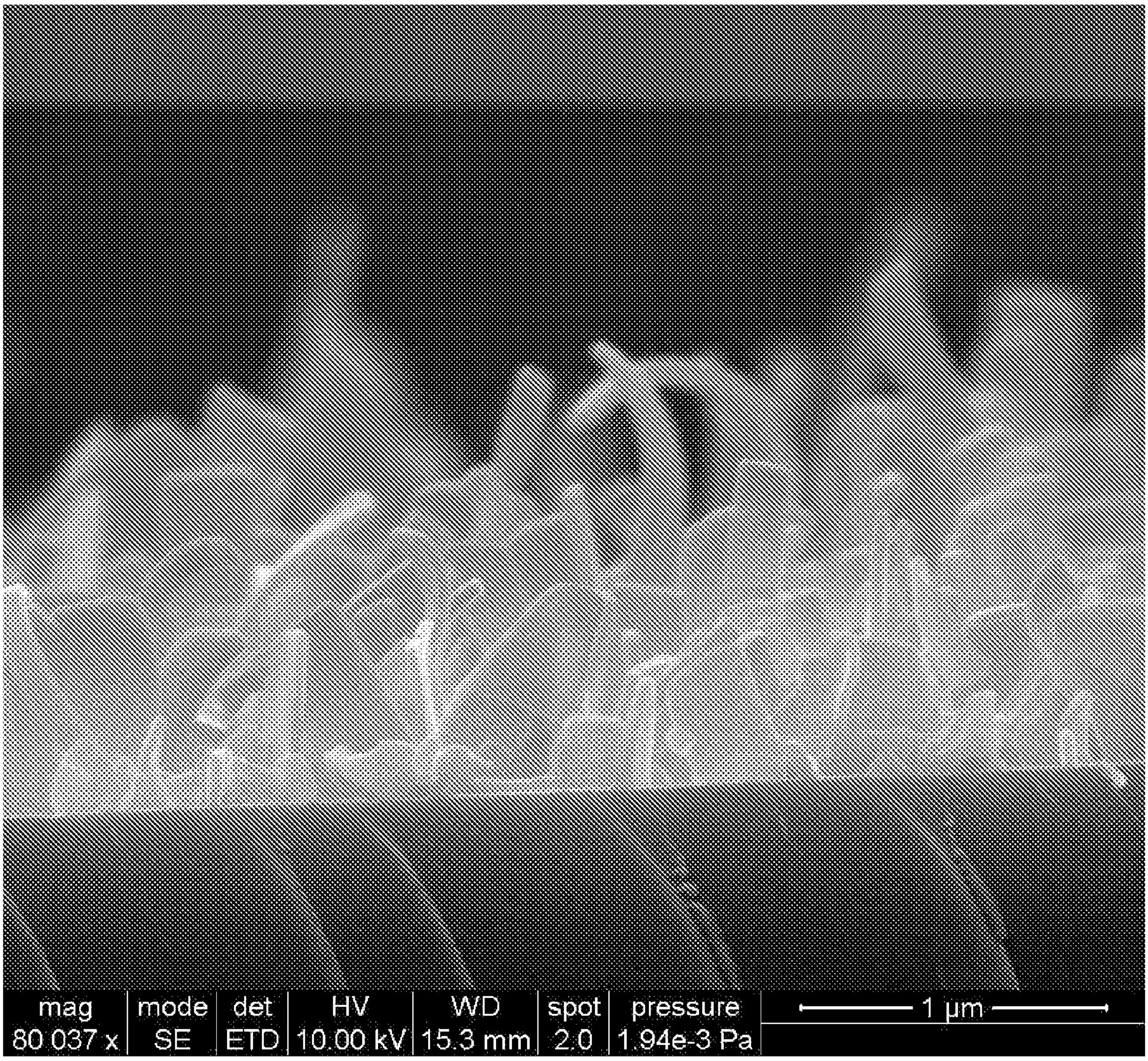
mag
80 037 x
mode
SE
det
ETD
HV
10.00 kV
WD
15.3 mm
spot
2.0
pressure
1.94e-3 Pa
1 μm

FIG. 48

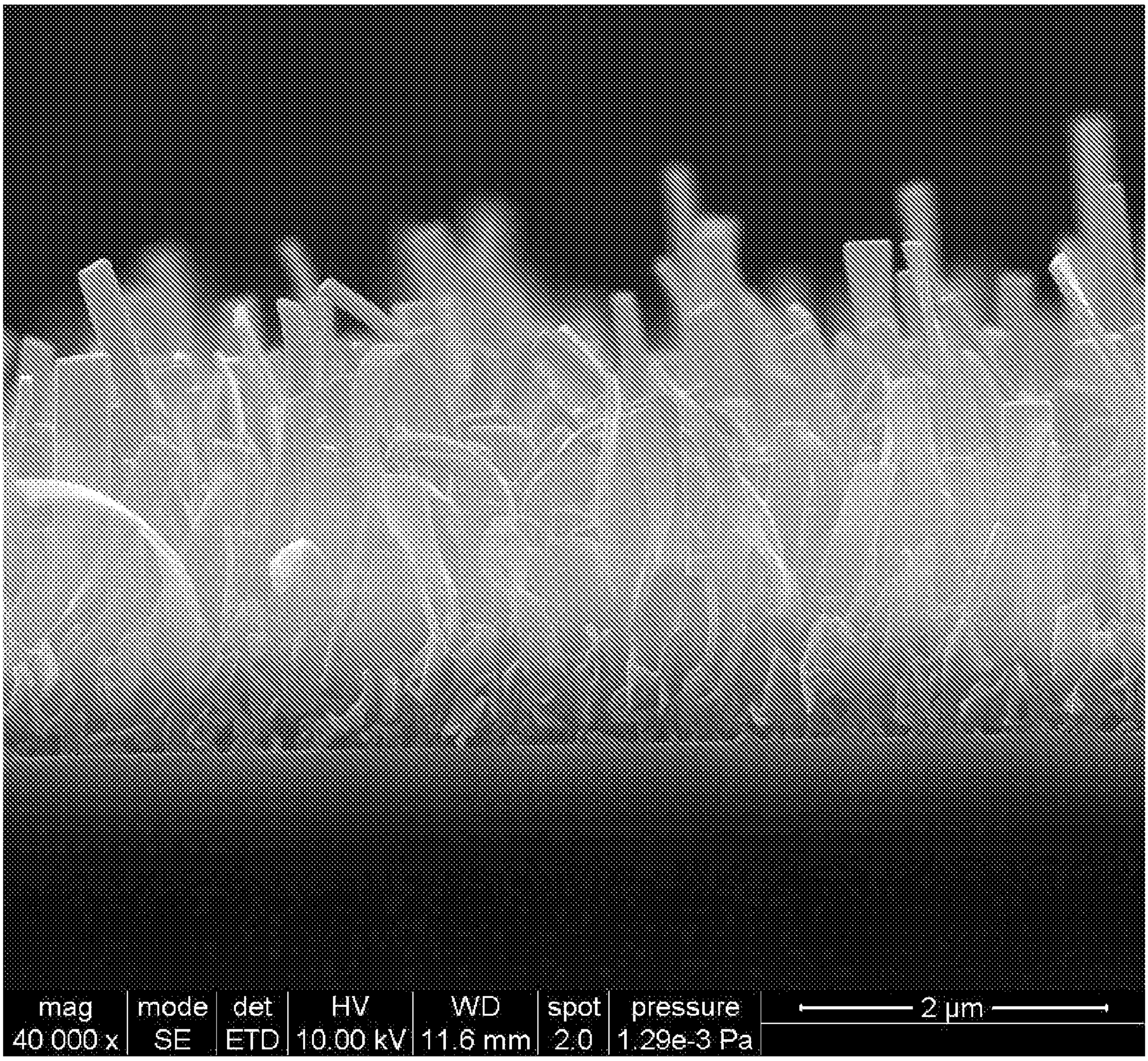
mag
40 000 x
mode
SE
det
ETD
HV
10.00 kV
WD
11.6 mm
spot
2.0
pressure
1.29e-3 Pa
2 µm
FIG. 49

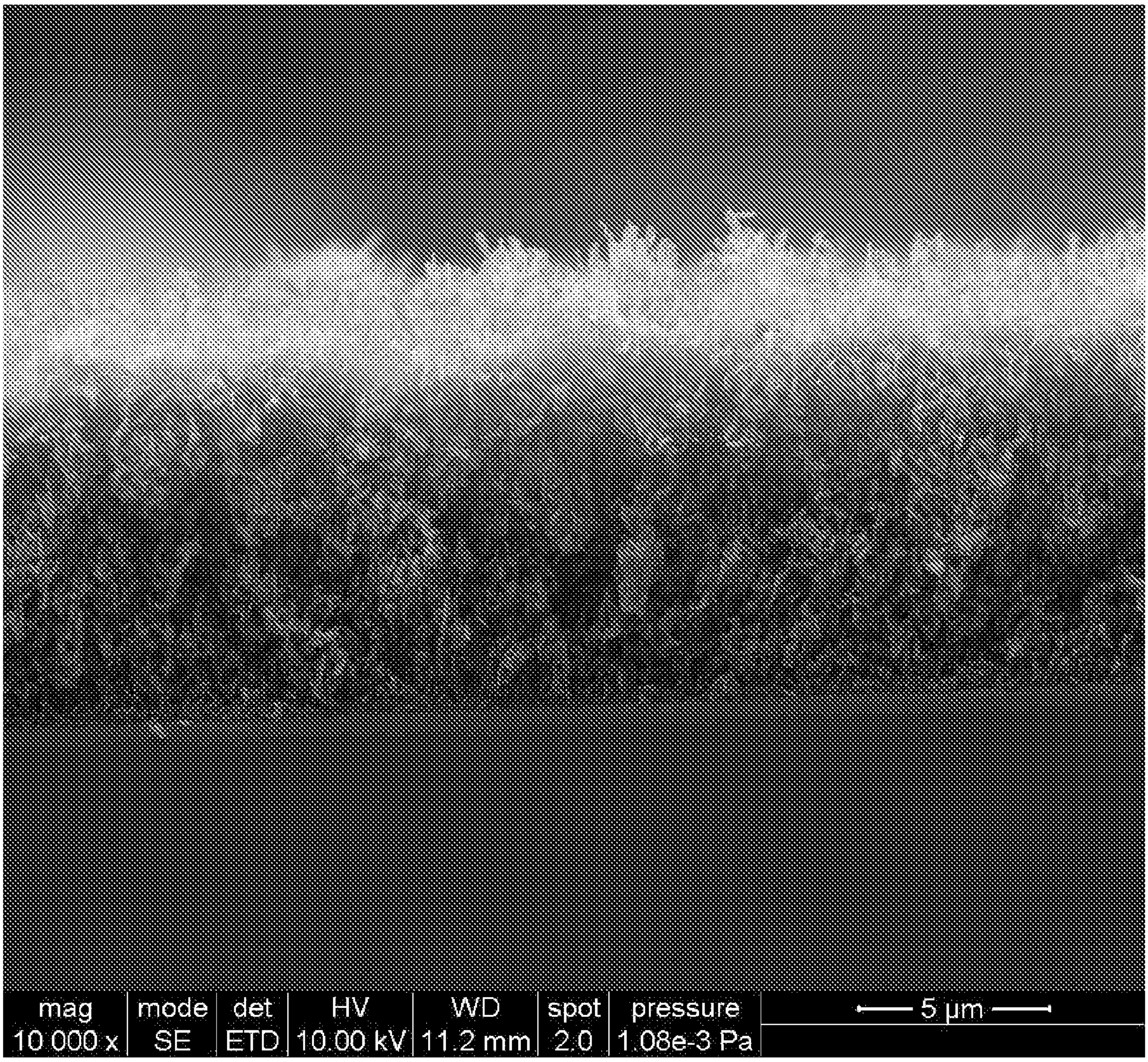
mag
10 000 x
mode
SE
det
ETD
HV
10.00 kV
WD
11.2 mm
spot
2.0
pressure
1.08e-3 Pa
5 μm
FIG. 50

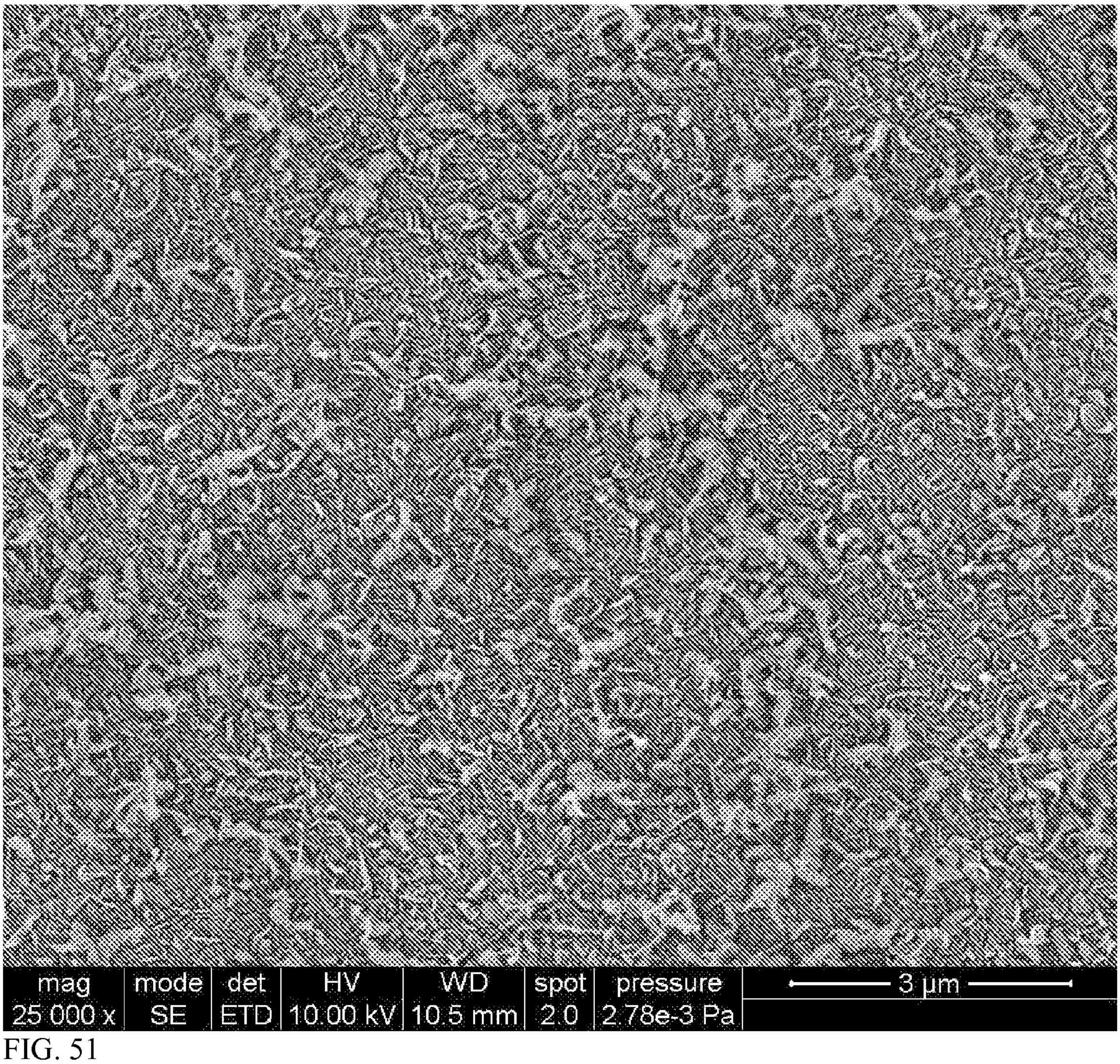
mag
25 000 x
mode
SE
det
ETD
HV
10.00 kV
WD
10.5 mm
spot
2.0
pressure
2.78e-3 Pa
3 μm

FIG. 51

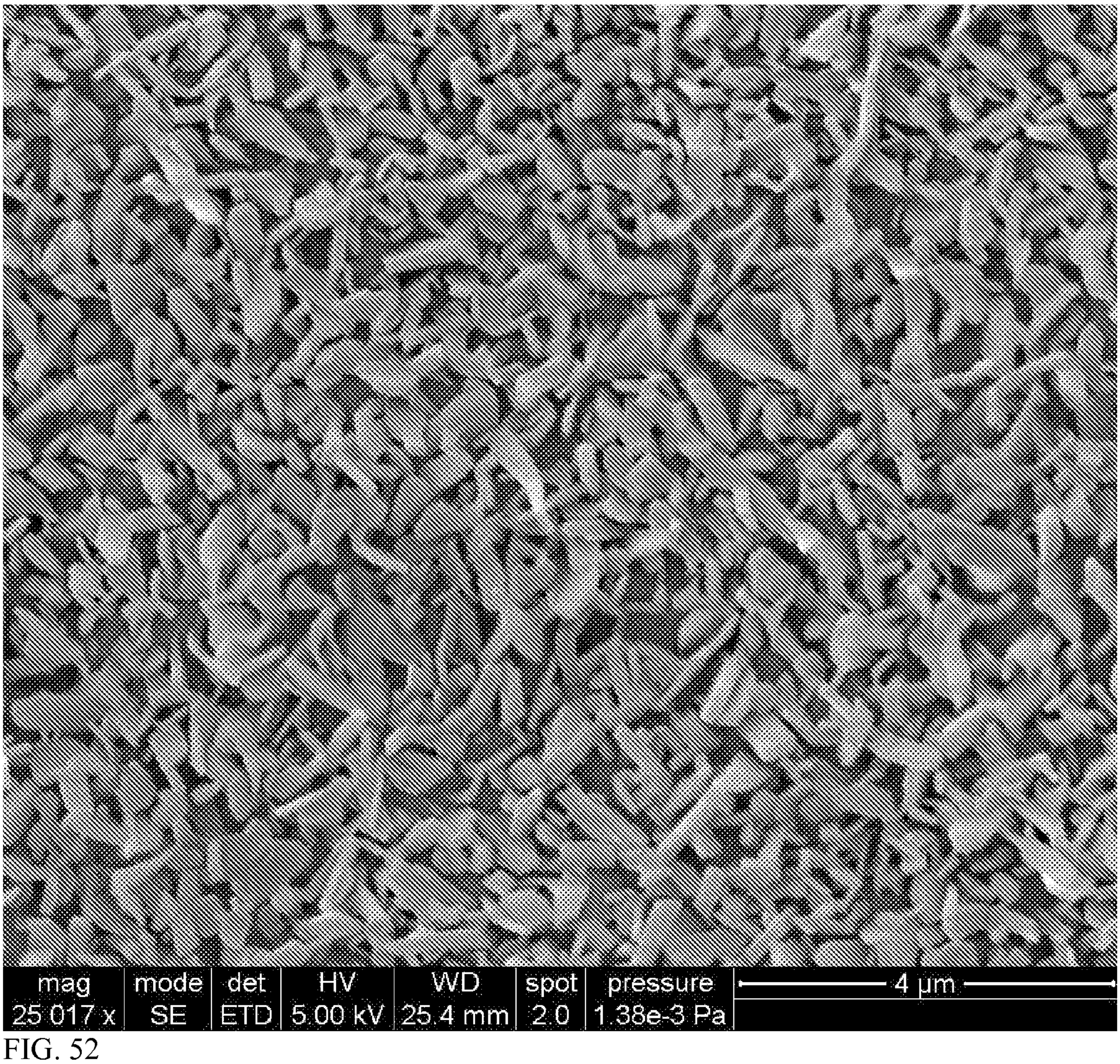
mag
25 017 x
mode
SE
det
ETD
HV
5.00 kV
WD
25.4 mm
spot
2.0
pressure
1.38e-3 Pa
4 μm
FIG. 52

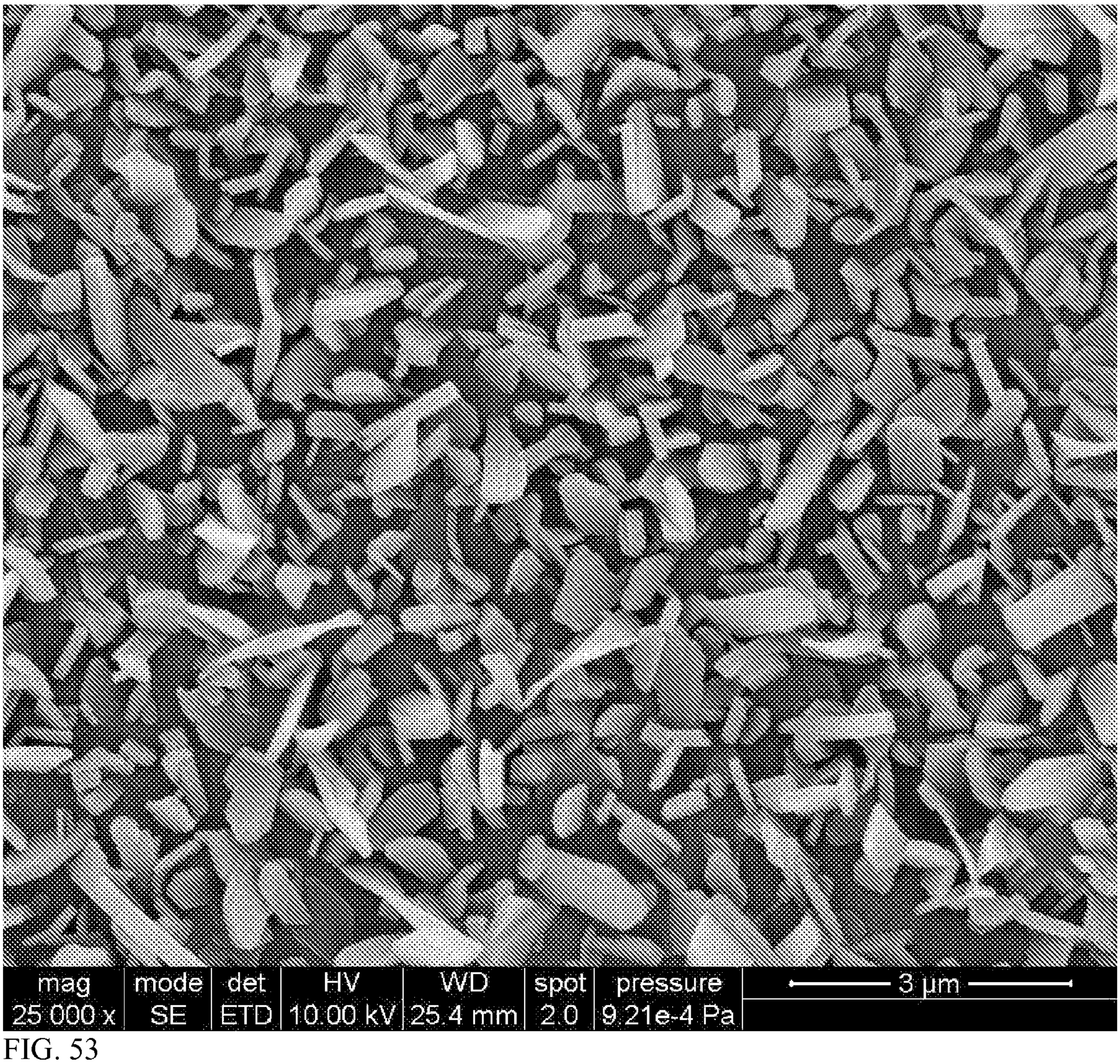
mag
25 000 x
mode
SE
det
ETD
HV
10.00 kV
WD
25.4 mm
spot
2.0
pressure
9.21e-4 Pa
3 µm

FIG. 53

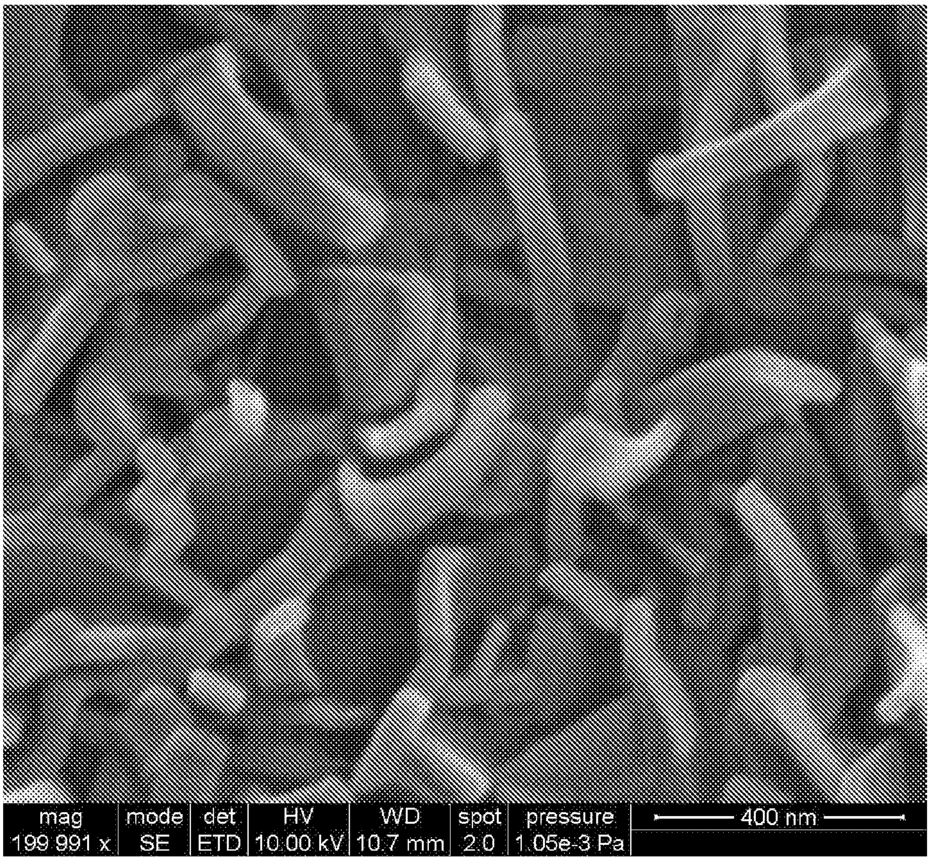
mag
199 991 x
mode
SE
det
ETD
HV
10.00 kV
WD
10.7 mm
spot
2.0
pressure
1.05e-3 Pa
400 nm

FIG. 54

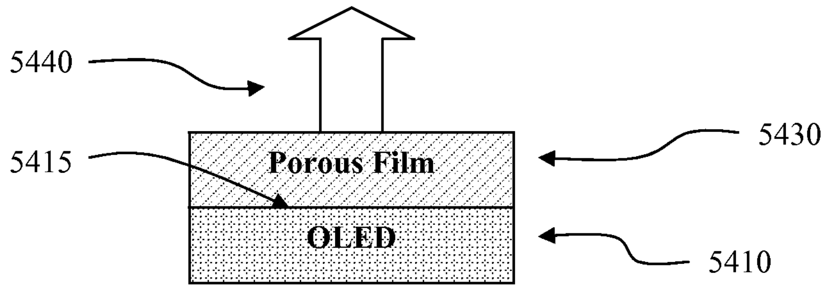
5440
5430
5415
Porous Film
OLED
5410

FIG. 55

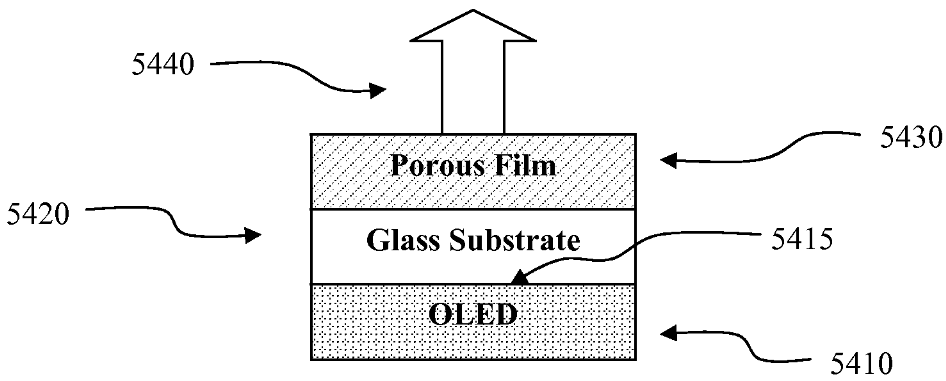
5440
5430
Porous Film
5420
Glass Substrate
5415
OLED
5410

FIG. 56

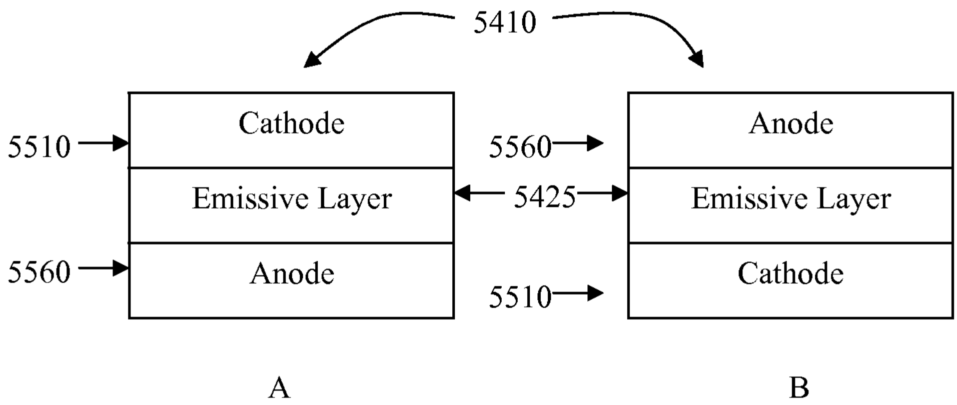
5410
5510
Cathode
Emissive Layer
5560
Anode
5560
Anode
5425
Emissive Layer
5510
Cathode
A
B

FIG. 57

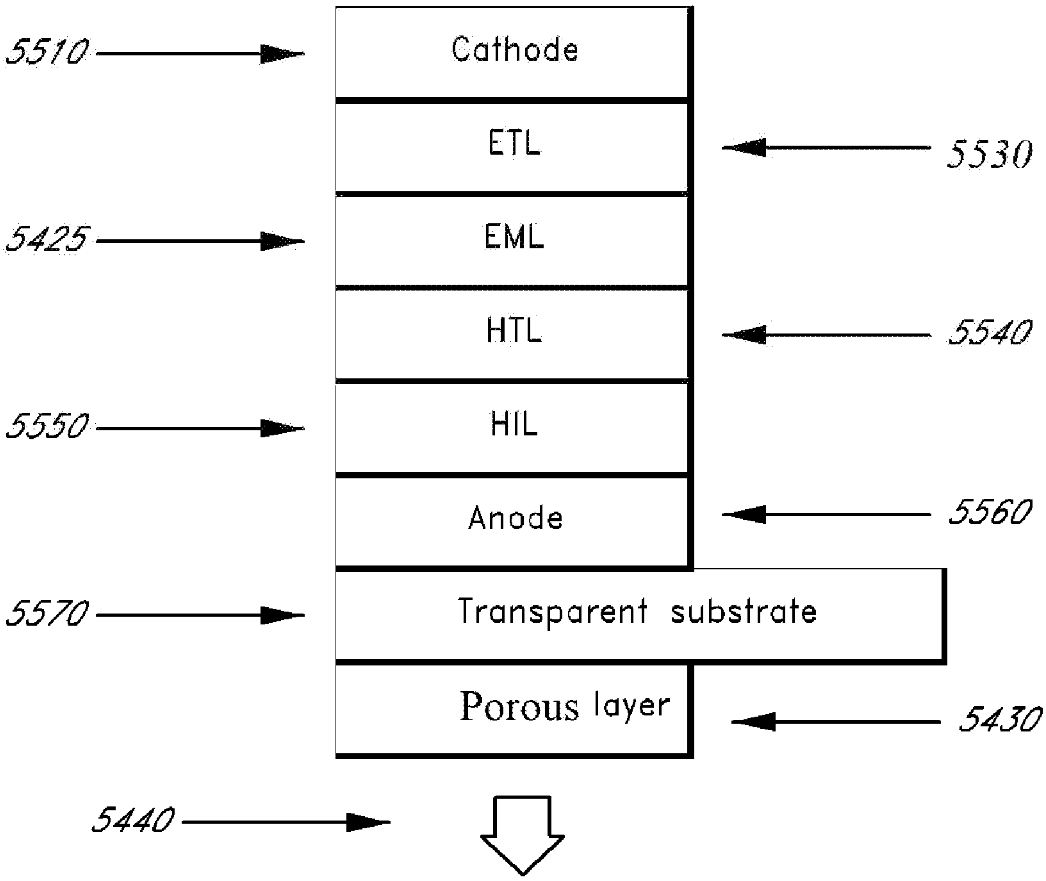
5510
Cathode
ETL
5530
5425
EML
HTL
5540
5550
HIL
Anode
5560
5570
Transparent substrate
Porous layer
5430
5440

FIG. 58

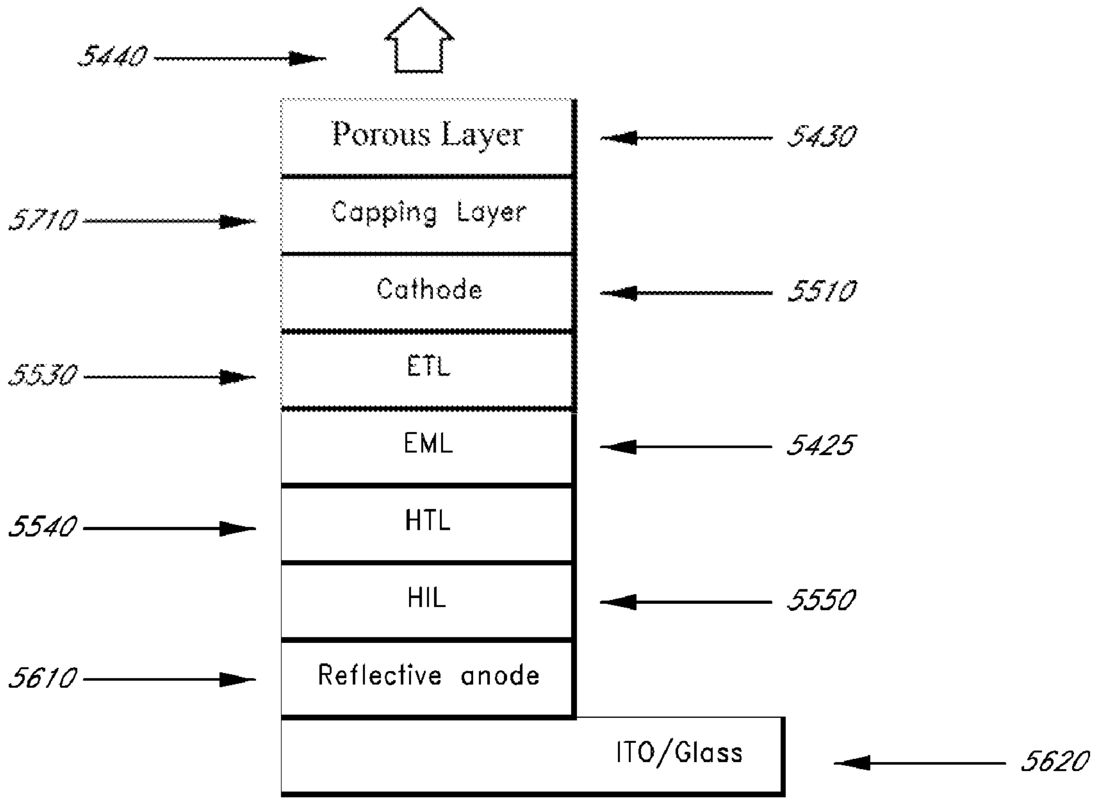
5440
Porous Layer
5430
5710
Capping Layer
Cathode
5510
5530
ETL
EML
5425
5540
HTL
HIL
5550
5610
Reflective anode
ITO/Glass
5620

FIG. 59

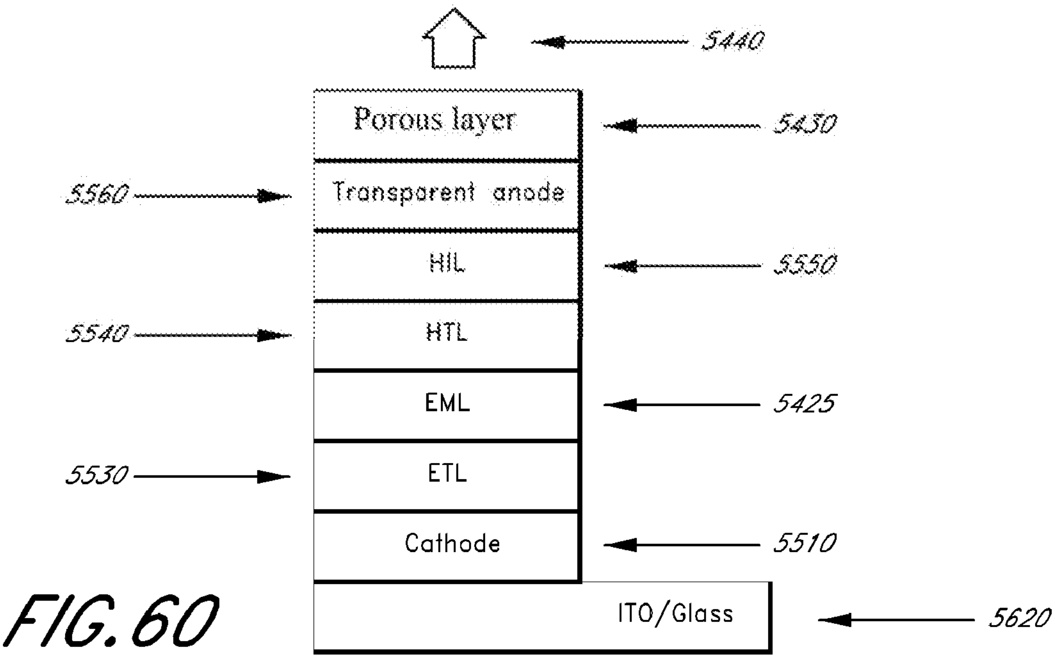
5440
Porous layer
5430
5560
Transparent anode
HIL
5550
5540
HTL
EML
5425
5530
ETL
Cathode
5510
ITO/Glass
5620

FIG. 60

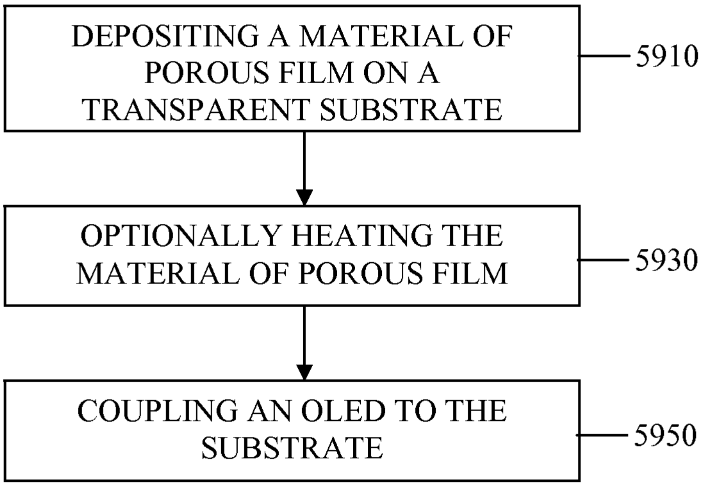
DEPOSITING A MATERIAL OF POROUS FILM ON A TRANSPARENT SUBSTRATE
5910
OPTIONALLY HEATING THE MATERIAL OF POROUS FILM
5930
COUPLING AN OLED TO THE SUBSTRATE
5950

*FIG. 61*

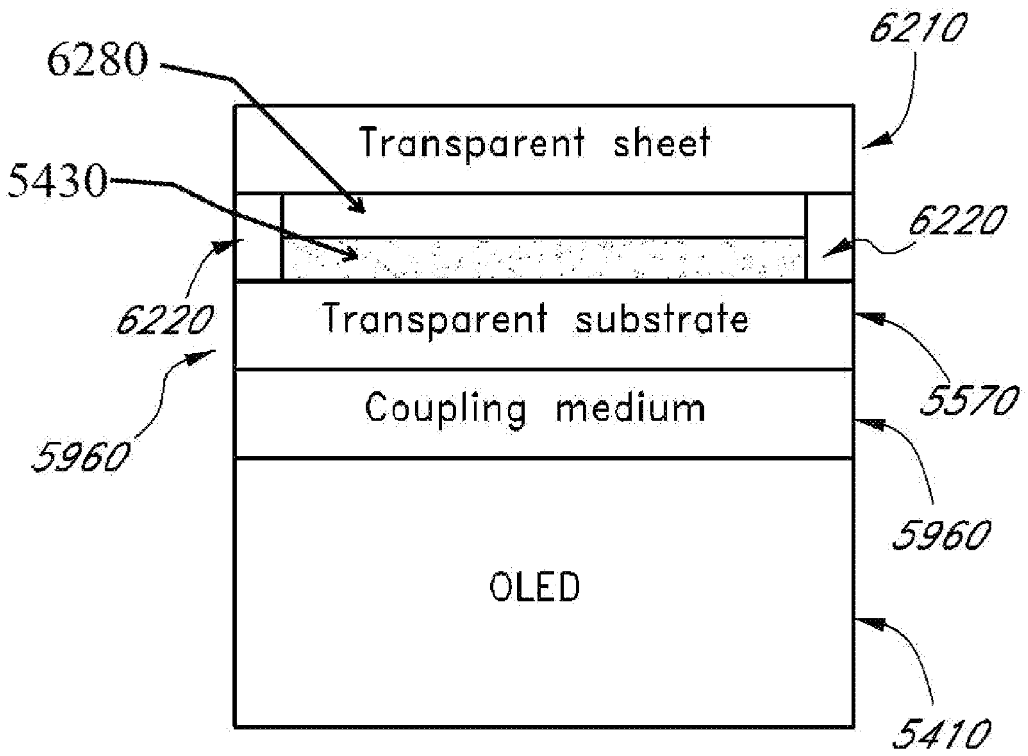


FIG. 62A

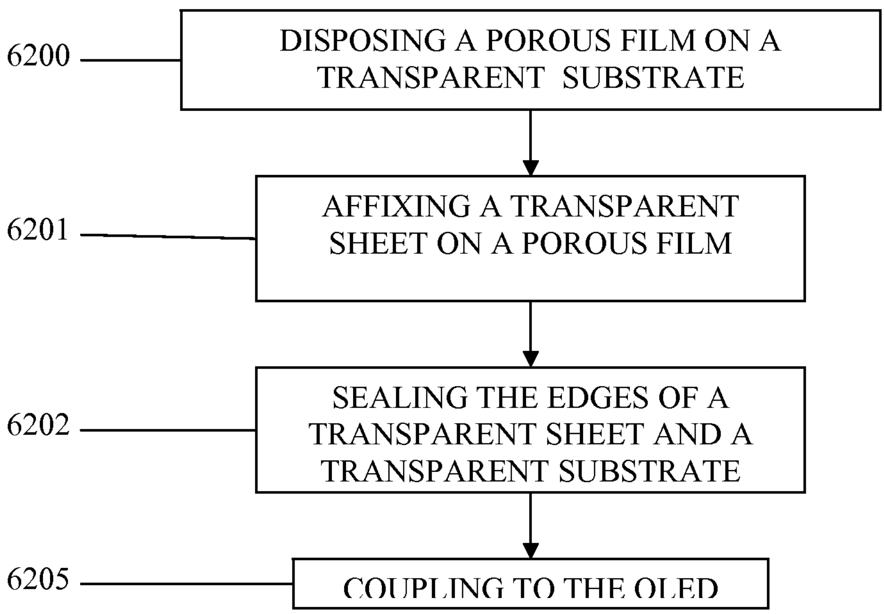


FIG. 62B

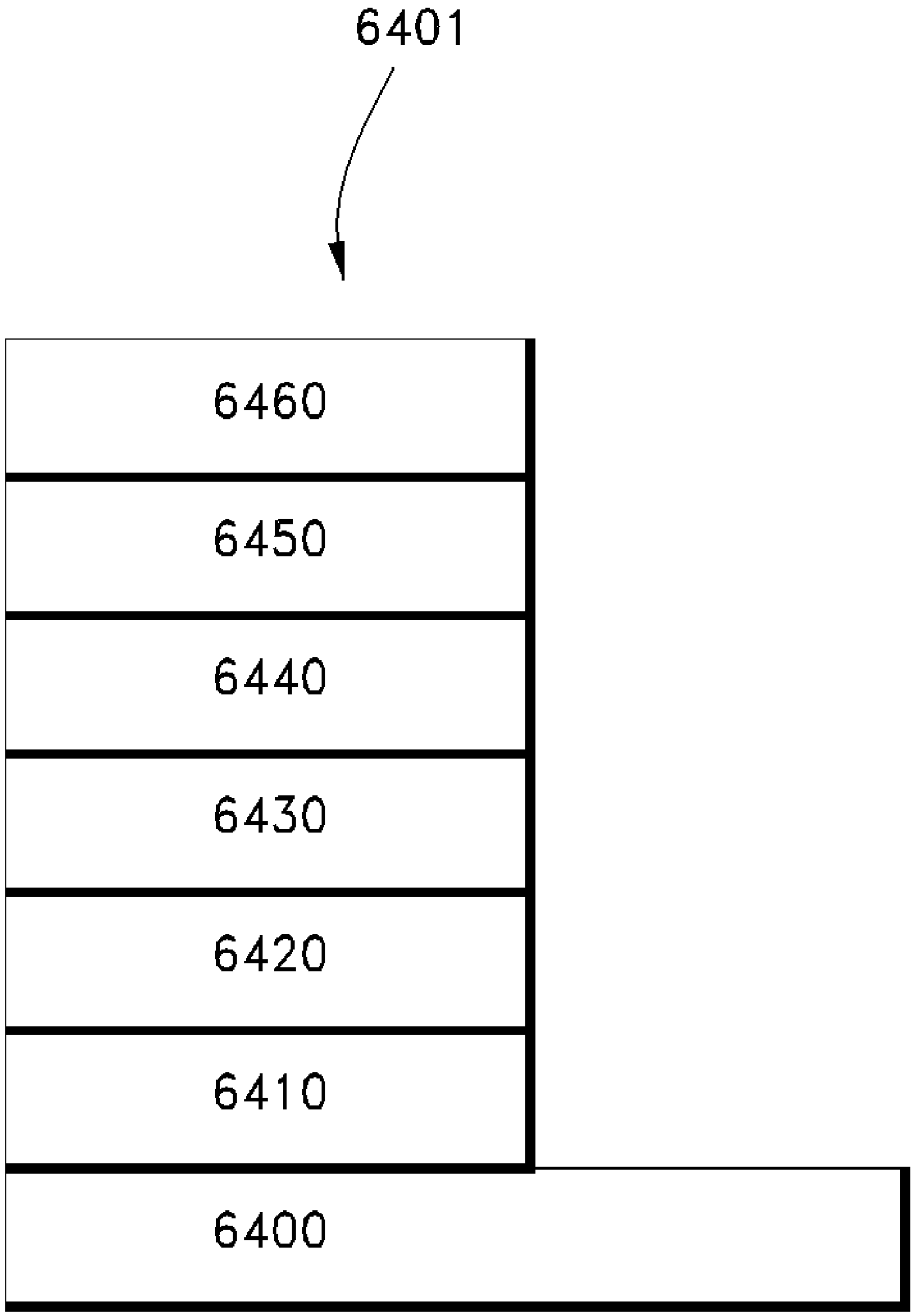


FIG. 63

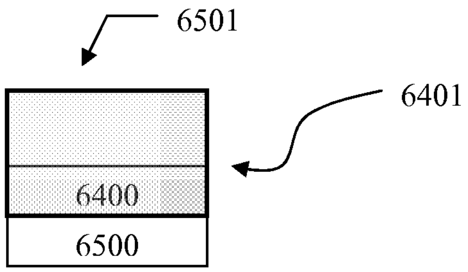


FIG. 64

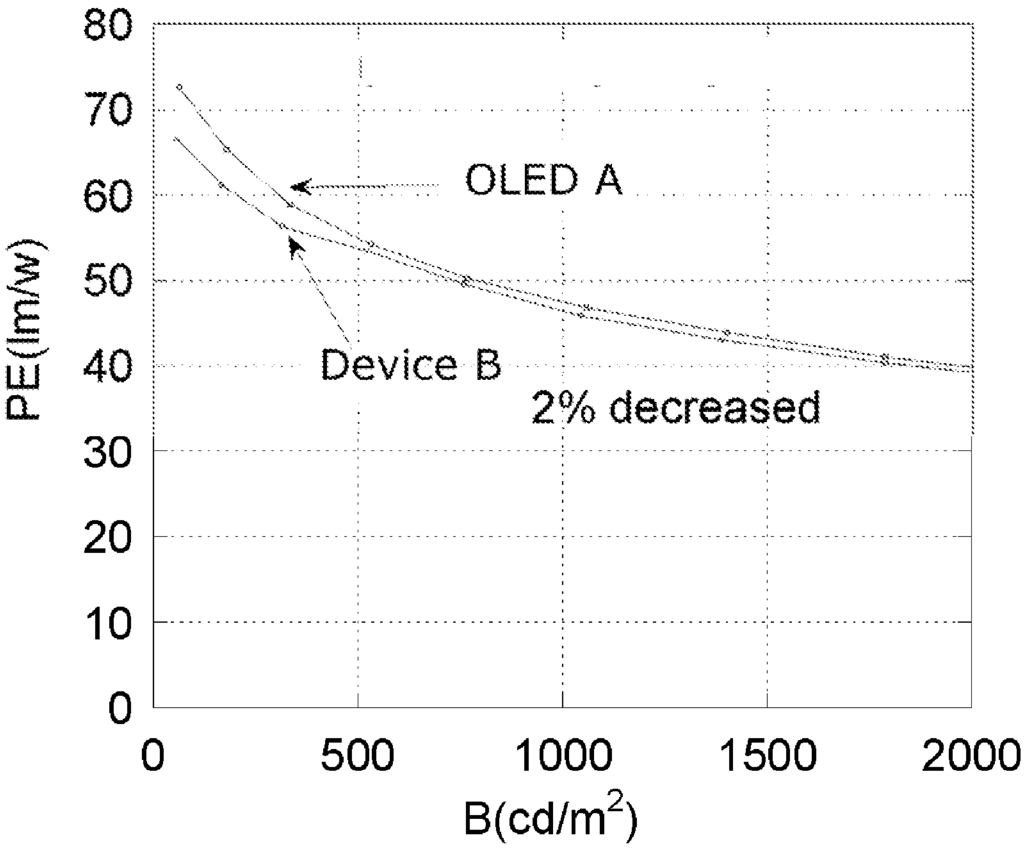


FIG. 65

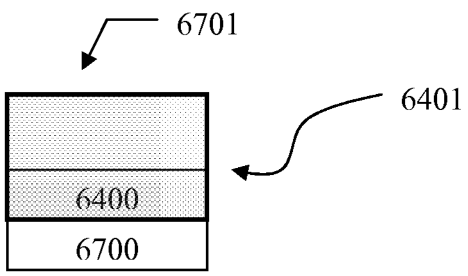


FIG. 66

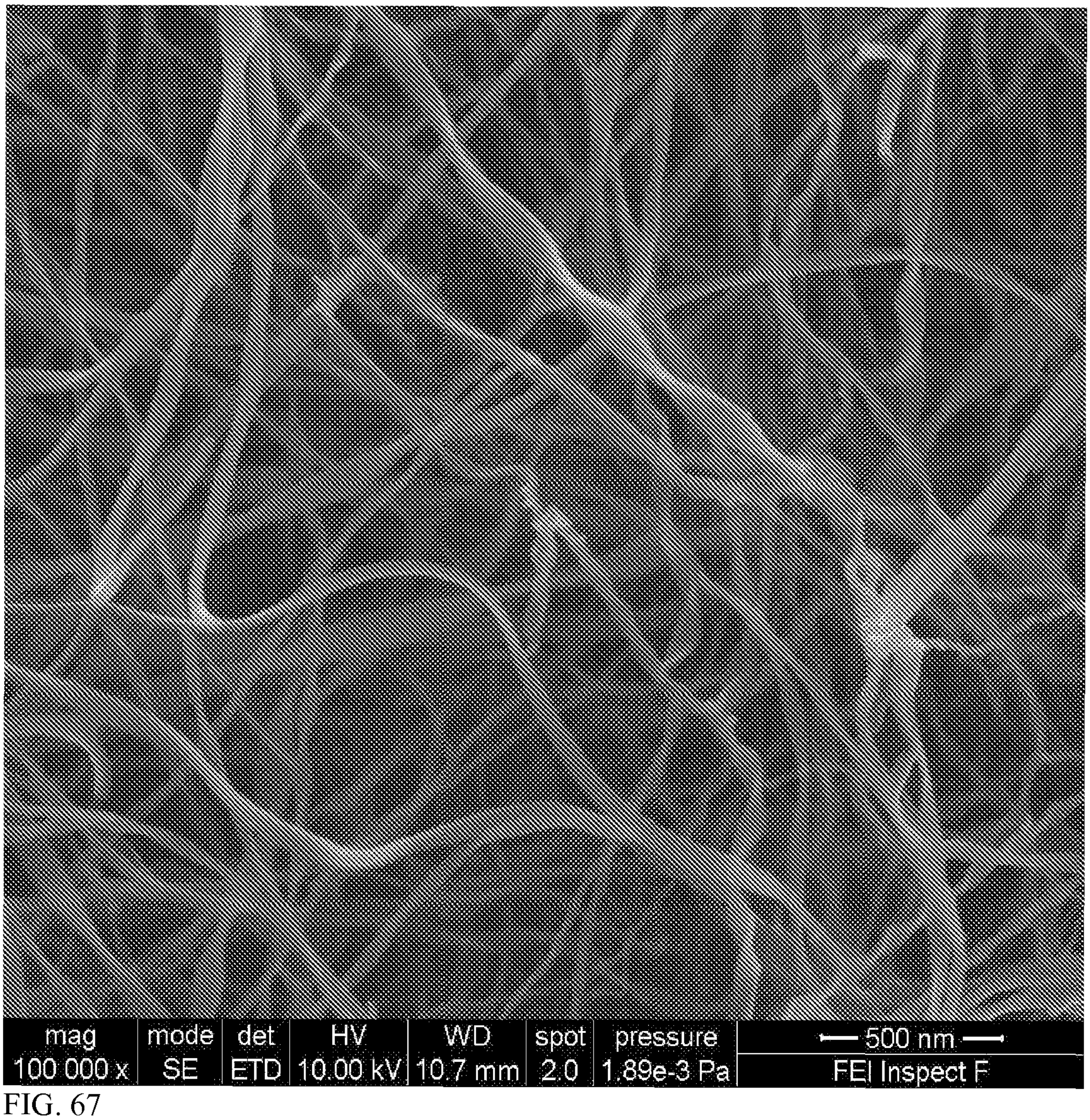
mag
100 000 x
mode
SE
det
ETD
HV
10.00 kV
WD
10.7 mm
spot
2.0
pressure
1.89e-3 Pa
500 nm
FEI Inspect F

FIG. 67

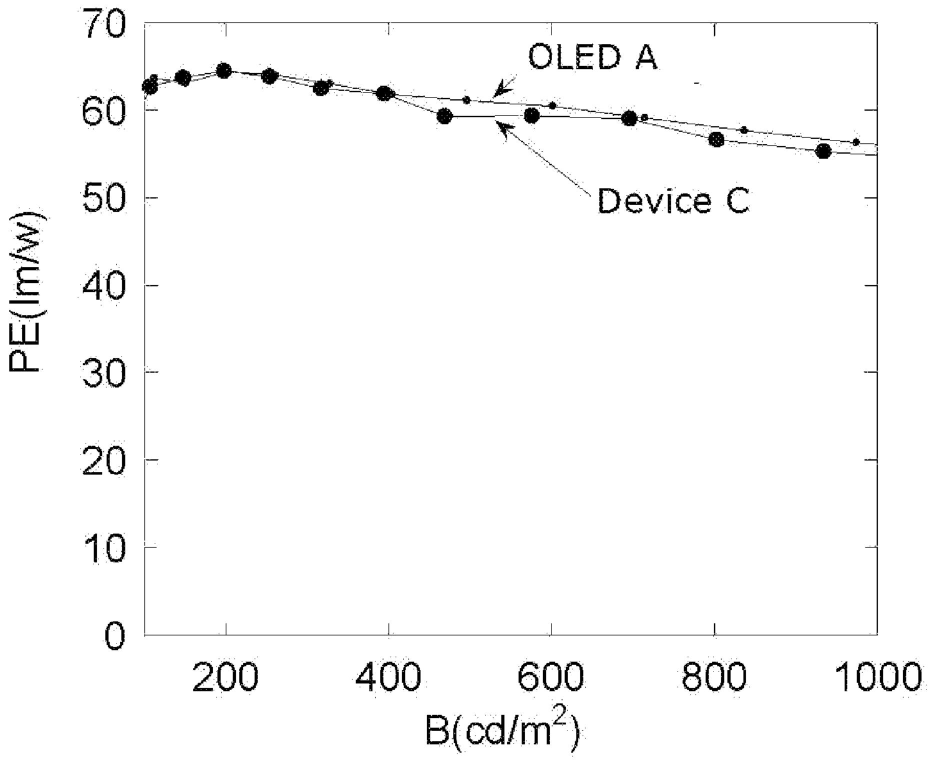
70
60
50
40
30
20
10
0
PE(lm/w)
OLED A
Device C
200
400
600
800
1000
B(cd/m2)

FIG. 68

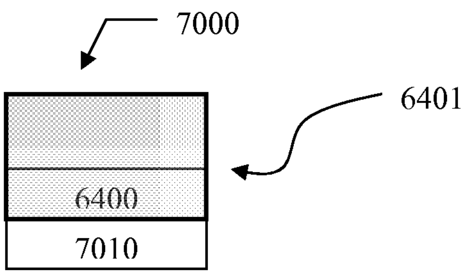
7000
6401
6400
7010

FIG. 69

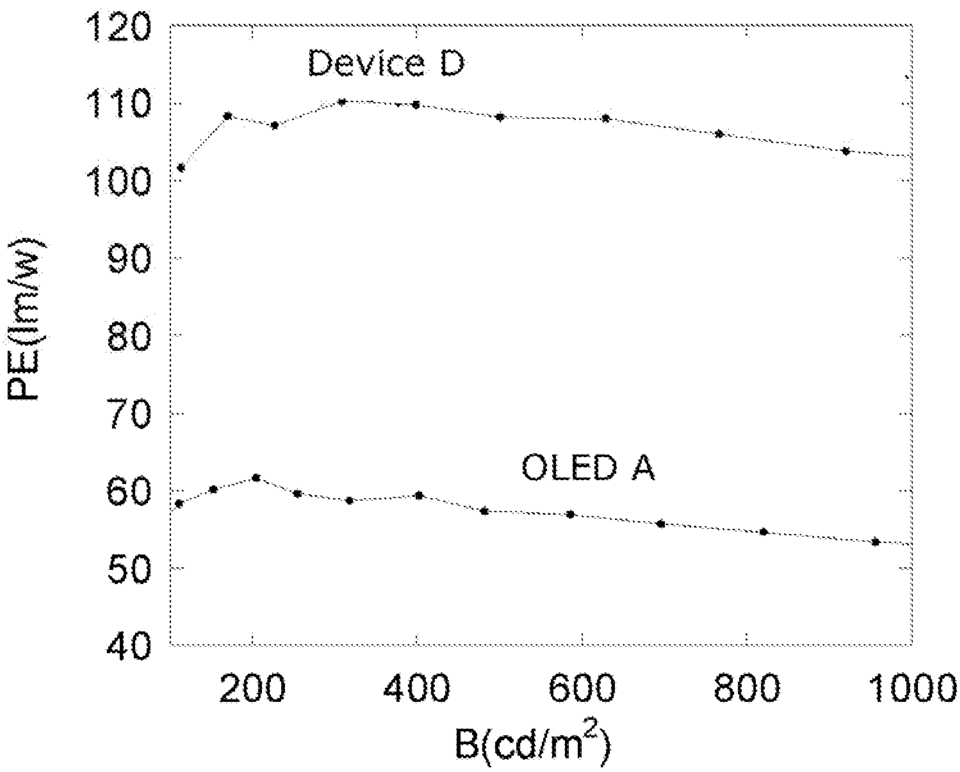
Device D
OLED A
PE(lm/w)
B(cd/m2)
120
110
100
90
80
70
60
50
40
200
400
600
800
1000

FIG. 70

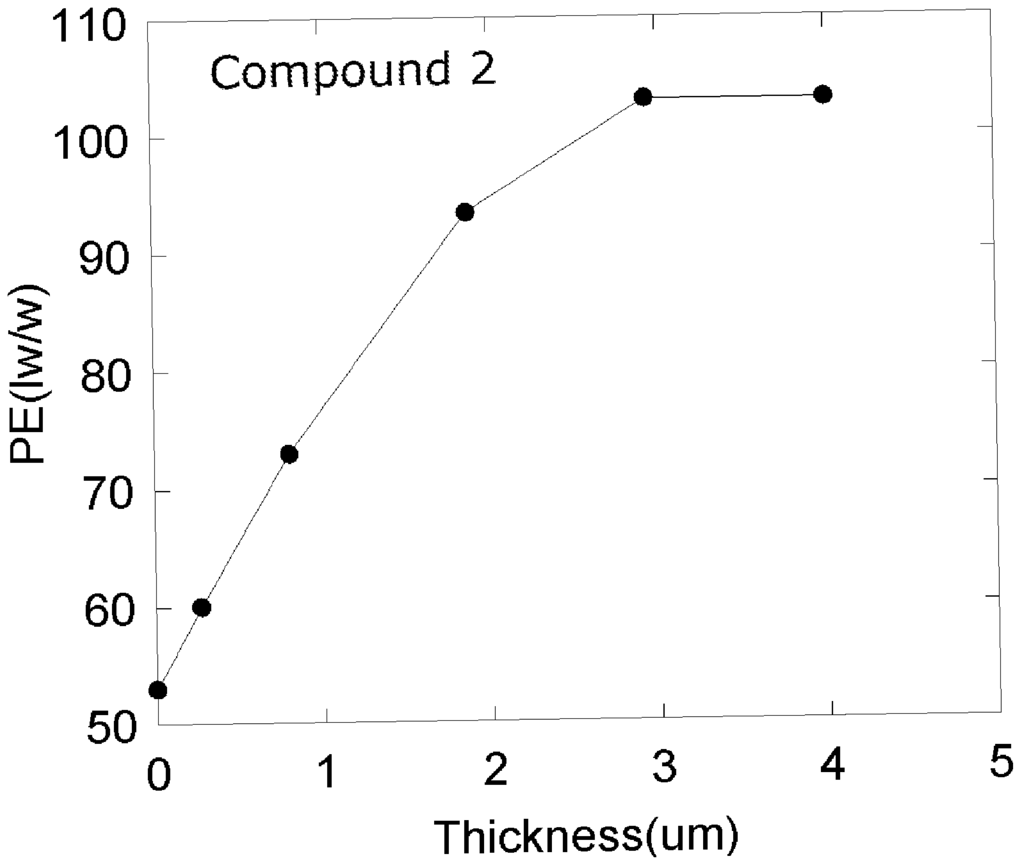
Compound 2
PE(lw/w)
110
100
90
80
70
60
50
0
1
2
3
4
5
Thickness(um)

FIG. 71

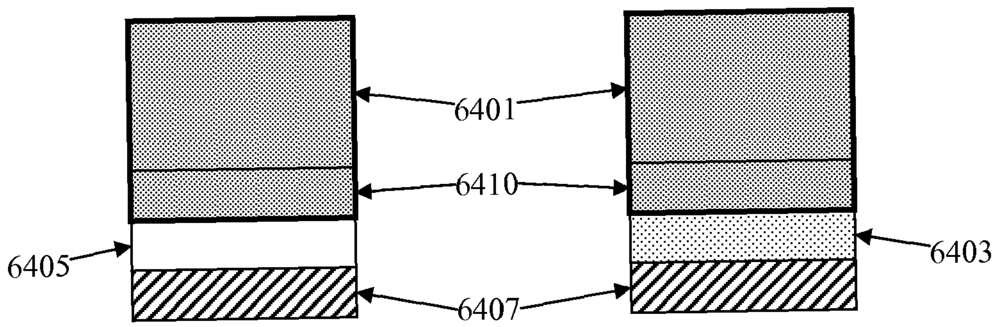
6401
6410
6405
6403
6407

FIG. 72

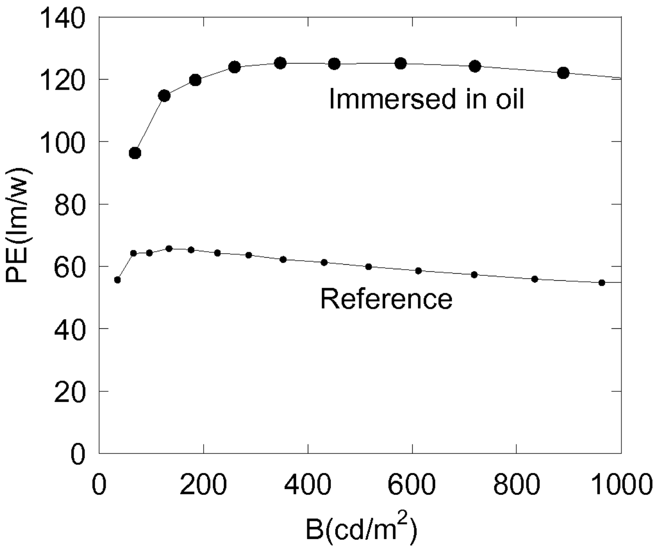


FIG. 73

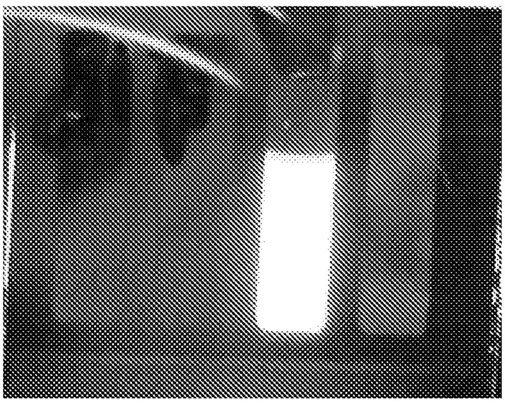

A

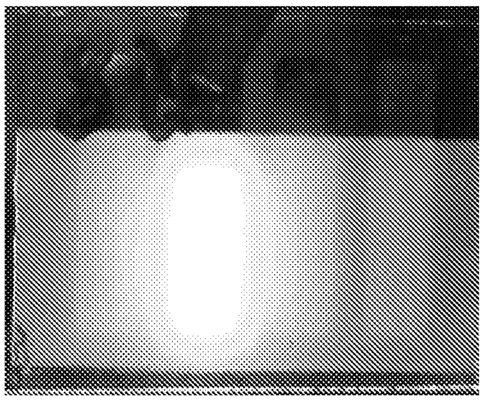

B

FIG. 74

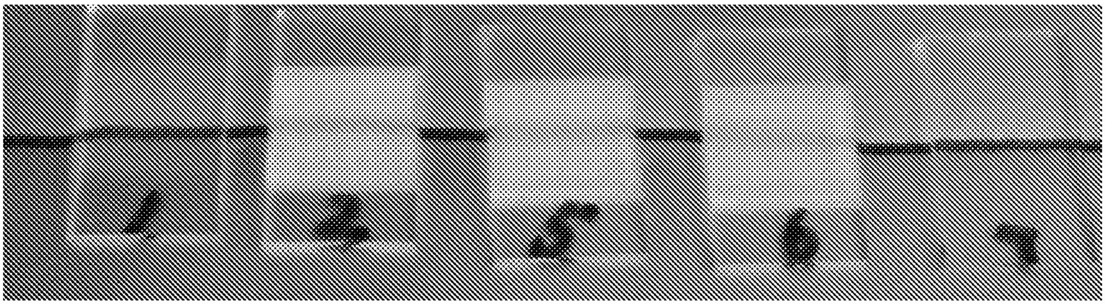

FIG. 75

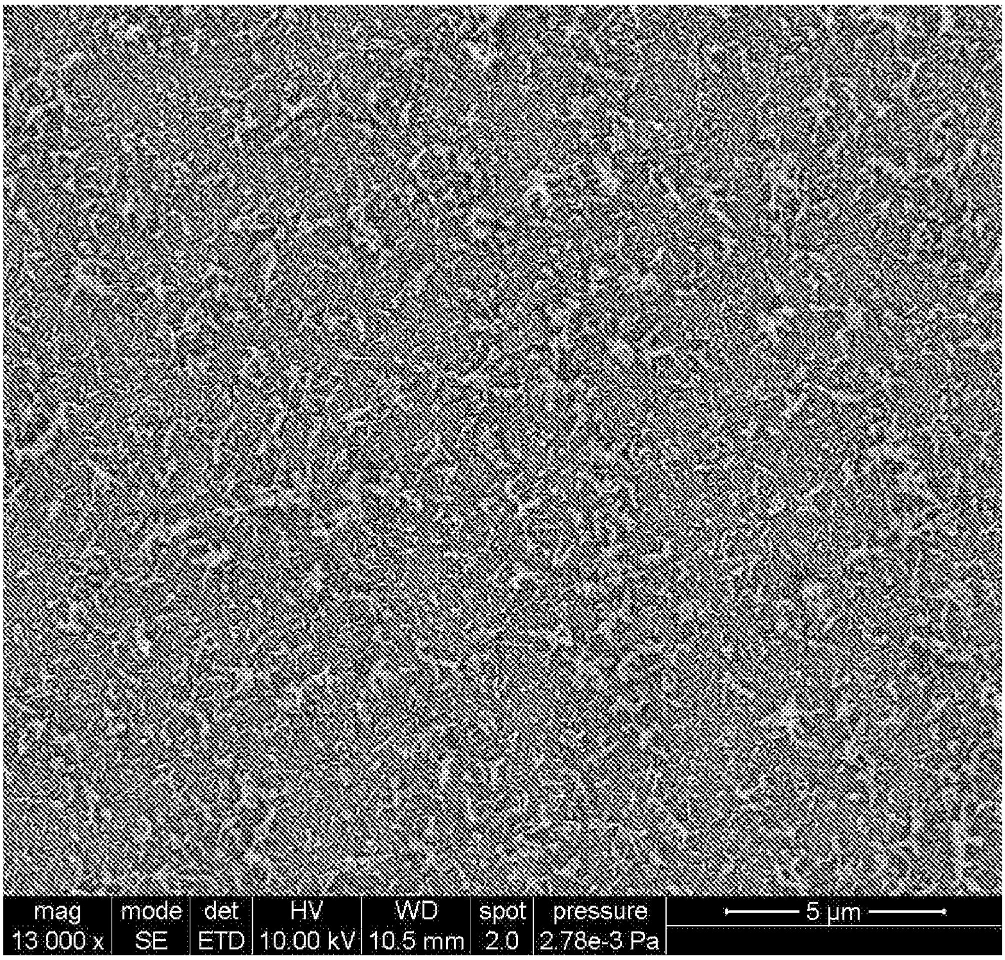
mag
13 000 x
mode
SE
det
ETD
HV
10.00 kV
WD
10.5 mm
spot
2.0
pressure
2.78e-3 Pa
5 μm

FIG. 76

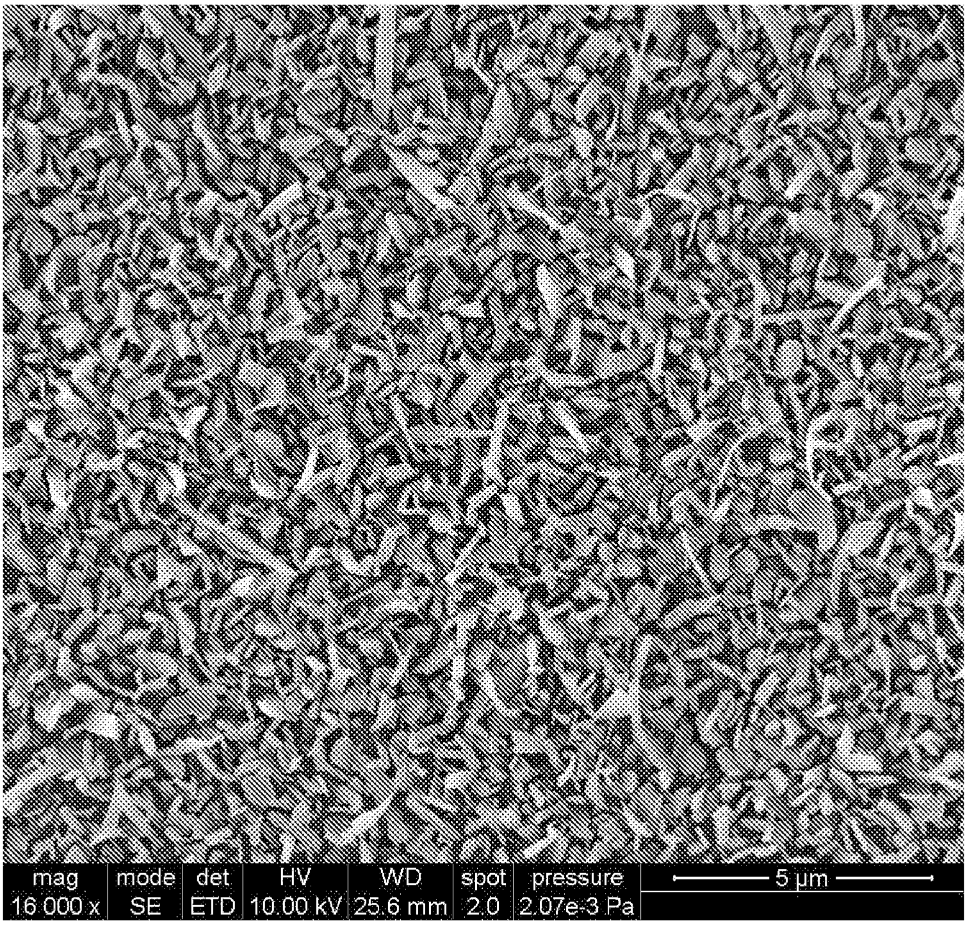
mag
16 000 x
mode
SE
det
ETD
HV
10.00 kV
WD
25.6 mm
spot
2.0
pressure
2.07e-3 Pa
5 µm

FIG. 77

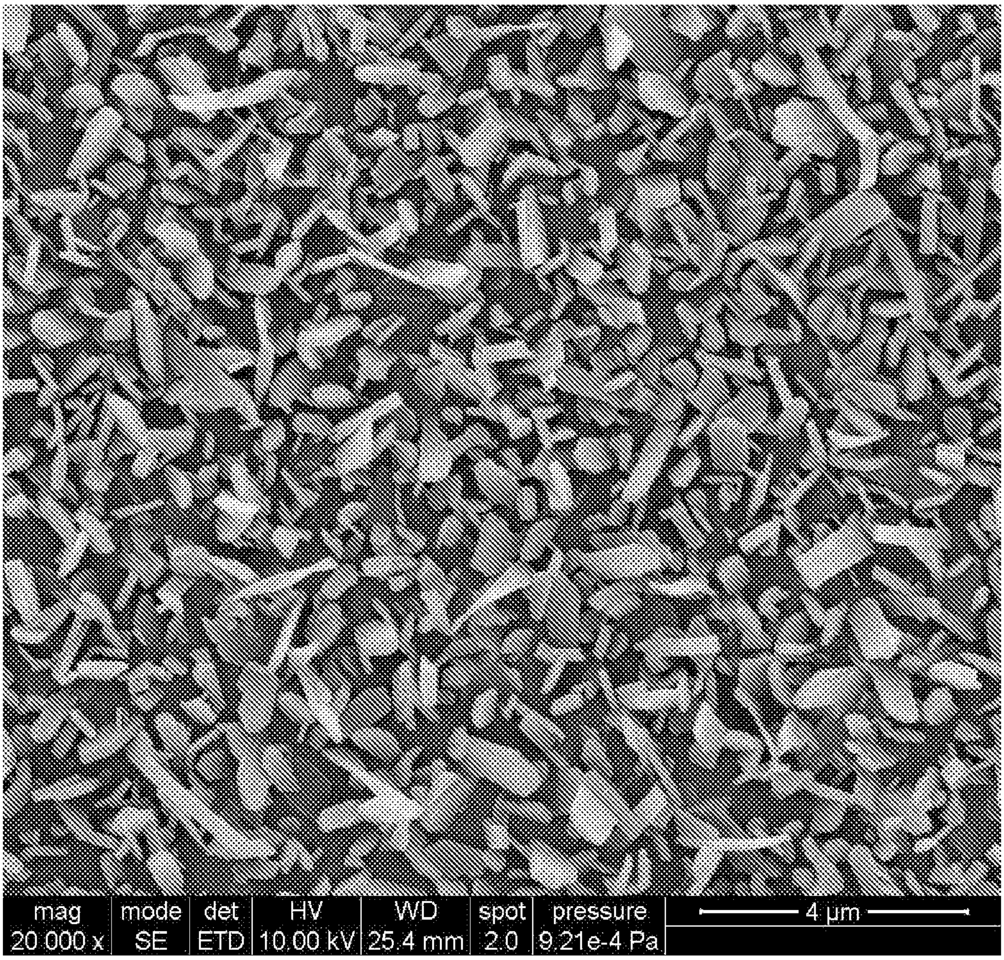
mag
20 000 x
mode
SE
det
ETD
HV
10.00 kV
WD
25.4 mm
spot
2.0
pressure
9.21e-4 Pa
4 µm

FIG. 78

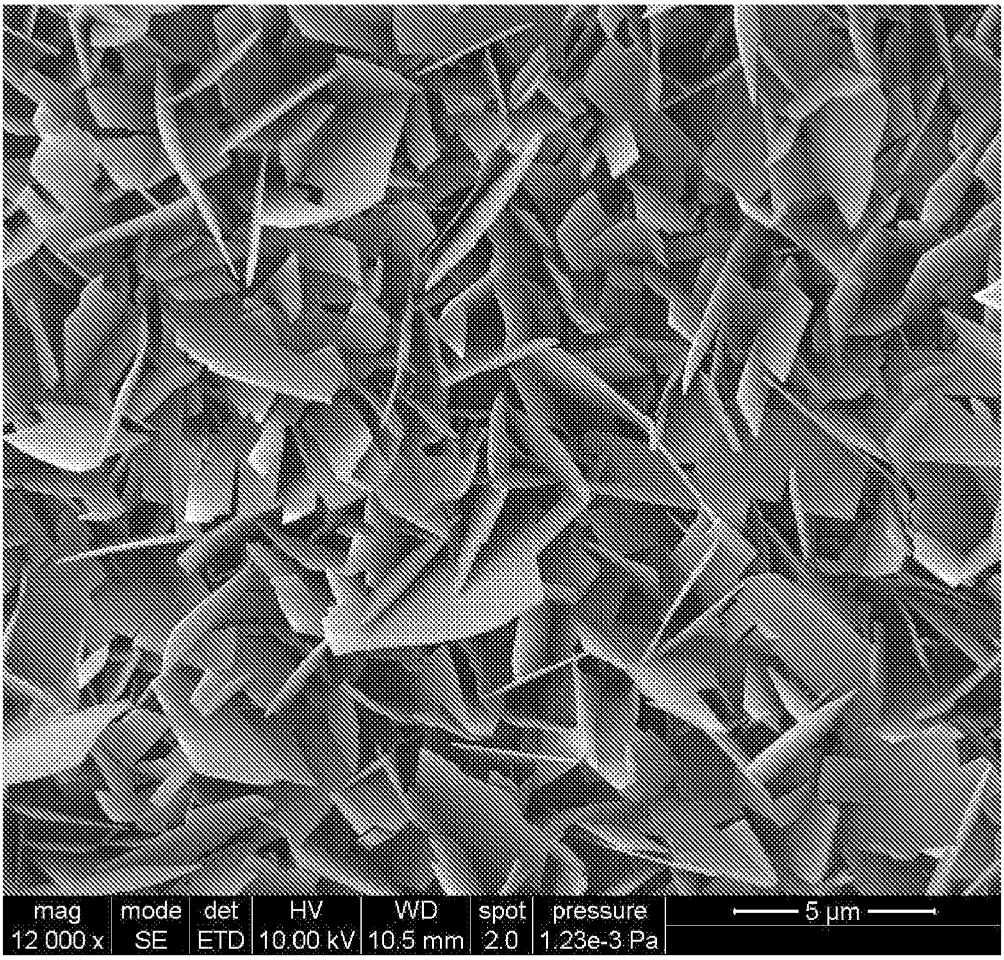
mag
12 000 x
mode
SE
det
ETD
HV
10.00 kV
WD
10.5 mm
spot
2.0
pressure
1.23e-3 Pa
5 μm

FIG. 79

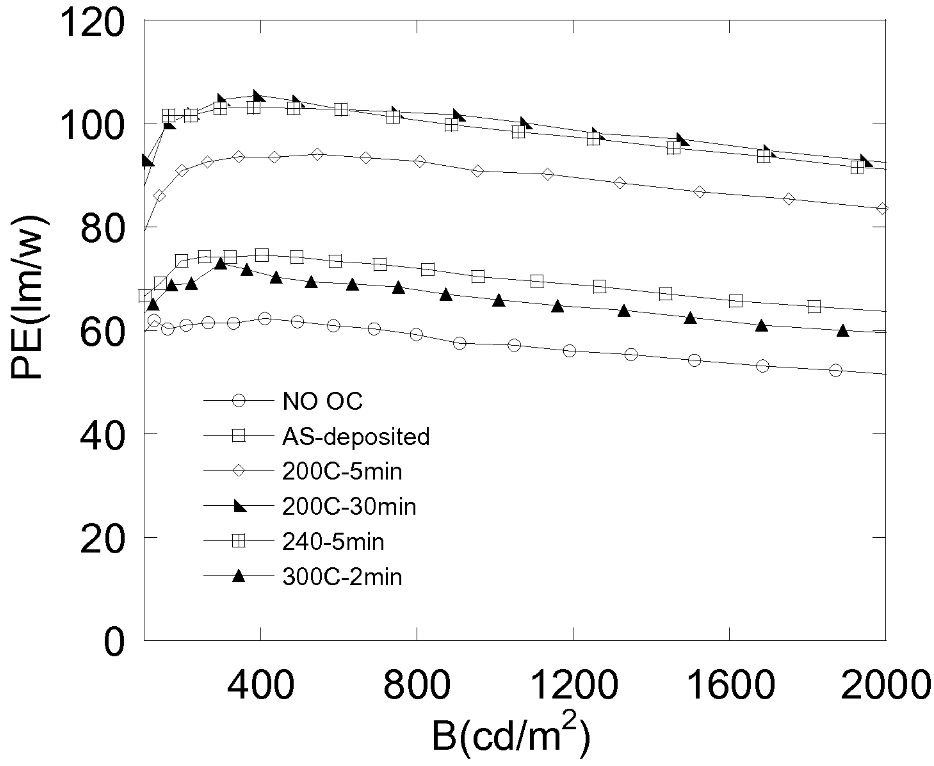

120
100
80
60
40
20
0
PE(lm/w)
400
800
1200
1600
2000
B(cd/m2)
NO OC
AS-deposited
200C-5min
200C-30min
240-5min
300C-2min


FIG. 80

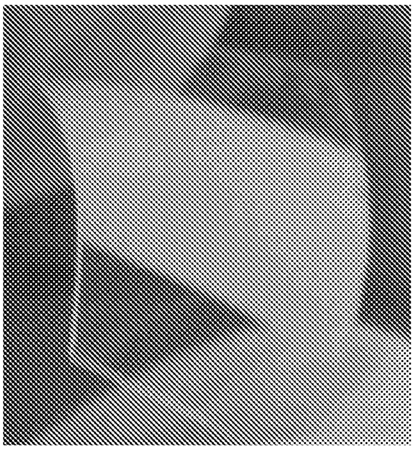

FIG. 81

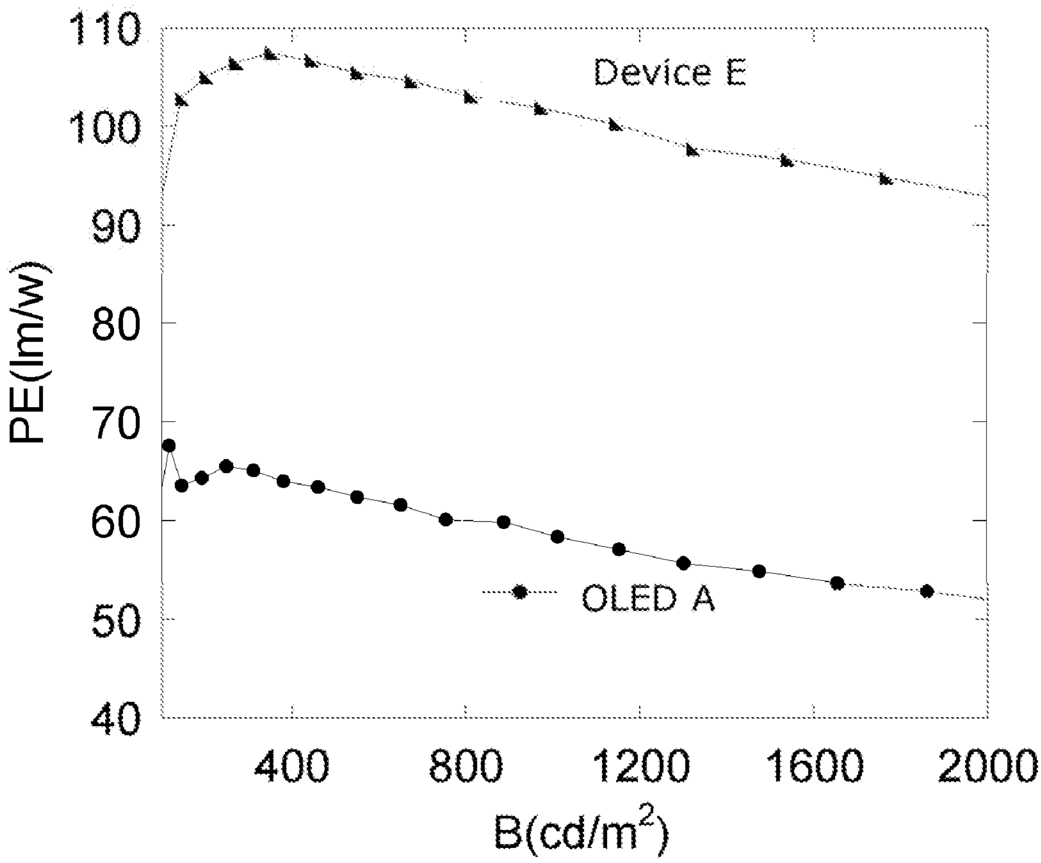
110
100
90
80
70
60
50
40
PE(lm/w)
400
800
1200
1600
2000
B(cd/m2)
Device E
OLED A

FIG. 82

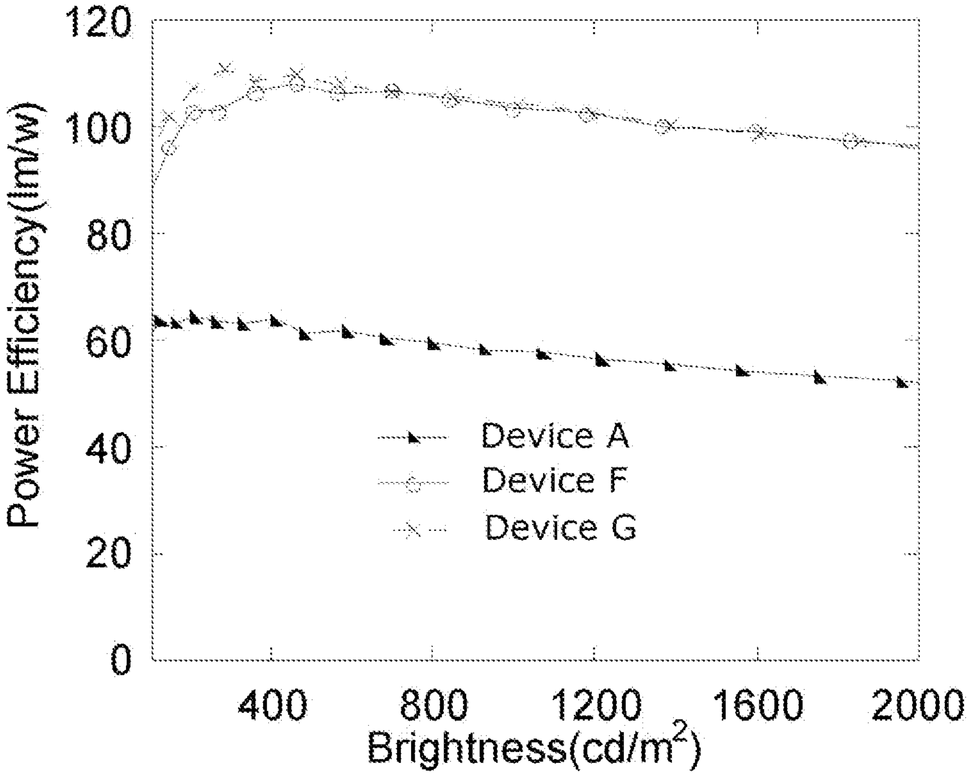
120
100
80
60
40
20
0
Power Efficiency(lm/w)
400
800
1200
1600
2000
Brightness(cd/m2)
Device A
Device F
Device G

FIG. 83

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 61449032 A
- US 2005156520 A
- US 61221427 B
- US 12825953 B
- US 61383602 B
- US 61426259 B
- US 61449001 B
- US 61449034 B


### Non-patent literature cited in the description


- Flexible light-emitting diodes made from soluble conducting polymer. *Nature,* 11 June 1992, vol. 357, 477-479